# EUROPEAN PATENT SPECIFICATION

(11) **EP 4 395 516 B1**
(45) Date of publication and mention of the grant of the patent: **11.02.2026**
(21) Application number: 23197247.2
(22) Date of filing: 13.09.2023
(51) Int. Cl.: H10K 85/30, H10K 85/60

(54) **ORGANIC LIGHT EMITTING DIODE AND ORGANIC LIGHT EMITTING DEVICE INCLUDING THE SAME**
ORGANISCHE LICHTEMITTIERENDE DIODE UND ORGANISCHE LICHTEMITTIERENDE VORRICHTUNG DAMIT
DIODE ÉLECTROLUMINESCENTE ORGANIQUE ET DISPOSITIF ÉLECTROLUMINESCENT ORGANIQUE LA COMPRENANT

(30) Priority: 26.12.2022 KR 20220184113
(43) Date of publication of application: 03.07.2024
(73) Proprietor: LG Display Co., Ltd., Seoul 07336 (KR)
(72) Inventor: KIM, Sang-Beom, 10845 Seoul (KR); YU, Young-Jun, 10845 Seoul (KR); YOO, Seon-Keun, 10845 Seoul (KR); YOON, Dae-Wi, 10845 Seoul (KR); CHOI, Su-Na, 10845 Seoul (KR); JEON, Seong-Su, 10845 Seoul (KR); KIM, Yong-Hwan, 10845 Seoul (KR); PARK, Jin-Hwan, 10845 Seoul (KR); KIM, Ji-Yun, 10845 Seoul (KR)
(74) Representative: Ter Meer Steinmeister & Partner

(56) References cited:
- WO-A1-2021/010656
- US-A1- 2022 209 119
- US-A1- 2022 285 625

## Description

The present invention relates to an organic light emitting device, and more specifically, to an organic light emitting diode (OLED) having high emitting efficiency and color purity and improved lifespan.

### BACKGROUND

As requests for a flat panel display device having a small occupied area have been increased, an organic light emitting display device including an OLED has been the subject of recent research and development.

The OLED emits light by injecting electrons from a cathode as an electron injection electrode and holes from an anode as a hole injection electrode into an emitting material layer (EML), combining the electrons with the holes, generating an exciton, and transforming the exciton from an excited state to a ground state. A flexible substrate, for example, a plastic substrate, can be used as a base substrate where elements are formed. In addition, the organic light emitting display device can be operated at a voltage (e.g., 10V or below) lower than a voltage required to operate other display devices. Moreover, the organic light emitting display device has advantages in the power consumption and the color sense.

The OLED includes a fist electrode as an anode over a substrate, a second electrode, which is spaced apart from and faces the first electrode, and an organic emitting layer therebetween.

For example, the organic light emitting display device may include a red pixel region, a green pixel region and a blue pixel region, and the OLED may be formed in each of the red, green and blue pixel regions.

US 2022/0285625 A1 refers to an organic electroluminescence device comprising: an anode, a cathode, and an emitting region between the anode and the cathode, wherein the emitting region comprises a first emitting layer and a second emitting layer, the first emitting layer and the second emitting layer are directly adjacent to each other, the first emitting layer is between the anode and the second emitting layer, and one of the first emitting layer and the second emitting layer comprises a compound having at least one deuterium atom.

US 2022/0209119 A1 is directed to an organic light emitting diode including at least one emitting material layer including a boron-based dopant and an anthracene-based host substituted with at least one deuterium.

However, the OLED in the blue pixel does not provide sufficient emitting efficiency, color purity and lifespan such that the organic light emitting display device has a limitation in the emitting efficiency, the color purity and the lifespan.

### SUMMARY

The present invention is directed to an OLED and an organic light emitting device including the OLED that substantially obviate one or more of the problems associated with the limitations and disadvantages of the related conventional art.

Additional features and advantages of the present invention are set forth in the description which follows, and will be apparent from the description, or evident by practice of the present invention. The objectives and other advantages of the present invention are realized and attained by the features described herein as well as in the appended drawings.

To achieve these and other advantages in accordance with the purpose of the embodiments of the present invention, as described herein, an aspect of the present invention is an organic light emitting diode comprising a first electrode; a second electrode facing the first electrode; and a first emitting part including a first blue emitting layer and a second blue emitting layer and positioned between the first and second electrode, the second blue emitting layer positioned between the first blue emitting layer and the second electrode and contacting the first blue emitting layer, wherein the first blue emitting layer includes a first host and a first dopant, and the second blue emitting layer includes a second host and a second dopant, wherein the first host is an anthracene derivative having a first deuteration ratio, and the second host is an anthracene derivative having a second deuteration ratio smaller than the first deuteration ratio, wherein the first dopant is a first compound represented by Formula 3a: 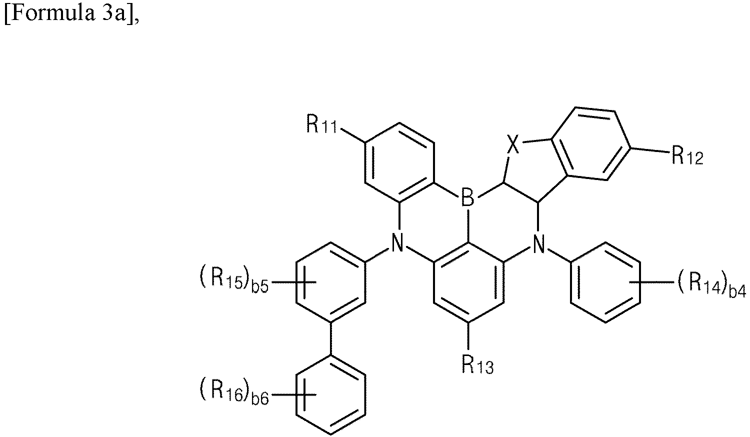
wherein in the Formula 3a, , X is O or S, R₁₁, R₁₂ and R₁₃ is independently selected from the group consisting of a substituted or unsubstituted C1 to C30 alkyl group, a substituted or unsubstituted C3 to C30 cycloalkyl group, a substituted or unsubstituted C6 to C30 arylamino group, a substituted or unsubstituted C6 to C30 aryl group and a substituted or unsubstituted C3 to C30 heteroaryl group, or at least one pair of adjacent two or more R₁₁, adjacent two or more R₁₂ and adjacent two or more R₁₃ are connected to each other to form a substitute or unsubstituted ring, each of b4 and b6 is independently an integer of 0 to 5, and b5 is an integer of 0 to 4,
each of R₁₄, R₁₅ and R₁₆ is selected from the group consisting of a substituted or unsubstituted C1 to C30 alkyl group and a substituted or unsubstituted C3 to C30 cycloalkyl group, or at least one pair of adjacent two R₁₄ and adjacent R₁₅ and R₁₆ are connected to each other to form a substituted or unsubstituted ring, wherein the second dopant is a second compound represented by Formula 7: 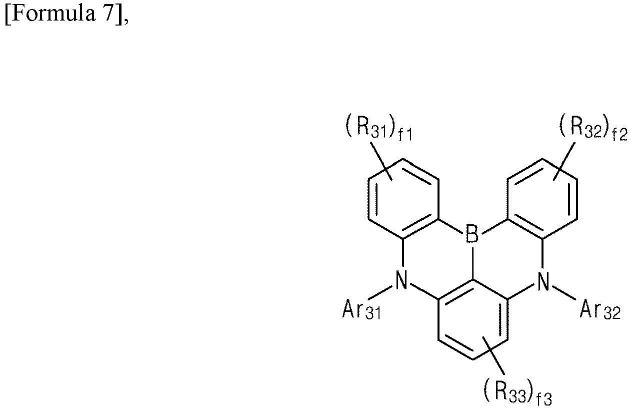
wherein in the Formula 7,
each of f1 and f2 is independently an integer of 0 to 4, and f3 is an integer of 0 to 3, each of Ar₃₁ and Ar₃₂ is independently selected from the group consisting of a substituted or unsubstituted C6 to C30 aryl group, a substituted or unsubstituted C3 to C30 heteroaryl group and a substituted or unsubstituted C6 to C30 alicyclic group, and R₃₁, R₃₂ and R₃₃ is independently selected from the group consisting of a substituted or unsubstituted C1 to C30 alkyl group, a substituted or unsubstituted C3 to C30 cycloalkyl group, a substituted or unsubstituted C6 to C30 arylamino group, a substituted or unsubstituted C6 to C30 aryl group and a substituted or unsubstituted C3 to C30 heteroaryl group.

In an embodiment, the second dopant is represented by Formula 7a: 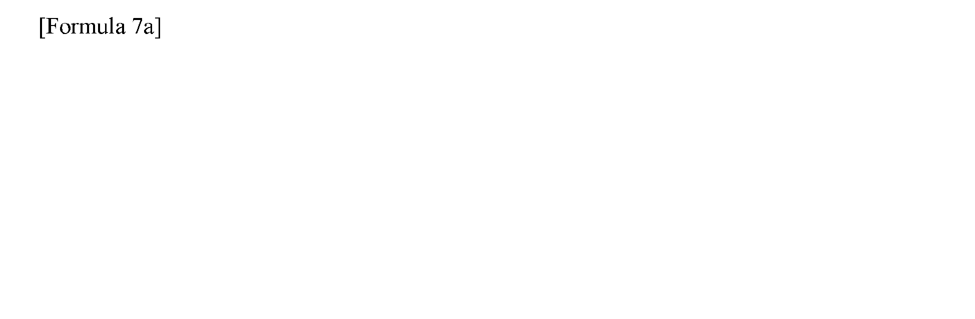 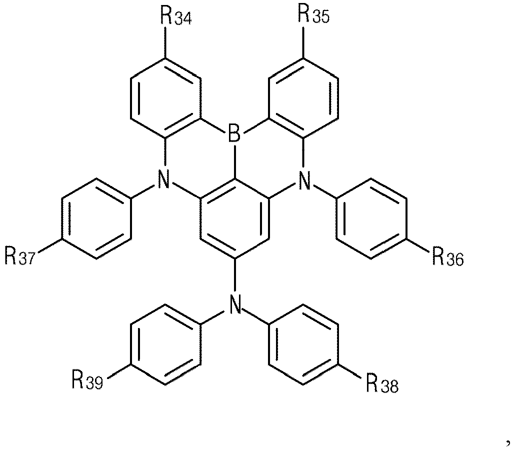 wherein in the Formula 7a, each of R₃₄ to R₃₉ is independently selected from the group consisting of hydrogen, a substituted or unsubstituted C1 to C30 alkyl group, a substituted or unsubstituted C3 to C30 cycloalkyl group, a substituted or unsubstituted C6 to C30 aryl group and a substituted or unsubstituted C3 to C30 heteroaryl group.

In an embodiment, the first dopant is one of compounds in Formula 4:

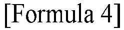

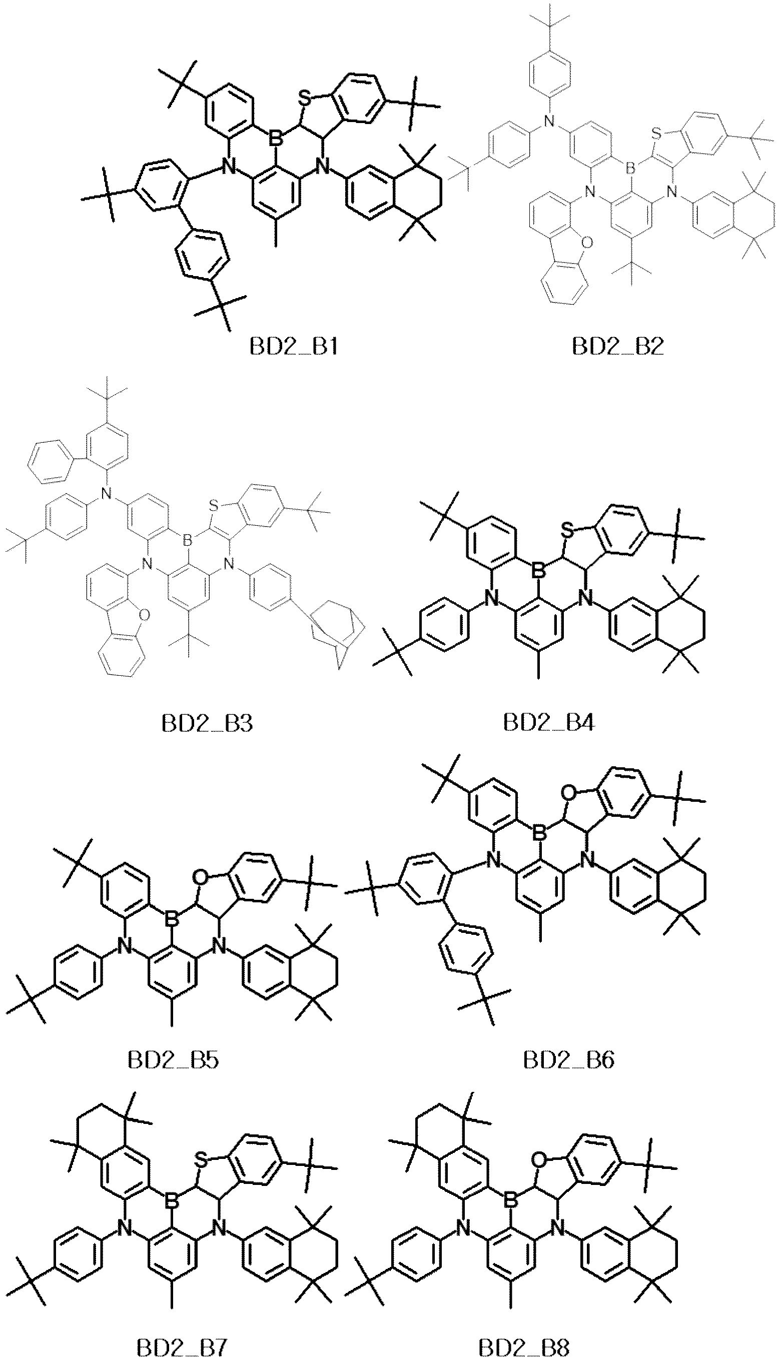

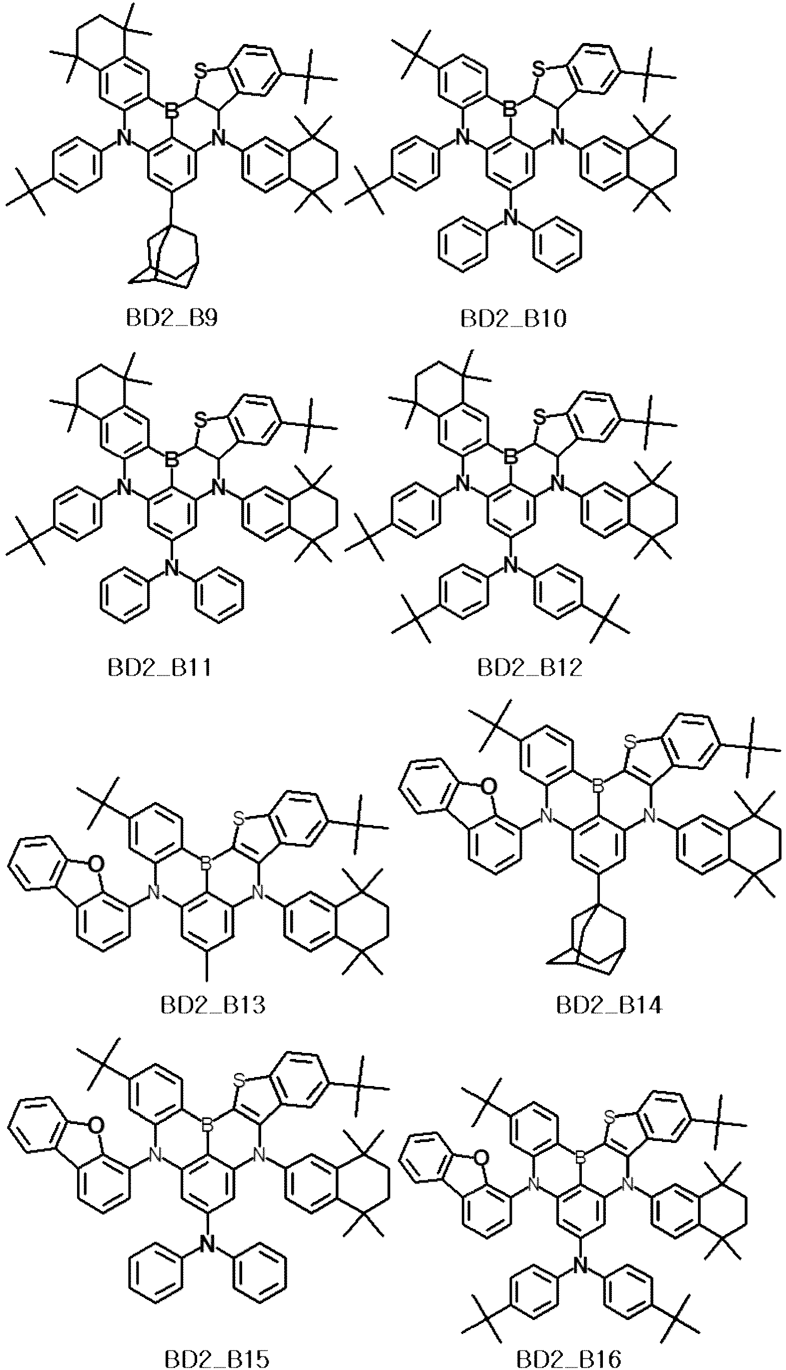

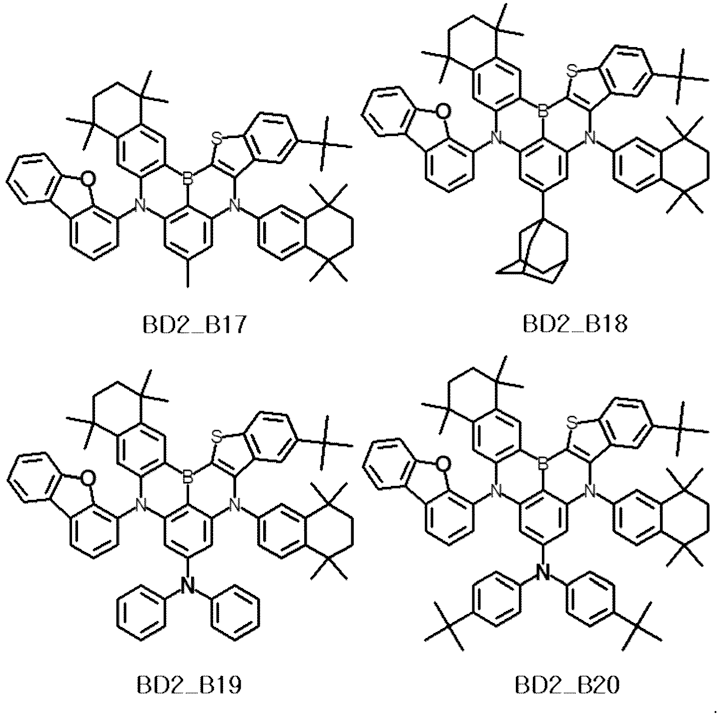

In an embodiment, the second dopant is one of compounds in Formula 8:

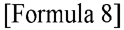

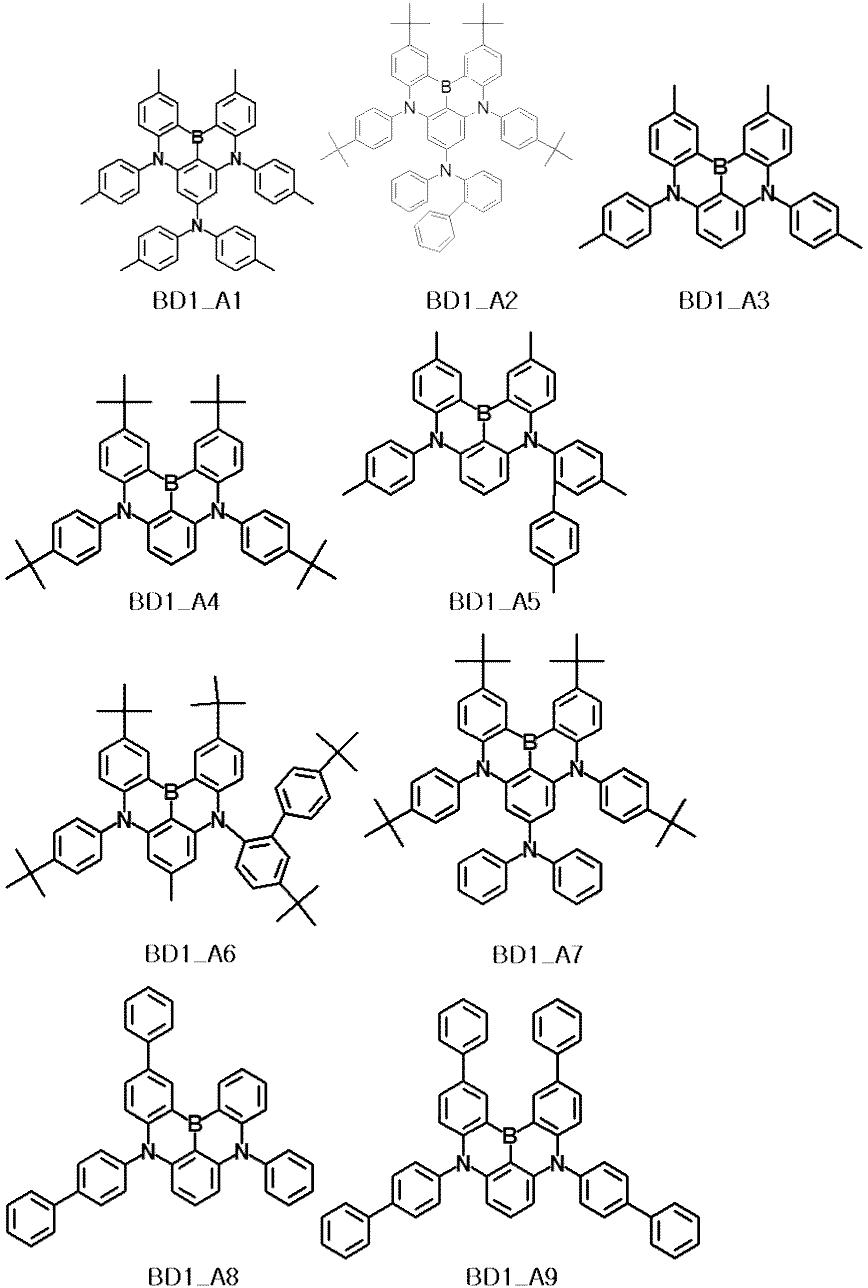

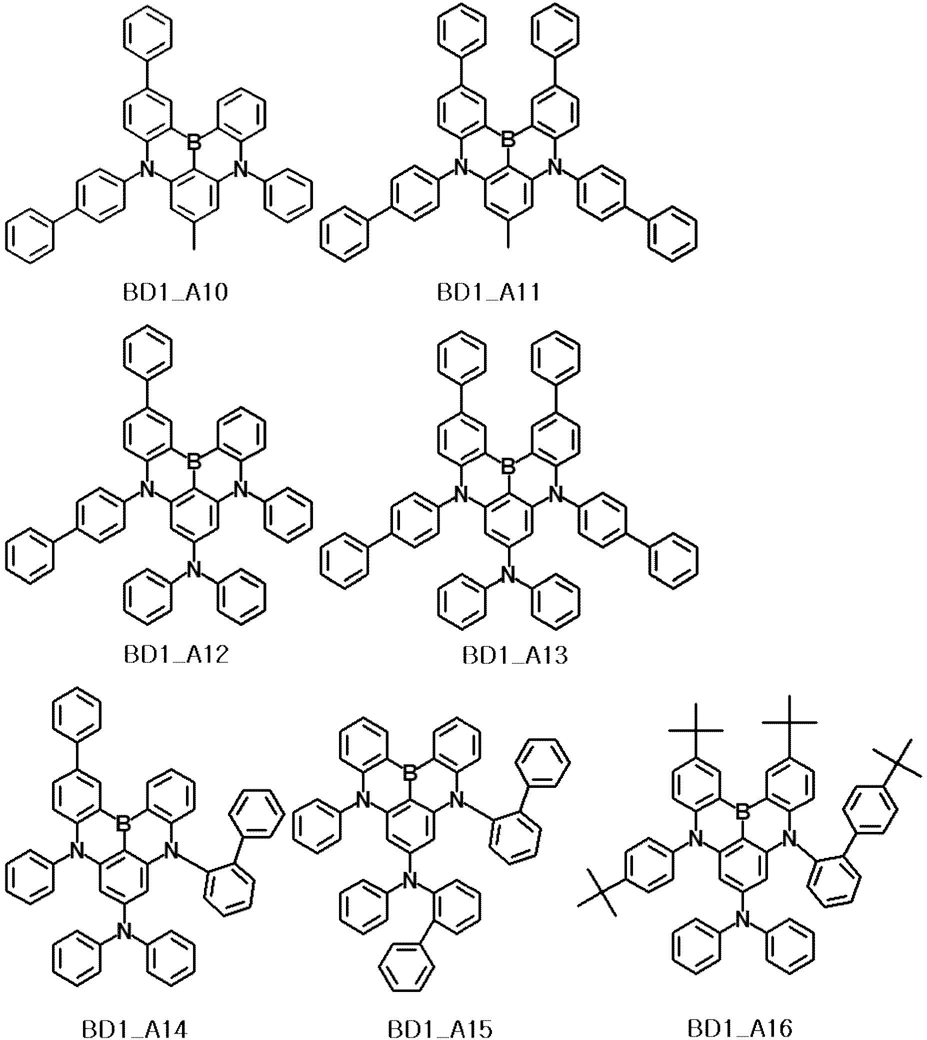

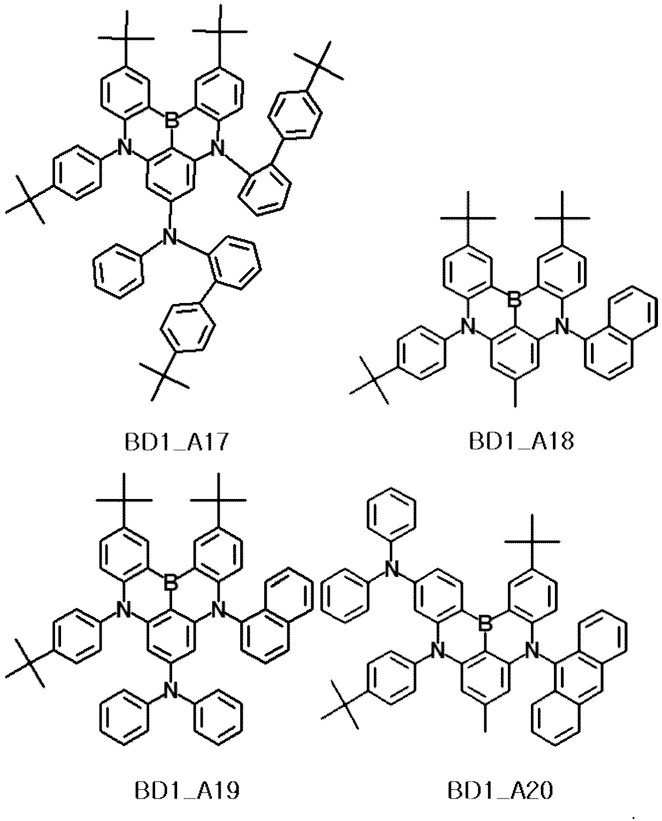

In an embodiment, the first host is represented by Formula 1: 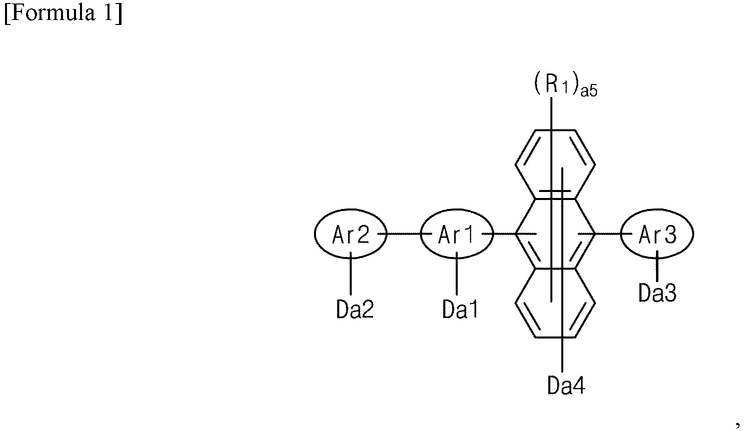
wherein in the Formula 1, each of a1, a2 and a3 is independently an integer of 0 or 30, each of a4 and a5 is independently an integer of 0 to 8, and at least one of a1 to a4 is a positive integer,
Ar1 is selected from the group consisting of a single bond (a direct bond), a substituted or unsubstituted C6 to C30 arylene group and a substituted or unsubstituted C3 to C30 heteroarylene group,
each of Ar2 and Ar3 is selected from the group consisting of a substituted or unsubstituted C6 to C30 aryl group and a substituted or unsubstituted C3 to C30 heteroaryl group, and R₁ is selected from the group consisting of a C1 to C30 alkyl group unsubstituted or substituted with deuterium and a C3 to C30 cycloalkyl group unsubstituted or substituted with deuterium, wherein the second host is represented by Formula 5: 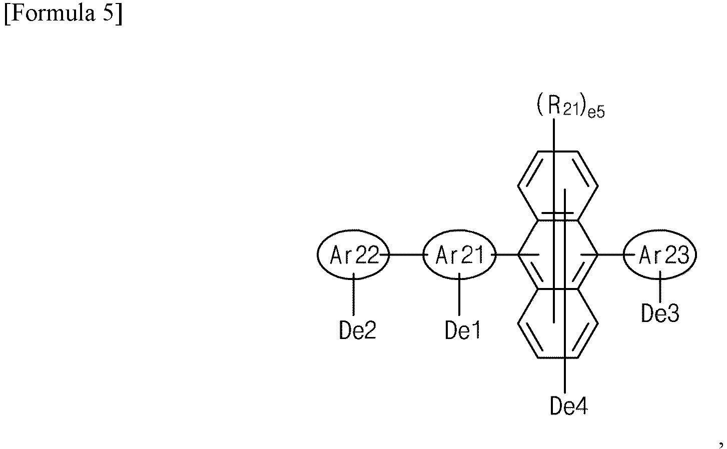
wherein in the Formula 5,
each of e1, e2 and e3 is independently an integer of 0 or 30, each of e4 and e5 is independently an integer of 0 to 8, and a summation of e1 to e4 is smaller than a summation of a1 to a4 in Formula 1,
Ar21 is selected from the group consisting of a single bond (a direct bond), a substituted or unsubstituted C6 to C30 arylene group and a substituted or unsubstituted C3 to C30 heteroarylene group, each of Ar22 and Ar23 is selected from the group consisting of a substituted or unsubstituted C6 to C30 aryl group and a substituted or unsubstituted C3 to C30 heteroaryl group, and R₂₁ is selected from the group consisting of a C1 to C30 alkyl group unsubstituted or substituted with deuterium and a C3 to C30 cycloalkyl group unsubstituted or substituted with deuterium.

In an embodiment, the first host is represented by Formula 1a: 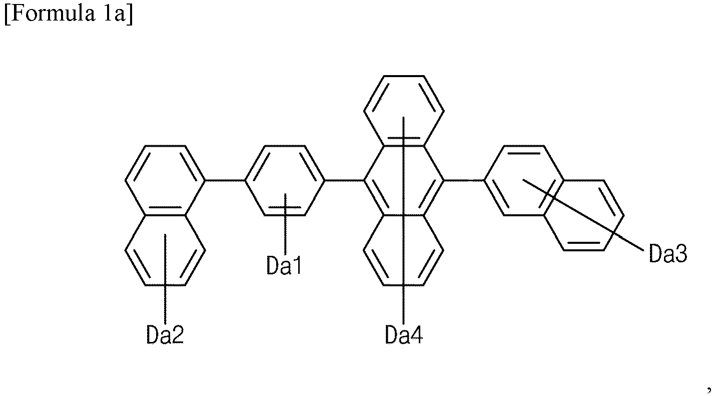
wherein in the Formula 1a, a1 is an integer of 0 to 4, each of a2 and a3 is independently an integer of 0 to 7, a4 is an integer of 0 to 8, and at least one of a1 to a4 is a positive integer, wherein the second host is represented by Formula 5a: 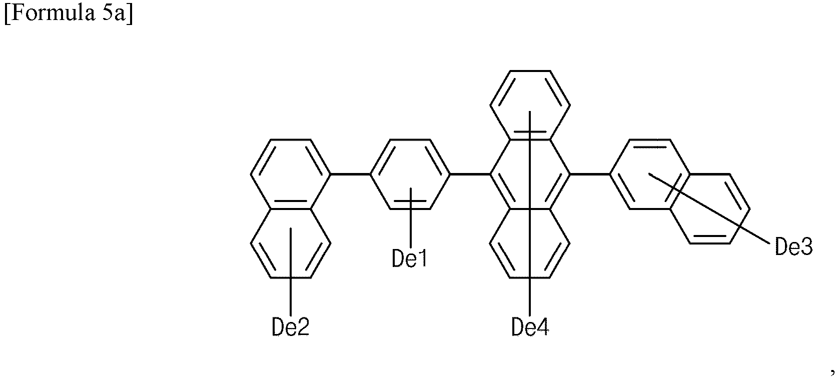
wherein in the Formula 5a, e1 is an integer of 0 to 4, each of e2 and e3 is independently an integer of 0 to 7, e4 is an integer of 0 to 8, and a summation of e1 to e4 is smaller than a summation of a1 to a4 in Formula 1a.

In an embodiment, the first host includes at least one of first host compounds in Formula 2:

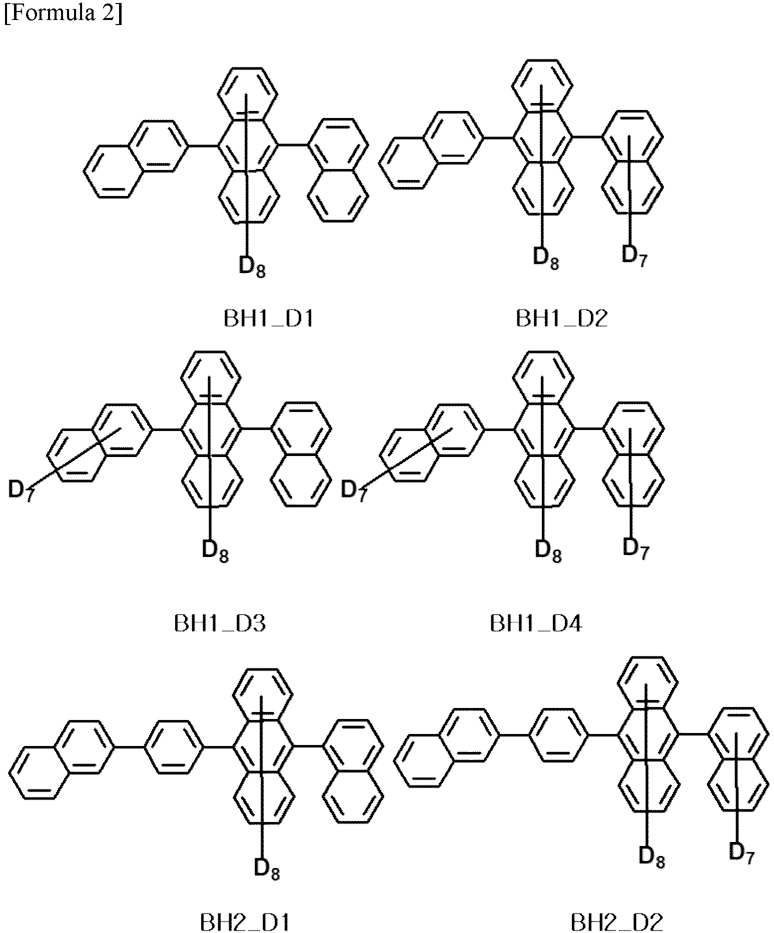

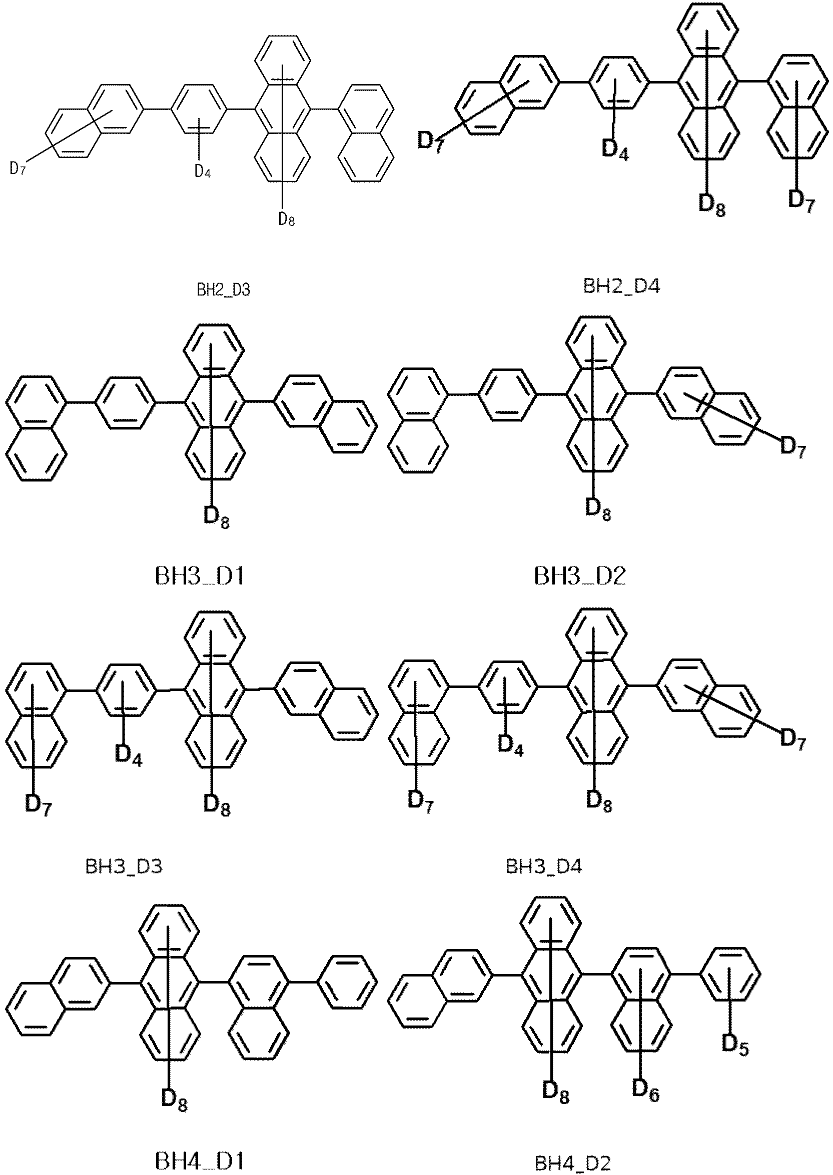

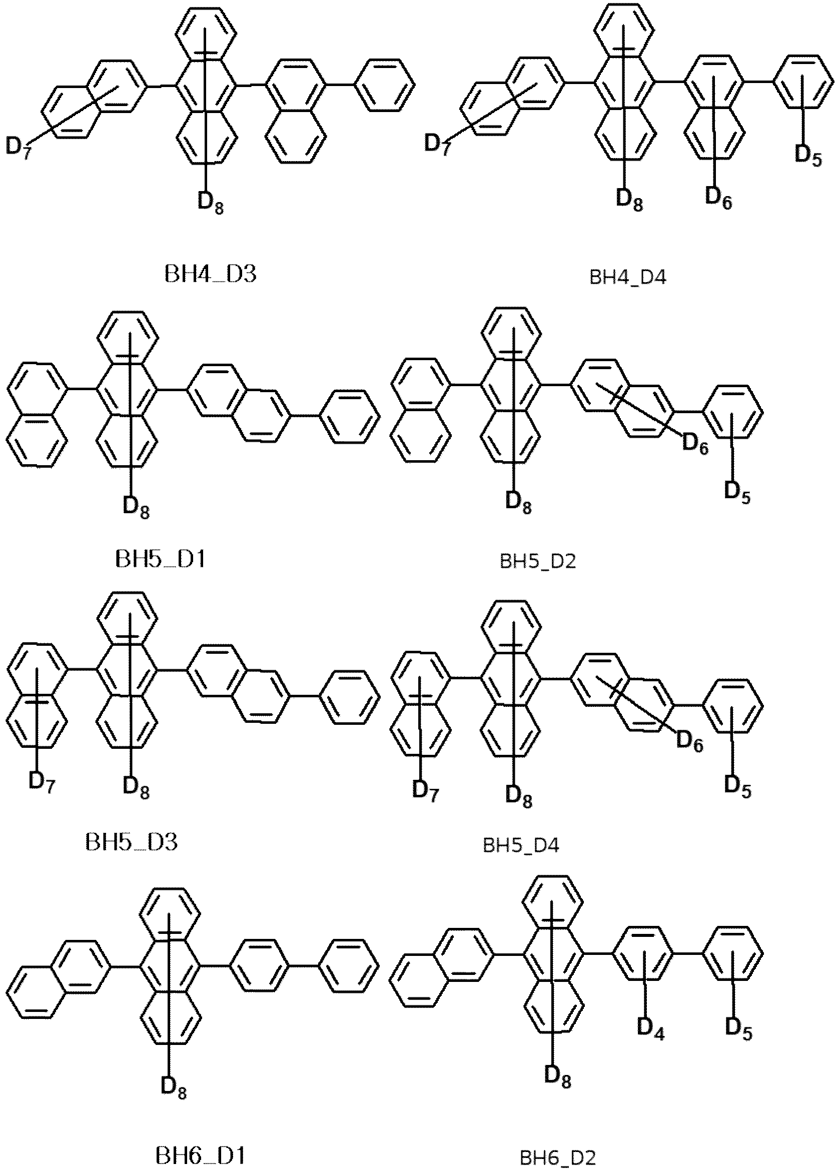

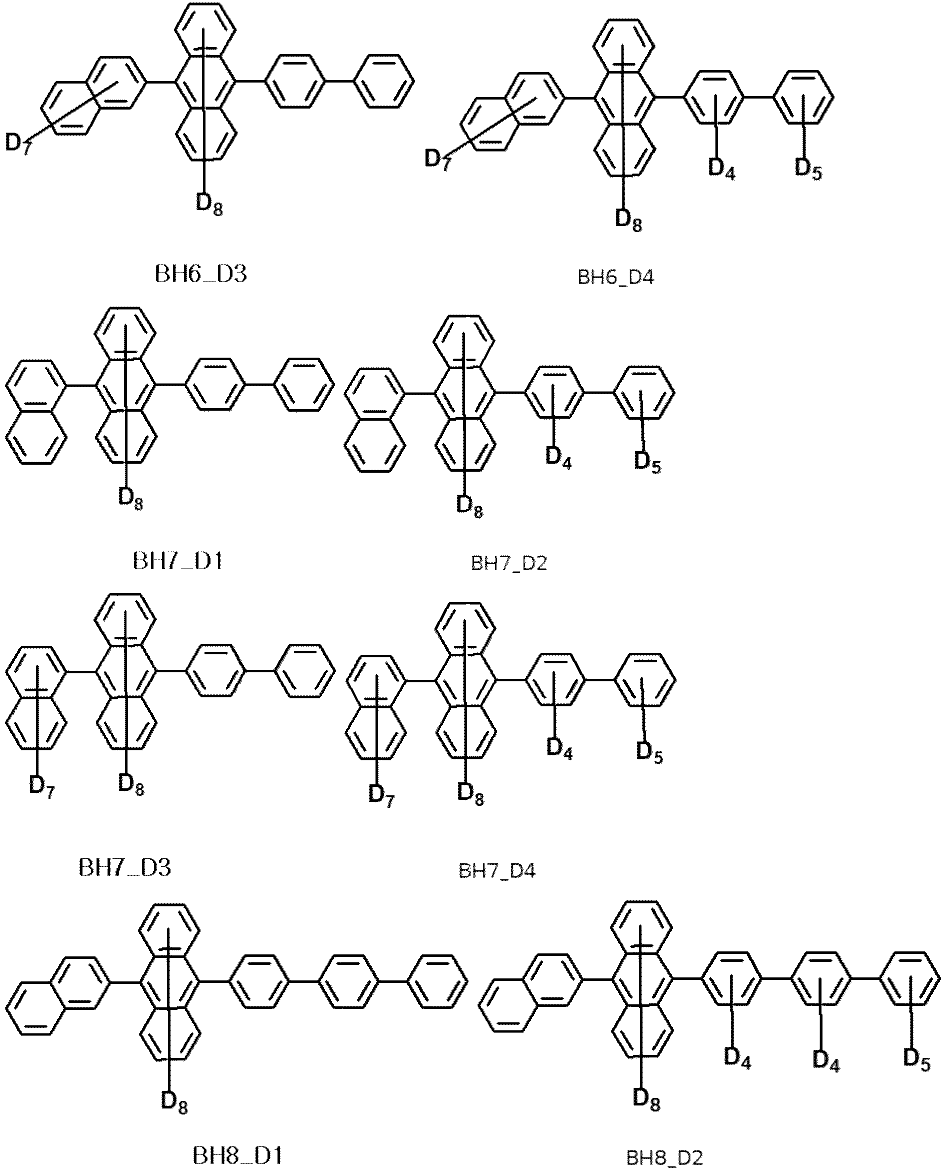

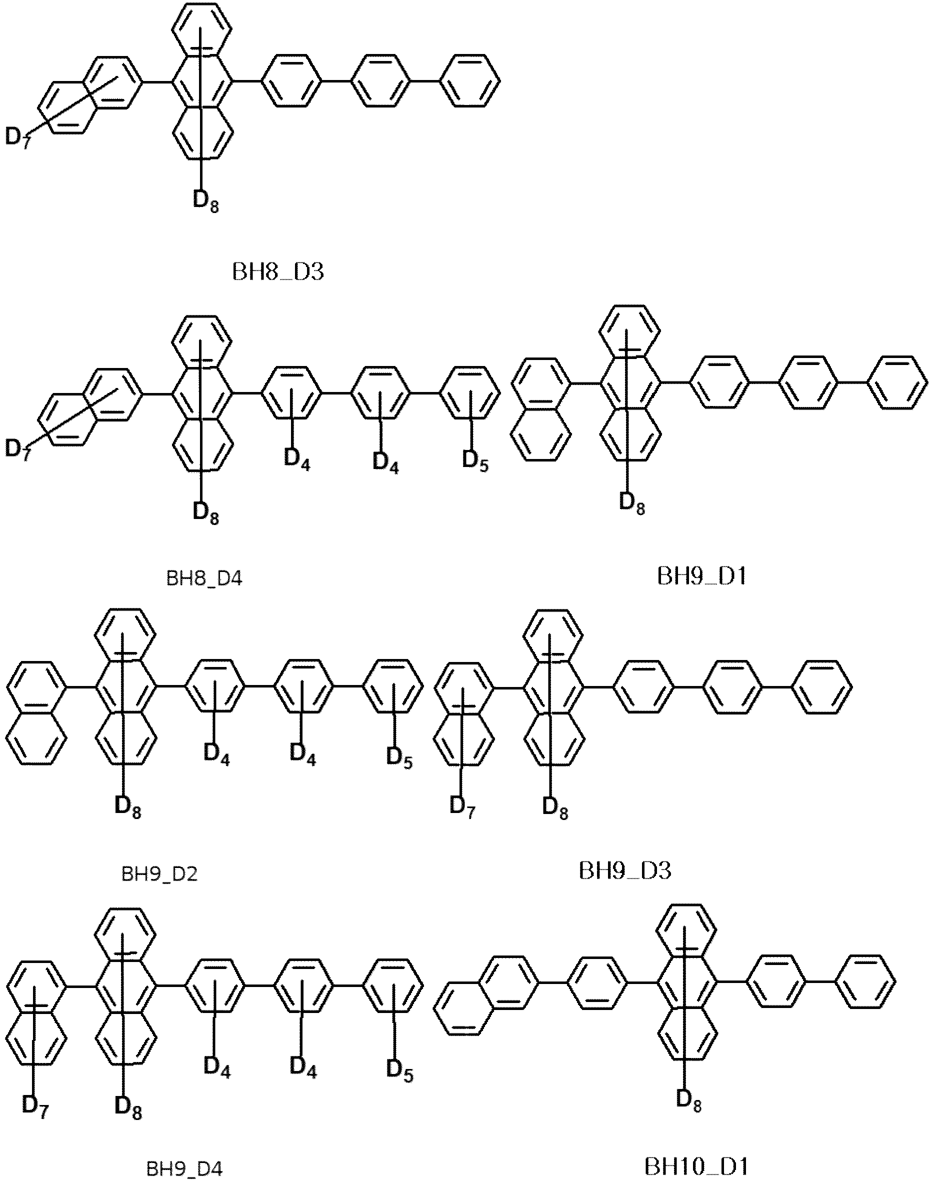

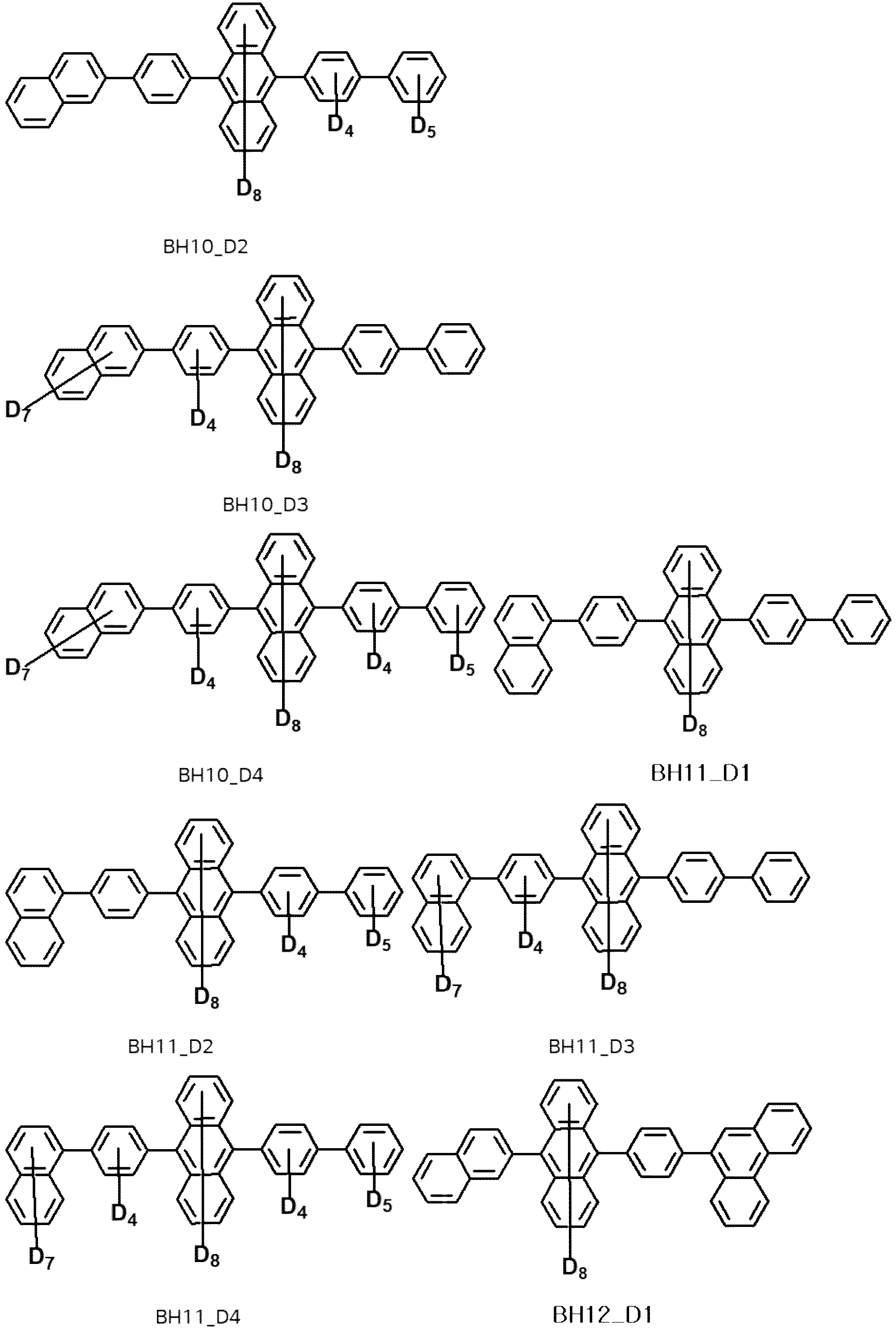

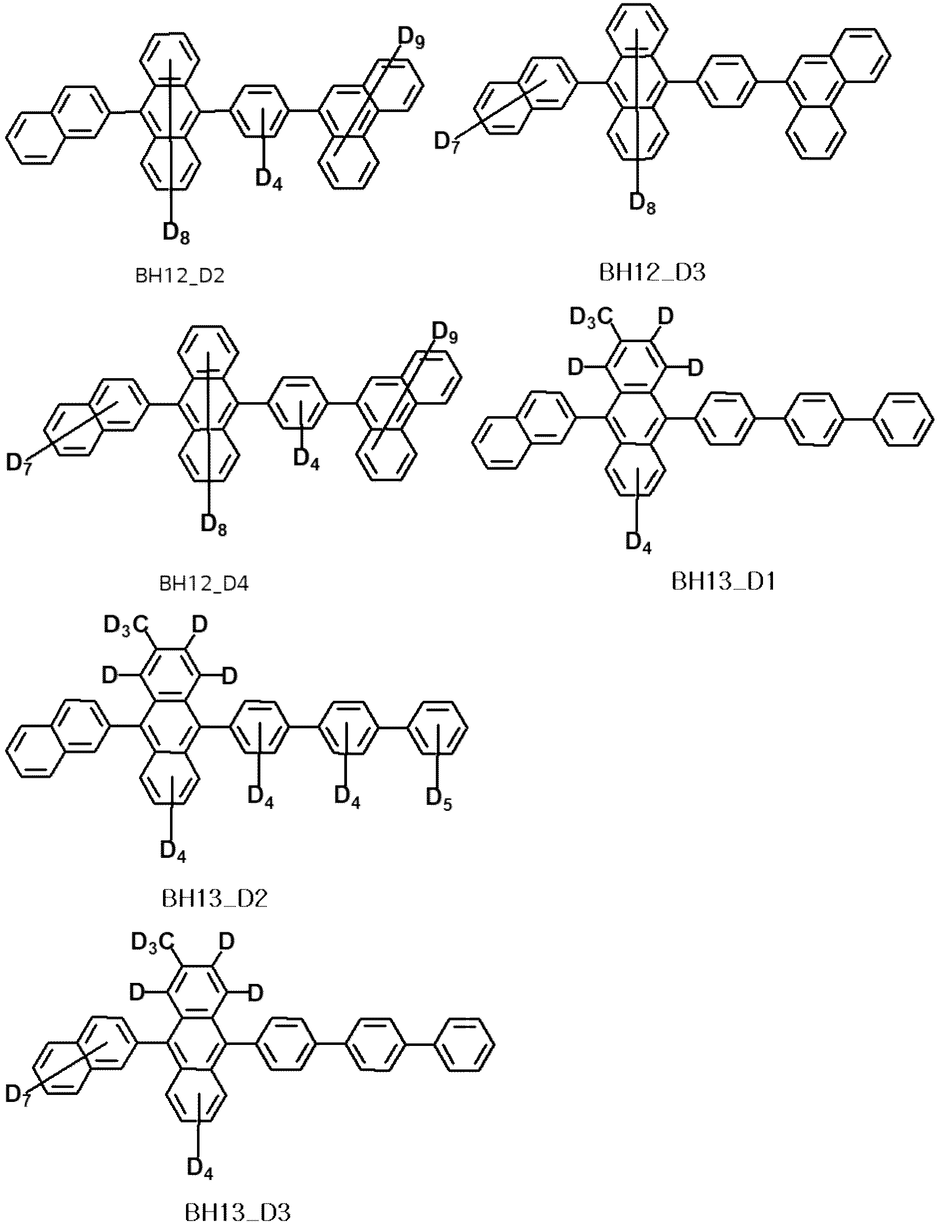

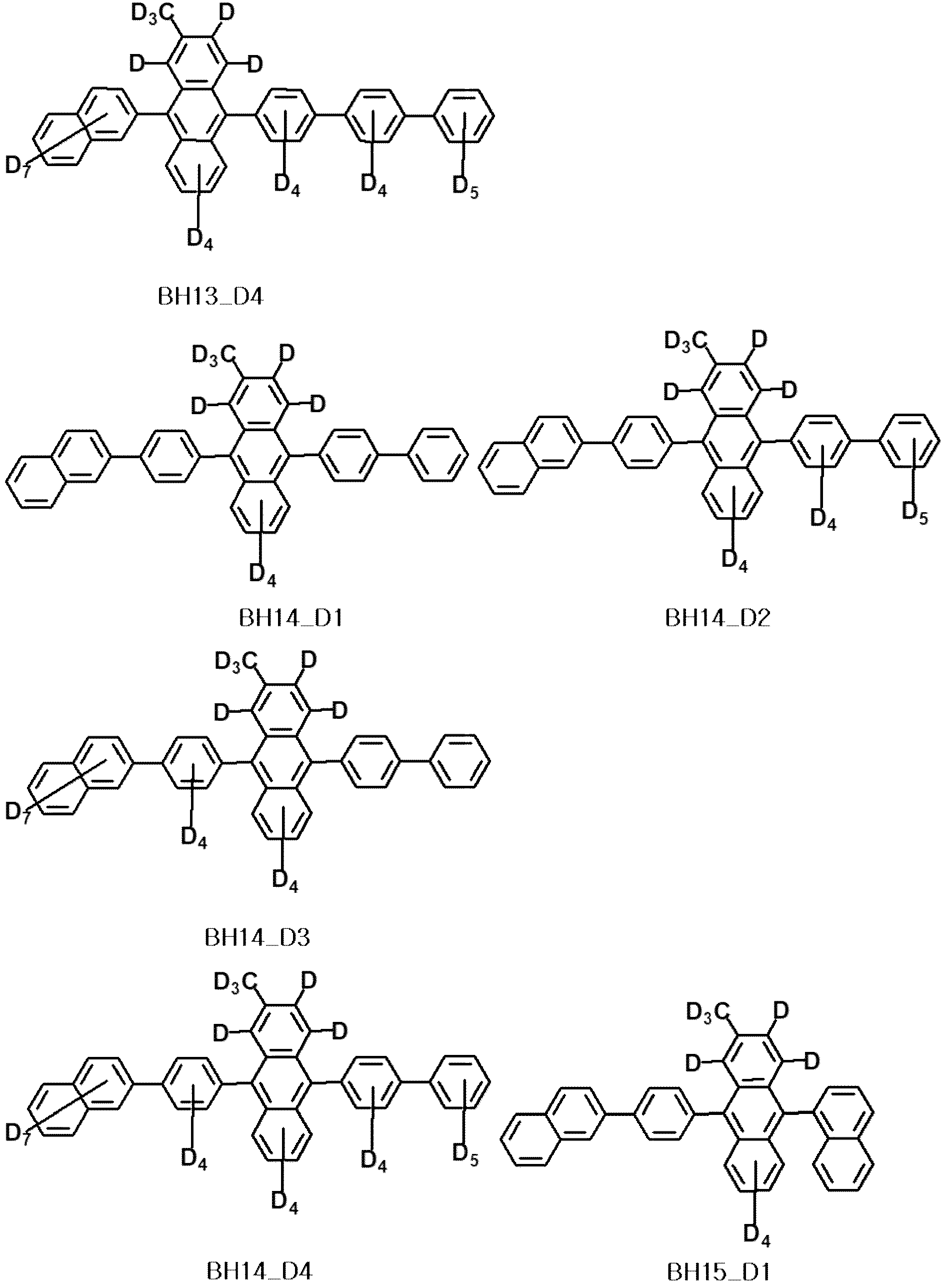

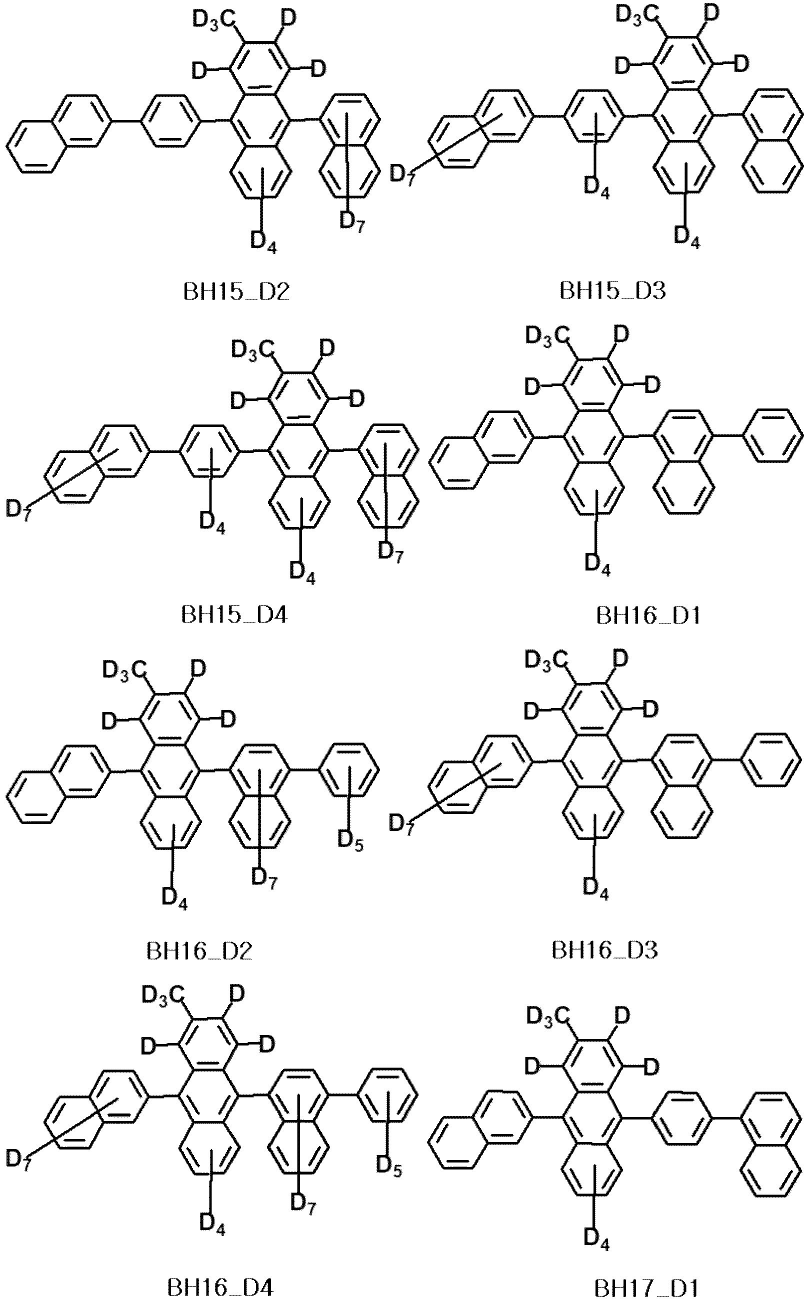

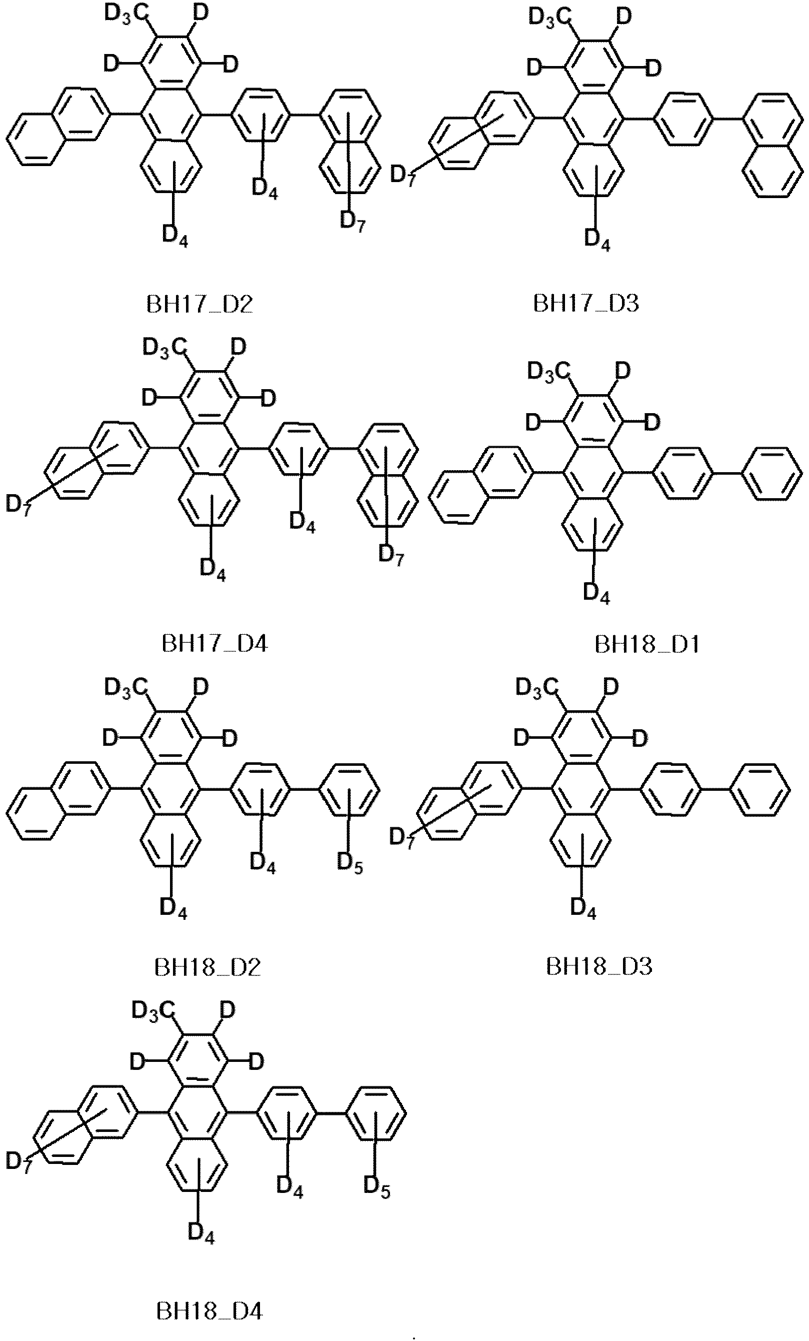

In an embodiment, the second host includes at least one of second host compounds in Formula 6:

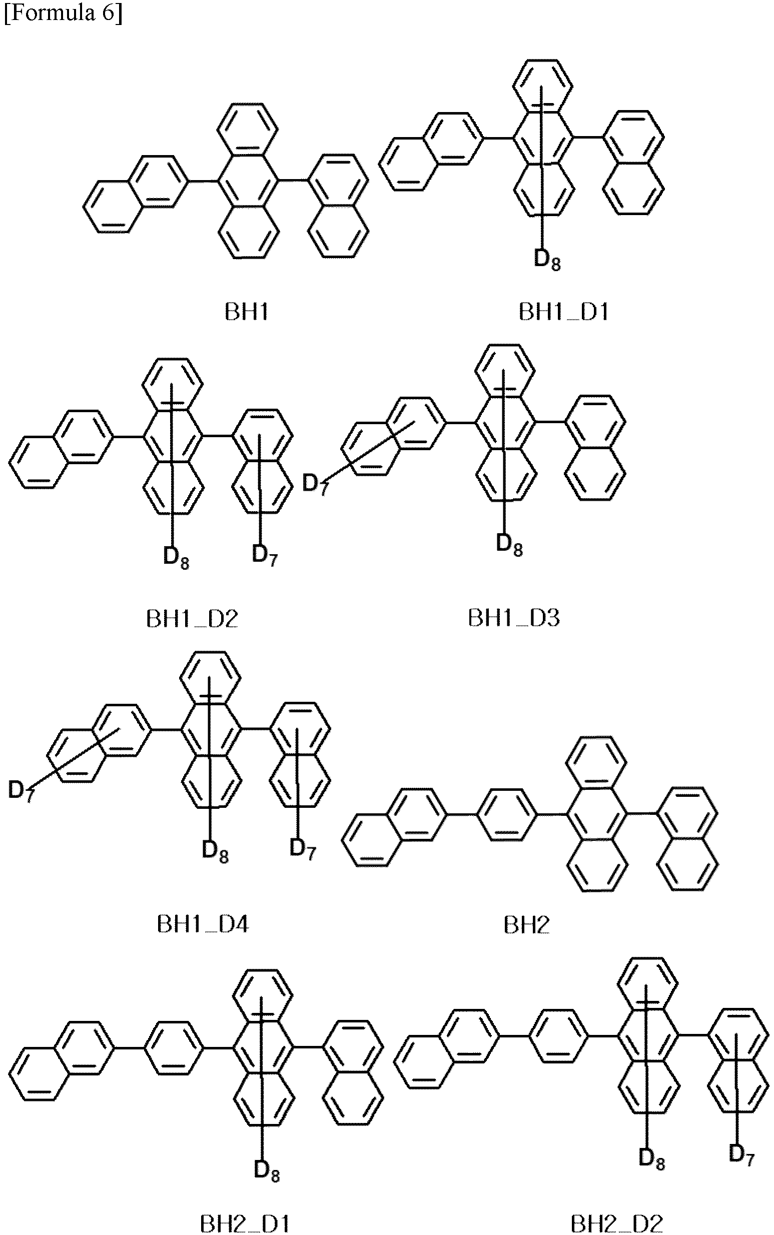

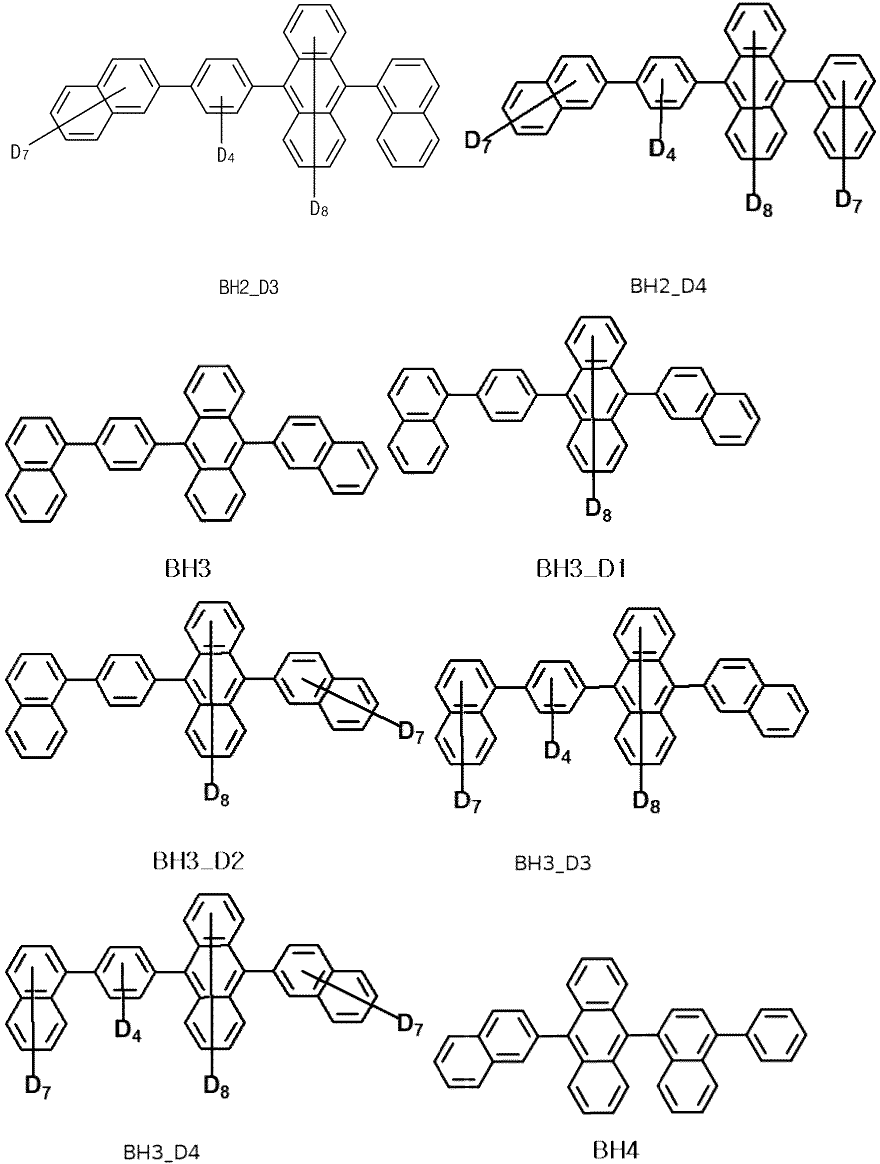

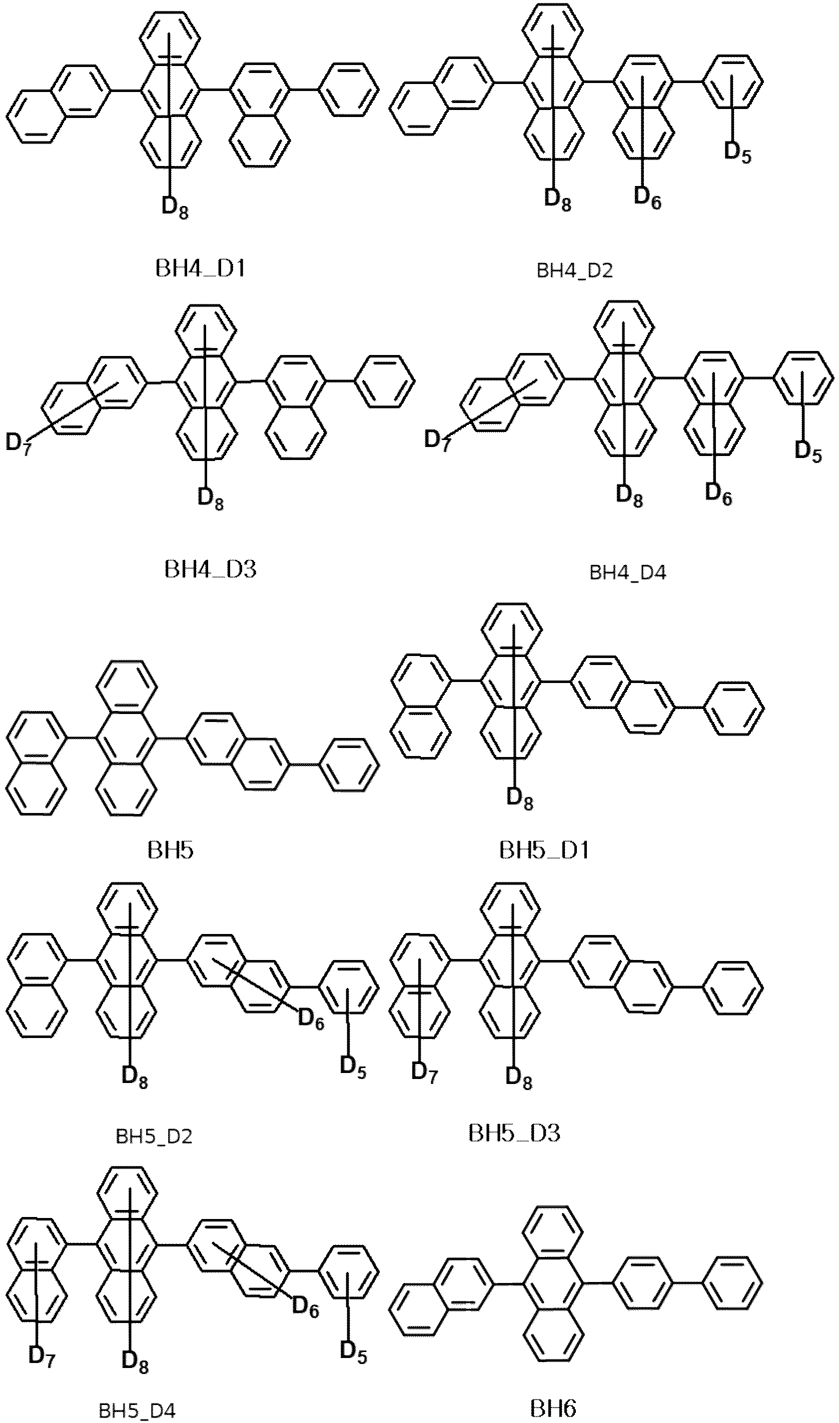

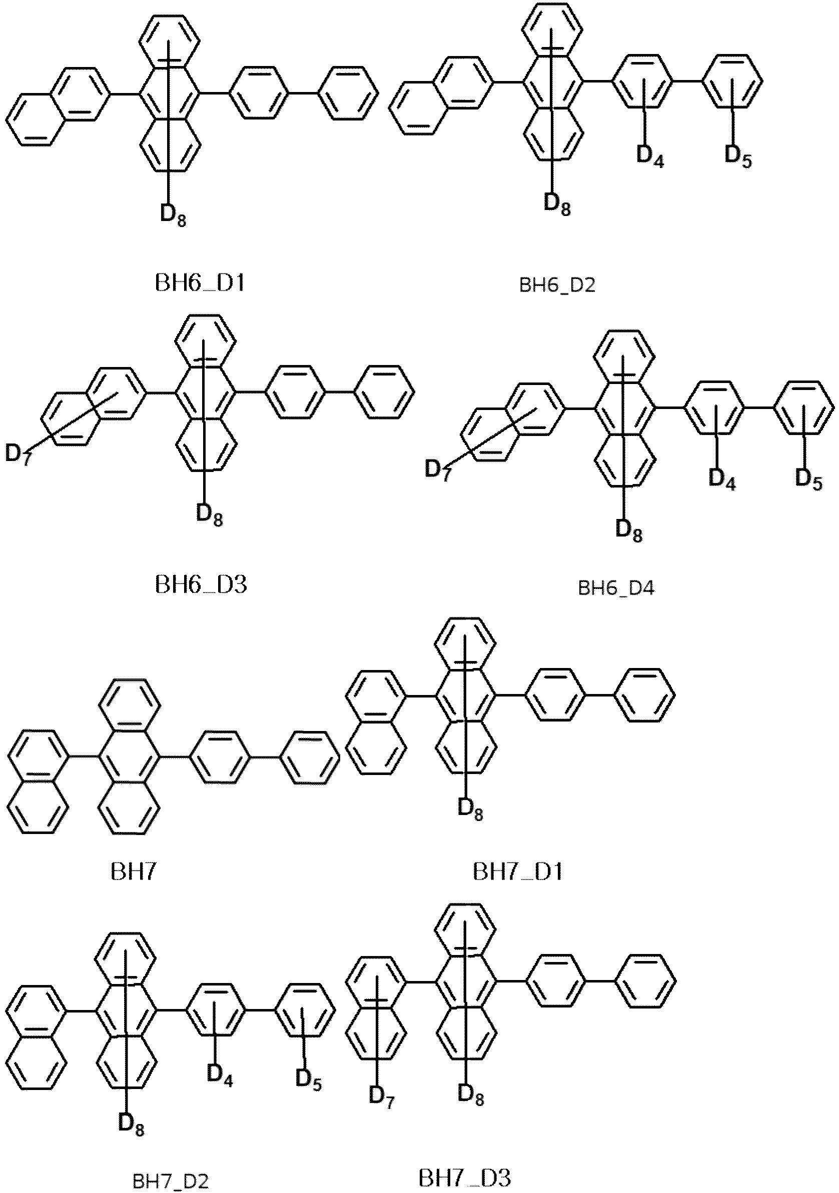

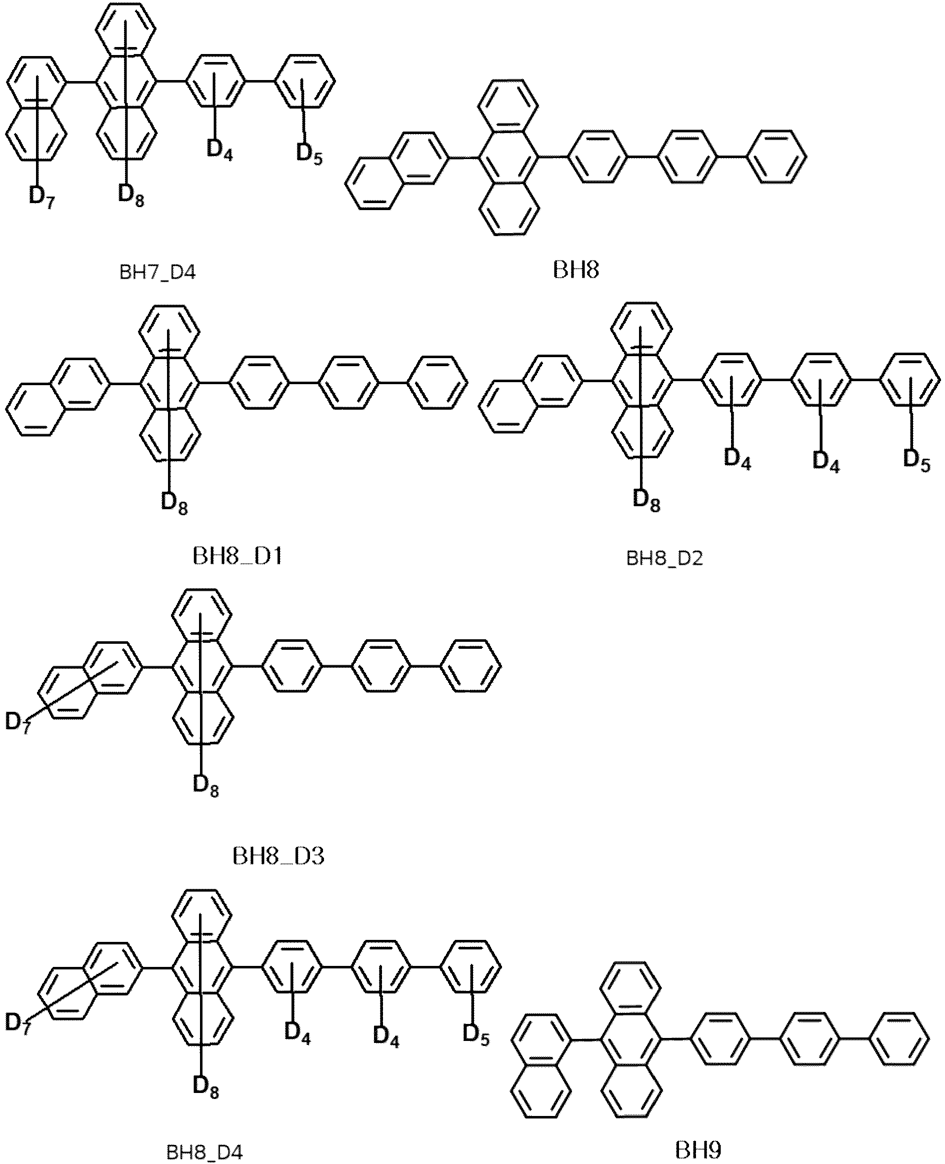

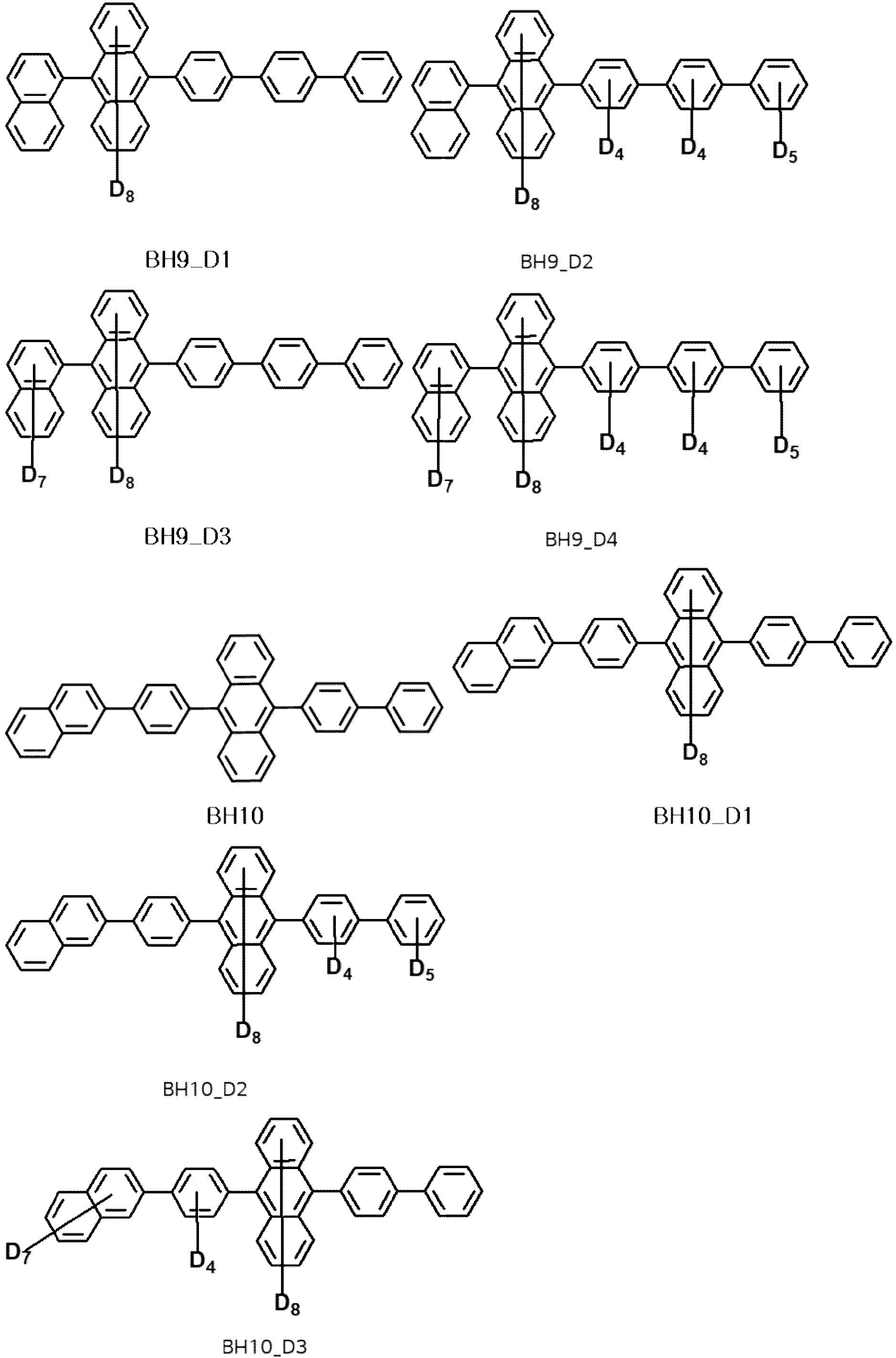

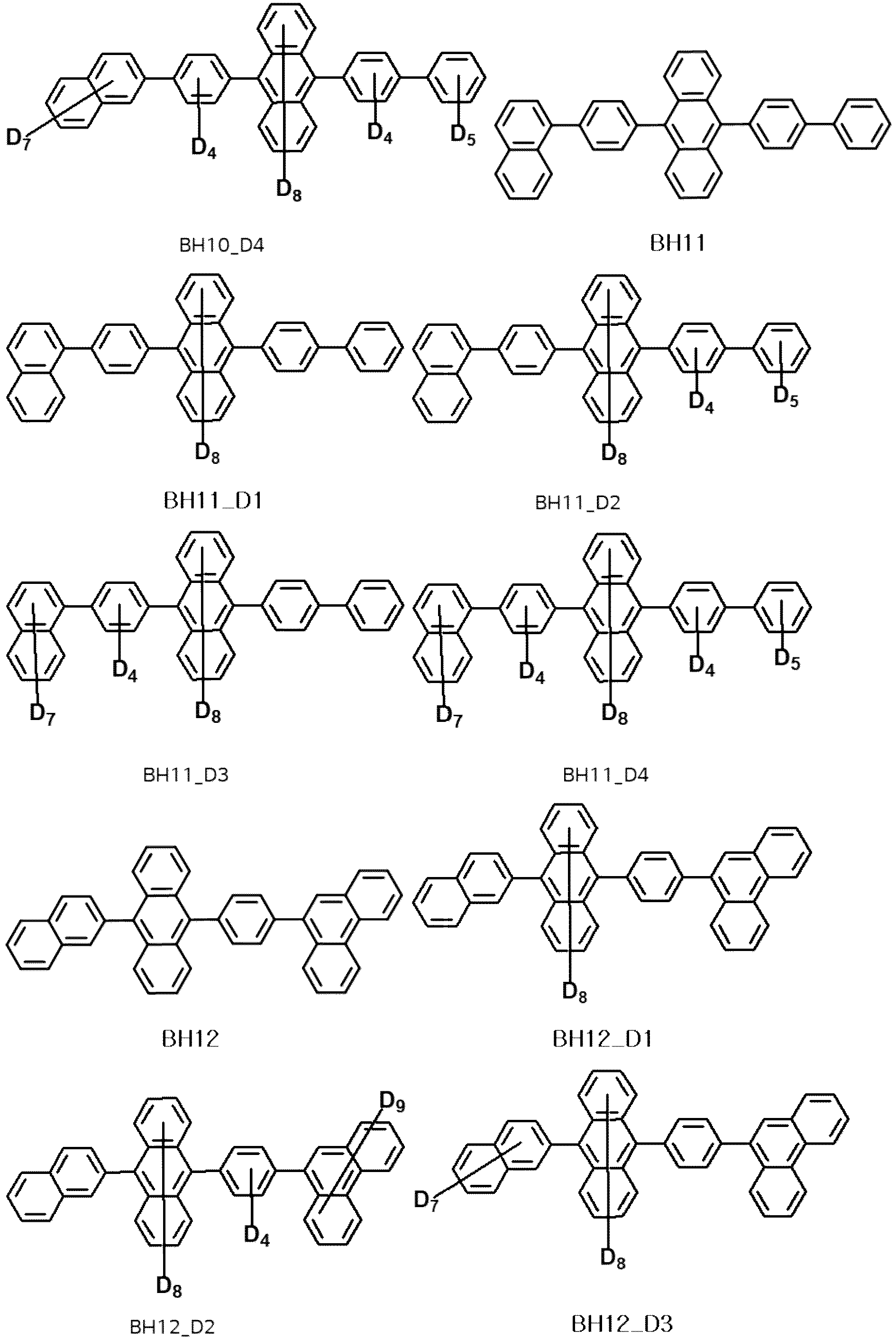

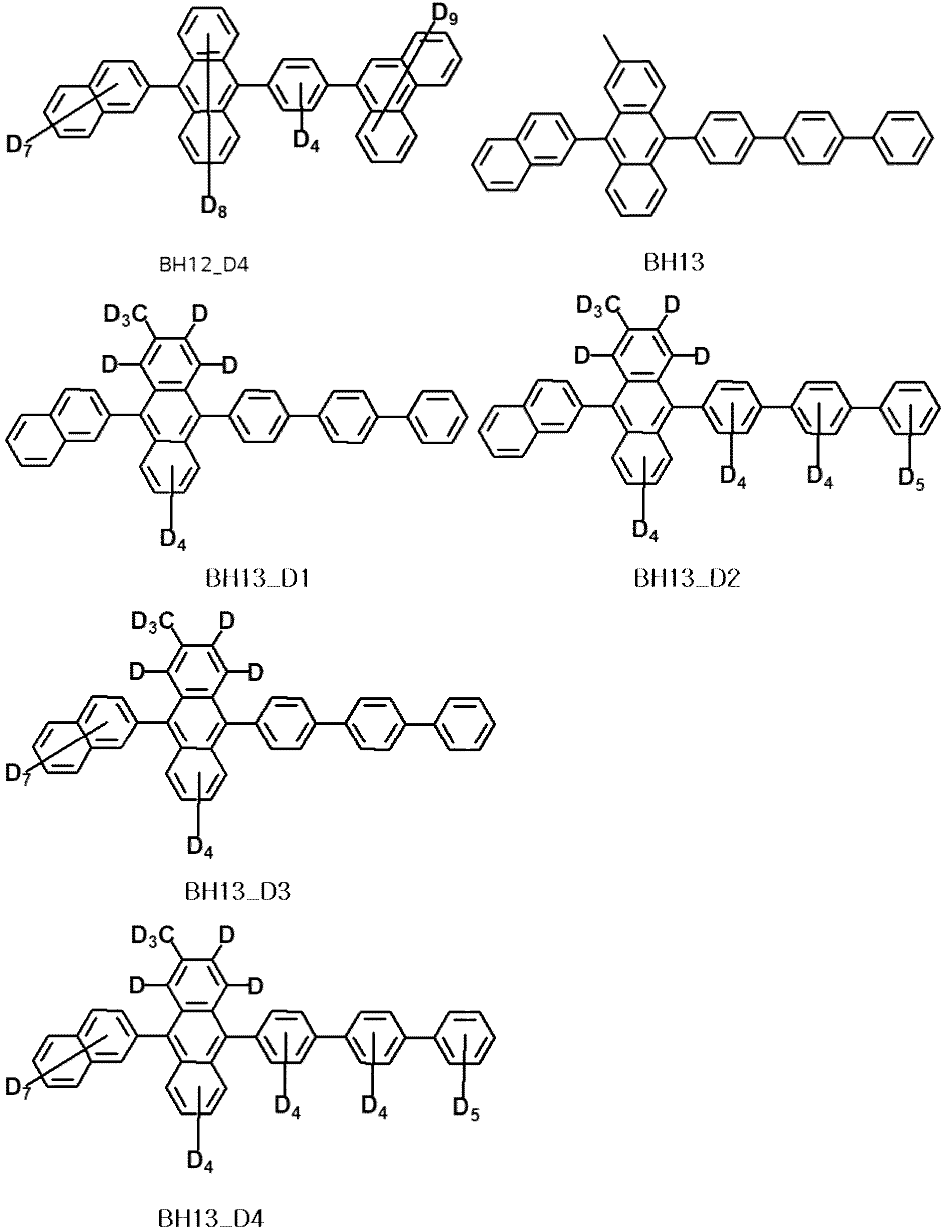

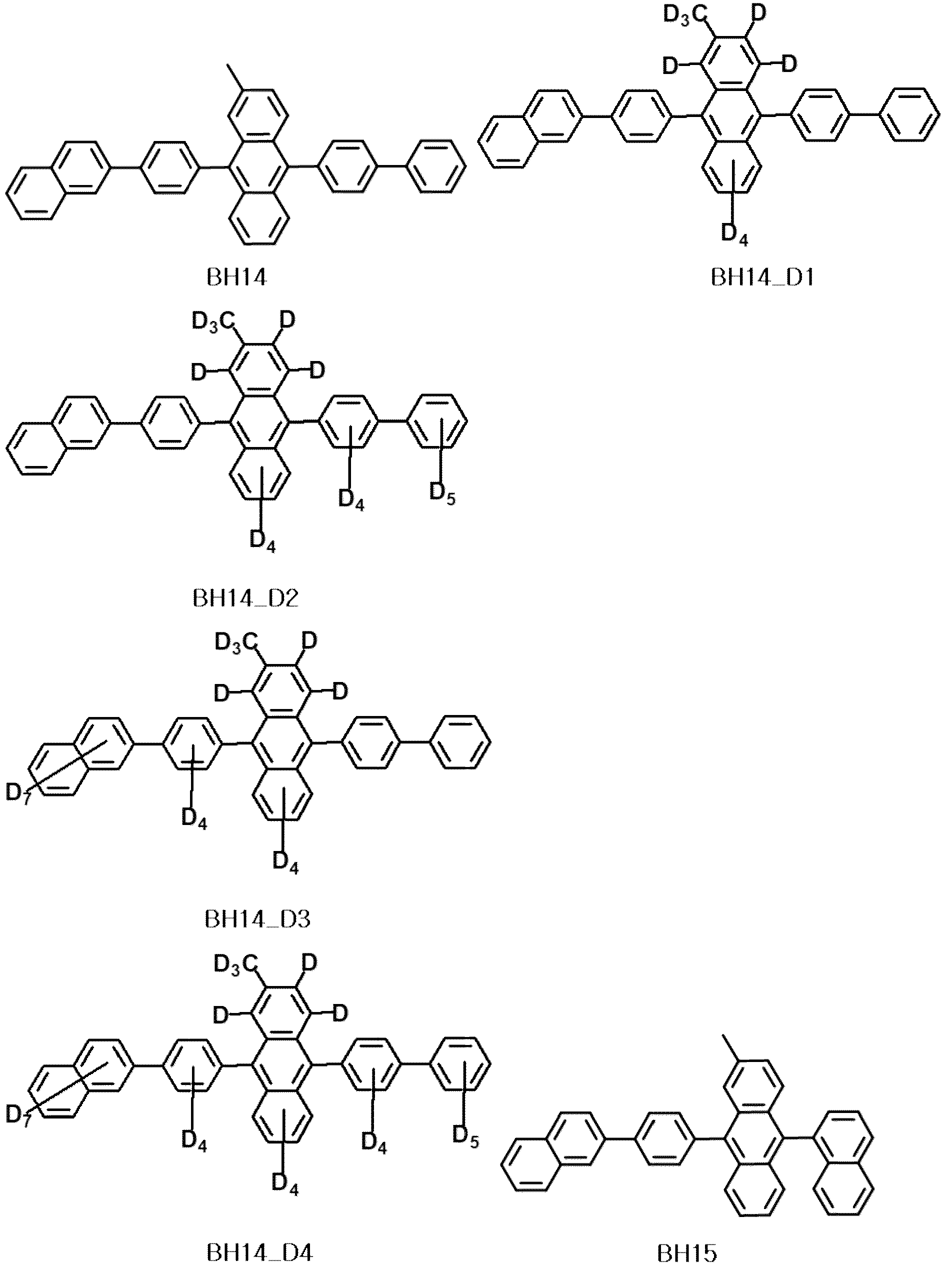

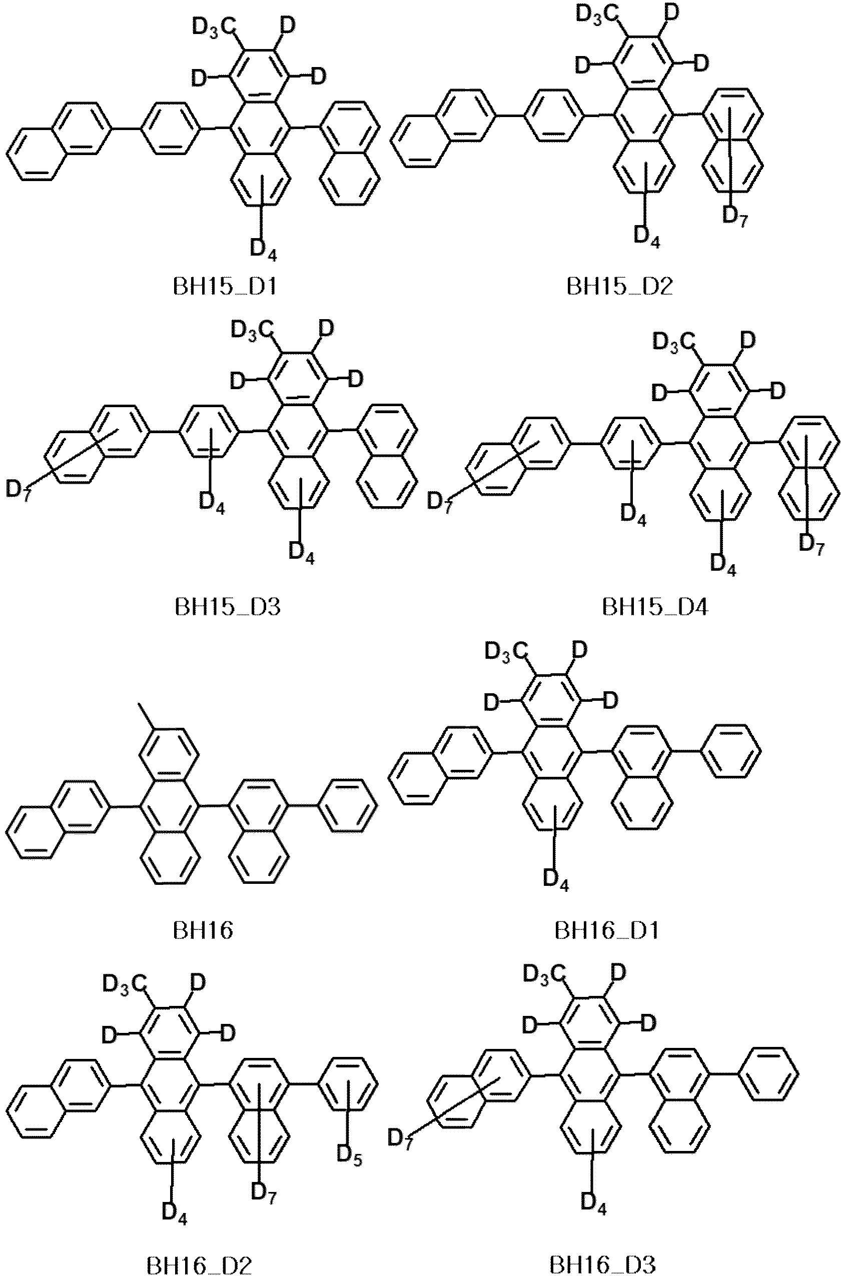

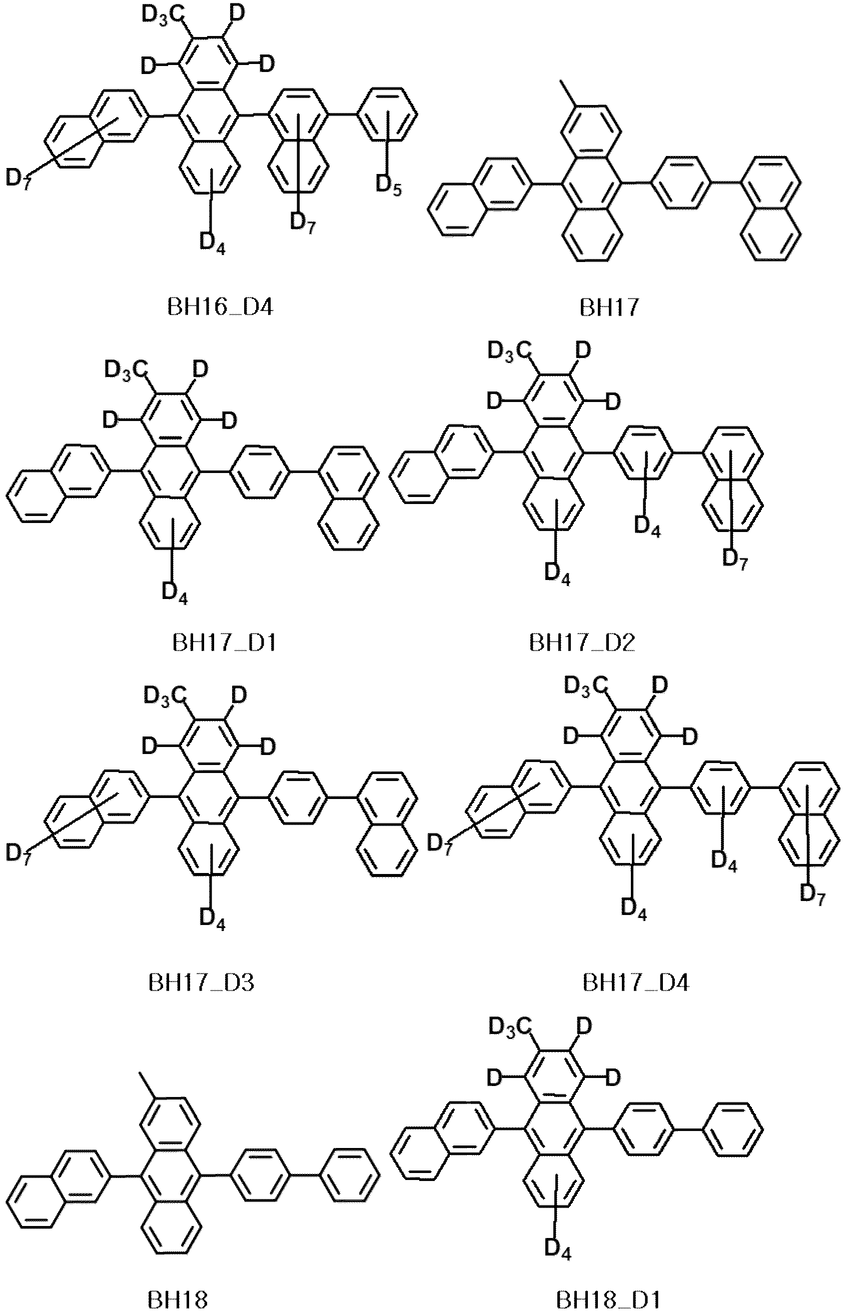

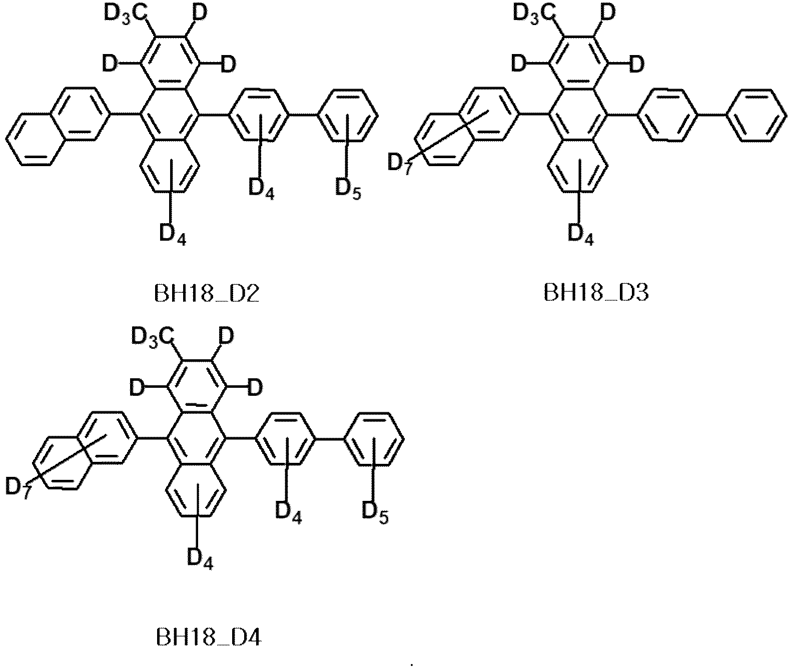

In an embodiment, the organic light emitting diode further comprises:
a second emitting part including a third blue emitting layer and a fourth blue emitting layer and positioned between the first emitting part and the second electrode, the fourth blue emitting layer positioned between the third blue emitting layer and the second electrode and contacting the third blue emitting layer,
   wherein the third blue emitting layer includes a third host and a third dopant, and the fourth blue emitting layer includes a fourth host and a fourth dopant,
   wherein the third host is an anthracene derivative having a third deuteration ratio, and the fourth host is an anthracene derivative having a fourth deuteration ratio smaller than the third deuteration ratio,
wherein the third dopant is a third compound represented by the Formula 3, and the fourth dopant is a fourth compound represented by the Formula 7, 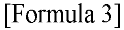 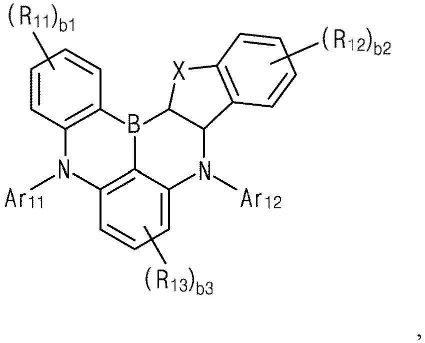
wherein in the Formula 3,
each of b1 and b2 is independently an integer of 0 to 4, and b3 is an integer of 0 to 3,
X is O or S,
each of Ar₁₁ and Ar₁₂ is independently selected from the group consisting of a substituted or unsubstituted C6 to C30 aryl group, a substituted or unsubstituted C3 to C30 heteroaryl group and a substituted or unsubstituted C6 to C30 alicyclic group, and
R₁₁, R₁₂ and R₁₃ is independently selected from the group consisting of a substituted or unsubstituted C1 to C30 alkyl group, a substituted or unsubstituted C3 to C30 cycloalkyl group, a substituted or unsubstituted C6 to C30 arylamino group, a substituted or unsubstituted C6 to C30 aryl group and a substituted or unsubstituted C3 to C30 heteroaryl group, or at least one pair of adjacent two or more R₁₁, adjacent two or more R₁₂ and adjacent two or more R₁₃ are connected to each other to form a substitute or unsubstituted ring,

In an embodiment, the third dopant is represented by Formula 3a: 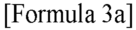 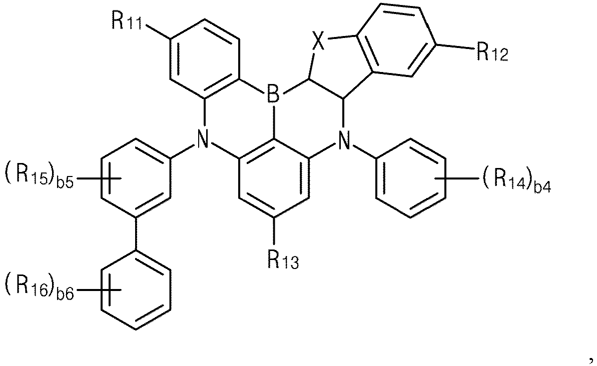
wherein in the Formula 3a, the definitions of X, R₁₁, R₁₂ and R₁₃ is same as those in Formula 3, each of b4 and b6 is independently an integer of 0 to 5, and b5 is an integer of 0 to 4,
each of R₁₄, R₁₅ and R₁₆ is selected from the group consisting of a substituted or unsubstituted C1 to C30 alkyl group and a substituted or unsubstituted C3 to C30 cycloalkyl group, or at least one pair of adjacent two R₁₄ and adjacent R₁₅ and R₁₆ are connected to each other to form a substituted or unsubstituted ring,
wherein the fourth dopant is represented by Formula 7a: 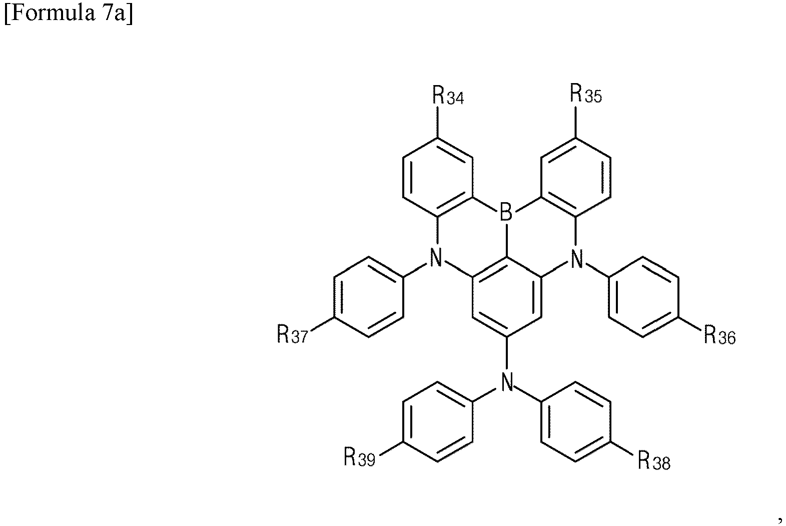
wherein in the Formula 7a, each of R₃₄ to R₃₉ is independently selected from the group consisting of hydrogen, a substituted or unsubstituted C1 to C30 alkyl group, a substituted or unsubstituted C3 to C30 cycloalkyl group, a substituted or unsubstituted C6 to C30 aryl group and a substituted or unsubstituted C3 to C30 heteroaryl group.

In an embodiment, the third host is represented by Formula 1: 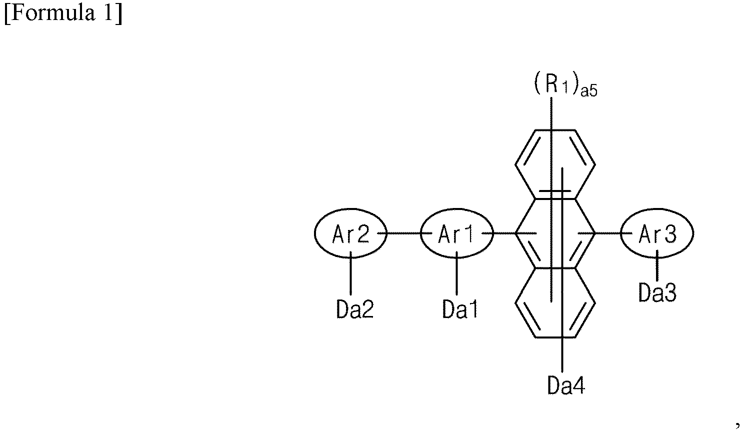
wherein in the Formula 1,
each of a1, a2 and a3 is independently an integer of 0 or 30, each of a4 and a5 is independently an integer of 0 to 8, and at least one of a1 to a4 is a positive integer,
Ar1 is selected from the group consisting of a single bond (a direct bond), a substituted or unsubstituted C6 to C30 arylene group and a substituted or unsubstituted C3 to C30 heteroarylene group,
each of Ar2 and Ar3 is selected from the group consisting of a substituted or unsubstituted C6 to C30 aryl group and a substituted or unsubstituted C3 to C30 heteroaryl group, and R₁ is selected from the group consisting of a C1 to C30 alkyl group unsubstituted or substituted with deuterium and a C3 to C30 cycloalkyl group unsubstituted or substituted with deuterium, wherein the fourth host is represented by Formula 5: 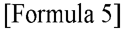 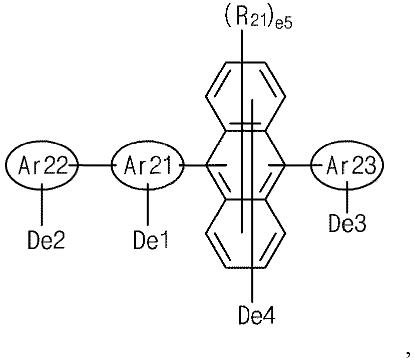
wherein in the Formula 5,
each of e1, e2 and e3 is independently an integer of 0 or 30, each of e4 and e5 is independently an integer of 0 to 8, and a summation of e1 to e4 is smaller than a summation of a1 to a4 in Formula 1,
Ar21 is selected from the group consisting of a single bond (a direct bond), a substituted or unsubstituted C6 to C30 arylene group and a substituted or unsubstituted C3 to C30 heteroarylene group,
each of Ar22 and Ar23 is selected from the group consisting of a substituted or unsubstituted C6 to C30 aryl group and a substituted or unsubstituted C3 to C30 heteroaryl group, and R₂₁ is selected from the group consisting of a C1 to C30 alkyl group unsubstituted or substituted with deuterium and a C3 to C30 cycloalkyl group unsubstituted or substituted with deuterium.

In an embodiment, the third host is represented by Formula 1a: 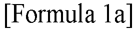 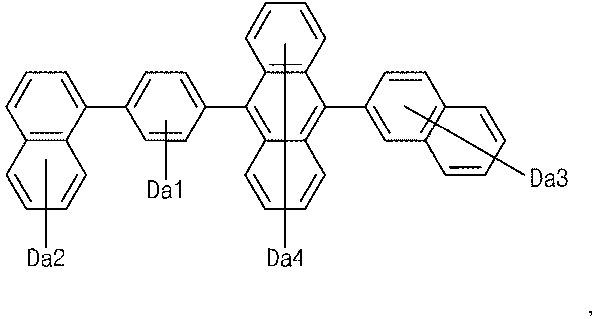
wherein in the Formula 1a, a1 is an integer of 0 to 4, each of a2 and a3 is independently an integer of 0 to 7, a4 is an integer of 0 to 8, and at least one of a1 to a4 is a positive integer, wherein the fourth host is represented by Formula 5a: 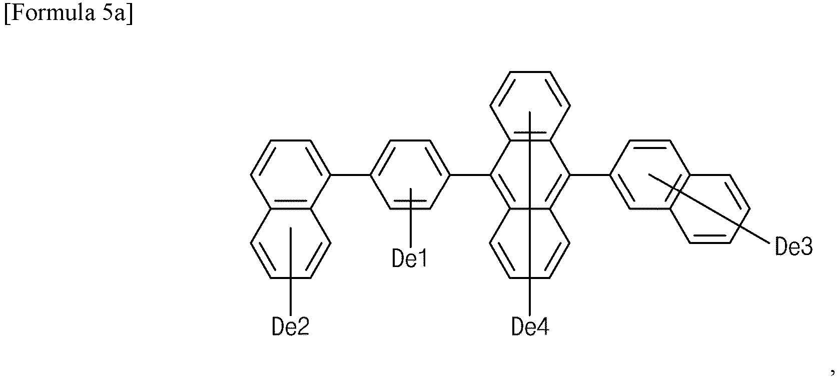
wherein in the Formula 5a,
e1 is an integer of 0 to 4, each of e2 and e3 is independently an integer of 0 to 7, e4 is an integer of 0 to 8, and a summation of e1 to e4 is smaller than a summation of a1 to a4 in Formula 1a.

In an embodiment, the organic light emitting diode further comprises:
a third emitting part including a red emitting layer and a green emitting layer and positioned between the first and second emitting parts.

In an embodiment, the organic light emitting diode further comprises:
a second emitting part including a yellow-green emitting layer and positioned between the first emitting part and the second electrode.

In an embodiment, the first dopant is a boron derivative having a first HOMO energy level, and the second dopant is a boron derivative having a second HOMO energy level lower than the first HOMO energy level.

In an embodiment, the first dopant has a first triplet energy, and the second dopant has a second triplet energy greater than the first triplet energy.

Another aspect of the present invention is an organic light emitting device comprising a substrate; the organic light emitting diode of the invention over the substrate; and an encapsulation layer covering the organic light emitting diode.
In an embodiment, the substrate includes a red pixel region, a green pixel region and a blue pixel region, and the organic light emitting diode corresponds to the red pixel region, the green pixel region and the blue pixel region,
wherein the organic light emitting device further comprises: a color filter layer corresponding to the red pixel region, the green pixel region and the blue pixel region and positioned between the substrate and the organic light emitting diode or over the organic light emitting diode.
In an embodiment, the substrate includes a red pixel region, a green pixel region and a blue pixel region, and the organic light emitting diode corresponds to the red pixel region, the green pixel region and the blue pixel region,
wherein the organic light emitting device further comprises: a color conversion layer corresponding to the red pixel region and the green pixel region and positioned between the substrate and the organic light emitting diode or over the organic light emitting diode.

It is to be understood that both the foregoing general description and the following detailed description are exemplary and explanatory and are intended to further explain the present invention as claimed.

### BRIEF DESCRIPTION OF THE DRAWINGS

The accompanying drawings, which are included to provide a further understanding of the present invention and are incorporated in and constitute a part of this specification, illustrate embodiments of the present invention and together with the description serve to explain the principles of the present invention.
FIG. 1 is a schematic circuit diagram illustrating an organic light emitting display device of the present invention.
FIG. 2 is a schematic cross-sectional view illustrating an organic light emitting display device according to a first embodiment of the present invention.
FIG. 3 is a schematic cross-sectional view illustrating an OLED according to a second embodiment of the present invention.
FIG. 4 is a schematic cross-sectional view illustrating an OLED according to a third embodiment of the present invention.
FIG. 5 is a schematic cross-sectional view illustrating an organic light emitting display device according to a fourth embodiment of the present invention.
FIG. 6 is a schematic cross-sectional view illustrating an organic light emitting display device according to a fifth embodiment of the present invention.
FIG. 7 is a schematic cross-sectional view illustrating an OLED according to a sixth embodiment of the present invention.
FIG. 8 is a schematic cross-sectional view illustrating an OLED according to a seventh embodiment of the present invention.

### DETAILED DESCRIPTION

Reference will now be made in detail to aspects of the present invention, examples of which may be illustrated in the accompanying drawings. In the following description, when a detailed description of well-known functions or configurations related to this document is determined to unnecessarily cloud a gist of the inventive concept, the detailed description thereof will be omitted. The progression of processing steps and/or operations described is an example; however, the sequence of steps and/or operations is not limited to that set forth herein and may be changed as is known in the art, with the exception of steps and/or operations necessarily occurring in a particular order. Like reference numerals designate like elements throughout. Names of the respective elements used in the following explanations are selected only for convenience of writing the specification and may be thus different from those used in actual products.

Advantages and features of the present invention and methods of achieving them will be apparent with reference to the aspects described below in detail with the accompanying drawings. However, the present invention is not limited to the aspects disclosed below, but can be realized in a variety of different forms, and only these aspects allow the disclosure of the present invention to be complete. The present disclosure is provided to fully inform the scope of the invention to the skilled in the art.

The shapes, sizes, proportions, angles, numbers, and the like disclosed in the drawings for explaining the aspects of the present invention are illustrative, and the present invention is not limited to the illustrated matters. The same reference numerals refer to the same elements throughout the specification. In addition, in describing the present invention, if it is determined that a detailed description of the related known technology unnecessarily obscure the subject matter of the present invention, the detailed description thereof can be omitted. When 'including', 'having', 'consisting', and the like are used in this specification, other parts may be added unless 'only' is used. When a component is expressed in the singular, cases including the plural are included unless specific statement is described.

In construing an element, the element is construed as including an error or tolerance range although there is no explicit description of such an error or tolerance range.

In describing a position relationship, for example, when a position relation between two parts is described as, for example, "on," "over," "under," and "next," one or more other parts may be disposed between the two parts unless a more limiting term, such as "just" or "direct(ly)" is used.

In describing a time relationship, for example, when the temporal order is described as, for example, "after," "subsequent," "next," and "before," a case that is not continuous may be included unless a more limiting term, such as "just," "immediate(ly)," or "direct(ly)" is used.

It will be understood that, although the terms "first," "second," etc. may be used herein to describe various elements, these elements should not be limited by these terms. These terms are only used to distinguish one element from another. For example, a first element could be termed a second element, and, similarly, a second element could be termed a first element, without departing from the scope of the present invention.

Features of various aspects of the present invention may be partially or overall coupled to or combined with each other, and may be variously inter-operated with each other and driven technically as those skilled in the art can sufficiently understand. The aspects of the present invention may be carried out independently from each other, or may be carried out together in co-dependent relationship.

Reference will now be made in detail to some of the examples and preferred embodiments, which are illustrated in the accompanying drawings.

In the present invention, an organic light emitting device including the OLED may be an organic light emitting display device or an organic lightening device. As an example, an organic light emitting display device, which is a display device including the OLED of the present invention, will be mainly described.

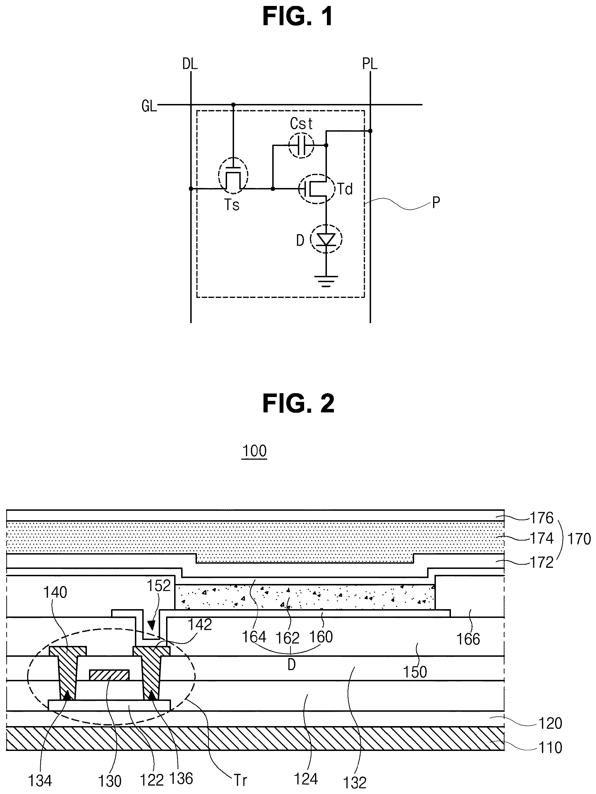

FIG. 1 is a schematic circuit diagram illustrating an organic light emitting display device of the present invention.

As illustrated in FIG. 1, a gate line GL and a data line DL, which cross each other to define a pixel region P, and a power line PL are formed in an organic light display device. A switching thin film transistor (TFT) Ts, a driving thin film transistor (TFT) Td, a storage capacitor Cst and an OLED D are formed in the pixel region P. The pixel region P may include a red pixel region, a green pixel region and a blue pixel region.

The switching thin film transistor Ts is connected to the gate line GL and the data line DL, and the driving thin film transistor Td and the storage capacitor Cst are connected between the switching thin film transistor Ts and the power line PL. The OLED D is connected to the driving thin film transistor Td.

When the switching thin film transistor Ts is turned on by the gate signal applied through the gate line GL, the data signal applied through the data line DL is applied to a gate electrode of the driving thin film transistor Td and one electrode of the storage capacitor Cst through the switching thin film transistor Ts.

The driving thin film transistor Td is turned on by the data signal applied into the gate electrode so that a current proportional to the data signal is supplied from the power line PL to the OLED D through the driving thin film transistor Td. The OLED D emits light having a luminance proportional to the current flowing through the driving thin film transistor Td.

In this case, the storage capacitor Cst is charged with a voltage proportional to the data signal so that the voltage of the gate electrode in the driving thin film transistor Td is kept constant during one frame.

Therefore, the organic light emitting display device can display a desired image.

FIG. 2 is a schematic cross-sectional view illustrating an organic light emitting display device according to a first embodiment of the present invention.

As illustrated in FIG. 2, the organic light emitting display device 100 includes a substrate 110, a TFT Tr and an OLED D disposed on a planarization layer and connected to the TFT Tr.

The substrate 110 may be a glass substrate or a flexible substrate. For example, the flexible substrate may be a polyimide (PI) substrate, a polyethersulfone (PES) substrate, a polyethylenenaphthalate (PEN) substrate, a polyethylene terephthalate (PET) substrate or a polycarbonate (PC) substrate.

A buffer layer 120 is formed on the substrate, and the TFT Tr is formed on the buffer layer 120. The buffer layer 120 may be omitted.

A semiconductor layer 122 is formed on the buffer layer 120. The semiconductor layer 122 may include an oxide semiconductor material or polycrystalline silicon. When the semiconductor layer 122 includes the oxide semiconductor material, a light-shielding pattern (not shown) may be formed under the semiconductor layer 122. The light to the semiconductor layer 122 is shielded or blocked by the light-shielding pattern such that thermal degradation of the semiconductor layer 122 can be prevented. On the other hand, when the semiconductor layer 122 includes polycrystalline silicon, impurities may be doped into both sides of the semiconductor layer 122.

A gate insulating layer 124 is formed on the semiconductor layer 122. The gate insulating layer 124 may be formed of an inorganic insulating material such as silicon oxide (SiOx) or silicon nitride (SiNx).

A gate electrode 130, which is formed of a conductive material, e.g., metal, is formed on the gate insulating layer 124 to correspond to a center of the semiconductor layer 122. In FIG. 2, the gate insulating layer 124 is formed on an entire surface of the substrate 110. Alternatively, the gate insulating layer 124 may be patterned to have the same shape as the gate electrode 130.

An interlayer insulating layer 132, which is formed of an insulating material, is formed on the gate electrode 130. The interlayer insulating layer 132 may be formed of an inorganic insulating material, e.g., silicon oxide or silicon nitride, or an organic insulating material, e.g., benzocyclobutene or photo-acryl.

The interlayer insulating layer 132 includes first and second contact holes 134 and 136 exposing both sides of the semiconductor layer 122. The first and second contact holes 134 and 136 are positioned at both sides of the gate electrode 130 to be spaced apart from the gate electrode 130. The first and second contact holes 134 and 136 are formed through the gate insulating layer 124. Alternatively, when the gate insulating layer 124 is patterned to have the same shape as the gate electrode 130, the first and second contact holes 134 and 136 is formed only through the interlayer insulating layer 132.

A source electrode 140 and a drain electrode 142, which are formed of a conductive material, e.g., metal, are formed on the interlayer insulating layer 132. The source electrode 140 and the drain electrode 142 are spaced apart from each other with respect to the gate electrode 130 and respectively contact both sides of the semiconductor layer 122 through the first and second contact holes 134 and 136.

The semiconductor layer 122, the gate electrode 130, the source electrode 140 and the drain electrode 142 constitute the TFT Tr. The TFT Tr serves as a driving element. Namely, the TFT Tr may correspond to the driving TFT Td (of FIG. 1).

In the TFT Tr, the gate electrode 130, the source electrode 140, and the drain electrode 142 are positioned over the semiconductor layer 122. Namely, the TFT Tr has a coplanar structure. Alternatively, in the TFT Tr, the gate electrode may be positioned under the semiconductor layer, and the source and drain electrodes may be positioned over the semiconductor layer such that the TFT Tr may have an inverted staggered structure. In this instance, the semiconductor layer may include amorphous silicon.

Although not shown, the gate line and the data line cross each other to define the pixel region, and the switching TFT is formed to be connected to the gate and data lines. The switching TFT is connected to the TFT Tr as the driving element. In addition, the power line, which may be formed to be parallel to and spaced apart from one of the gate and data lines, and the storage capacitor for maintaining the voltage of the gate electrode of the TFT Tr in one frame may be further formed.

A planarization layer 150 is formed on the source and drain electrodes 140 and 142 and over an entire surface of the substrate 110. The planarization layer 150 has a flat top surface and includes a drain contact hole 152 exposing the drain electrode 142 of the TFT Tr.

The OLED D is disposed on the planarization layer 150 and includes a first electrode 160, which is connected to the drain electrode 142 of the TFT Tr, an organic emitting layer 162 on the first electrode 160 and a second electrode 164 on the organic emitting layer 162. The OLED D is disposed at each of the red, green and blue pixel regions and emits red light, green light and blue light in the red, green and blue pixel regions, respectively.

The first electrode 160 is separately formed in each pixel region. The first electrode 160 may be an anode and may be formed of a conductive material having a relatively high work function. For example, the first electrode 160 may be formed of a conductive material having a relatively high work function, e.g., a transparent conductive oxide (TCO). for example, the first electrode 160 may include at least one of indium-tin-oxide (ITO), indium-zinc-oxide (IZO), indium-tin-zinc oxide (ITZO), tin oxide (SnO), zinc oxide (ZnO), indium-copper-oxide (ICO) and aluminum-zinc-oxide (Al:ZnO, AZO).

When the organic light emitting display device 100 is operated in a bottom-emission type, the first electrode 160 may have a single-layered structure formed of the transparent conductive oxide. Alternatively, when the organic light emitting display device 100 is operated in a top-emission type, the first electrode 160 may further include a reflective layer to have a double-layered structure or a triple-layered structure. For example, the reflective layer may include silver (Ag) or aluminum-palladium-copper alloy (APC). In the top-emission type OLED D, the first electrode 160 may have a double-layered structure of Ag/ITO or APC/ITO or a triple-layered structure of ITO/Ag/ITO or ITO/APC/ITO.

A bank layer 166 is formed on the planarization layer 150 to cover an edge of the first electrode 160. Namely, the bank layer 166 is positioned at a boundary of the pixel region and exposes a center of the first electrode 160 in the pixel region.

An organic emitting layer 162 is formed on the first electrode 160. The organic emitting layer 162 may have a single-layered structure of an emitting material layer (EML). Alternatively, the organic emitting layer 162 may further include at least one of a hole injection layer (HIL), a hole transport layer (HTL), an electron blocking layer (EBL), a hole blocking layer (HBL), an electron transport layer (ETL) and an electron injection layer (EIL) to have a multi-layered structure.

In the blue pixel region, the organic emitting layer 162 of the OLED D includes a blue EML, and the blue EML includes a first blue emitting layer and a second blue emitting layer.

The first blue emitting layer includes a first host having a first deuteration ratio and a first dopant represented by Formula 3a, and the second blue emitting layer includes a second host having a second deuteration ratio, which is smaller than the first deuteration ratio, and a second dopant represented by Formula 7. As a result, each of the OLED D and the organic light emitting display device 100 has high emitting efficiency and color purity and improved lifespan.

The organic emitting layer 162 may include two or more blue EMLs, which are disposed to be spaced apart from each other, so that the OLED D may have a tandem structure.

The second electrode 164 is formed over the substrate 110 where the organic emitting layer 162 is formed. The second electrode 164 covers an entire surface of the display area and may be formed of a conductive material having a relatively low work function to serve as a cathode. For example, the second electrode 164 may be formed of a material having high reflectance, such as aluminum (Al), magnesium (Mg), calcium (Ca), silver (Ag), their alloys or their combinations. In the top-emission type organic light emitting display device 100, the second electrode 164 may have a thin profile (small thickness) to provide a light transmittance property (or a semi-transmittance property).

An encapsulation layer (or encapsulation film) 170 is formed on the second electrode 164 to prevent penetration of moisture into the OLED D. The encapsulation film 170 includes a first inorganic insulating layer 172, an organic insulating layer 174 and a second inorganic insulating layer 176 sequentially stacked, but it is not limited thereto. The encapsulation film 170 may be omitted.

In the bottom-emission type organic light emitting display device 100, a metal plate may be disposed on the encapsulation layer 170.

The organic light emitting display device 100 may include a color filter layer corresponding to the red, green and blue pixel regions. The color filter layer may include red, green and blue color filters respectively corresponding to the red, green and blue pixel regions. The organic light emitting display device 100 with the color filter layer may have improved color purity.

In the bottom-emission type organic light emitting display device 100, the color filter layer may be disposed between the OLED D and the substrate 110, e.g., between the interlayer insulating layer 132 and the planarization layer 150. In the top-emission type organic light emitting display device 100, the color filter layer may be disposed over the OLED D, e.g., on or over the second electrode 164 or the encapsulation layer 170.

The organic light emitting display device 100 may further include a polarization plate for reducing an ambient light reflection. For example, the polarization plate may be a circular polarization plate. In the bottom-emission type organic light emitting display device 100, the polarization plate may be disposed under the substrate 110. In the top-emission type organic light emitting display device 100, the polarization plate may be disposed on or over the encapsulation film 170.

In addition, in the top-emission type organic light emitting display device 100, a cover window may be attached to the encapsulation film 170 or the polarization plate. In this instance, the substrate 110 and the cover window have a flexible property such that a flexible organic light emitting display device may be provided.

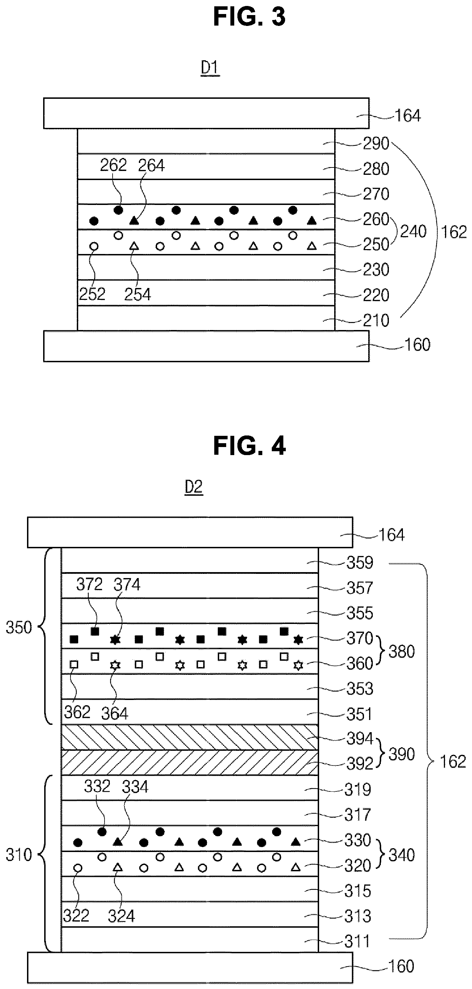

FIG. 3 is a schematic cross-sectional view illustrating an OLED according to a second embodiment of the present invention.

As illustrated in FIG. 3, the OLED D1 includes the first and second electrodes 160 and 164, which face each other, and the organic emitting layer 162 therebetween, and the organic emitting layer 162 includes a blue EML 240.

The organic light emitting display device 100 (of FIG. 2) includes red, green and blue pixels. In addition, the organic light emitting display device 100 may further include a white pixel region. The OLED D1 may be positioned in the blue pixel.

The organic emitting layer 162 in the red pixel region includes a red EML, and the organic emitting layer 162 in the green pixel region includes a green EML.

One of the first and second electrodes 160 and 164 is an anode, and the other one of the first and second electrodes 160 and 164 is a cathode. One of the first and second electrodes 160 and 164 is a reflection electrode, and the other one of the first and second electrodes 160 and 164 is a transparent electrode (or a semi-transparent electrode).

For example, the first electrode 160 may include a transparent conductive material layer of ITO or IZO, and the second electrode 164 may be formed of one of Al, Mg, Ag, AlMg and MgAg.

The blue EML 240 includes a first blue emitting layer 250 being closer to the first electrode 160 and a second blue emitting layer 260 being closer to the second electrode 164 and adjacent to the first blue emitting layer 250. Namely, the second blue emitting layer 260 is disposed between the first blue emitting layer 250 and the second electrode 164 and contacts the first blue emitting layer 250.

The blue EML 240 may have a thickness of 100 to 500Å. A summation of a thickness of the first blue emitting layer 250 and a thickness of the second blue emitting layer 260 is equal to a thickness of the blue EML 240, and the thickness of the first blue emitting layer 250 and the thickness of the second blue emitting layer 260 may be same or different. Each of the thickness of the first blue emitting layer 250 and the thickness of the second blue emitting layer 260 may be 50 to 250 Å, e.g., 70 to 150 Å.

The first blue emitting layer 250 includes a first host 252 and a first dopant (e.g., a first emitter) 254. In the first blue emitting layer 250, the first host 252 may have a weight % (wt%) of 80 to 99, preferably 95 to 99, and the first dopant 254 may have a wt% of 1 to 20, preferably 1 to 5.

The first host 252 may include at least one of a first host compound represented by Formula 1.

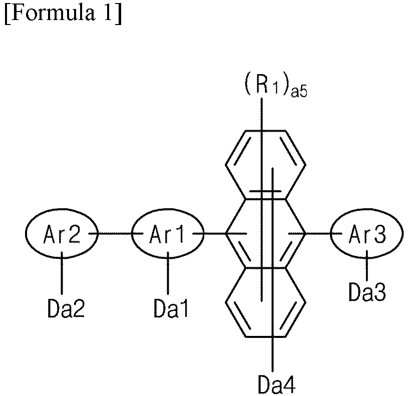

In Formula 1, each of a1, a2 and a3 is independently an integer of 0 or 30, each of a4 and a5 is independently an integer of 0 to 8, and at least one of a1 to a4 is a positive integer,
Ar1 is selected from the group consisting of a single bond (a direct bond), a substituted or unsubstituted C6 to C30 arylene group and a substituted or unsubstituted C3 to C30 heteroarylene group,
each of Ar2 and Ar3 is selected from the group consisting of a substituted or unsubstituted C6 to C30 aryl group and a substituted or unsubstituted C3 to C30 heteroaryl group, and
R₁ is selected from the group consisting of a C1 to C30 alkyl group unsubstituted or substituted with deuterium and a C3 to C30 cycloalkyl group unsubstituted or substituted with deuterium.

In Formula 1, D denotes a deuterium atom, each of a1, a2, a3 and a4 is a number of deuterium atoms, and a5 is a number of R₁ as a substituent.

In the present invention, without specific definition, a substituent of an alkyl group, a cycloalkyl group, an alicylic group, an aryl group, a heteroaryl group and an arylamino group may be at least one of a substituted or unsubstituted C1 to C10 alkyl group, a substituted or unsubstituted C3 to C30 cycloalkyl group, a substituted or unsubstituted C6 to C30 aryl group and a substituted or unsubstituted C3 to C30 heteroaryl group.

In the present invention, without specific definition, a C1 to C30 alkyl group may be selected from the group consisting of methyl, ethyl, propyl and butyl, e.g., tert-buty or isobutyl).

In the present invention, without specific definition, a C3 to C30 cycloalkyl group may be selected from the group consisting of cyclopropyl, cyclobutyl, cyclopentyl, cyclohexyl, and adamantanyl.

In the present invention, without specific definition, a C6 to C30 alicyclic group may be selected from the group consisting of tetralinyl, methyltetralinyl, ethyltetralinyl, tetramethyltetralinyl and pentamethylindanyl.

In the present invention, without specific definition, a C6 to C30 aryl group may be selected from the group consisting of phenyl, biphenyl, terphenyl, naphthyl, anthracenyl, pentanenyl, indenyl, indenoindenyl, heptalenyl, biphenylenyl, indacenyl, phenanthrenyl, benzophenanthrenyl, dibenzophenanthrenyl, azulenyl, pyrenyl, fluoranthenyl, triphenylenyl, chrysenyl, tetraphenyl, tetrasenyl, picenyl, pentaphenyl, pentacenyl, fluorenyl, indenofluorenyl and spiro-fluorenyl.

In the present invention, without specific definition, a C6 to C30 arylene group may be selected from the group consisting of phenylene, biphenylene, terphenylene, naphthylene, anthracenylene, pentanenylene, indenylene, indenoindenylene, heptalenylene, biphenylenylene, indacenylene, phenanthrenylene, benzophenanthrenylene, dibenzophenanthrenylene, azulenylene, pyrenylene, fluoranthenylene, triphenylenylene, chrysenylene, tetraphenylene, tetrasenylene, picenylene, pentaphenylene, pentacenylene, fluorenylene, indenofluorenylene and spiro-fluorenylene.

In the present invention, without specific definition, a C3 to C30 heteroaryl group may be selected from the group consisting of pyrrolyl, pyridinyl, pyrimidinyl, pyrazinyl, pyridazinyl, triazinyl, tetrazinyl, imidazolyl, pyrazolyl, indolyl, isoindolyl, indazolyl, indolizinyl, pyrrolizinyl, carbazolyl, benzocarbazolyl, dibenzocarbazolyl, indolocarbazolyl, indenocarbazolyl, benzofurocarbazolyl, benzothienocarbazolyl, quinolinyl, isoquinolinyl, phthalazinyl, quinoxalinyl, cinnolinyl, quinazolinyl, quinozolinyl, quinolinyl, purinyl, phthalazinyl, quinoxalinyl, benzoquinolinyl, benzoisoquinolinyl, benzoquinazolinyl, benzoquinoxalinyl, acridinyl, phenanthrolinyl, perimidinyl, phenanthridinyl, pteridinyl, cinnolinyl, naphtharidinyl, furanyl, oxazinyl, oxazolyl, oxadiazolyl, triazolyl, dioxynyl, benzofuranyl, dibenzofuranyl, thiopyranyl, xanthenyl, chromanyl, isochromanyl, thioazinyl, thiophenyl, benzothiophenyl, dibenzothiophenyl, difuropyrazinyl, benzofurodibenzofuranyl, benzothienobenzothiophenyl, benzothienodibenzothiophenyl, benzothienobenzofuranyl, and benzothienodibenzofuranyl.

In the present invention, without specific definition, a C3 to C30 heteroarylene group may be selected from the group consisting of pyrrolylene, pyridinylv, pyrimidinylene, pyrazinylene, pyridazinylene, triazinylene, tetrazinylene, imidazolylene, pyrazolylene, indolylene, isoindolylene, indazolylene, indolizinylene, pyrrolizinylene, carbazolylene, benzocarbazolylene, dibenzocarbazolylene, indolocarbazolylene, indenocarbazolylene, benzofurocarbazolylene, benzothienocarbazolylene, quinolinylene, isoquinolinylene, phthalazinylene, quinoxalinylene, cinnolinylene, quinazolinylene, quinozolinylene, quinolinylene, purinylene, phthalazinylene, quinoxalinylene, benzoquinolinylene, benzoisoquinolinylene, benzoquinazolinylene, benzoquinoxalinylene, acridinylene, phenanthrolinylene, perimidinylene, phenanthridinylene, pteridinylene, cinnolinylene, naphtharidinylene, furanylene, oxazinylene, oxazolylene, oxadiazolylene, triazolylene, dioxynylene, benzofuranyenel, dibenzofuranylene, thiopyranylene, xanthenylene, chromanylene, isochromanylene, thioazinylene, thiophenylene, benzothiophenylene, dibenzothiophenylene, difuropyrazinylene, benzofurodibenzofuranylene, benzothienobenzothiophenylene, benzothienodibenzothiophenylene, benzothienobenzofuranylene, and benzothienodibenzofuranylene.

In Formula 1, Ar1 may be a single bond or a substituted or unsubstituted C6 to C30 arylene group. In an aspect of the present invention, Ar1 may be selected from the group consisting of a single bond, phenylene and naphthylene, e.g., a-naphthylene or 2-naphthylene.

Each of Ar2 and Ar3 may be a substituted or unsubstituted C6 to C30 aryl group. In an aspect of the present invention, each of Ar2 and Ar3 may be selected from the group consisting of phenyl, naphthyl, e.g., a-naphthyl or 2-naphthyl, and phenanthrenyl.

R₁ may be a C1 to C30 alkyl group substituted deuterium, e.g., CD₃.

As described above, at least one of a1 to a4 in Formula 1 is a positive integer. Namely, the first host 252 is a partially or wholly deuterated anthracene derivative (compound). For example, the first host 252 may have a first deuteration ratio of about 1 to 100%, e.g., about 30 to 100%.

For example, when the first host 252 is formed by co-depositing a first compound having a deuteration ratio x and a second compound having a deuteration ratio y in a ratio of a:b, the deuteration ratio of the first host 252 is (ax+ by)/(a+b).

In an aspect of the present invention, the first host 252 may be represented by Formula 1a.

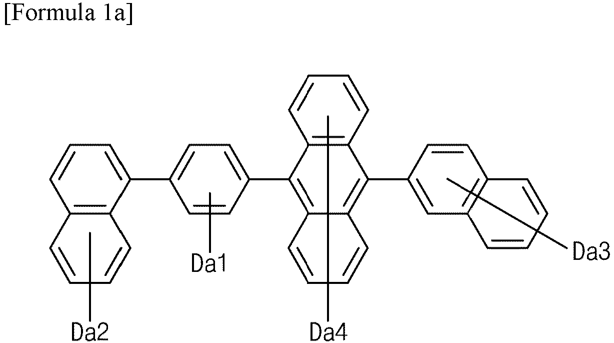

In Formula 1a, a1 is an integer of 0 to 4, each of a2 and a3 is independently an integer of 0 to 7, a4 is an integer of 0 to 8, and at least one of a1 to a4 is a positive integer.

For example, the first host 252 included in the first blue emitting layer 250 may include at least one of compounds in Formula 2 as referred to herein above.

The first dopant 254 is represented by Formula 3a.

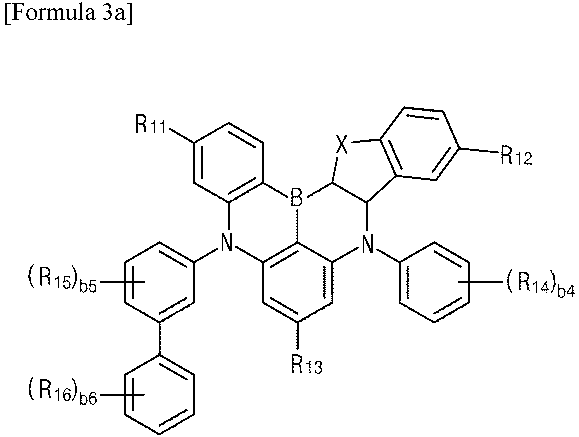

In Formula 3a, each of b4 and b6 is independently an integer of 0 to 5, and b5 is an integer of 0 to 4,
X is O or S,
R₁₁, R₁₂ and R₁₃ is independently selected from the group consisting of a substituted or unsubstituted C1 to C30 alkyl group, a substituted or unsubstituted C3 to C30 cycloalkyl group, a substituted or unsubstituted C6 to C30 arylamino group, a substituted or unsubstituted C6 to C30 aryl group and a substituted or unsubstituted C3 to C30 heteroaryl group, or at least one pair of adjacent two or more R₁₁, adjacent two or more R₁₂ and adjacent two or more R₁₃ are connected to each other to form a substitute or unsubstituted ring, and
each of R₁₄, R₁₅ and R₁₆ is selected from the group consisting of a substituted or unsubstituted C1 to C30 alkyl group and a substituted or unsubstituted C3 to C30 cycloalkyl group, or at least one pair of adjacent two R₁₄ and adjacent R₁₃ and R₁₆ are connected to each other to form a substituted or unsubstituted ring.

In an aspect of the present invention, each of R₁₁, R₁₂ and R₁₃ may be independently selected from the group consisting of a substituted or unsubstituted C1 to C30 alkyl group, e.g., methyl or tert-butyl, a C6 to C30 arylamino group, e.g., diphenyl group, unsubstituted or substituted with at least one of a C1 to C30 alkyl group and a C6 to C30 aryl group and a substituted or unsubstituted C3 to C30 cycloalkyl, e.g., adamantanyl. In an aspect of the present invention, adjacent two R1 may be connected to each other to form a C6 to C30 alicyclic group, e.g., tetramethyltetralin, which is unsubstituted or substituted with a C1 to C30 alkyl group, e.g., methyl, with a benzene ring in Formula 3a.

In an aspect of the present invention, R₁₄ may be a substituted or unsubstituted C3 to C30 cycloalkyl group, e.g., adamantanyl, or adjacent two R₁₄ may be connected to each other to form a C6 to C30 alicyclic group, e.g., tetramethyltetralin, which is unsubstituted or substituted with a C1 to C30 alkyl group, e.g., methyl, with a benzene ring in Formula 3a.

In an aspect of the present invention, each of R₁₅ and R₁₆ may be may be a substituted or unsubstituted C1 to C30 alkyl group, e.g., tert-butyl, or may be connected to each other to form a substituted or unsubstituted C6 to C30 heteroaryl group, e.g., dibenzofuran with a benzene ring in Formula 3a.

For example, the first dopant 254 included in the first blue emitting layer 250 may be one of compounds in Formula 4 as referred to herein above.

The second blue emitting layer 260 includes a second host 262 and a second dopant (e.g., a second emitter) 264. In the second blue emitting layer 260, the second host 262 may have a weight % (wt%) of 80 to 99, preferably 95 to 99, and the second dopant 264 may have a wt% of 1 to 20, preferably 1 to 5.

The second host 262 includes at least one of a second host compound represented by Formula 5.

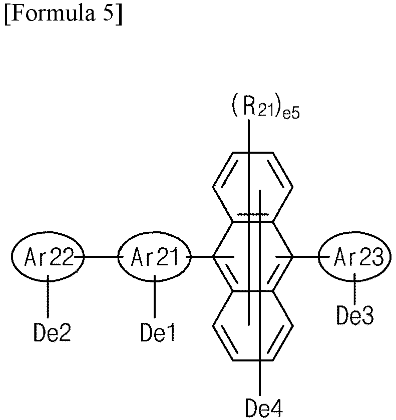

In Formula 5, each of e1, e2 and e3 is independently an integer of 0 or 30, each of e4 and e5 is independently an integer of 0 to 8, and a summation of e1 to e4 is smaller than a summation of a1 to a4 in Formula 1,
Ar21 is selected from the group consisting of a single bond (a direct bond), a substituted or unsubstituted C6 to C30 arylene group and a substituted or unsubstituted C3 to C30 heteroarylene group,
each of Ar22 and Ar23 is selected from the group consisting of a substituted or unsubstituted C6 to C30 aryl group and a substituted or unsubstituted C3 to C30 heteroaryl group, and
R₂₁ is selected from the group consisting of a C1 to C30 alkyl group unsubstituted or substituted with deuterium and a C3 to C30 cycloalkyl group unsubstituted or substituted with deuterium.

In Formula 5, D denotes a deuterium atom, each of e1, e2, e3 and e4 is a number of deuterium atoms, and e5 is a number of R₂₁ as a substituent.

In Formula 5, Ar21 may be a single bond or a substituted or unsubstituted C6 to C30 arylene group. In an aspect of the present invention, Ar21 may be selected from the group consisting of a single bond, phenylene and naphthylene, e.g., a-naphthylene or 2-naphthylene.

Each of Ar22 and Ar23 may be a substituted or unsubstituted C6 to C30 aryl group. In an aspect of the present invention, each of Ar22 and Ar23 may be selected from the group consisting of phenyl, naphthyl, e.g., a-naphthyl or 2-naphthyl, and phenanthrenyl.

R₂₁ may be a C1 to C30 alkyl group substituted deuterium, e.g., CD₃.

The second host 262 is a non-deuterated or partially deuterated anthracene derivative. As described above, a summation of e1 to e4 in Formula 5 is smaller than a summation of a1 to a4 in Formula 1. Namely, the second host 262 has a second deuteration ratio smaller than the first deuteration ratio of the first host 252. For example, the second deuteration ratio of the second host 262 may be 0 to 99%, e.g., 0 to 75%.

In an aspect of the present invention, the second host 262 may be represented by Formula 5a.

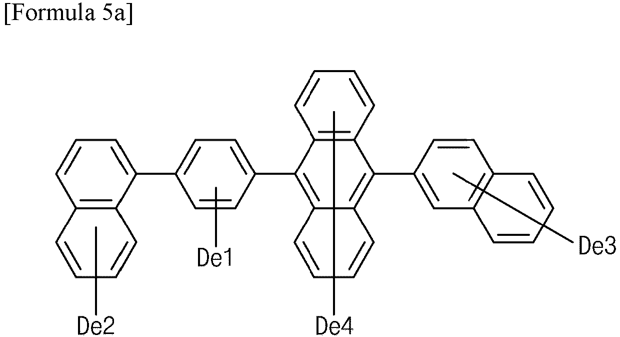

In Formula 5a, e1 is an integer of 0 to 4, each of e2 and e3 is independently an integer of 0 to 7, e4 is an integer of 0 to 8, and a summation of e1 to e4 is smaller than a summation of a1 to a4 in Formula 1a.

For example, the second host 262 included in the second blue emitting layer 260 may include at least one of compounds in Formula 6 as referred to herein above.

The second dopant 264 is represented by Formula 7.

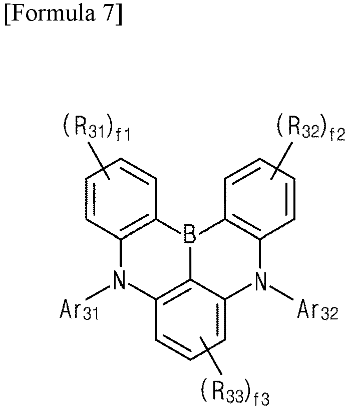

In Formula 7, each of f1 and f2 is independently an integer of 0 to 4, and f3 is an integer of 0 to 3,
each of Ar₃₁ and Ar₃₂ is independently selected from the group consisting of a substituted or unsubstituted C6 to C30 aryl group, a substituted or unsubstituted C3 to C30 heteroaryl group and a substituted or unsubstituted C6 to C30 alicyclic group, and
R₃₁, R₃₂ and R₃₃ is independently selected from the group consisting of a substituted or unsubstituted C1 to C30 alkyl group, a substituted or unsubstituted C3 to C30 cycloalkyl group, a substituted or unsubstituted C6 to C30 arylamino group, a substituted or unsubstituted C6 to C30 aryl group and a substituted or unsubstituted C3 to C30 heteroaryl group.

In an aspect of the present invention, each of Ar₃₁ and Ar₃₂ may be a C6 to C30 aryl group, e.g., phenyl, biphenyl, naphthyl or anthracenyl, unsubstituted or substituted with a C1 to C30 alkyl group, e.g., methyl or tert-butyl.

In an aspect of the present invention, each of R₃₁, R₃₂ and R₃₃ may be independently selected from the group consisting of a substituted or unsubstituted C1 to C30 alkyl group, e.g., methyl or tert-butyl, a substituted or unsubstituted C6 to C30 aryl group, e.g., phenyl, and a substituted or unsubstituted C6 to C30 arylamino group, e.g., diphenylamino.

In an aspect of the present invention, the second dopant 264 may be represented by Formula 7a.

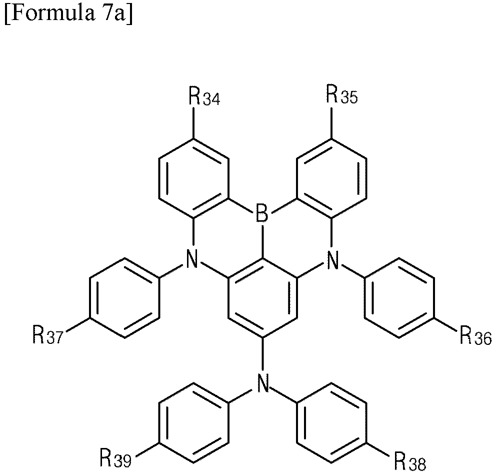

In Formula 7a, each of R₃₄ to R₃₉ is independently selected from the group consisting of hydrogen, a substituted or unsubstituted C1 to C30 alkyl group, a substituted or unsubstituted C3 to C30 cycloalkyl group, a substituted or unsubstituted C6 to C30 aryl group and a substituted or unsubstituted C3 to C30 heteroaryl group.

In an aspect of the present invention, each of R₃₄ to R₃₉ may be independently selected from the group consisting of a substituted or unsubstituted C1 to C30 alkyl group, e.g., methyl or tert-butyl, and a substituted or unsubstituted C6 to C30 aryl group. e.g., phenyl.

For example, the second dopant 264 included in the second blue emitting layer 260 may be one of compounds in Formula 8 as referred to herein above.

A weight % of the first host 252 in the first blue emitting layer 250 and a weight % of the second host 262 in the second blue emitting layer 260 may be same or different, and a weight % of the first dopant 254 in the first blue emitting layer 250 and a weight % of the second dopant 264 in the second blue emitting layer 260 may be same or different.

The first dopant 254 included in the first blue emitting layer 250, which is disposed to be closer to the first electrode 160 as an anode for injecting a hole, has a relatively high HOMO (highest occupied molecular orbital) energy level, i.e., a shallow HOMO system, and the second dopant 264 included in the second blue emitting layer 260, which is disposed to be closer to the second electrode 164 as a cathode for injecting an electron, has a relatively low HOMO energy level, i.e., a deep HOMO system.

Namely, the first dopant 254 may be a boron derivative having a first HOMO energy level, and the second dopant 264 may be a boron derivative having a second HOMO energy level lower than the first HOMO energy level. A difference between the first HOMO energy level and the second HOMO energy level may be 0.5eV or less.

In addition, the first dopant 254 has a relatively high LUMO (lowest unoccupied molecular orbital) energy level, i.e., a shallow LUMO system, and the second dopant 264 has a relatively low LUMO energy level, i.e., a deep LUMO system. Namely, the first dopant 254 has a first LUMO energy level, and the second dopant 254 has a second LUMO energy level lower than the first LUMO energy level.

For example, the first HOMO energy level of the first dopant 254 may be in a range of -5.3 to -5.1eV, and the second HOMO energy level of the second dopant 264 may be in a range of -5.5 to -5.3eV. The first LUMO energy level of the first dopant 254 may be in a range of -2.6 to -2.3eV, and the second LUMO energy level of the second dopant 264 may be in a range of -2.7 to -2.5eV.

The HOMO energy level of the first dopant 254 may be higher than that of the first host 252, and the LUMO energy level of the first dopant 254 may be higher than that of the first host 252. The HOMO energy level of the second dopant 264 may be higher than that of the second host 262, and the LUMO energy level of the second dopant 264 may be higher than that of the second host 262.

The HOMO energy level of the first host 252 and the HOMO energy level of the second host 262 may be same or different, and the LUMO energy level of the first host 252 and the LUMO energy level of the second host 262 may be same or different. Each of the HOMO energy level of the first host 252 and the HOMO energy level of the second host 262 may be in a range of -6.0 to -5.8eV, and each of the LUMO energy level of the first host 252 and the LUMO energy level of the second host 262 may be in a range of -3.1 to -2.9eV.

The first dopant 254 included in the first blue emitting layer, which is disposed to be closer to the first electrode 160 as an anode for injecting a hole, has a relatively small triplet energy, and the second dopant 264 included in the second blue emitting layer, which is disposed to be closer to the second electrode 164 as a cathode for injecting an electron, has a relatively large triplet energy level. Namely, the first dopant 254 has a first triplet energy, and the second dopant 264 has a second triplet energy greater than the first triplet energy.

For example, the first triplet energy of the first dopant 254 may be 2.5eV or less, e.g., in a range of 2.3 to 2.5eV, and the second triplet energy of the second dopant 264 may be in a range of 2.5 to 2.7eV.

The triplet energy of the first dopant 254 may be greater than that of the first host 252, and the triplet energy of the second dopant 264 may be greater than that of the second host 262.

The triplet energy of the first host 252 and the triplet energy of the second host 262 may be same or different. The triplet energy of the first host 252 and the triplet energy of the second host 262 may be in a range of 1.6 to 2.0eV.

Namely, the first host 252 in the first blue emitting layer 250 and the second host 262 in the second blue emitting layer 260 have the same chemical structure and different deuteration ratios, and the first dopant 254 in the first bule emitting layer 250 and the second dopant 264 in the second blue emitting layer 260 have different chemical structures and different electro-optic property, e.g., a HOMO energy level, a LUMO energy level or a triplet energy.

The organic emitting layer 162 may further include at least one of an HTL 220 disposed under the blue EML 240 and an ETL 280 disposed over the blue EML 240. Namely, the HTL 220 may be disposed between the blue EML 240 and the first electrode 160, and the ETL 280 may be disposed between the blue EML 240 and the second electrode 164.

The organic emitting layer 162 may further include at least one of an HIL 210 between the HTL 220 and the first electrode 160 and an EIL 290 between the ETL 280 and the second electrode 164.

The organic emitting layer 162 may further include at least one of an EBL 230 between the blue EML 240 and the HTL 220 and an HBL 270 between the blue EML 240 and the ETL 280.

For example, the organic emitting layer 162 may have a structure of the HIL 210, the HTL 220, the EBL 230, the first bule emitting layer 250, the second blue emitting layer 260, the HBL 270, the ETL 280 and the EIL 290 sequentially stacked on the first electrode 160.

Alternatively, the HBL 270 may be omitted so that the ETL 280 may contact the second blue emitting layer 260.

The HIL 210 may include a hole injection material being at least one compound selected from the group consisting of 4,4' ,4" -tris(3-methylphenylamino)triphenylamine (MTDATA), 4,4' ,4" -tris(N,N-diphenyl-amino)triphenylamine (NATA), 4,4' ,4" -tris(N-(naphthalene-1-yl)-N-phenyl-amino)triphenylamine (1T-NATA), 4,4' ,4" -tris(N-(naphthalene-2-yl)-N-phenyl-amino)triphenylamine (2T-NATA), copper phthalocyanine(CuPc), tris(4-carbazoyl-9-yl-phenyl)amine (TCTA), N,N' -diphenyl-N,N' - bis(1-naphthyl)-1,1' -biphenyl-4,4" -diamine (NPB or NPD), 1,4,5,8,9,11-hexaazatriphenylenehexacarbonitrile(dipyrazino[2,3-f:2' 3' -h]quinoxaline-2,3,6,7,10,11-hexacarbonitrile (HAT-CN), 1,3,5-tris[4-(diphenylamino)phenyl]benzene (TDAPB), poly(3,4-ethylenedioxythiphene)polystyrene sulfonate (PEDOT/PSS), and N-(biphenyl-4-yl)-9,9-dimethyl-N-(4-(9-phenyl-9H-carbazol-3-yl)phenyl)-9H-fluoren-2-amine, but it is not limited thereto. For example, the hole injection material for the HIL 210 may be a compound in Formula 11. The HIL 210 may have a thickness of 10 to 100Å.

The HTL 220 may include a hole transporting material being at least one compound selected from the group consisting of N,N' -diphenyl-N,N' -bis(3-methylphenyl)-1,1' -biphenyl-4,4' -diamine (TPD), NPB (or NPD), 4,4' -bis(N-carbazolyl)-1,1' -biphenyl (CBP), poly[N,N' -bis(4-butylphenyl)-N,N' -bis(phenyl)-benzidine] (poly-TPD), (poly[(9,9-dioctylfluorenyl-2,7-diyl)-co-(4,4' -(N-(4-sec-butylphenyl)diphenylamine))] (TFB), di-[4-(N,N-di-p-tolyl-amino)-phenyl]cyclohexane (TAPC), 3,5-di(9H-carbazol-9-yl)-N,N-diphenylaniline (DCDPA), N-(biphenyl-4-yl)-9,9-dimethyl-N-(4-(9-phenyl-9H-carbazol-3-yl)phenyl)-9H-fluoren-2-amine, and N-(biphenyl-4-yl)-N-(4-(9-phenyl-9H-carbazol-3-yl)phenyl)biphenyl-4-amine, but it is not limited thereto. For example, the hole transporting material for the HTL 220 may be the compound in Formula 12. The HTL 220 may have a thickness of 500 to 1500Å, preferably 700 to 1300Å.

The ETL 280 may include an electron transporting material being at least one compound selected from the group consisting of tris-(8-hydroxyquinoline aluminum (Alq₃), 2-biphenyl-4-yl-5-(4-t-butylphenyl)-1,3,4-oxadiazole (PBD), spiro-PBD, lithium quinolate (Liq), 1,3,5-tris(N-phenylbenzimidazol-2-yl)benzene (TPBi), bis(2-methyl-8-quinolinolato-N1,08)-(1,1' -biphenyl-4-olato)aluminum (BAlq), 4,7-diphenyl-1,10-phenanthroline (Bphen), 2,9-bis(naphthalene-2-yl)-4,7-diphenyl-1,10-phenanthroline (NBphen), 2,9-dimethyl-4,7-diphenyl-1,10-phenathroline (BCP), 3-(4-biphenyl)-4-phenyl-5-tert-butylphenyl-1,2,4-triazole (TAZ), 4-(naphthalen-1-yl)-3,5-diphenyl-4H-1,2,4-triazole (NTAZ), 1,3,5-tri(p-pyrid-3-yl-phenyl)benzene (TpPyPB), 2,4,6-tris(3' -(pyridin-3-yl)biphenyl-3-yl)1,3,5-triazine (TmPPPyTz), poly[9,9-bis(3' -((N,N-dimethyl)-N-ethylammonium)-propyl)-2,7-fluorene]-alt-2,7-(9,9-dioctylfluorene)] (PFNBr), tris(phenylquinoxaline) (TPQ), diphenyl-4-triphenylsilyl-phenylphosphine oxide (TSPO1), and 2-[4-(9,10-Di-2-naphthalen2-yl-2-anthracen-2-yl)phenyl]-1-phenyl-1H-benzimidazole (ZADN). For example, the electron transporting material for the ETL 280 may be a compound in Formula 13. The ETL 280 may have a thickness of 100 to 500Å, preferably 200 to 400Å.

The EIL 290 may include an electron injection material being at least one of an alkali metal, such as Li, an alkali halide compound, such as LiF, CsF, NaF, or BaF₂, and an organo-metallic compound, such as Liq, lithium benzoate, or sodium stearate. Alternatively, the EIL 290 may include a compound in Formula 14 and a dopant, e.g., Li, and the dopant may have a weight % of 1 to 10. The EIL 290 may have a thickness of 50 to 400Å, preferably 100 to 300Å.

The EBL 230 may include an electron blocking material being at least one compound selected from the group consisting of TCTA, tris[4-(diethylamino)phenyl]amine, N-(biphenyl-4-yl)-9,9-dimethyl-N-(4-(9-phenyl-9H-carbazol-3-yl)phenyl)-9H-fluoren-2-amine, TAPC, MTDATA, 1,3-bis(carbazol-9-yl)benzene (mCP), 3,3' -bis(N-carbazolyl)-1,1' - biphenyl (mCBP), CuPc, N,N' -bis[4-[bis(3-methylphenyl)amino]phenyl]-N,N' -diphenyl-[1,1' -biphenyl]-4,4' -diamine (DNTPD), TDAPB, and DCDPA, 2,8-bis(9-phenyl-9H-carbazol-3-yl)dibenzo[b,d]thiophene). The EBL 230 may have a thickness of 100 to 300Å.

Alternatively, the electron blocking material of the EBL 230 may be a compound represented by Formula 9.

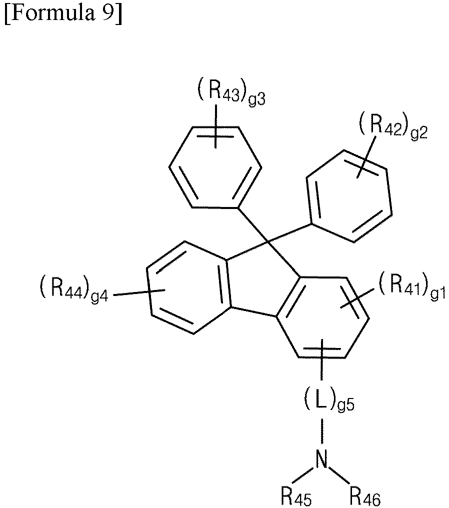

In Formula 9, g1 is an integer of 0 to 3, each of g2 and g3 is independently an integer of 0 to 5, g4 is an integer of 0 to 4, and g5 is 0 or 1,
each of R₄₁ and R₄₄ is independently selected from the group consisting of deuterium, a substituted or unsubstituted C1 to C30 alkyl group, a substituted or unsubstituted C3 to C30 cycloalkyl group, a substituted or unsubstituted C6 to C30 aryl group and a substituted or unsubstituted C3 to C30 heteroaryl group,
each of R₄₂ and R₄₃ is independently selected from the group consisting of deuterium, a substituted or unsubstituted C1 to C30 alkyl group, a C3 to C30 cycloalkyl group unsubstituted or substituted with deuterium, a substituted or unsubstituted C6 to C30 aryl group and a substituted or unsubstituted C3 to C30 heteroaryl group, or R₄₂ and R₄₃ are connected to each other to form a ring,
each of R₄₃ and R₄₆ is independently selected from the group consisting of a substituted or unsubstituted C6 to C30 aryl group and a substituted or unsubstituted C3 to C30 heteroaryl group,
L is selected from the group consisting of a substituted or unsubstituted C6 to C30 arylene group and a substituted or unsubstituted C3 to C30 heteroarylene group.

In an aspect of the present invention, g5 may be 0, or L may be a substituted or unsubstituted C6 to C30 arylene group, e.g., phenylene.

In an aspect of the present invention, each of R₄₂ and R₄₃ may be connected to each other so that the electron blocking material in Formula 9 has a structure of a spiro-fluorene.

In an aspect of the present invention, each of R₄₃ and R₄₆ may be independently selected from the group consisting of biphenyl, fluorenyl, carbazolyl, phenylcarbazolyl, carbazolylphenyl, dibenzothiophenyl and dibenzofuranyl and may be substituted with a C1 to C10 alkyl group or a C6 to C30 aryl group, e.g., phenyl.

For example, the electron blocking material in Formula 9 may be an amine derivative substituted with spiro-fluorene group.

A HOMO energy level of the electron blocking material, i.e., the compound in Formula 9, in the EBL 230 may be lower than each of a HOMO energy level of the first dopant 254 and a HOMO energy level of the second dopant 264.

The HOMO energy level of the electron blocking material, i.e., the compound in Formula 9, in the EBL 230 may be in a range of -5.8 to -5.6eV, and a LUMO energy level of the electron blocking material, i.e., the compound in Formula 9, in the EBL 230 may be in a range of -2.6 to -2.3eV.

For example, the electron blocking material in the EBL 230 may be one of compounds in Formula 10.

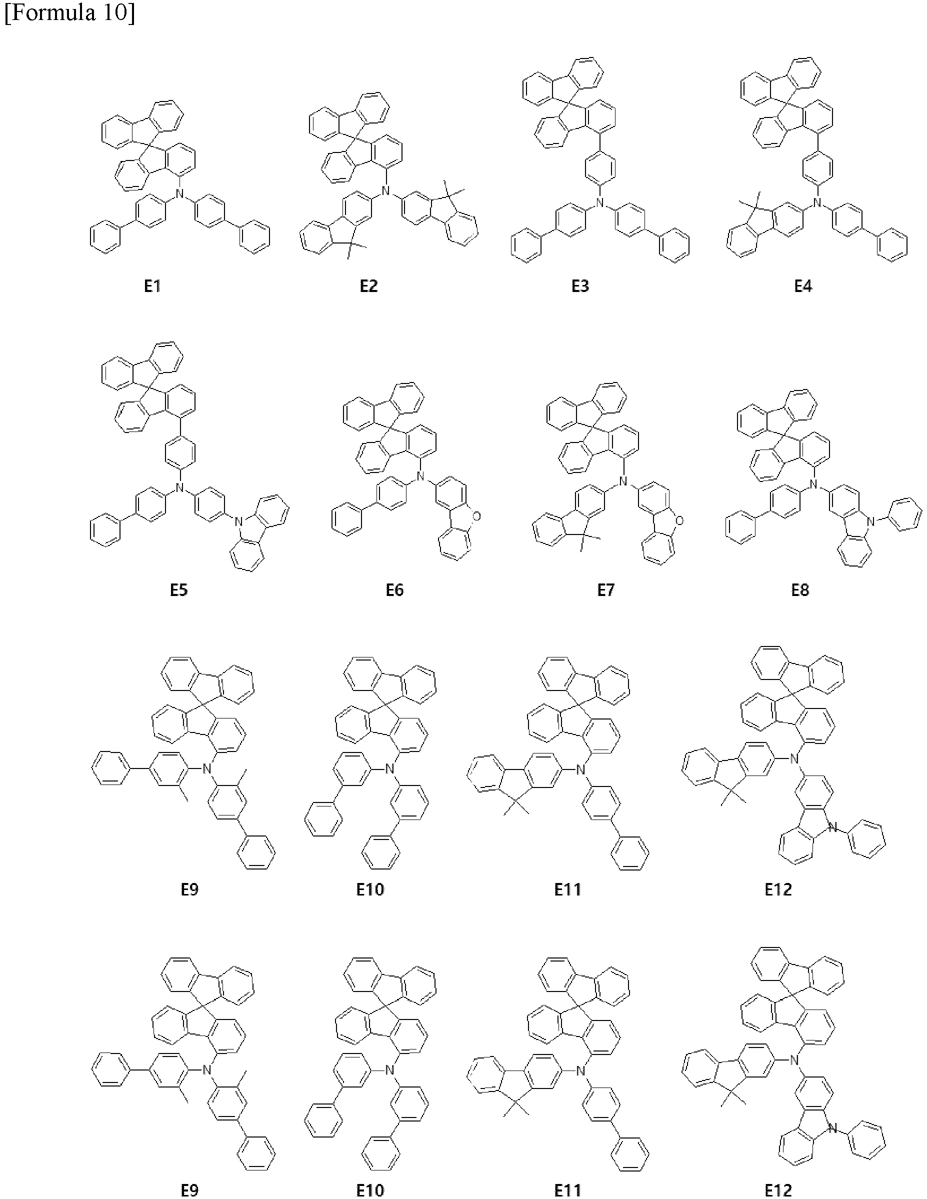

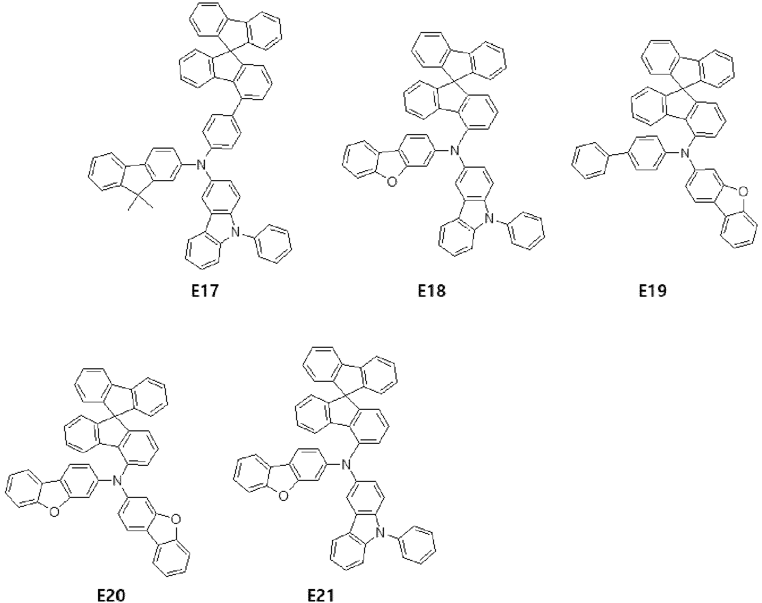

The HBL 270 may include the material of the HTL 280. For example, the HBL 270 may include a hole blocking material being at least one compound selected from the group consisting of BCP, BAlq, Alq3, PBD, spiro-PBD, Liq, bis-4,6-(3,5-di-3-pyridylphenyl)-2-methylpyrimidine (B3PYMPM), bis[2-(diphenylphosphino)phenyl]ether oxide (DPEPO), 9-(6-9H-carbazol-9-yl)pyridine-3-yl)-9H-3,9'-bicarbazole, TSPO1 and the compound in Formula 12, but it is not limited thereto. The HBL 270 may have a thickness of 100 to 500Å, preferably 200 to 400Å.

In the OLED D1, the blue EML 240 including the first and second blue emitting layers 250 and 260 constitutes an emitting part, or the blue EML 240 including the first and second blue emitting layers 250 and 260 with at least one of the HIL 210, the HTL 220, the EBL 230, the HBL 270, the ETL 280 and the EIL 290 constitutes an emitting part.

As described above, in the OLED D1 of the present invention, the blue EML 240 includes the first blue emitting layer 250, which includes the first host 252 and the first dopant 254 and is disposed to be closer to the first electrode 160 as an anode, and the second blue emitting layer 260, which includes the second host 262 and the second dopant 264 and is disposed to be closer to the second electrode 164 as a cathode. In this case, the first host 252 includes at least one of the first host compounds represented by Formula 1, the second host 262 includes at least one of the second host compounds represented by Formula 5, the first dopant 254 is represented by Formula 3a, and the second dopant 264 is represented by Formula 7.

Accordingly, the OLED D1 and the organic light emitting display device 100 may have an advantage in at least one of the emitting efficiency, the color purity and the lifespan.

In the OLED D1 of the present invention, the blue EML 240 includes the first blue emitting layer 250, which includes the first host 252 and the first dopant 254 and is disposed to be closer to the first electrode 160 as an anode, and the second blue emitting layer 260, which includes the second host 262 and the second dopant 264 and is disposed to be closer to the second electrode 164 as a cathode. In this case, a deuteration ratio of the second host 262 is smaller than that of the first host 252, a HOMO energy level of the second dopant 264 is lower than that of the first dopant 254, and a triplet energy of the second dopant 264 is greater than that of the first dopant 254.

Accordingly, the OLED D1 and the organic light emitting display device 100 may have an advantage in at least one of the emitting efficiency, the color purity and the lifespan.

FIG. 4 is a schematic cross-sectional view illustrating an OLED according to a third embodiment of the present invention.

As illustrated in FIG. 4, the OLED D2 includes the first and second electrodes 160 and 164 facing each other and the organic emitting layer 162 between the first and second electrodes 160 and 164. The organic emitting layer 162 includes a first emitting part 310 including a first blue EML 340 and a second emitting part 350 including a second blue EML 380. In addition, the organic emitting layer 162 may further include a charge generation layer (CGL) 390 between the first and second emitting parts 310 and 380.

The organic light emitting display device 100 (of FIG. 2) includes a red pixel, a green pixel and a blue pixel. The organic light emitting display device 100 may further include a white pixel region. The OLED D2 is positioned in the blue pixel.

One of the first and second electrodes 160 and 164 is an anode, and the other one of the first and second electrodes 160 and 164 is cathode. In addition, one of the first and second electrodes 160 and 164 may be a reflection electrode, and the other one of the first and second electrodes 160 and 164 may be a transparent (or a semi-transparent) electrode.

For example, the first electrode 160 may include a transparent conductive material layer of ITO or IZO, and the second electrode 164 may be formed of one of Al, Mg, Ag, AlMg and MgAg.

The CGL 390 is positioned between the first and second emitting parts 310 and 350, and the first emitting part 310, the CGL 390 and the second emitting part 350 are sequentially stacked on the first electrode 160. Namely, the first emitting part 310 is positioned between the first electrode 160 and the CGL 390, and the second emitting part 350 is positioned between the second electrode 164 and the CGL 390.

In the first emitting part 310, the first blue EML 340 includes a first blue emitting layer 320 being closer to the first electrode 160 and a second blue emitting layer 330 being closer to the second electrode 164 and adjacent to the first blue emitting layer 320. Namely, the second blue emitting layer 330 is disposed between the first blue emitting layer 320 and the second electrode 164 and contacts the first blue emitting layer 320.

The first blue EML 340 may have a thickness of 100 to 500Å. A summation of a thickness of the first blue emitting layer 320 and a thickness of the second blue emitting layer 330 is equal to a thickness of the first blue EML 340, and the thickness of the first blue emitting layer 320 and the thickness of the second blue emitting layer 330 may be same or different. Each of the thickness of the first blue emitting layer 320 and the thickness of the second blue emitting layer 330 may be 50 to 250 Å, e.g., 70 to 150 Å.

The first blue emitting layer 320 includes a first host 322 and a first dopant (e.g., a first emitter) 324. In the first blue emitting layer 320, the first host 322 may have a weight % (wt%) of 80 to 99, preferably 95 to 99, and the first dopant 324 may have a wt% of 1 to 20, preferably 1 to 5.

The first host 322 includes at least one of the first host compounds represented by Formula 1, and the first dopant 324 is represented by Formula 3a. In an aspect of the present invention, the first host 322 may be represented by Formula 1a, and the first dopant 324 may be represented by Formula 3a. For example, the first host 322 may include at least one of the compounds in Formula 2, and the first dopant 324 may include at least one of the compounds in Formula 4.

The first host 322 is a partially or wholly deuterated anthracene derivative. For example, the first host 322 may have a first deuteration ratio of about 1 to 100%, e.g., about 30 to 100%.

The second blue emitting layer 330 includes a second host 332 and a second dopant (e.g., a second emitter) 334. In the second blue emitting layer 330, the second host 332 may have a weight % (wt%) of 80 to 99, preferably 95 to 99, and the second dopant 334 may have a wt% of 1 to 20, preferably 1 to 5.

The second host 332 includes at least one of the first host compounds represented by Formula 5, and the second dopant 334 is represented by Formula 7. In an aspect of the present invention, the second host 332 may be represented by Formula 5a, and the second dopant 334 may be represented by Formula 7a. For example, the second host 332 may include at least one of the compounds in Formula 6, and the second dopant 334 may include at least one of the compounds in Formula 8.

The second host 332 is a non-deuterated or partially deuterated anthracene derivative. Namely, the second host 332 has a second deuteration ratio smaller than the first deuteration ratio of the first host 322. For example, the second deuteration ratio of the second host 332 may be 0 to 99%, e.g., 0 to 75%.

A weight % of the first host 322 in the first blue emitting layer 320 and a weight % of the second host 332 in the second blue emitting layer 330 may be same or different, and a weight % of the first dopant 324 in the first blue emitting layer 320 and a weight % of the second dopant 334 in the second blue emitting layer 330 may be same or different.

The first dopant 324 included in the first blue emitting layer 320, which is disposed to be closer to the first electrode 160 as an anode for injecting a hole, has a relatively high HOMO energy level, i.e., a shallow HOMO system, and the second dopant 334 included in the second blue emitting layer 330, which is disposed to be closer to the second electrode 164 as a cathode for injecting an electron, has a relatively low HOMO energy level, i.e., a deep HOMO system. Namely, the first dopant 324 may have a first HOMO energy level, and the second dopant 334 may have a second HOMO energy level lower than the first HOMO energy level. A difference between the first HOMO energy level and the second HOMO energy level may be 0.5eV or less.

In addition, the first dopant 324 has a relatively high LUMO energy level, i.e., a shallow LUMO system, and the second dopant 334 has a relatively low LUMO energy level, i.e., a deep LUMO system. Namely, the first dopant 324 has a first LUMO energy level, and the second dopant 334 has a second LUMO energy level lower than the first LUMO energy level.

For example, the first HOMO energy level of the first dopant 324 may be in a range of -5.3 to -5.1eV, and the second HOMO energy level of the second dopant 334 may be in a range of -5.5 to -5.3eV. The first LUMO energy level of the first dopant 324 may be in a range of -2.6 to -2.3eV, and the second LUMO energy level of the second dopant 334 may be in a range of -2.7 to -2.5eV.

The HOMO energy level of the first dopant 324 may be higher than that of the first host 322, and the LUMO energy level of the first dopant 324 may be higher than that of the first host 322. The HOMO energy level of the second dopant 334 may be higher than that of the second host 332, and the LUMO energy level of the second dopant 334 may be higher than that of the second host 332.

The HOMO energy level of the first host 322 and the HOMO energy level of the second host 332 may be same or different, and the LUMO energy level of the first host 322 and the LUMO energy level of the second host 332 may be same or different. Each of the HOMO energy level of the first host 322 and the HOMO energy level of the second host 332 may be in a range of -6.0 to -5.8eV, and each of the LUMO energy level of the first host 322 and the LUMO energy level of the second host 332 may be in a range of -3.1 to -2.9eV.

The first dopant 324 included in the first blue emitting layer 320, which is disposed to be closer to the first electrode 160 as an anode for injecting a hole, has a relatively small triplet energy, and the second dopant 334 included in the second blue emitting layer 330, which is disposed to be closer to the second electrode 164 as a cathode for injecting an electron, has a relatively large triplet energy level. Namely, the first dopant 324 has a first triplet energy, and the second dopant 334 has a second triplet energy greater than the first triplet energy.

For example, the first triplet energy of the first dopant 324 may be 2.5eV or less, e.g., in a range of 2.3 to 2.5eV, and the second triplet energy of the second dopant 334 may be in a range of 2.5 to 2.7eV.

The triplet energy of the first dopant 324 may be greater than that of the first host 322, and the triplet energy of the second dopant 334 may be greater than that of the second host 332. The triplet energy of the first host 322 and the triplet energy of the second host 332 may be same or different. The triplet energy of the first host 322 and the triplet energy of the second host 332 may be in a range of 1.6 to 2.0eV.

Namely, in the first blue EML 340, the first host 322 in the first blue emitting layer 320 and the second host 332 in the second blue emitting layer 330 have the same chemical structure and different deuteration ratios, and the first dopant 324 in the first bule emitting layer 320 and the second dopant 334 in the second blue emitting layer 330 have different chemical structures and different electro-optic property, e.g., a HOMO energy level, a LUMO energy level or a triplet energy.

The first emitting part 310 may further include at least one of a first HTL 313 disposed under the first blue EML 340 and a first ETL 319 disposed over the first blue EML 340. Namely, the first HTL 313 may be disposed between the first blue EML 340 and the first electrode 160, and the first ETL 319 may be disposed between the first blue EML 340 and the second electrode 164.

The first emitting part 310 may further include an HIL 311 between the first HTL 313 and the first electrode 160

The first emitting part 310 may further include at least one of a first EBL 315 between the first blue EML 340 and the first HTL 313 and a first HBL 317 between the first blue EML 340 and the first ETL 319.

For example, the first emitting part 310 may have a structure of the HIL 311, the first HTL 313, the first EBL 315, the first bule emitting layer 320, the second blue emitting layer 330, the first HBL 317 and the first ETL 319 sequentially stacked on the first electrode 160. Alternatively, the first HBL 317 may be omitted so that the first ETL 319 may contact the second blue emitting layer 330.

In the second emitting part 350, the second blue EML 380 includes a third blue emitting layer 360, which is disposed to be closer to the first electrode 160, and a fourth blue emitting layer 370, which is disposed to be closer to the second electrode 164 and is adjacent to the third blue emitting layer 360. Namely, the fourth blue emitting layer 370 is positioned between the third blue emitting layer 360 and the second electrode 164 and contacts the third blue emitting layer 360.

The second blue EML 380 may have a thickness of 100 to 500Å. A summation of a thickness of the third blue emitting layer 360 and a thickness of the fourth blue emitting layer 370 is equal to a thickness of the second blue EML 380, and the thickness of the third blue emitting layer 360 and the thickness of the fourth blue emitting layer 370 may be same or different. Each of the thickness of the third blue emitting layer 360 and the thickness of the fourth blue emitting layer 370 may be 50 to 250 Å, e.g., 70 to 150 Å.

The third blue emitting layer 360 includes a third host 362 and a third dopant (e.g., a third emitter) 364. In the third blue emitting layer 360, the third host 362 may have a weight % (wt%) of 80 to 99, preferably 95 to 99, and the third dopant 364 may have a wt% of 1 to 20, preferably 1 to 5.

The third host 362 includes at least one of the first host compounds represented by Formula 1, and the third dopant 364 is represented by Formula 3. In an aspect of the present invention, the third host 362 may be represented by Formula 1a, and the third dopant 364 may be represented by Formula 3a. For example, the third host 362 may include at least one of the compounds in Formula 2, and the third dopant 364 may include at least one of the compounds in Formula 4.

The third host 362 and the first host 322 may be same or different, and the third dopant 364 and the first dopant 324 may be same or different.

The third host 362 is a partially or wholly deuterated anthracene derivative. For example, the third host 362 may have a third deuteration ratio of about 1 to 100%, e.g., about 30 to 100%.

The fourth blue emitting layer 370 includes a fourth host 372 and a fourth dopant (e.g., a fourth emitter) 374. In the fourth blue emitting layer 370, the fourth host 372 may have a weight % (wt%) of 80 to 99, preferably 95 to 99, and the fourth dopant 374 may have a wt% of 1 to 20, preferably 1 to 5.

The fourth host 372 includes at least one of the first host compounds represented by Formula 5, and the fourth dopant 374 is represented by Formula 7. In an aspect of the present invention, the fourth host 372 may be represented by Formula 5a, and the fourth dopant 374 may be represented by Formula 7a. For example, the fourth host 372 may include at least one of the compounds in Formula 6, and the fourth dopant 374 may include at least one of the compounds in Formula 8.

The fourth host 372 and the second host 332 may be same or different, and the fourth dopant 374 and the second dopant 334 may be same or different.

The fourth host 372 is a non-deuterated or partially deuterated anthracene derivative. Namely, the fourth host 372 has a fourth deuteration ratio smaller than the third deuteration ratio of the third host 362. For example, the fourth deuteration ratio of the fourth host 372 may be 0 to 99%, e.g., 0 to 75%.

A weight % of the third host 362 in the third blue emitting layer 360 and a weight % of the fourth host 372 in the fourth blue emitting layer 370 may be same or different, and a weight % of the third dopant 364 in the third blue emitting layer 360 and a weight % of the fourth dopant 374 in the fourth blue emitting layer 370 may be same or different.

The third dopant 364 included in the third blue emitting layer 360, which is disposed to be closer to the first electrode 160 as an anode for injecting a hole, has a relatively high HOMO energy level, i.e., a shallow HOMO system, and the fourth dopant 374 included in the fourth blue emitting layer 370, which is disposed to be closer to the second electrode 164 as a cathode for injecting an electron, has a relatively low HOMO energy level, i.e., a deep HOMO system. Namely, the third dopant 364 may have a third HOMO energy level, and the fourth dopant 374 may have a fourth HOMO energy level lower than the third HOMO energy level. A difference between the third HOMO energy level and the fourth HOMO energy level may be 0.5eV or less.

In addition, the third dopant 364 has a relatively high LUMO energy level, i.e., a shallow LUMO system, and the fourth dopant 374 has a relatively low LUMO energy level, i.e., a deep LUMO system. Namely, the third dopant 364 has a third LUMO energy level, and the fourth dopant 374 has a fourth LUMO energy level lower than the third LUMO energy level.

For example, the third HOMO energy level of the third dopant 364 may be in a range of -5.3 to -5.1eV, and the fourth HOMO energy level of the fourth dopant 374 may be in a range of -5.5 to -5.3eV. The third LUMO energy level of the third dopant 364 may be in a range of -2.6 to -2.3eV, and the fourth LUMO energy level of the fourth dopant 374 may be in a range of -2.7 to -2.5eV.

The HOMO energy level of the third dopant 364 may be higher than that of the third host 362, and the LUMO energy level of the third dopant 364 may be higher than that of the third host 362. The HOMO energy level of the fourth dopant 374 may be higher than that of the fourth host 372, and the LUMO energy level of the fourth dopant 374 may be higher than that of the fourth host 372.

The HOMO energy level of the third host 362 and the HOMO energy level of the fourth host 372 may be same or different, and the LUMO energy level of the third host 362 and the LUMO energy level of the fourth host 372 may be same or different. Each of the HOMO energy level of the third host 362 and the HOMO energy level of the fourth host 372 may be in a range of -6.0 to -5.8eV, and each of the LUMO energy level of the third host 362 and the LUMO energy level of the fourth host 372 may be in a range of -3.1 to -2.9eV.

The third dopant 364 included in the third blue emitting layer 360, which is disposed to be closer to the first electrode 160 as an anode for injecting a hole, has a relatively small triplet energy, and the fourth dopant 374 included in the fourth blue emitting layer 370, which is disposed to be closer to the second electrode 164 as a cathode for injecting an electron, has a relatively large triplet energy level. Namely, the third dopant 364 has a third triplet energy, and the fourth dopant 374 has a fourth triplet energy greater than the third triplet energy.

For example, the third triplet energy of the third dopant 364 may be 2.5eV or less, e.g., in a range of 2.3 to 2.5eV, and the fourth triplet energy of the fourth dopant 374 may be in a range of 2.5 to 2.7eV.

The triplet energy of the third dopant 364 may be greater than that of the third host 362, and the triplet energy of the fourth dopant 374 may be greater than that of the fourth host 372. The triplet energy of the third host 362 and the triplet energy of the fourth host 372 may be same or different. The triplet energy of the third host 362 and the triplet energy of the fourth host 372 may be in a range of 1.6 to 2.0eV.

Namely, in the second blue EML 380, the third host 362 in the third blue emitting layer 360 and the fourth host 372 in the fourth blue emitting layer 370 have the same chemical structure and different deuteration ratios, and the third dopant 364 in the third bule emitting layer 360 and the fourth dopant 374 in the fourth blue emitting layer 370 have different chemical structures and different electro-optic property, e.g., a HOMO energy level, a LUMO energy level or a triplet energy.

The second emitting part 350 may further include at least one of a second HTL 351 disposed under the second blue EML 380 and a second ETL 357 disposed over the second blue EML 380. Namely, the second HTL 351 is positioned between the second blue EML 380 and the first emitting part 310, and the second ETL 357 is positioned between the second blue EML 380 and the second electrode 164.

The second emitting part 350 may further include an EIL 359 between the second ETL 357 and the second electrode 164.

The second emitting part 350 may further include a second EBL 353 between the second blue EML 380 and the second HTL 351 and a second HBL 355 between the second blue EML 380 and the second ETL 357.

For example, the second emitting part 350 may have a structure of the second HTL 351, the second EBL 353, the third emitting layer 360, the fourth emitting layer 370, the second HBL 355, the second ETL 357 and the EIL 359. Alternatively, the second HBL 355 may be omitted so that the second ETL 357 may contact the fourth blue emitting layer 370.

The HIL 311 may include the above-mentioned hole injection material and may have a thickness of 10 to 100Å.

Each of the first and second HTLs 313 and 351 may include the above-mentioned hole transporting material and may have a thickness of 500 to 1500Å, preferably 700 to 1300Å.

Each of the first and second ETLs 319 and 357 may include the above-mentioned electron transporting material and may have a thickness of 100 to 500Å, preferably 200 to 400Å.

The EIL 359 may include the above-mentioned electron injection material and may have a thickness of 50 to 400Å, preferably 100 to 300Å.

Each of the first and second EBLs 315 and 353 may include the above-mentioned electron blocking material and may have a thickness of 10 to 300Å.

Each of the first and second HBLs 317 and 355 may include the above-mentioned hole blocking material and may have a thickness of 100 to 500Å, preferably 200 to 400Å.

A HOMO energy level of the electron blocking material, e.g., a compound in Formula 9, in the first ETL 315 may be lower than each of a HOMO energy level of the first dopant 324 and a HOMO energy level of the second dopant 334. A HOMO energy level of the electron blocking material, e.g., a compound in Formula 9, in the second ETL 353 may be lower than each of a HOMO energy level of the third dopant 364 and a HOMO energy level of the fourth dopant 374.

A HOMO energy level and a LUMO energy of the electron blocking material, e.g., a compound in Formula 9, in the first ETL 315 may be higher than a HOMO energy level and a LUMO energy of the first host 322, respectively. A HOMO energy level and a LUMO energy of the electron blocking material, e.g., a compound in Formula 9, in the second ETL 353 may be higher than a HOMO energy level and a LUMO energy of the third host 362, respectively.

The HOMO energy level of the electron blocking material, i.e., the compound in Formula 9, in each of the first and second EBLs 315 and 353 may be in a range of -5.8 to - 5.6eV, and a LUMO energy level of the electron blocking material, i.e., the compound in Formula 9, in each of the first and second EBLs 315 and 353 may be in a range of -2.6 to - 2.3eV.

The CGL 390 is positioned between the first and second emitting parts 310 and 350. Namely, the first and second emitting parts 310 and 350 are connected through the CGL 390. The CGL 390 may be a P-N junction CGL of an N-type CGL 392 and a P-type CGL 394.

The N-type CGL 392 is positioned between the first HBL 317 and the second HTL 351, and the P-type CGL 394 is positioned between the N-type CGL 392 and the second HTL 351.

The N-type CGL 392 may be an organic layer doped with an alkali metal, e.g., Li, Na, K and Cs, and/or an alkali earth metal, e.g., Mg, Sr, Ba and Ra. For example, the N-type CGL 392 may be formed of an N-type charge generation material including a host being the organic material, e.g., 4,7-dipheny-1,10-phenanthroline (Bphen) and MTDATA, a dopant being an alkali metal and/or an alkali earth metal, and the dopant may be doped with a weight % of 0.01 to 30.

The P-type CGL 394 may be formed of a P-type charge generation material including an inorganic material, e.g., tungsten oxide (Wox), molybdenum oxide (MoOx), beryllium oxide (Be2O3) and vanadium oxide (V2O5), an organic material, e.g., NPD, HAT-CN, F4TCNQ, TPD, TNB, TCTA and N,N'-dioctyl-3,4,9,10-perylenedicarboximide (PTCDI-C8).

In FIG. 4, the first blue EML 340 has a double-layered structure including the first and second blue emitting layers 320 and 330, and the second blue EML 380 has a double-layered structure including the third and fourth blue emitting layers 360 and 370.

Alternatively, one of the first and second blue EMLs 340 and 380 may have a double-layered structure, while the other one of the first and second blue EMLs 340 and 380 may have a single-layered structure. In this instance, the other one of the first and second blue EMLs 340 and 380 may include a blue host and a blue dopant.

For example, the blue host may be selected from the group consisting of mCP, 9-(3-(9H-carbazol-9-yl)phenyl)-9H-carbazole-3-carbonitrile (mCP-CN), mCBP, CBP-CN, 9-(3-(9H-Carbazol-9-yl)phenyl)-3-(diphenylphosphoryl)-9H-carbazole (mCPPO1) 3,5-Di(9H-carbazol-9-yl)biphenyl (Ph-mCP), TSPO1, 9-(3'-(9H-carbazol-9-yl)-[1,1'-biphenyl]-3-yl)-9H-pyrido[2,3-b]indole (CzBPCb), bis(2-methylphenyl)diphenylsilane (UGH-1), 1,4-bis(triphenylsilyl)benzene (UGH-2), 1,3-bis(triphenylsilyl)benzene (UGH-3), 9,9-spiorobifluoren-2-yl-diphenyl-phosphine oxide (SPPO1) and 9,9'-(5-(triphenylsilyl)-1,3-phenylene)bis(9H-carbazole) (SimCP).

The blue dopant may be selected from the group consisting of perylene, 4,4'-bis[4-(di-p-tolylamino)styryl]biphenyl (DPAVBi), 4-(di-p-tolylamino)-4-4'-[(di-p-tolylamino)styryl]stilbene (DPAVB), 4,4'-bis[4-(diphenylamino)styryl]biphenyl (BDAVBi), 2,7-bis(4-diphenylamino)styryl)-9,9-spiorfluorene (spiro-DPVBi), [1,4-bis[2-[4-[N,N-di(p-tolyl)amino]phenyl]vinyl] benzene (DSB), 1-4-di-[4-(N,N-diphenyl)amino]styryl-benzene (DSA), 2,5,8,11-tetra-tetr-butylperylene (TBPe), bis(2-hydroxylphenyl)-pyridine)beryllium (Bepp2), 9-(9-Phenylcarbazole-3-yl)-10-(naphthalene-1-yl)anthracene (PCAN), mer-tris(1-phenyl-3-methylimidazolin-2-ylidene-C,C(2)'iridium(III) (mer-Ir(pmi)3), fac-Tris(1,3-diphenyl-benzimidazolin-2-ylidene-C,C(2)'iridium(III) (fac-Ir(dpbic)3), bis(3,4,5-trifluoro-2-(2-pyridyl)phenyl-(2-carboxypyridyl)iridium(III) (Ir(tfpd)2pic), tris(2-(4,6-difluorophenyl)pyridine))iridium(III) (Ir(Fppy)3) and bis[2-(4,6-difluorophenyl)pyridinato-C2,N](picolinato)iridium(III) (FIrpic).

The OLED D2 of the present invention includes the first emitting part 310 including the first blue EML 340 and the second emitting part 350 including the second blue EML 380, and at least one of the first and second blue EMLs 340 and 380 includes a first blue emitting layer including a first host and a first dopant and a second blue emitting layer including a second host and a second dopant. In this case, the first host includes at least one of the first host compounds represented by Formula 1, the second host includes at least one of the second host compounds represented by Formula 5, the first dopant is represented by Formula 3a, and the second dopant is represented by Formula 7.

Accordingly, the OLED D2 and the organic light emitting display device 100 may have an advantage in at least one of the emitting efficiency, the color purity and the lifespan.

The OLED D2 of the present invention includes the first emitting part 310 including the first blue EML 340 and the second emitting part 350 including the second blue EML 380, and at least one of the first and second blue EMLs 340 and 380 includes a first blue emitting layer including a first host and a first dopant and a second blue emitting layer including a second host and a second dopant. In this case, a deuteration ratio of the second host in the second blue emitting layer, which is closer to the second electrode 164 as a cathode, is smaller than that of the first host in the first blue emitting layer, which is closer to the first electrode 160 as an anode, a HOMO energy level of the second dopant in the second blue emitting layer, which is closer to the second electrode 164 as a cathode, is lower than that of the first dopant in the first blue emitting layer, which is closer to the first electrode 160 as an anode, and a triplet energy of the second dopant is greater than that of the first dopant.

Accordingly, the OLED D2 and the organic light emitting display device 100 may have an advantage in at least one of the emitting efficiency, the color purity and the lifespan.

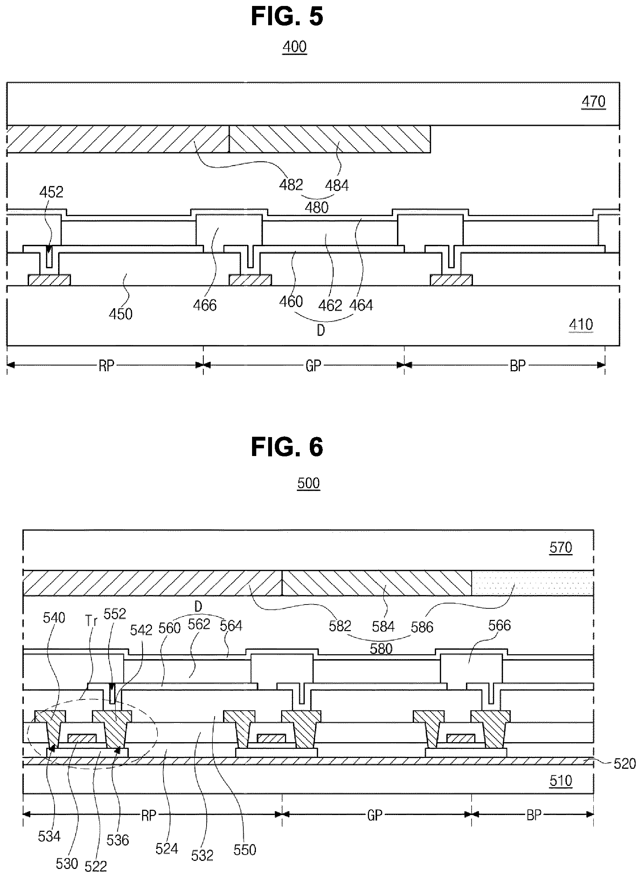

FIG. 5 is a schematic cross-sectional view illustrating an organic light emitting display device according to a fourth embodiment of the present invention.

As illustrated in FIG. 5, the organic light emitting display device 400 includes a first substrate 410, where a red pixel RP, a green pixel GP and a blue pixel BP are defined, a second substrate 470 facing the first substrate 410, an OLED D, which is positioned between the first and second substrates 410 and 470 and providing white emission, and a color conversion layer 480 between the OLED D and the second substrate 470.

Although not shown, a color filter may be formed between the second substrate 470 and each color conversion layer 480.

Each of the first and second substrates 410 and 470 may be a glass substrate or a flexible substrate. For example, each of the first and second substrates 410 and 470 may be a polyimide (PI) substrate, a polyethersulfone (PES) substrate, a polyethylenenaphthalate (PEN) substrate, a polyethylene terephthalate (PET) substrate or a polycarbonate (PC) substrate.

A TFT Tr, which corresponding to each of the red, green and blue pixels RP, GP and BP, is formed on the first substrate 410, and a planarization layer 450, which has a drain contact hole 452 exposing an electrode, e.g., a drain electrode, of the TFT Tr is formed to cover the TFT Tr.

The OLED D including a first electrode 460, an organic emitting layer 462 and a second electrode 464 is formed on the planarization layer 450. In this instance, the first electrode 460 may be connected to the drain electrode of the TFT Tr through the drain contact hole 452.

A bank layer 466 is formed on the planarization layer 450 to cover an edge of the first electrode 460. Namely, the bank layer 466 is positioned at a boundary of the pixel and exposes a center of the first electrode 460 in the pixel.

The OLED D emits a blue light and may have a structure shown in FIG. 3 or FIG. 4. Namely, the OLED D is formed in each of the red, green and blue pixels RP, GP and BP and provides the blue light.

For example, referring to FIG. 3, the organic emitting layer 462 of the OLED D includes the blue EML 240 including the first blue emitting layer 250, which is disposed to be closer to the first electrode 160 as an anode, and the second blue emitting layer 260, which is disposed to be closer to the second electrode 164 as a cathode. The first blue emitting layer 250 includes the first host 252 and the first dopant 254, and the second blue emitting layer 260 includes the second host 262 and the second dopant 264. In this case, the first host 252 includes at least one of the first host compounds represented by Formula 1, the second host 262 includes at least one of the second host compounds represented by Formula 5, the first dopant 254 is represented by Formula 3a, and the second dopant is represented by Formula 7.

The color conversion layer 480 includes a first color conversion layer 482 corresponding to the red pixel RP and a second color conversion layer 484 corresponding to the green pixel GP. For example, the color conversion layer 480 may include an inorganic color conversion material such as a quantum dot.

The blue light from the OLED D is converted into the red light by the first color conversion layer 482 in the red pixel RP, and the blue light from the OLED D is converted into the green light by the second color conversion layer 484 in the green pixel GP.

Accordingly, the organic light emitting display device 400 can display a full-color image.

A color filter layer may be disposed between the second substrate 470 and the color conversion layer 480. The color filter layer may include a red color filter and a green color filter respectively corresponding to the red and green pixel regions.

On the other hand, when the light from the OLED D passes through the first substrate 410, the color conversion layer 480 is disposed between the OLED D and the first substrate 410. In this case, the color filter layer may be disposed between the first substrate 410 and the color conversion layer 480.

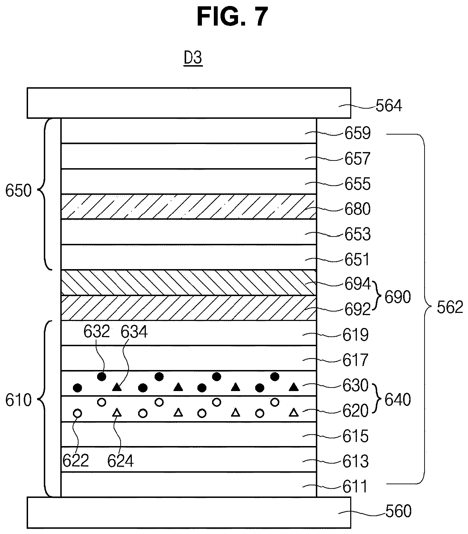

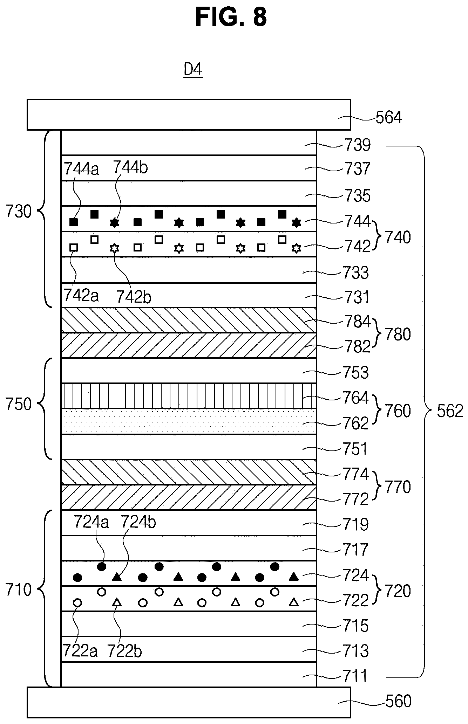

FIG. 6 is a schematic cross-sectional view illustrating an organic light emitting display device according to a fifth embodiment of the present invention. FIG. 7 is a schematic cross-sectional view illustrating an OLED according to a sixth embodiment of the present invention, and FIG. 8 is a schematic cross-sectional view illustrating an OLED according to a seventh embodiment of the present invention.

As illustrated in FIG. 6, the organic light emitting display device 500 includes a first substrate 510, where a red pixel RP, a green pixel GP and a blue pixel BP are defined, a second substrate 570 facing the first substrate 510, an OLED D, which is positioned between the first and second substrates 510 and 570 and providing white emission, and a color filter layer 580 between the OLED D and the second substrate 570.

Each of the first and second substrates 510 and 570 may be a glass substrate or a flexible substrate. For example, each of the first and second substrates 510 and 570 may be a polyimide (PI) substrate, a polyethersulfone (PES) substrate, a polyethylenenaphthalate (PEN) substrate, a polyethylene terephthalate (PET) substrate or a polycarbonate (PC) substrate.

A buffer layer 520 is formed on the substrate, and the TFT Tr corresponding to each of the red, green and blue pixels RP, GP and BP is formed on the buffer layer 520. The buffer layer 520 may be omitted.

A semiconductor layer 522 is formed on the buffer layer 520. The semiconductor layer 522 may include an oxide semiconductor material or polycrystalline silicon.

A gate insulating layer 524 is formed on the semiconductor layer 522. The gate insulating layer 524 may be formed of an inorganic insulating material such as silicon oxide or silicon nitride.

A gate electrode 530, which is formed of a conductive material, e.g., metal, is formed on the gate insulating layer 524 to correspond to a center of the semiconductor layer 522.

An interlayer insulating layer 532, which is formed of an insulating material, is formed on the gate electrode 530. The interlayer insulating layer 532 may be formed of an inorganic insulating material, e.g., silicon oxide or silicon nitride, or an organic insulating material, e.g., benzocyclobutene or photo-acryl.

The interlayer insulating layer 532 includes first and second contact holes 534 and 536 exposing both sides of the semiconductor layer 522. The first and second contact holes 534 and 536 are positioned at both sides of the gate electrode 530 to be spaced apart from the gate electrode 530.

A source electrode 540 and a drain electrode 542, which are formed of a conductive material, e.g., metal, are formed on the interlayer insulating layer 532.

The source electrode 540 and the drain electrode 542 are spaced apart from each other with respect to the gate electrode 530 and respectively contact both sides of the semiconductor layer 522 through the first and second contact holes 534 and 536.

The semiconductor layer 522, the gate electrode 530, the source electrode 540 and the drain electrode 542 constitute the TFT Tr. The TFT Tr serves as a driving element. Namely, the TFT Tr may correspond to the driving TFT Td (of FIG. 1).

Although not shown, the gate line and the data line cross each other to define the pixel, and the switching TFT is formed to be connected to the gate and data lines. The switching TFT is connected to the TFT Tr as the driving element.

In addition, the power line, which may be formed to be parallel to and spaced apart from one of the gate and data lines, and the storage capacitor for maintaining the voltage of the gate electrode of the TFT Tr in one frame may be further formed.

A planarization layer 550, which includes a drain contact hole 552 exposing the drain electrode 542 of the TFT Tr, is formed to cover the TFT Tr.

A first electrode 560, which is connected to the drain electrode 542 of the TFT Tr through the drain contact hole 552, is separately formed in each pixel and on the planarization layer 550. The first electrode 560 may be an anode and may be formed of a conductive material having a relatively high work function. For example, the first electrode 560 may be formed of a transparent conductive material, e.g., ITO or IZO.

A reflective electrode or a reflective layer may be further formed under the first electrode 560 on the planarization layer 550. For example, the reflective electrode or the reflective layer may be formed of aluminum-palladium-copper (APC) alloy.

A bank layer 566 is formed on the planarization layer 550 to cover an edge of the first electrode 560. Namely, the bank layer 566 is positioned at a boundary of the pixel and exposes a center of the first electrode 560 in the pixel.

An organic emitting layer 562 is formed on the first electrode 560.

Referring to FIG. 7, the OLED D3 includes the first electrode 560, the second electrode 564 and the organic emitting layer 562 therebetween, and the organic emitting layer 562 includes a first emitting part 610 including a first EML 640 and a second emitting part 650 including a second EML 680. In addition, the organic emitting layer 562 may further include a charge generation layer (CGL) 690 between the first and second emitting parts 610 and 680.

The OLED D3 is positioned to correspond to all of the red, green and blue pixel regions RP, GP and BP.

The CGL 690 is positioned between the first and second emitting parts 610 and 650, and the first emitting part 610, the CGL 690 and the second emitting part 650 are sequentially stacked on the first electrode 560. Namely, the first emitting part 610 is positioned between the first electrode 560 and the CGL 690, and the second emitting part 650 is positioned between the second electrode 564 and the CGL 690.

The first EML 640 in the first emitting part 610 is a blue EML. The first EML 640 includes a first blue emitting layer 620 being closer to the first electrode 160 and a second blue emitting layer 630 being closer to the second electrode 564 and adjacent to the first blue emitting layer 620. Namely, the second blue emitting layer 630 is disposed between the first blue emitting layer 620 and the second electrode 564 and contacts the first blue emitting layer 620.

The first EML 640 may have a thickness of 100 to 500Å. A summation of a thickness of the first blue emitting layer 620 and a thickness of the second blue emitting layer 630 is equal to a thickness of the first EML 640, and the thickness of the first blue emitting layer 620 and the thickness of the second blue emitting layer 630 may be same or different. Each of the thickness of the first blue emitting layer 620 and the thickness of the second blue emitting layer 630 may be 50 to 250 Å, e.g., 70 to 150 Å.

The first host 622 includes at least one of the first host compounds represented by Formula 1, and the first dopant 624 is represented by Formula 3a. In an aspect of the present invention, the first host 622 may be represented by Formula 1a, and the first dopant 624 may be represented by Formula 3a. For example, the first host 622 may include at least one of the compounds in Formula 2, and the first dopant 624 may include at least one of the compounds in Formula 4.

The first host 622 is a partially or wholly deuterated anthracene derivative. For example, the first host 622 may have a first deuteration ratio of about 1 to 100%, e.g., about 30 to 100%.

The second blue emitting layer 630 includes a second host 632 and a second dopant (e.g., a second emitter) 634. In the second blue emitting layer 630, the second host 632 may have a weight % (wt%) of 80 to 99, preferably 95 to 99, and the second dopant 634 may have a wt% of 1 to 20, preferably 1 to 5.

The second host 632 includes at least one of the first host compounds represented by Formula 5, and the second dopant 634 is represented by Formula 7. In an aspect of the present invention, the second host 632 may be represented by Formula 5a, and the second dopant 634 may be represented by Formula 7a. For example, the second host 632 may include at least one of the compounds in Formula 6, and the second dopant 634 may include at least one of the compounds in Formula 8.

The second host 632 is a non-deuterated or partially deuterated anthracene derivative. Namely, the second host 632 has a second deuteration ratio smaller than the first deuteration ratio of the first host 622. For example, the second deuteration ratio of the second host 632 may be 0 to 99%, e.g., 0 to 75%.

A weight % of the first host 622 in the first blue emitting layer 620 and a weight % of the second host 632 in the second blue emitting layer 630 may be same or different, and a weight % of the first dopant 624 in the first blue emitting layer 620 and a weight % of the second dopant 634 in the second blue emitting layer 630 may be same or different.

The first dopant 624 included in the first blue emitting layer 620, which is disposed to be closer to the first electrode 160 as an anode for injecting a hole, has a relatively high HOMO energy level, i.e., a shallow HOMO system, and the second dopant 634 included in the second blue emitting layer 630, which is disposed to be closer to the second electrode 164 as a cathode for injecting an electron, has a relatively low HOMO energy level, i.e., a deep HOMO system. Namely, the first dopant 624 may have a first HOMO energy level, and the second dopant 634 may have a second HOMO energy level lower than the first HOMO energy level. A difference between the first HOMO energy level and the second HOMO energy level may be 0.5eV or less.

In addition, the first dopant 624 has a relatively high LUMO energy level, i.e., a shallow LUMO system, and the second dopant 634 has a relatively low LUMO energy level, i.e., a deep LUMO system. Namely, the first dopant 624 has a first LUMO energy level, and the second dopant 634 has a second LUMO energy level lower than the first LUMO energy level.

For example, the first HOMO energy level of the first dopant 624 may be in a range of -5.3 to -5.1eV, and the second HOMO energy level of the second dopant 634 may be in a range of -5.5 to -5.3eV. The first LUMO energy level of the first dopant 624 may be in a range of -2.6 to -2.3eV, and the second LUMO energy level of the second dopant 634 may be in a range of -2.7 to -2.5eV.

The HOMO energy level of the first dopant 624 may be higher than that of the first host 622, and the LUMO energy level of the first dopant 624 may be higher than that of the first host 622. The HOMO energy level of the second dopant 634 may be higher than that of the second host 632, and the LUMO energy level of the second dopant 634 may be higher than that of the second host 632.

The HOMO energy level of the first host 622 and the HOMO energy level of the second host 632 may be same or different, and the LUMO energy level of the first host 622 and the LUMO energy level of the second host 632 may be same or different. Each of the HOMO energy level of the first host 622 and the HOMO energy level of the second host 632 may be in a range of -6.0 to -5.8eV, and each of the LUMO energy level of the first host 622 and the LUMO energy level of the second host 632 may be in a range of -3.1 to -2.9eV.

The first dopant 624 included in the first blue emitting layer 620, which is disposed to be closer to the first electrode 160 as an anode for injecting a hole, has a relatively small triplet energy, and the second dopant 634 included in the second blue emitting layer 630, which is disposed to be closer to the second electrode 164 as a cathode for injecting an electron, has a relatively large triplet energy level. Namely, the first dopant 624 has a first triplet energy, and the second dopant 634 has a second triplet energy greater than the first triplet energy.

For example, the first triplet energy of the first dopant 624 may be 2.5eV or less, e.g., in a range of 2.3 to 2.5eV, and the second triplet energy of the second dopant 634 may be in a range of 2.5 to 2.7eV.

The triplet energy of the first dopant 624 may be greater than that of the first host 622, and the triplet energy of the second dopant 634 may be greater than that of the second host 632. The triplet energy of the first host 622 and the triplet energy of the second host 632 may be same or different. The triplet energy of the first host 622 and the triplet energy of the second host 632 may be in a range of 1.6 to 2.0eV.

Namely, in the first blue EML 640, the first host 622 in the first blue emitting layer 620 and the second host 632 in the second blue emitting layer 630 have the same chemical structure and different deuteration ratios, and the first dopant 624 in the first bule emitting layer 620 and the second dopant 634 in the second blue emitting layer 630 have different chemical structures and different electro-optic property, e.g., a HOMO energy level, a LUMO energy level or a triplet energy.

The first emitting part 610 may further include at least one of a first HTL 613 disposed under the first EML 640 and a first ETL 619 disposed over the first EML 640. Namely, the first HTL 613 may be disposed between the first EML 640 and the first electrode 560, and the first ETL 619 may be disposed between the first EML 640 and the second electrode 564.

The first emitting part 610 may further include an HIL 611 between the first HTL 613 and the first electrode 560

The first emitting part 610 may further include at least one of a first EBL 615 between the first EML 640 and the first HTL 613 and a first HBL 617 between the first EML 340 and the first ETL 619.

For example, the first emitting part 610 may have a structure of the HIL 611, the first HTL 613, the first EBL 615, the first bule emitting layer 620, the second blue emitting layer 630, the first HBL 617 and the first ETL 619 sequentially stacked on the first electrode 560. Alternatively, the first HBL 617 may be omitted so that the first ETL 619 may contact the second blue emitting layer 630.

The second EML 680 in the second emitting part 650 may be a yellow-green EML. The second EML 680 may include a yellow-green host and a yellow-green dopant. For example, the yellow-green dopant may be one of a fluorescent compound, a phosphorescent compound and a delayed fluorescent compound.

In the second EML 680, the yellow-green host may have a weight % of about 70 to 99.9, and the yellow-green dopant may have a weight % of about 0.1 to 10, preferably about 1 to 5.

For example, the yellow-green host may be selected from the group consisting of mCP-CN, CBP, mCBP, mCP, DPEPO, 2,8-bis(diphenylphosphoryl)dibenzothiophene (PPT), TmPyPB, PYD-2Cz, 2,8-di(9H-carbazol-9-yl)dibenzothiophene (DCzDBT), 3',5'-di(carbazol-9-yl)-[1,1'-bipheyl]-3,5-dicarbonitrile (DCzTPA), 4'-(9H-carbazol-9-yl)biphenyl-3,5-dicarbonitrile(4'-(9H-carbazol-9-yl)biphenyl-3,5-dicarbonitrile (pCzB-2CN), 3'-(9H-carbazol-9-yl)biphenyl-3,5-dicarbonitrile (mCzB-2CN), TSPO1, and 9-(9-phenyl-9H-carbazol-6-yl)-9H-carbazole (CCP), but it is not limited thereto.

For example, the yellow-green dopant may be selected from the group consisting of 5,6,11,12-tetraphenylnaphthalene (Rubrene), 2,8-di-tert-butyl-5,11-bis(4-tert-butylphenyl)-6,12-diphenyltetracene (TBRb), bis(2-phenylbenzothiazolato)(acetylacetonate)irdium(III) (Ir(BT)2(acac)), bis(2-(9,9-diethytl-fluoren-2-yl)-1-phenyl-1H-benzo[d]imdiazolato)(acetylacetonate)iridium(III) (Ir(fbi)2(acac)), bis(2-phenylpyridine)(3-(pyridine-2-yl)-2H-chromen-2-onate)iridium(III) (fac-Ir(ppy)2Pc), bis(2-(2,4-difluorophenyl)quinoline)(picolinate)iridium(III) (FPQIrpic), and bis(4-phenylthieno[3,2-c]pyridinato-N,C2') (acetylacetonate) iridium(III) (PO-01), but it is not limited thereto.

The second emitting part 650 may further include at least one of a second HTL 651 disposed under the second EML 680 and a second ETL 657 disposed over the second EML 680. Namely, the second HTL 651 is positioned between the second EML 680 and the first emitting part 610, and the second ETL 657 is positioned between the second EML 680 and the second electrode 564.

The second emitting part 650 may further include an EIL 659 between the second ETL 657 and the second electrode 564.

The second emitting part 650 may further include a second EBL 653 between the second blue EML 680 and the second HTL 651 and a second HBL 655 between the second EML 680 and the second ETL 657.

The HIL 611 may include the above-mentioned hole injection material and may have a thickness of 10 to 100Å.

Each of the first and second HTLs 613 and 651 may include the above-mentioned hole transporting material and may have a thickness of 500 to 1500Å, preferably 700 to 1300Å.

Each of the first and second ETLs 619 and 657 may include the above-mentioned electron transporting material and may have a thickness of 100 to 500Å, preferably 200 to 400Å.

The EIL 659 may include the above-mentioned electron injection material and may have a thickness of 50 to 400Å, preferably 100 to 300Å.

Each of the first and second EBLs 615 and 653 may include the above-mentioned electron blocking material and may have a thickness of 10 to 300Å.

Each of the first and second HBLs 617 and 655 may include the above-mentioned hole blocking material and may have a thickness of 100 to 500Å, preferably 200 to 400Å.

A HOMO energy level of the electron blocking material, e.g., a compound in Formula 9, in the first ETL 615 may be lower than each of a HOMO energy level of the first dopant 624 and a HOMO energy level of the second dopant 634.

A HOMO energy level and a LUMO energy of the electron blocking material, e.g., a compound in Formula 9, in the first ETL 615 may be higher than a HOMO energy level and a LUMO energy of the first host 622, respectively.

The HOMO energy level of the electron blocking material, i.e., the compound in Formula 9, in the first ETL 615 may be in a range of -5.8 to -5.6eV, and a LUMO energy level of the electron blocking material, i.e., the compound in Formula 9, in the first ETL 615 may be in a range of -2.6 to -2.3eV.

The CGL 690 is positioned between the first and second emitting parts 610 and 650. Namely, the first and second emitting parts 610 and 650 are connected through the CGL 690. The CGL 390 may be a P-N junction CGL of an N-type CGL 692 and a P-type CGL 694.

The N-type CGL 692 is positioned between the first HBL 617 and the second HTL 651, and the P-type CGL 694 is positioned between the N-type CGL 692 and the second HTL 651.

The N-type CGL 692 may include the above-mentioned N-type charge generation material, and the P-type CGL 694 may include the above-mentioned P-type charge generation material.

In FIG. 7, the first EML 640 between the first electrode 560 and the CGL 690 is the blue EML including the first and second blue emitting layers 620 and 630, while the second EML 680 between the second electrode 564 and the CGL 690 is the yellow-green EML.

Alternatively, the first EML 640 between the first electrode 560 and the CGL 690 may be the yellow-green EML, while the second EML 680 between the second electrode 564 and the CGL 690 may be the blue EML including the first and second blue emitting layers 620 and 630.

In the OLED D3 of the present invention, the first EML 640 includes the first blue emitting material layer 620, which includes the first host 622 and the first dopant 624 and is disposed to be closer to the first electrode 560 as an anode, and the second blue emitting material layer 630, which includes the second host 632 and the second dopant 634 and is disposed to be closer to the second electrode 564 as a cathode. In this case, the first host 622 includes at least one of the first host compounds represented by Formula 1, and the second host 632 includes at least one of the second host compounds represented by Formula 5, the first dopant 624 is represented by Formula 3a, and the second dopant 634 is represented by Formula 7.

Accordingly, the OLED D3 and the organic light emitting display device 500 may have an advantage in at least one of the emitting efficiency, the color purity and the lifespan.

In the OLED D3 of the present invention, the first EML 640 includes the first blue emitting material layer 620, which includes the first host 622 and the first dopant 624 and is disposed to be closer to the first electrode 560 as an anode, and the second blue emitting material layer 630, which includes the second host 632 and the second dopant 634 and is disposed to be closer to the second electrode 564 as a cathode. In this case, a deuteration ratio of the second host 632 in the second blue emitting layer 630, which is closer to the second electrode 564 as a cathode, is smaller than that of the first host 622 in the first blue emitting layer 620, which is closer to the first electrode 560 as an anode, a HOMO energy level of the second dopant 634 in the second blue emitting layer 630, which is closer to the second electrode 564 as a cathode, is lower than that of the first dopant 624 in the first blue emitting layer 620, which is closer to the first electrode 560 as an anode, and a triplet energy of the second dopant 634 is greater than that of the first dopant 624.

Accordingly, the OLED D3 and the organic light emitting display device 100 may have an advantage in at least one of the emitting efficiency, the color purity and the lifespan.

In addition, the OLED D3 including the first emitting part 610, which emits a blue light, and the second emitting part 650, which emits a yellow-green light, can provide a white light.

Referring to FIG. 8, the OLED D4 includes the first electrode 560, the second electrode 564 and the organic emitting layer 562 therebetween, and the organic emitting layer 562 includes a first emitting part 710 including a first EML 720, a second emitting part 730 including a second EML 740 and a third emitting part 750 including a third EML 760. In addition, the organic emitting layer 562 may further include a first CGL 770 between the first and third emitting parts 710 and 750 and a second CGL 780 between the second and third emitting parts 730 and 750.

The OLED D4 is positioned to correspond to all of the red, green and blue pixel regions RP, GP and BP.

The first CGL 770 is positioned between the first and third emitting parts 710 and 750, and the second CGL 780 is positioned between the second and third emitting parts 730 and 750. Namely, the first emitting part 710, the first CGL 770, the third emitting part 750, the second CGL 780 and the second emitting part 730 may be sequentially stacked on the first electrode 560. In other words, the first emitting part 710 may be positioned between the first electrode 560 and the first CGL 770, the third emitting part 750 may be positioned between the first and second CGLs 770 and 780, and the second emitting part 730 may be positioned between the second CGL 780 and the second electrode 564.

The first EML 720 in the first emitting part 710 is a blue EML. The first EML 720 includes a first blue emitting layer 722 being closer to the first electrode 560 and a second blue emitting layer 724 being closer to the second electrode 564 and adjacent to the first blue emitting layer 722. Namely, the second blue emitting layer 724 is disposed between the first blue emitting layer 722 and the second electrode 564 and contacts the first blue emitting layer 722.

The first EML 720 may have a thickness of 100 to 500Å. A summation of a thickness of the first blue emitting layer 722 and a thickness of the second blue emitting layer 724 is equal to a thickness of the first EML 720, and the thickness of the first blue emitting layer 722 and the thickness of the second blue emitting layer 724 may be same or different. Each of the thickness of the first blue emitting layer 722 and the thickness of the second blue emitting layer 724 may be 50 to 250 Å, e.g., 70 to 150 Å.

In an aspect of the present invention, the thickness of the first blue emitting layer 722 may be smaller than that of the second blue emitting layer 724. For example, the first blue emitting layer 722 may have a thickness of 20 to 100 Å, and the second blue emitting layer 724 may have a thickness of 150 to 250 Å.

The first blue emitting layer 720 includes a first host 722a and a first dopant (e.g., a first emitter) 722b. In the first blue emitting layer 720, the first host 722a may have a weight % (wt%) of 80 to 99, preferably 95 to 99, and the first dopant 722b may have a wt% of 1 to 20, preferably 1 to 5.

The second blue emitting layer 724 includes a second host 724a and a second dopant (e.g., a second emitter) 724b. In the second blue emitting layer 724, the second host 724a may have a weight % (wt%) of 80 to 99, preferably 95 to 99, and the second dopant 724b may have a wt% of 1 to 20, preferably 1 to 5.

The first host 722aa includes at least one of the first host compounds represented by Formula 1, and the first dopant 722b is represented by Formula 3a. In an aspect of the present invention, the first host 722a may be represented by Formula 1a, and the first dopant 722b may be represented by Formula 3a. For example, the first host 722a may include at least one of the compounds in Formula 2, and the first dopant 722b may include at least one of the compounds in Formula 4.

The first host 722a is a partially or wholly deuterated anthracene derivative. For example, the first host 722a may have a first deuteration ratio of about 1 to 100%, e.g., about 30 to 100%.

The second blue emitting layer 724 includes a second host 724a and a second dopant (e.g., a second emitter) 724b. In the second blue emitting layer 724, the second host 724a may have a weight % (wt%) of 80 to 99, preferably 95 to 99, and the second dopant 724b may have a wt% of 1 to 20, preferably 1 to 5.

The second host 724a includes at least one of the first host compounds represented by Formula 5, and the second dopant 724b is represented by Formula 7. In an aspect of the present invention, the second host 724a may be represented by Formula 5a, and the second dopant 724b may be represented by Formula 7a. For example, the second host 724a may include at least one of the compounds in Formula 6, and the second dopant 724b may include at least one of the compounds in Formula 8.

The second host 724a is a non-deuterated or partially deuterated anthracene derivative. Namely, the second host 724a has a second deuteration ratio smaller than the first deuteration ratio of the first host 722a. For example, the second deuteration ratio of the second host 724a may be 0 to 99%, e.g., 0 to 75%.

A weight % of the first host 722a in the first blue emitting layer 720 and a weight % of the second host 724a in the second blue emitting layer 724 may be same or different, and a weight % of the first dopant 722b in the first blue emitting layer 720 and a weight % of the second dopant 724b in the second blue emitting layer 724 may be same or different.

The first dopant 722b included in the first blue emitting layer 720, which is disposed to be closer to the first electrode 560 as an anode for injecting a hole, has a relatively high HOMO energy level, i.e., a shallow HOMO system, and the second dopant 724b included in the second blue emitting layer 724, which is disposed to be closer to the second electrode 564 as a cathode for injecting an electron, has a relatively low HOMO energy level, i.e., a deep HOMO system. Namely, the first dopant 722b may have a first HOMO energy level, and the second dopant 724b may have a second HOMO energy level lower than the first HOMO energy level. A difference between the first HOMO energy level and the second HOMO energy level may be 0.5eV or less.

In addition, the first dopant 722b has a relatively high LUMO energy level, i.e., a shallow LUMO system, and the second dopant 724b has a relatively low LUMO energy level, i.e., a deep LUMO system. Namely, the first dopant 722b has a first LUMO energy level, and the second dopant 724b has a second LUMO energy level lower than the first LUMO energy level.

For example, the first HOMO energy level of the first dopant 722b may be in a range of -5.3 to -5.1eV, and the second HOMO energy level of the second dopant 724b may be in a range of -5.5 to -5.3eV. The first LUMO energy level of the first dopant 722b may be in a range of -2.6 to -2.3eV, and the second LUMO energy level of the second dopant 724b may be in a range of -2.7 to -2.5eV.

The HOMO energy level of the first dopant 722b may be higher than that of the first host 722a, and the LUMO energy level of the first dopant 722b may be higher than that of the first host 722a. The HOMO energy level of the second dopant 724b may be higher than that of the second host 724a, and the LUMO energy level of the second dopant 724b may be higher than that of the second host 724a.

The HOMO energy level of the first host 722a and the HOMO energy level of the second host 724a may be same or different, and the LUMO energy level of the first host 722a and the LUMO energy level of the second host 724a may be same or different. Each of the HOMO energy level of the first host 722a and the HOMO energy level of the second host 724a may be in a range of -6.0 to -5.8eV, and each of the LUMO energy level of the first host 722a and the LUMO energy level of the second host 724a may be in a range of -3.1 to -2.9eV.

The first dopant 722b included in the first blue emitting layer 720, which is disposed to be closer to the first electrode 560 as an anode for injecting a hole, has a relatively small triplet energy, and the second dopant 724b included in the second blue emitting layer 724, which is disposed to be closer to the second electrode 564 as a cathode for injecting an electron, has a relatively large triplet energy level. Namely, the first dopant 722b has a first triplet energy, and the second dopant 724b has a second triplet energy greater than the first triplet energy.

For example, the first triplet energy of the first dopant 722b may be 2.5eV or less, e.g., in a range of 2.3 to 2.5eV, and the second triplet energy of the second dopant 724b may be in a range of 2.5 to 2.7eV.

The triplet energy of the first dopant 722b may be greater than that of the first host 722a, and the triplet energy of the second dopant 724b may be greater than that of the second host 724a. The triplet energy of the first host 722a and the triplet energy of the second host 724a may be same or different. The triplet energy of the first host 722a and the triplet energy of the second host 724a may be in a range of 1.6 to 2.0eV.

Namely, in the first blue EML 720, the first host 722a in the first blue emitting layer 720 and the second host 724a in the second blue emitting layer 724 have the same chemical structure and different deuteration ratios, and the first dopant 722b in the first bule emitting layer 720 and the second dopant 724b in the second blue emitting layer 724 have different chemical structures and different electro-optic property, e.g., a HOMO energy level, a LUMO energy level or a triplet energy.

The first emitting part 710 may further include at least one of a first HTL 713 disposed under the first EML 720 and a first ETL 719 disposed over the first EML 720. Namely, the first HTL 713 may be disposed between the first EML 720 and the first electrode 560, and the first ETL 719 may be disposed between the first EML 720 and the second electrode 564.

The first emitting part 710 may further include an HIL 711 between the first HTL 713 and the first electrode 560

The first emitting part 710 may further include at least one of a first EBL 715 between the first EML 720 and the first HTL 713 and a first HBL 717 between the first EML 720 and the first ETL 719.

For example, the first emitting part 710 may have a structure of the HIL 711, the first HTL 713, the first EBL 715, the first bule emitting layer 722, the second blue emitting layer 724, the first HBL 717 and the first ETL 719 sequentially stacked on the first electrode 560. Alternatively, the first HBL 717 may be omitted so that the first ETL 719 may contact the second blue emitting layer 730.

The second EML 740 in the second emitting part 730 is a blue EML. The second EML 740 includes a third blue emitting layer 742, which is disposed to be closer to the first electrode 560, and a fourth blue emitting layer 744, which is disposed to be closer to the second electrode 564 and is adjacent to the third blue emitting layer 742. Namely, the fourth blue emitting layer 744 is positioned between the third blue emitting layer 742 and the second electrode 564 and contacts the third blue emitting layer 742.

The second EML 740 may have a thickness of 100 to 500Å. A summation of a thickness of the third blue emitting layer 742 and a thickness of the fourth blue emitting layer 744 is equal to a thickness of the second EML 740, and the thickness of the third blue emitting layer 742 and the thickness of the fourth blue emitting layer 744 may be same or different. Each of the thickness of the third blue emitting layer 742 and the thickness of the fourth blue emitting layer 744 may be 50 to 250 Å, e.g., 70 to 150 Å.

The third blue emitting layer 742 includes a third host 742a and a third dopant (e.g., a third emitter) 742b. In the third blue emitting layer 742, the third host 742a may have a weight % (wt%) of 80 to 99, preferably 95 to 99, and the third dopant 742b may have a wt% of 1 to 20, preferably 1 to 5.

The third host 742a includes at least one of the first host compounds represented by Formula 1, and the third dopant 742b is represented by Formula 3. In an aspect of the present invention, the third host 742a may be represented by Formula 1a, and the third dopant 742b may be represented by Formula 3a. For example, the third host 742a may include at least one of the compounds in Formula 2, and the third dopant 742b may include at least one of the compounds in Formula 4.

The third host 742a and the first host 722a may be same or different, and the third dopant 742b and the first dopant 722b may be same or different.

The third host 742a is a partially or wholly deuterated anthracene derivative. For example, the third host 742a may have a third deuteration ratio of about 1 to 100%, e.g., about 30 to 100%.

The fourth blue emitting layer 744 includes a fourth host 744a and a fourth dopant (e.g., a fourth emitter) 744b. In the fourth blue emitting layer 744, the fourth host 744a may have a weight % (wt%) of 80 to 99, preferably 95 to 99, and the fourth dopant 744b may have a wt% of 1 to 20, preferably 1 to 5.

The fourth host 744a includes at least one of the first host compounds represented by Formula 5, and the fourth dopant 744b is represented by Formula 7. In an aspect of the present invention, the fourth host 744a may be represented by Formula 5a, and the fourth dopant 744b may be represented by Formula 7a. For example, the fourth host 744a may include at least one of the compounds in Formula 6, and the fourth dopant 744b may include at least one of the compounds in Formula 8.

The fourth host 744a and the second host 724a may be same or different, and the fourth dopant 744b and the second dopant 724b may be same or different.

The fourth host 744a is a non-deuterated or partially deuterated anthracene derivative. Namely, the fourth host 744a has a fourth deuteration ratio smaller than the third deuteration ratio of the third host 742a. For example, the fourth deuteration ratio of the fourth host 744a may be 0 to 99%, e.g., 0 to 75%.

A weight % of the third host 742a in the third blue emitting layer 742 and a weight % of the fourth host 744a in the fourth blue emitting layer 744 may be same or different, and a weight % of the third dopant 742b in the third blue emitting layer 742 and a weight % of the fourth dopant 744b in the fourth blue emitting layer 744 may be same or different.

The third dopant 742b included in the third blue emitting layer 742, which is disposed to be closer to the first electrode 560 as an anode for injecting a hole, has a relatively high HOMO energy level, i.e., a shallow HOMO system, and the fourth dopant 744b included in the fourth blue emitting layer 744, which is disposed to be closer to the second electrode 564 as a cathode for injecting an electron, has a relatively low HOMO energy level, i.e., a deep HOMO system. Namely, the third dopant 742b may have a third HOMO energy level, and the fourth dopant 744b may have a fourth HOMO energy level lower than the third HOMO energy level. A difference between the third HOMO energy level and the fourth HOMO energy level may be 0.5eV or less.

In addition, the third dopant 742b has a relatively high LUMO energy level, i.e., a shallow LUMO system, and the fourth dopant 744b has a relatively low LUMO energy level, i.e., a deep LUMO system. Namely, the third dopant 742b has a third LUMO energy level, and the fourth dopant 744b has a fourth LUMO energy level lower than the third LUMO energy level.

For example, the third HOMO energy level of the third dopant 742b may be in a range of -5.3 to -5.1eV, and the fourth HOMO energy level of the fourth dopant 744b may be in a range of -5.5 to -5.3eV. The third LUMO energy level of the third dopant 742b may be in a range of -2.6 to -2.3eV, and the fourth LUMO energy level of the fourth dopant 744b may be in a range of -2.7 to -2.5eV.

The HOMO energy level of the third dopant 742b may be higher than that of the third host 742a, and the LUMO energy level of the third dopant 742b may be higher than that of the third host 742a. The HOMO energy level of the fourth dopant 744b may be higher than that of the fourth host 744a, and the LUMO energy level of the fourth dopant 744b may be higher than that of the fourth host 744a.

The HOMO energy level of the third host 742a and the HOMO energy level of the fourth host 744a may be same or different, and the LUMO energy level of the third host 742a and the LUMO energy level of the fourth host 744a may be same or different. Each of the HOMO energy level of the third host 742a and the HOMO energy level of the fourth host 744a may be in a range of -6.0 to -5.8eV, and each of the LUMO energy level of the third host 742a and the LUMO energy level of the fourth host 744a may be in a range of -3.1 to -2.9eV.

The third dopant 742b included in the third blue emitting layer 742, which is disposed to be closer to the first electrode 560 as an anode for injecting a hole, has a relatively small triplet energy, and the fourth dopant 744b included in the fourth blue emitting layer 744, which is disposed to be closer to the second electrode 564 as a cathode for injecting an electron, has a relatively large triplet energy level. Namely, the third dopant 742b has a third triplet energy, and the fourth dopant 744b has a fourth triplet energy greater than the third triplet energy.

For example, the third triplet energy of the third dopant 742b may be 2.5eV or less, e.g., in a range of 2.3 to 2.5eV, and the fourth triplet energy of the fourth dopant 744b may be in a range of 2.5 to 2.7eV.

The triplet energy of the third dopant 742b may be greater than that of the third host 742a, and the triplet energy of the fourth dopant 744b may be greater than that of the fourth host 744a. The triplet energy of the third host 742a and the triplet energy of the fourth host 744a may be same or different. The triplet energy of the third host 742a and the triplet energy of the fourth host 744a may be in a range of 1.6 to 2.0eV.

Namely, in the second blue EML 740, the third host 742a in the third blue emitting layer 742 and the fourth host 744a in the fourth blue emitting layer 744 have the same chemical structure and different deuteration ratios, and the third dopant 742b in the third bule emitting layer 742 and the fourth dopant 744b in the fourth blue emitting layer 744 have different chemical structures and different electro-optic property, e.g., a HOMO energy level, a LUMO energy level or a triplet energy.

The second emitting part 730 may further include at least one of a second HTL 731 disposed under the second EML 740 and a second ETL 737 disposed over the second EML 740. Namely, the second HTL 731 is positioned between the second EML 740 and the first emitting part 710, and the second ETL 737 is positioned between the second EML 740 and the second electrode 564.

The second emitting part 730 may further include an EIL 739 between the second ETL 737 and the second electrode 564.

The second emitting part 730 may further include a second EBL 733 between the second EML 740 and the second HTL 731 and a second HBL 735 between the second EML 740 and the second ETL 737.

For example, the second emitting part 730 may have a structure of the second HTL 731, the second EBL 733, the third emitting layer 742, the fourth emitting layer 744, the second HBL 735, the second ETL 737 and the EIL 739. Alternatively, the second HBL 735 may be omitted so that the second ETL 737 may contact the fourth blue emitting layer 744.

The third EML 760 in the third emitting part 750 includes a red emitting layer 762 and a green emitting layer 764 to provide red and green light.

The red emitting layer 762 may include a red host and a red dopant. For example, the red dopant may be one of a fluorescent compound, a phosphorescent compound and a delayed fluorescent compound.

The red host may be selected from the group consisting of mCP-CN, CBP, mCBP, mCP, DPEPO, 2,8-bis(diphenylphosphoryl)dibenzothiophene (PPT), 1,3,5-tri[(3-pyridyl)-phen-3-yl]benzene (TmPyPB), 2,6-di(9H-carbazol-9-yl)pyridine (PYD-2Cz), 2,8-di(9H-carbazol-9-yl)dibenzothiophene (DCzDBT), 3',5'-di(carbazol-9-yl)-[1,1'-bipheyl]-3,5-dicarbonitrile (DCzTPA), 4'-(9H-carbazol-9-yl)biphenyl-3,5-dicarbonitrile(4'-(9H-carbazol-9-yl)biphenyl-3,5-dicarbonitrile (pCzB-2CN), 3'-(9H-carbazol-9-yl)biphenyl-3,5-dicarbonitrile (mCzB-2CN), TSPO1, 9-(9-phenyl-9H-carbazol-6-yl)-9H-carbazole (CCP), 4-(3-(triphenylen-2-yl)phenyl)dibenzo[b,d]thiophene, 9-(4-(9H-carbazol-9-yl)phenyl)-9H-3,9'-bicarbazole, 9-(3-(9H-carbazol-9-yl)phenyl)-9H-3,9'-bicarbazole, 9-(6-(9H-carbazol-9-yl)pyridin-3-yl)-9H-3,9'-bicabazole, 9,9'-diphenyl-9H,9'H-3,3'-bicarbazole (BCzPh), 1,3,5-tris(carbazole-9-yl)benzene (TCP), TCTA, 4,4'-bis(carbazole-9-yl)-2,2'-dimethylbipheyl (CDBP), 2,7-bis(carbazole-9-yl)-9,9-dimethylfluorene (DMFL-CBP), 2,2',7,7'-tetrakis(carbazole-9-yl)-9,9-spiorofluorene (Spiro-CBP), and 3,6-bis(carbazole-9-yl)-9-(2-ethyl-hexyl)-9H-carbazole; TCz1), but it is not limited thereto.

The red dopant may be selected from the group consisting of[bis(2-(4,6-dimethyl)phenylquinoline)](2,2,6,6-tetramethylheptane-3,5-dionate)iridium(III), bis[2-(4-n-hexylphenyl)quinoline](acetylacetonate)iridium(III) (Hex-Ir(phq)2(acac)), tris[2-(4-n-hexylphenyl)quinoline]iridium(III) (Hex-Ir(phq)3), tris[2-phenyl-4-methylquinoline]iridium(III) (Ir(Mphq)3), bis(2-phenylquinoline)(2,2,6,6-tetramethylheptene-3,5-dionate)iridium(III) (Ir(dpm)PQ2), bis(phenylisoquinoline)(2,2,6,6-tetramethylheptene-3,5-dionate)iridium(III) (Ir(dpm)(piq)2), bis[(4-n-hexylphenyl)isoquinoline](acetylacetonate)iridium(III) (Hex-Ir(piq)2(acac)), tris[2-(4-n-hexylphenyl)quinoline]iridium(III) (Hex-Ir(piq)3), tris(2-(3-methylphenyl)-7-methyl-quinolato)iridium (Ir(dmpq)3), bis[2-(2-methylphenyl)-7-methylquinoline](acetylacetonate)iridium(III) (Ir(dmpq)2(acac)), bis[2-(3,5-dimethylphenyl)-4-methyl-quinoline](acetylacetonate)iridium(III) (Ir(mphmq)2(acac)), and tris(dibenzoylmethane)mono(1,10-phenanthroline)europium(III) (Eu(dbm)3(phen)), but it is not limited thereto.

The green emitting layer 764 may include a green host and a green dopant. For example, the green dopant may be one of a fluorescent compound, a phosphorescent compound and a delayed fluorescent compound.

The green host may be one of the materials for the yellow-green host.

The green dopant may be selected from the group consisting of bis(2-phenylpyridine)](pyridyl-2-benzofuro[2,3-b]pyridine)iridium), tris[2-phenylpyridine]iridium(III) (Ir(ppy)3), fac-tris(2-phenylpyridine)iridium(III) (fac-Ir(ppy)3), bis(2-phenylpyridine)(acetylacetonate)iridium(III) (Ir(ppy)2(acac)), tris[2-(p-tolyl)pyridine]iridium(III) (Ir(mppy)3), bis(2-(naphthalene-2-yl)pyridine)(acetylacetonate)iridium(III) (Ir(npy)2acac), tris(2-phenyl-3-methylpyridine)iidium (Ir(3mppy)3), and fac-tris(2-(3-p-xylyl)phenyl)pyridine iridium(III) (TEG), but it is not limited thereto.

In an aspect, the third EML 760 in the third emitting part 750 may further include a yellow-green emitting layer to have a triple-layered structure. The yellow-green emitting layer may include the above-mentioned yellow-green host and the above-mentioned yellow-green dopant. In another aspect, the yellow-green EML may be included instead of the third emitting part 760.

The third emitting part 750 may further include at least one of a third HTL 751 under the third EML 760 and a third ETL 753 on the third EML 760.

In addition, the third emitting part 750 may further include at least one of a third EBL between the third HTL 751 and the third EML 760 and a third HBL between the third EML 760 and the third ETL 753.

The HIL 711 may include the above-mentioned hole injection material and may have a thickness of 10 to 100Å.

Each of the first to third HTLs 713, 731 and 751 may include the above-mentioned hole transporting material and may have a thickness of 500 to 1500Å, preferably 700 to 1300Å.

Each of the first to third ETLs 719, 737 and 753 may include the above-mentioned electron transporting material and may have a thickness of 100 to 500Å, preferably 200 to 400Å.

The EIL 739 may include the above-mentioned electron injection material and may have a thickness of 50 to 400Å, preferably 100 to 300Å.

Each of the first EBL 715, the second EBL 733 and the third EBL may include the above-mentioned electron blocking material and may have a thickness of 10 to 300Å.

Each of the first HBL 717, the second HBL 735 and the third HBL may include the above-mentioned hole blocking material and may have a thickness of 100 to 500Å, preferably 200 to 400Å.

A HOMO energy level of the electron blocking material, e.g., a compound in Formula 9, in the first ETL 715 may be lower than each of a HOMO energy level of the first dopant 724b and a HOMO energy level of the second dopant 744b. A HOMO energy level of the electron blocking material, e.g., a compound in Formula 9, in the second ETL 733 may be lower than each of a HOMO energy level of the third dopant 742b and a HOMO energy level of the fourth dopant 744b.

A HOMO energy level and a LUMO energy of the electron blocking material, e.g., a compound in Formula 9, in the first ETL 715 may be higher than a HOMO energy level and a LUMO energy of the first host 722a, respectively. A HOMO energy level and a LUMO energy of the electron blocking material, e.g., a compound in Formula 9, in the second ETL 73 may be higher than a HOMO energy level and a LUMO energy of the third host 742a, respectively.

The HOMO energy level of the electron blocking material, i.e., the compound in Formula 9, in each of the first and second EBLs 715 and 733 may be in a range of -5.8 to - 5.6eV, and a LUMO energy level of the electron blocking material, i.e., the compound in Formula 9, in each of the first and second EBLs 715 and 733 may be in a range of -2.6 to - 2.3eV.

The first CGL 770 is positioned between the first and third emitting parts 710 and 750, and the second CGL 780 is positioned between the second and third emitting parts 730 and 750. Namely, the first and third emitting parts 710 and 750 may be connected to each other through the first CGL 770, and the second and third emitting parts 730 and 750 may be connected to each other through the second CGL 780. The first CGL 770 may be a P-N junction CGL of a first N-type CGL 772 and a first P-type CGL 774, and the second CGL 780 may be a P-N junction CGL of a second N-type CGL 782 and a second P-type CGL 784.

In the first CGL 770, the first N-type CGL 772 is positioned between the first ETL 719 and the third HTL 751, and the first P-type CGL 774 is positioned between the first N-type CGL 772 and the third HTL 751.

In the second CGL 780, the second N-type CGL 782 is positioned between the third ETL 753 and the second HTL 731, and the second P-type CGL 784 is positioned between the second N-type CGL 782 and the second HTL 731.

Each of the first and second N-type CGLs 772 and 782 may include the above-mentioned N-type charge generation material, and each of the first and second P-type CGLs 774 and 784 may include the above-mentioned P-type charge generation material.

In FIG. 8, the first EML 720 has a double-layered structure including the first and second blue emitting layers 722 and 724, and the second EML 740 has a double-layered structure including the third and fourth blue emitting layers 742 and 744.

Alternatively, one of the first and second EMLs 720 and 740 may have a double-layered structure, while the other one of the first and second EMLs 720 and 740 may have a single-layered structure. In this instance, the other one of the first and second EMLs 720 and 740 may include a blue host and a blue dopant. The blue host may be the above-mentioned blue host material, and the blue dopant may be the above-mentioned blue dopant material.

The OLED D4 of the present invention includes the first emitting part 710 including the first EML 720 (e.g., a first blue EML), the second emitting part 730 including the second EML 740 (e.g., a second blue EML) and the third emitting part 750 including the third EML 760, which includes the red and green emitting layers 762 and 764, and at least one of the first and second blue EMLs 720 and 740 includes a first blue emitting layer including a first host and a first dopant and a second blue emitting layer including a second host and a second dopant. In this case, the first host includes at least one of the first host compounds represented by Formula 1, the second host includes at least one of the second host compounds represented by Formula 5, the first dopant is represented by Formula 3a, and the second dopant is represented by Formula 7.

Accordingly, the OLED D4 and the organic light emitting display device 500 may have an advantage in at least one of the emitting efficiency, the color purity and the lifespan.

The OLED D4 of the present invention includes the first emitting part 710 including the first EML 720 (e.g., a first blue EML), the second emitting part 730 including the second EML 740 (e.g., a second blue EML) and the third emitting part 750 including the third EML 760, which includes the red and green emitting layers 762 and 764, and at least one of the first and second blue EMLs 720 and 740 includes a first blue emitting layer including a first host and a first dopant and a second blue emitting layer including a second host and a second dopant. In this case, a deuteration ratio of the second host in the second blue emitting layer, which is closer to the second electrode 564 as a cathode, is smaller than that of the first host in the first blue emitting layer, which is closer to the first electrode 560 as an anode, a HOMO energy level of the second dopant in the second blue emitting layer, which is closer to the second electrode 564 as a cathode, is lower than that of the first dopant in the first blue emitting layer, which is closer to the first electrode 560 as an anode, and a triplet energy of the second dopant is greater than that of the first dopant.

Accordingly, the OLED D4 and the organic light emitting display device 500 may have an advantage in at least one of the emitting efficiency, the color purity and the lifespan.

In addition, the OLED D4 includes the first and second emitting parts 710 and 730 each providing a blue emission and the third emitting part 750 providing a red-green emission such that the OLED D4 can provide a white emission.

The OLED D4 in FIG. 8 has a three-stack structure including the first, second and third emitting parts 710, 730 and 750. The OLED D4 may further include additional emitting part and additional CGL.

Referring to FIG. 6 again, a second electrode 564 is formed over the substrate 510 where the organic emitting layer 562 is formed.

In the organic light emitting display device 500, since the light emitted from the organic emitting layer 562 is incident to the color filter layer 580 through the second electrode 564, the second electrode 564 has a thin profile for transmitting the light.

The first electrode 560, the organic emitting layer 562 and the second electrode 564 constitute the OLED D.

The color filter layer 580 is disposed over the OLED D and includes a red color filter 582, a green color filter 584 and a blue color filter 586 respectively corresponding to the red pixel region RP, the green pixel region GP and the blue pixel region BP.

The color filter layer 580 may be attached to the OLED D using an adhesive layer. Alternatively, the color filter layer 580 may be formed directly on the OLED D.

An encapsulation layer (or an encapsulation film) may be formed to prevent penetration of moisture into the OLED D. For example, the encapsulation film may include a first inorganic insulating layer, an organic insulating layer and a second inorganic insulating layer sequentially stacked, but it is not limited thereto. The encapsulation film may be omitted.

A polarization plate for reducing an ambient light reflection may be disposed over the top-emission type OLED D. For example, the polarization plate may be a circular polarization plate.

In the OLED D of FIG. 6, the light from the organic emitting layer 562 passes through the second electrode 564, and the color filter layer 580 is disposed over the OLED D. Alternatively, the light from the organic emitting layer 562 may pass through the first electrode 560, the color filter layer 580 may be disposed between the OLED D and the first substrate 510.

A color conversion layer (not shown) may be formed between the OLED D and the color filter layer 580. The color conversion layer may include a red color conversion layer, a green color conversion layer and a blue color conversion layer respectively corresponding to the red, green and blue pixels RP, GP and BP. The white light from the OLED D is converted into the red light, the green light and the blue light by the red, green and blue color conversion layer, respectively.

As described above, in the organic light emitting display device 500, the OLED D in the red, green and blue pixels RP, GP and BP emits the white light, and the white light from the organic light emitting diode D passes through the red color filter 582, the green color filter 584 and the blue color filter 586. As a result, the red light, the green light and the blue light are provided from the red pixel RP, the green pixel GP and the blue pixel BP, respectively.

In FIGs. 6 to 8, the OLED D emitting the white light is used for a display device. Alternatively, the OLED D may be formed on an entire surface of a substrate without at least one of the driving element and the color filter layer to be used for a lightening device. The display device and the lightening device each including the OLED D of the present invention may be referred to as an organic light emitting device.

### [OLED]

On an anode (ITO, 1100Å), an HIL (the compound in Formula 11, 750Å), an HTL (the compound in Formula 12, 1100Å), an EBL (the compound E1 in Formula 10, 150Å), a first blue emitting layer (a first host (97wt%) and a first dopant (3wt%), 100Å), a second blue emitting layer (a second host (97wt%) and a second dopant (3wt%), 100Å), an ETL (the compound in Formula 13, 150Å), an EIL (the compound in Formula 14 (97wt%) and Li (3wt%), 200Å), and a cathode (Al, 1000Å) were sequentially stacked to form an OLED.

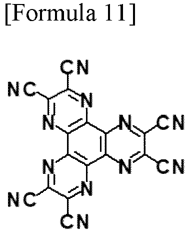

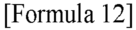

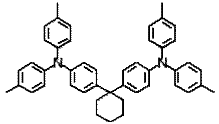

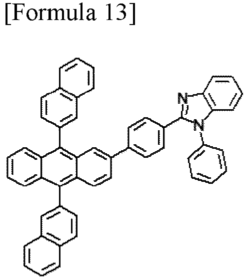

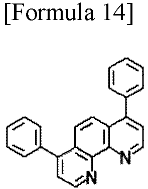

### 1. Comparative Examples

### (1) Comparative Examples 1 to 5 (Ref1 to Ref5)

The compound BH3 in Formula 6 was used as the first host, the compound BD1_A1 in Formula 8 was used as the first dopant. The compound BD2_B1 in Formula 4 was used as the second dopant, and the compounds BH3, BH3_D1, BH3_D2, BH3_D3 and BH3_D4 in Formula 6 were used as the second host, respectively.

### (2) Comparative Examples 6 to 9 (Ref6 to Ref9)

The compound BH3 in Formula 6 was used as the second host, the compound BD1_A1 in Formula 8 was used as the first dopant. The compound BD2_B1 in Formula 4 was used as the second dopant, and the compounds BH3_D1, BH3_D2, BH3_D3 and BH3_D4 in Formula 6 (or Formula 2) were used as the first host, respectively.

### (3) Comparative Examples 10 to 13 (Ref10 to Refl3)

The compound BD1_A1 in Formula 8 was used as the first dopant, and the compound BD2_B1 in Formula 4 was used as the second dopant. The compounds BH3_D1, BH3_D2, BH3_D3 and BH3_D4 in Formula 6 (or Formula 2) were used as the first host, respectively, and the compounds BH3_D1, BH3_D2, BH3_D3 and BH3_D4 in Formula 6 (or Formula 2) were used as the second host, respectively.

### (4) Comparative Examples 14 and 15 (Ref14 and Ref15)

The compound BD1_A1 in Formula 8 was used as the first dopant, and the compound BD2_B1 in Formula 4 was used as the second dopant. The compounds BH3_D1 and BH3_D4 in Formula 6 (or Formula 2) were used as the first host, respectively, and the compound BH3_D4 and BH3_D1 in Formula 6 (or Formula 2) were used as the second host, respectively.

### (5) Comparative Examples 16 to 20 (Ref16 to Ref20)

The compound BH3 in Formula 6 was used as the first host, the compound BD1_A2 in Formula 8 was used as the first dopant. The compound BD2_B1 in Formula 4 was used as the second dopant, and the compounds BH3, BH3_D1, BH3_D2, BH3_D3 and BH3_D4 in Formula 6 were used as the second host, respectively.

### (6) Comparative Examples 21 to 24 (Ref21 to Ref24)

The compound BH3 in Formula 6 was used as the second host, the compound BD1_A2 in Formula 8 was used as the first dopant. The compound BD2_B1 in Formula 4 was used as the second dopant, and the compounds BH3_D1, BH3_D2, BH3_D3 and BH3_D4 in Formula 6 (or Formula 2) were used as the first host, respectively.

### (7) Comparative Examples 25 to 28 (Ref25 to Ref28)

The compound BD1_A2 in Formula 8 was used as the first dopant, and the compound BD2_B1 in Formula 4 was used as the second dopant. The compounds BH3_D1, BH3_D2, BH3_D3 and BH3_D4 in Formula 6 (or Formula 2) were used as the first host, respectively, and the compounds BH3_D1, BH3_D2, BH3_D3 and BH3_D4 in Formula 6 (or Formula 2) were used as the second host, respectively.

### (8) Comparative Examples 29 and 30 (Ref29 to Ref30)

The compound BD1_A2 in Formula 8 was used as the first dopant, and the compound BD2_B1 in Formula 4 was used as the second dopant. The compounds BH3_D1 and BH3_D4 in Formula 6 (or Formula 2) were used as the first host, respectively, and the compound BH3_D4 and BH3_D1 in Formula 6 (or Formula 2) were used as the second host, respectively.

### (9) Comparative Examples 31 to 35 (Ref31 to Ref35)

The compound BH3 in Formula 6 was used as the first host, the compound BD1_A1 in Formula 8 was used as the first dopant. The compound BD2_B2 in Formula 4 was used as the second dopant, and the compounds BH3, BH3_D1, BH3_D2, BH3_D3 and BH3_D4 in Formula 6 were used as the second host, respectively.

### (10) Comparative Examples 36 to 39 (Ref36 to Ref39)

The compound BH3 in Formula 6 was used as the second host, the compound BD1_A1 in Formula 8 was used as the first dopant. The compound BD2_B2 in Formula 4 was used as the second dopant, and the compounds BH3_D1, BH3_D2, BH3_D3 and BH3_D4 in Formula 6 (or Formula 2) were used as the first host, respectively.

### (11) Comparative Examples 40 to 43 (Ref40 to Ref43)

The compound BD1_A1 in Formula 8 was used as the first dopant, and the compound BD2_B2 in Formula 4 was used as the second dopant. The compounds BH3_D1, BH3_D2, BH3_D3 and BH3_D4 in Formula 6 (or Formula 2) were used as the first host, respectively, and the compounds BH3_D1, BH3_D2, BH3_D3 and BH3_D4 in Formula 6 (or Formula 2) were used as the second host, respectively.

### (12) Comparative Examples 44 and 45 (Ref44 and Ref45)

The compound BD1_A1 in Formula 8 was used as the first dopant, and the compound BD2_B2 in Formula 4 was used as the second dopant. The compounds BH3_D1 and BH3_D4 in Formula 6 (or Formula 2) were used as the first host, respectively, and the compound BH3_D4 and BH3_D1 in Formula 6 (or Formula 2) were used as the second host, respectively.

### (13) Comparative Examples 46 to 50 (Ref46 to Ref50)

The compound BH3 in Formula 6 was used as the first host, the compound BD1_A2 in Formula 8 was used as the first dopant. The compound BD2_B2 in Formula 4 was used as the second dopant, and the compounds BH3, BH3_D1, BH3_D2, BH3_D3 and BH3_D4 in Formula 6 were used as the second host, respectively.

### (14) Comparative Examples 51 to 54 (Ref51 to Ref54)

The compound BH3 in Formula 6 was used as the second host, the compound BD1_A2 in Formula 8 was used as the first dopant. The compound BD2_B2 in Formula 4 was used as the second dopant, and the compounds BH3_D1, BH3_D2, BH3_D3 and BH3_D4 in Formula 6 (or Formula 2) were used as the first host, respectively.

### (15) Comparative Examples 55 to 58 (Ref55 to Ref58)

The compound BD1_A2 in Formula 8 was used as the first dopant, and the compound BD2_B2 in Formula 4 was used as the second dopant. The compounds BH3_D1, BH3_D2, BH3_D3 and BH3_D4 in Formula 6 (or Formula 2) were used as the first host, respectively, and the compounds BH3_D1, BH3_D2, BH3_D3 and BH3_D4 in Formula 6 (or Formula 2) were used as the second host, respectively.

### (16) Comparative Examples 59 and 60 (Ref59 and Ref60)

The compound BD1_A2 in Formula 8 was used as the first dopant, and the compound BD2_B2 in Formula 4 was used as the second dopant. The compounds BH3_D1 and BH3_D4 in Formula 6 (or Formula 2) were used as the first host, respectively, and the compound BH3_D4 and BH3_D1 in Formula 6 (or Formula 2) were used as the second host, respectively.

### (17) Comparative Examples 61 to 65 (Ref61 to Ref65)

The compound BH3 in Formula 6 was used as the first host, the compound BD1_A1 in Formula 8 was used as the first dopant. The compound BD2_B3 in Formula 4 was used as the second dopant, and the compounds BH3, BH3_D1, BH3_D2, BH3_D3 and BH3_D4 in Formula 6 were used as the second host, respectively.

### (18) Comparative Examples 66 to 69 (Ref66 to Ref69)

The compound BH3 in Formula 6 was used as the second host, the compound BD1_A1 in Formula 8 was used as the first dopant. The compound BD2_B3 in Formula 4 was used as the second dopant, and the compounds BH3_D1, BH3_D2, BH3_D3 and BH3_D4 in Formula 6 (or Formula 2) were used as the first host, respectively.

### (19) Comparative Examples 70 to 73 (Ref70 to Ref73)

The compound BD1_A1 in Formula 8 was used as the first dopant, and the compound BD2_B3 in Formula 4 was used as the second dopant. The compounds BH3_D1, BH3_D2, BH3_D3 and BH3_D4 in Formula 6 (or Formula 2) were used as the first host, respectively, and the compounds BH3_D1, BH3_D2, BH3_D3 and BH3_D4 in Formula 6 (or Formula 2) were used as the second host, respectively.

### (20) Comparative Examples 74 and 75 (Ref74 and Ref75)

The compound BD1_A1 in Formula 8 was used as the first dopant, and the compound BD2_B3 in Formula 4 was used as the second dopant. The compounds BH3_D1 and BH3_D4 in Formula 6 (or Formula 2) were used as the first host, respectively, and the compound BH3_D4 and BH3_D1 in Formula 6 (or Formula 2) were used as the second host, respectively.

### (21) Comparative Examples 76 to 80 (Ref76 to Ref80)

The compound BH3 in Formula 6 was used as the first host, the compound BD1_A2 in Formula 8 was used as the first dopant. The compound BD2_B3 in Formula 4 was used as the second dopant, and the compounds BH3, BH3_D1, BH3_D2, BH3_D3 and BH3_D4 in Formula 6 were used as the second host, respectively.

### (22) Comparative Examples 81 to 84 (Ref81 to Ref84)

The compound BH3 in Formula 6 was used as the second host, the compound BD1_A2 in Formula 8 was used as the first dopant. The compound BD2_B3 in Formula 4 was used as the second dopant, and the compounds BH3_D1, BH3_D2, BH3_D3 and BH3_D4 in Formula 6 (or Formula 2) were used as the first host, respectively.

### (23) Comparative Examples 85 to 88 (Ref85 to Ref88)

The compound BD1_A2 in Formula 8 was used as the first dopant, and the compound BD2_B3 in Formula 4 was used as the second dopant. The compounds BH3_D1, BH3_D2, BH3_D3 and BH3_D4 in Formula 6 (or Formula 2) were used as the first host, respectively, and the compounds BH3_D1, BH3_D2, BH3_D3 and BH3_D4 in Formula 6 (or Formula 2) were used as the second host, respectively.

### (24) Comparative Examples 89 and 90 (Ref89 and Ref90)

The compound BD1_A2 in Formula 8 was used as the first dopant, and the compound BD2_B3 in Formula 4 was used as the second dopant. The compounds BH3_D1 and BH3_D4 in Formula 6 (or Formula 2) were used as the first host, respectively, and the compound BH3_D4 and BH3_D1 in Formula 6 (or Formula 2) were used as the second host, respectively.

### (25) Comparative Examples 91 to 94 (Ref91 to Ref94)

The compound BH3 in Formula 6 was used as the first host, the compound BD2_B1 in Formula 4 was used as the first dopant. The compound BD1_A1 in Formula 8 was used as the second dopant, and the compounds BH3_D1, BH3_D2, BH3_D3 and BH3_D4 in Formula 2 were used as the second host, respectively.

### (26) Comparative Example 95 (Ref95)

The compound BH3_D1 in Formula 6 was used as the first host, the compound BD2_B1 in Formula 4 was used as the first dopant. The compound BD1_A1 in Formula 8 was used as the second dopant, and the compound BH3_D4 in Formula 6 (or Formula 2) was used as the second host.

### (27) Comparative Examples 96 to 99 (Ref96 to Ref99)

The compound BH3 in Formula 6 was used as the first host, the compound BD2_B1 in Formula 4 was used as the first dopant. The compound BD1_A2 in Formula 8 was used as the second dopant, and the compounds BH3_D1, BH3_D2, BH3_D3 and BH3_D4 in Formula 2 were used as the second host, respectively.

### (28) Comparative Example 100 (Ref100)

The compound BH3_D1 in Formula 6 was used as the first host, the compound BD2_B1 in Formula 4 was used as the first dopant. The compound BD1_A2 in Formula 8 was used as the second dopant, and the compound BH3_D4 in Formula 6 (or Formula 2) was used as the second host.

### (29) Comparative Examples 101 and 104 (Ref101 and Ref104)

The compound BH3 in Formula 6 was used as the first host, the compound BD2_B2 in Formula 4 was used as the first dopant. The compound BD1_A1 in Formula 8 was used as the second dopant, and the compounds BH3_D1, BH3_D2, BH3_D3 and BH3_D4 in Formula 2 were used as the second host, respectively.

### (30) Comparative Example 105 (Ref105)

The compound BH3_D1 in Formula 6 was used as the first host, the compound BD2_B2 in Formula 4 was used as the first dopant. The compound BD1_A1 in Formula 8 was used as the second dopant, and the compound BH3_D4 in Formula 6 (or Formula 2) was used as the second host.

### (31) Comparative Examples 106 and 109 (Ref106 and Ref109)

The compound BH3 in Formula 6 was used as the first host, the compound BD2_B2 in Formula 4 was used as the first dopant. The compound BD1_A2 in Formula 8 was used as the second dopant, and the compounds BH3_D1, BH3_D2, BH3_D3 and BH3_D4 in Formula 2 were used as the second host, respectively.

### (32) Comparative Example 110 (Ref110)

The compound BH3_D1 in Formula 6 was used as the first host, the compound BD2_B2 in Formula 4 was used as the first dopant. The compound BD1_A2 in Formula 8 was used as the second dopant, and the compound BH3_D4 in Formula 6 (or Formula 2) was used as the second host.

### (33) Comparative Examples 111 and 114 (Ref111 and Ref114)

The compound BH3 in Formula 6 was used as the first host, the compound BD2_B3 in Formula 4 was used as the first dopant. The compound BD1_A1 in Formula 8 was used as the second dopant, and the compounds BH3_D1, BH3_D2, BH3_D3 and BH3_D4 in Formula 2 were used as the second host, respectively.

### (34) Comparative Example 115 (Ref115)

The compound BH3_D1 in Formula 6 was used as the first host, the compound BD2_B3 in Formula 4 was used as the first dopant. The compound BD1_A1 in Formula 8 was used as the second dopant, and the compound BH3_D4 in Formula 6 (or Formula 2) was used as the second host.

### (35) Comparative Examples 116 and 119 (Ref116 and Ref119)

The compound BH3 in Formula 6 was used as the first host, the compound BD2_B3 in Formula 4 was used as the first dopant. The compound BD1_A2 in Formula 8 was used as the second dopant, and the compounds BH3_D1, BH3_D2, BH3_D3 and BH3_D4 in Formula 2 were used as the second host, respectively.

### (36) Comparative Example 120 (Ref120)

The compound BH3_D1 in Formula 6 was used as the first host, the compound BD2_B3 in Formula 4 was used as the first dopant. The compound BD1_A2 in Formula 8 was used as the second dopant, and the compound BH3_D4 in Formula 6 (or Formula 2) was used as the second host.

### 2. Examples

### (1) Examples 1 to 4 (Ex1 to Ex4)

The compound BD2_B 1 in Formula 4 was used as the first dopant, the compound BD1_A1 in Formula 8 was used as the second dopant. The compound BH3 in Formula 6 was used as the second host, and the compounds BH3_D1, BH3_D2, BH3_D3 and BH3_D4 in Formula 2 were used as the first host, respectively.

### (2) Example 5 (Ex5)

The compound BH3_D4 in Formula 2 was used as the first host, the compound BD2_B1 in Formula 4 was used as the first dopant. The compound BH3_D1 in Formula 6 was used as the second host, and the compound BD1_A1 in Formula 8 was used as the second dopant.

### (3) Examples 6 to 9 (Ex6 to Ex9)

The compound BD2_B 1 in Formula 4 was used as the first dopant, the compound BD1_A2 in Formula 8 was used as the second dopant. The compound BH3 in Formula 6 was used as the second host, and the compounds BH3_D1, BH3_D2, BH3_D3 and BH3_D4 in Formula 2 were used as the first host, respectively.

### (4) Example 10 (Ex10)

The compound BH3_D4 in Formula 2 was used as the first host, the compound BD2_B1 in Formula 4 was used as the first dopant. The compound BH3_D1 in Formula 6 was used as the second host, and the compound BD1_A2 in Formula 8 was used as the second dopant.

### (5) Examples 11 to 14 (Ex11 to Ex14)

The compound BD2_B2 in Formula 4 was used as the first dopant, the compound BD1_A1 in Formula 8 was used as the second dopant. The compound BH3 in Formula 6 was used as the second host, and the compounds BH3_D1, BH3_D2, BH3_D3 and BH3_D4 in Formula 2 were used as the first host, respectively.

### (6) Example 15 (Ex15)

The compound BH3_D4 in Formula 2 was used as the first host, the compound BD2_B2 in Formula 4 was used as the first dopant. The compound BH3_D1 in Formula 6 was used as the second host, and the compound BD1_A1 in Formula 8 was used as the second dopant.

### (7) Examples 16 to 19 (Ex16 to Ex19)

The compound BD2_B2 in Formula 4 was used as the first dopant, the compound BD1_A2 in Formula 8 was used as the second dopant. The compound BH3 in Formula 6 was used as the second host, and the compounds BH3_D1, BH3_D2, BH3_D3 and BH3_D4 in Formula 2 were used as the first host, respectively.

### (8) Example 20 (Ex20)

The compound BH3_D4 in Formula 2 was used as the first host, the compound BD2_B2 in Formula 4 was used as the first dopant. The compound BH3_D1 in Formula 6 was used as the second host, and the compound BD1_A2 in Formula 8 was used as the second dopant.

### (9) Examples 21 to 24 (Ex21 to Ex24)

The compound BD2_B3 in Formula 4 was used as the first dopant, the compound BD1_A1 in Formula 8 was used as the second dopant. The compound BH3 in Formula 6 was used as the second host, and the compounds BH3_D1, BH3_D2, BH3_D3 and BH3_D4 in Formula 2 were used as the first host, respectively.

### (10) Example 25 (Ex25)

The compound BH3_D4 in Formula 2 was used as the first host, the compound BD2_B3 in Formula 4 was used as the first dopant. The compound BH3_D1 in Formula 6 was used as the second host, and the compound BD1_A1 in Formula 8 was used as the second dopant.

### (11) Examples 26 to 29 (Ex26 to Ex29)

The compound BD2_B3 in Formula 4 was used as the first dopant, the compound BD1_A2 in Formula 8 was used as the second dopant. The compound BH3 in Formula 6 was used as the second host, and the compounds BH3_D1, BH3_D2, BH3_D3 and BH3_D4 in Formula 2 were used as the first host, respectively.

### (12) Example 30 (Ex30)

The compound BH3_D4 in Formula 2 was used as the first host, the compound BD2_B3 in Formula 4 was used as the first dopant. The compound BH3_D1 in Formula 6 was used as the second host, and the compound BD1_A2 in Formula 8 was used as the second dopant.

The properties, i.e., a HOMO energy level, a LUMO energy level and a triplet energy (T1), of the dopants used for the first and second blue emitting layers of the OLEDs manufactured in Comparative Examples 1 to 120 and Examples 1 to 30 were measured and listed in Table 1.

Various methods of determining the HOMO energy level are known to the skilled person. For example, the HOMO energy level can be determined using a conventional surface analyser such as an AC3 surface analyser made by RKI instruments. The surface analyser may be used to interrogate a single film (neat film) of a compound with a thickness of 50 nm. The LUMO energy level can be calculated as follows:
LUMO = HOMO-bandgap.

The bandgap may be calculated using any conventional method known to the skilled person, such as from a UV-vis measurement of a single film with a thickness of 50 nm. For example, this can be done using a SCINCO S-3100 spectrophotometer. The HOMO and LUMO values of the compounds of the examples and embodiments disclosed herein may be determined in this way. Namely, the HOMO and LUMO values may be experimentally or empirically determined values of thin films, such as 50 nm films.

The triplet energy may be measured or calculated from a PL spectrum.

**Table 1**

| | HOMO (eV) | LUMO (eV) | T1 (eV) |
|---|---|---|---|
| BD1_A1 | -5.37 | -2.66 | 2.63 |
| BD1_A2 | -5.47 | -2.77 | 2.61 |
| BD2_B1 | -5.17 | -2.45 | 2.41 |
| BD2_B2 | -5.17 | -2.45 | 2.40 |
| BD2_B3 | -5.25 | -2.53 | 2.42 |

The combination of the compounds used for the first and second emitting layers of the OLEDs in Comparative Examples 1 to 120 and Examples 1 to 30 is listed in Tables 2 to 8, and the properties, i.e., a driving voltage (V), brightness (Cd/A), a blue color coordinate (Bx, By), an external quantum efficiency (EQE) and a lifespan (LT), of the OLEDs manufactured in Comparative Examples 1 to 120 and Examples 1 to 30 were measured and listed in Tables 9 to 15.

**Table 2**

| | B-EML 1 | | B-EML 2 | | D-ratio of Host | |
|---|---|---|---|---|---|---|
| | BH | BD | BH | BD | B-EML 1 | B-EML 2 |
| Ref1 | BH3 | BD1_A1 | BH3 | BD2_B1 | 0% | 0% |
| Ref2 | BH3 | BD1_A1 | BH3_D1 | BD2_B1 | 0% | 31% |
| Ref3 | BH3 | BD1_A1 | BH3_D4 | BD2_B1 | 0% | 58% |
| Ref4 | BH3 | BD1_A1 | BH3_D3 | BD2_B1 | 0% | 73% |
| Ref5 | BH3 | BD1_A1 | BH3_D4 | BD2_B1 | 0% | 100% |
| Ref6 | BH3_D1 | BD1_A1 | BH3 | BD2_B1 | 31% | 0% |
| Ref7 | BH3_D2 | BD1_A1 | BH3 | BD2_B1 | 58% | 0% |
| Ref8 | BH3_D3 | BD1_A1 | BH3 | BD2_B1 | 73% | 0% |
| Ref9 | BH3_D4 | BD1_A1 | BH3 | BD2_B1 | 100% | 0% |
| Ref10 | BH3_D1 | BD1_A1 | BH3_D1 | BD2_B1 | 31% | 31% |
| Ref11 | BH3_D2 | BD1_A1 | BH3_D2 | BD2_B1 | 58% | 58% |
| Ref12 | BH3_D3 | BD1_A1 | BH3_D3 | BD2_B1 | 73% | 73% |
| Ref13 | BH3_D4 | BD1_A1 | BH3_D4 | BD2_B1 | 100% | 100% |
| Ref14 | BH3_D1 | BD1_A1 | BH3_D4 | BD2_B1 | 31% | 100% |
| Ref15 | BH3_D4 | BD1_A1 | BH3_D1 | BD2_B1 | 100% | 31% |
| Ref16 | BH3 | BD1_A2 | BH3 | BD2_B1 | 0% | 0% |
| Ref17 | BH3 | BD1_A2 | BH3_D1 | BD2_B1 | 0% | 31% |
| Ref18 | BH3 | BD1_A2 | BH3_D2 | BD2_B1 | 0% | 58% |
| Ref19 | BH3 | BD1_A2 | BH3_D3 | BD2_B1 | 0% | 73% |
| Ref20 | BH3 | BD1_A2 | BH3_D4 | BD2_B1 | 0% | 100% |
| Ref21 | BH3_D1 | BD1_A2 | BH3 | BD2_B1 | 31% | 0% |
| Ref22 | BH3_D2 | BD1_A2 | BH3 | BD2_B1 | 58% | 0% |
| Ref23 | BH3_D3 | BD1_A2 | BH3 | BD2_B1 | 73% | 0% |
| Ref24 | BH3_D4 | BD1_A2 | BH3 | BD2_B1 | 100% | 0% |
| Ref25 | BH3_D1 | BD1_A2 | BH3_D1 | BD2_B1 | 31% | 31% |

**Table 3**

| | B-EML 1 | | B-EML 2 | | D-ratio of Host | |
|---|---|---|---|---|---|---|
| | BH | BD | BH | BD | B-EML 1 | B-EML 2 |
| Ref26 | BH3_D2 | BD1_A2 | BH3_D2 | BD2_B1 | 58% | 58% |
| Ref27 | BH3_D3 | BD1_A2 | BH3_D3 | BD2_B1 | 73% | 73% |
| Ref28 | BH3_D4 | BD1_A2 | BH3_D4 | BD2_B1 | 100% | 100% |
| Ref29 | BH3_D1 | BD1_A2 | BH3_D4 | BD2_B1 | 31% | 100% |
| Ref30 | BH3_D4 | BD1_A2 | BH3_D1 | BD2_B1 | 100% | 31% |
| Ref31 | BH3 | BD1_A1 | BH3 | BD2_B2 | 0% | 0% |
| Ref32 | BH3 | BD1_A1 | BH3_D1 | BD2_B2 | 0% | 31% |
| Ref33 | BH3 | BD1_A1 | BH3_D2 | BD2_B2 | 0% | 58% |
| Ref34 | BH3 | BD1_A1 | BH3_D3 | BD2_B2 | 0% | 73% |
| Ref35 | BH3 | BD1_A1 | BH3_D4 | BD2_B2 | 0% | 100% |
| Ref36 | BH3_D1 | BD1_A1 | BH3 | BD2_B2 | 31% | 0% |
| Ref37 | BH3_D2 | BD1_A1 | BH3 | BD2_B2 | 58% | 0% |
| Ref38 | BH3_D3 | BD1_A1 | BH3 | BD2_B2 | 73% | 0% |
| Ref39 | BH3_D4 | BD1_A1 | BH3 | BD2_B2 | 100% | 0% |
| Ref40 | BH3_D1 | BD1_A1 | BH3_D1 | BD2_B2 | 31% | 31% |
| Ref41 | BH3_D2 | BD1_A1 | BH3_D2 | BD2_B2 | 58% | 58% |
| Ref42 | BH3_D3 | BD1_A1 | BH3_D3 | BD2_B2 | 73% | 73% |
| Ref43 | BH3_D4 | BD1_A1 | BH3_D4 | BD2_B2 | 100% | 100% |
| Ref44 | BH3_D1 | BD1_A1 | BH3_D4 | BD2_B2 | 31% | 100% |
| Ref45 | BH3_D4 | BD1_A1 | BH3_D1 | BD2_B2 | 100% | 31% |
| Ref46 | BH3 | BD1_A2 | BH3 | BD2_B2 | 0% | 0% |
| Ref47 | BH3 | BD1_A2 | BH3_D1 | BD2_B2 | 0% | 31% |
| Ref48 | BH3 | BD1_A2 | BH3_D2 | BD2_B2 | 0% | 58% |
| Ref49 | BH3 | BD1_A2 | BH3_D3 | BD2_B2 | 0% | 73% |
| Ref50 | BH3 | BD1_A2 | BH3_D4 | BD2_B2 | 0% | 100% |

**Table 4**

| | B-EML 1 | | B-EML 2 | | D-ratio of Host | |
|---|---|---|---|---|---|---|
| | BH | BD | BH | BD | B-EML 1 | B-EML 2 |
| Ref51 | BH3_D1 | BD1_A2 | BH3 | BD2_B2 | 31% | 0% |
| Ref52 | BH3_D2 | BD1_A2 | BH3 | BD2_B2 | 58% | 0% |
| Ref53 | BH3_D3 | BD1_A2 | BH3 | BD2_B2 | 73% | 0% |
| Ref54 | BH3_D4 | BD1_A2 | BH3 | BD2_B2 | 100% | 0% |
| Ref55 | BH3_D1 | BD1_A2 | BH3_D1 | BD2_B2 | 31% | 31% |
| Ref56 | BH3_D2 | BD1_A2 | BH3_D2 | BD2_B2 | 58% | 58% |
| Ref57 | BH3_D3 | BD1_A2 | BH3_D3 | BD2_B2 | 73% | 73% |
| Ref58 | BH3_D4 | BD1_A2 | BH3_D4 | BD2_B2 | 100% | 100% |
| Ref59 | BH3_D1 | BD1_A2 | BH3_D4 | BD2_B2 | 31% | 100% |
| Ref60 | BH3_D4 | BD1_A2 | BH3_D1 | BD2_B2 | 100% | 31% |
| Ref61 | BH3 | BD1_A1 | BH3 | BD2_B3 | 0% | 0% |
| Ref62 | BH3 | BD1_A1 | BH3_D1 | BD2_B3 | 0% | 31% |
| Ref63 | BH3 | BD1_A1 | BH3_D2 | BD2_B3 | 0% | 58% |
| Ref64 | BH3 | BD1_A1 | BH3_D3 | BD2_B3 | 0% | 73% |
| Ref65 | BH3 | BD1_A1 | BH3_D4 | BD2_B3 | 0% | 100% |
| Ref66 | BH3_D1 | BD1_A1 | BH3 | BD2_B3 | 31% | 0% |
| Ref67 | BH3_D2 | BD1_A1 | BH3 | BD2_B3 | 58% | 0% |
| Ref68 | BH3_D3 | BD1_A1 | BH3 | BD2_B3 | 73% | 0% |
| Ref69 | BH3_D4 | BD1_A1 | BH3 | BD2_B3 | 100% | 0% |
| Ref70 | BH3_D1 | BD1_A1 | BH3_D1 | BD2_B3 | 31% | 31% |
| Ref71 | BH3_D2 | BD1_A1 | BH3_D2 | BD2_B3 | 58% | 58% |
| Ref72 | BH3_D3 | BD1_A1 | BH3_D3 | BD2_B3 | 73% | 73% |
| Ref73 | BH3_D4 | BD1_A1 | BH3_D4 | BD2_B3 | 100% | 100% |
| Ref74 | BH3_D1 | BD1_A1 | BH3_D4 | BD2_B3 | 31% | 100% |
| Ref75 | BH3_D4 | BD1_A1 | BH3_D1 | BD2_B3 | 100% | 31% |

**Table 5**

| | B-EML 1 | | B-EML 2 | | D-ratio of Host | |
|---|---|---|---|---|---|---|
| | BH | BD | BH | BD | B-EML 1 | B-EML 2 |
| Ref76 | BH3 | BD1_A2 | BH3 | BD2_B3 | 0% | 0% |
| Ref77 | BH3 | BD1_A2 | BH3_D1 | BD2_B3 | 0% | 31% |
| Ref78 | BH3 | BD1_A2 | BH3_D2 | BD2_B3 | 0% | 58% |
| Ref79 | BH3 | BD1_A2 | BH3_D3 | BD2_B3 | 0% | 73% |
| Ref80 | BH3 | BD1_A2 | BH3_D4 | BD2_B3 | 0% | 100% |
| Ref81 | BH3_D1 | BD1_A2 | BH3 | BD2_B3 | 31% | 0% |
| Ref82 | BH3_D2 | BD1_A2 | BH3 | BD2_B3 | 58% | 0% |
| Ref83 | BH3_D3 | BD1_A2 | BH3 | BD2_B3 | 73% | 0% |
| Ref84 | BH3_D4 | BD1_A2 | BH3 | BD2_B3 | 100% | 0% |
| Ref85 | BH3_D1 | BD1_A2 | BH3_D1 | BD2_B3 | 31% | 31% |
| Ref86 | BH3_D2 | BD1_A2 | BH3_D2 | BD2_B3 | 58% | 58% |
| Ref87 | BH3_D3 | BD1_A2 | BH3_D3 | BD2_B3 | 73% | 73% |
| Ref88 | BH3_D4 | BD1_A2 | BH3_D4 | BD2_B3 | 100% | 100% |
| Ref89 | BH3_D1 | BD1_A2 | BH3_D4 | BD2_B3 | 31% | 100% |
| Ref90 | BH3_D4 | BD1_A2 | BH3_D1 | BD2_B3 | 100% | 31% |
| Ref91 | BH3 | BD2_B1 | BH3_D1 | BD1_A1 | 0% | 31% |
| Ref92 | BH3 | BD2_B1 | BH3_D2 | BD1_A1 | 0% | 58% |
| Ref93 | BH3 | BD2_B1 | BH3_D3 | BD1_A1 | 0% | 73% |
| Ref94 | BH3 | BD2_B1 | BH3_D4 | BD1_A1 | 0% | 100% |
| Ref95 | BH3_D1 | BD2_B1 | BH3_D4 | BD1_A1 | 31% | 100% |
| Ref96 | BH3 | BD2_B1 | BH3_D1 | BD1_A2 | 0% | 31% |
| Ref97 | BH3 | BD2_B1 | BH3_D2 | BD1_A2 | 0% | 58% |
| Ref98 | BH3 | BD2_B1 | BH3_D3 | BD1_A2 | 0% | 73% |
| Ref99 | BH3 | BD2_B1 | BH3_D4 | BD1_A2 | 0% | 100% |
| Ref100 | BH3_D1 | BD2_B1 | BH3_D4 | BD1_A2 | 31% | 100% |

**Table 6**

| | B-EML 1 | | B-EML 2 | | D-ratio of Host | |
|---|---|---|---|---|---|---|
| | BH | BD | BH | BD | B-EML 1 | B-EML 2 |
| Ref101 | BH3 | BD2_B2 | BH3_D1 | BD1_A1 | 0% | 31% |
| Ref102 | BH3 | BD2_B2 | BH3_D2 | BD1_A1 | 0% | 58% |
| Ref103 | BH3 | BD2_B2 | BH3_D3 | BD1_A1 | 0% | 73% |
| Ref104 | BH3 | BD2_B2 | BH3_D4 | BD1_A1 | 0% | 100% |
| Ref105 | BH3_D1 | BD2_B2 | BH3_D4 | BD1_A1 | 31% | 100% |
| Ref106 | BH3 | BD2_B2 | BH3_D1 | BD1_A2 | 0% | 31% |
| Ref107 | BH3 | BD2_B2 | BH3_D2 | BD1_A2 | 0% | 58% |
| Ref108 | BH3 | BD2_B2 | BH3_D3 | BD1_A2 | 0% | 73% |
| Ref109 | BH3 | BD2_B2 | BH3_D4 | BD1_A2 | 0% | 100% |
| Ref110 | BH3_D1 | BD2_B2 | BH3_D4 | BD1_A2 | 31% | 100% |
| Ref111 | BH3 | BD2_B3 | BH3_D1 | BD1_A1 | 0% | 31% |
| Ref112 | BH3 | BD2_B3 | BH3_D2 | BD1_A1 | 0% | 58% |
| Ref113 | BH3 | BD2_B3 | BH3_D3 | BD1_A1 | 0% | 73% |
| Ref114 | BH3 | BD2_B3 | BH3_D4 | BD1_A1 | 0% | 100% |
| Ref115 | BH3_D1 | BD2_B3 | BH3_D4 | BD1_A1 | 31% | 100% |
| Ref116 | BH3 | BD2_B3 | BH3_D1 | BD1_A2 | 0% | 31% |
| Ref117 | BH3 | BD2_B3 | BH3_D2 | BD1_A2 | 0% | 58% |
| Ref118 | BH3 | BD2_B3 | BH3_D3 | BD1_A2 | 0% | 73% |
| Ref119 | BH3 | BD2_B3 | BH3_D4 | BD1_A2 | 0% | 100% |
| Ref120 | BH3_D1 | BD2_B3 | BH3_D4 | BD1_A2 | 31% | 100% |

**Table 7**

| | B-EML 1 | | B-EML 2 | | D-ratio of Host | |
|---|---|---|---|---|---|---|
| | BH | BD | BH | BD | B-EML 1 | B-EML 2 |
| Ex1 | BH3_D1 | BD2_B1 | BH3 | BD1_A1 | 31% | 0% |
| Ex2 | BH3_D2 | BD2_B1 | BH3 | BD1_A1 | 58% | 0% |
| Ex3 | BH3_D3 | BD2_B1 | BH3 | BD1_A1 | 73% | 0% |
| Ex4 | BH3_D4 | BD2_B1 | BH3 | BD1_A1 | 100% | 0% |
| Ex5 | BH3_D4 | BD2_B1 | BH3_D1 | BD1_A1 | 100% | 31% |
| Ex6 | BH3_D1 | BD2_B1 | BH3 | BD1_A2 | 31% | 0% |
| Ex7 | BH3_D2 | BD2_B1 | BH3 | BD1_A2 | 58% | 0% |
| Ex8 | BH3_D3 | BD2_B1 | BH3 | BD1_A2 | 73% | 0% |
| Ex9 | BH3_D4 | BD2_B1 | BH3 | BD1_A2 | 100% | 0% |
| Ex10 | BH3_D4 | BD2_B1 | BH3_D1 | BD1_A2 | 100% | 31% |
| Ex11 | BH3_D1 | BD2_B2 | BH3 | BD1_A1 | 31% | 0% |
| Ex12 | BH3_D2 | BD2_B2 | BH3 | BD1_A1 | 58% | 0% |
| Ex13 | BH3_D3 | BD2_B2 | BH3 | BD1_A1 | 73% | 0% |
| Ex14 | BH3_D4 | BD2_B2 | BH3 | BD1_A1 | 100% | 0% |
| Ex15 | BH3_D4 | BD2_B2 | BH3_D1 | BD1_A1 | 100% | 31% |

**Table 8**

| | B-EML 1 | | B-EML 2 | | D-ratio of Host | |
|---|---|---|---|---|---|---|
| | BH | BD | BH | BD | B-EML 1 | B-EML 2 |
| Ex16 | BH3_D1 | BD2_B2 | BH3 | BD1_A2 | 31% | 0% |
| Ex17 | BH3_D2 | BD2_B2 | BH3 | BD1_A2 | 58% | 0% |
| Ex18 | BH3_D3 | BD2_B2 | BH3 | BD1_A2 | 73% | 0% |
| Ex19 | BH3_D4 | BD2_B2 | BH3 | BD1_A2 | 100% | 0% |
| Ex20 | BH3_D4 | BD2_B2 | BH3_D1 | BD1_A2 | 100% | 31% |
| Ex21 | BH3_D1 | BD2_B3 | BH3 | BD1_A1 | 31% | 0% |
| Ex22 | BH3_D2 | BD2_B3 | BH3 | BD1_A1 | 58% | 0% |
| Ex23 | BH3_D3 | BD2_B3 | BH3 | BD1_A1 | 73% | 0% |
| Ex24 | BH3_D4 | BD2_B3 | BH3 | BD1_A1 | 100% | 0% |
| Ex25 | BH3_D4 | BD2_B3 | BH3_D1 | BD1_A1 | 100% | 31% |
| Ex26 | BH3_D1 | BD2_B3 | BH3 | BD1_A2 | 31% | 0% |
| Ex27 | BH3_D2 | BD2_B3 | BH3 | BD1_A2 | 58% | 0% |
| Ex28 | BH3_D3 | BD2_B3 | BH3 | BD1_A2 | 73% | 0% |
| Ex29 | BH3_D4 | BD2_B3 | BH3 | BD1_A2 | 100% | 0% |
| Ex30 | BH3_D4 | BD2_B3 | BH3_D1 | BD1_A2 | 100% | 31% |

**Table 9**

| | Property (@10mA) | | | | | LT |
|---|---|---|---|---|---|---|
| | V | Cd/A | Bx | By | EQE | |
| Ref1 | 0.00 | 100% | 0.142 | 0.062 | 100% | 100% |
| Ref2 | 0.09 | 100% | 0.142 | 0.062 | 100% | 102% |
| Ref3 | 0.15 | 100% | 0.142 | 0.062 | 100% | 103% |
| Ref4 | 0.18 | 100% | 0.142 | 0.062 | 100% | 104% |
| Ref5 | 0.23 | 100% | 0.142 | 0.062 | 100% | 106% |
| Ref6 | 0.08 | 100% | 0.142 | 0.062 | 100% | 107% |
| Ref7 | 0.14 | 100% | 0.142 | 0.062 | 100% | 113% |
| Ref8 | 0.16 | 100% | 0.142 | 0.062 | 100% | 117% |
| Ref9 | 0.20 | 100% | 0.142 | 0.062 | 100% | 124% |
| Ref10 | 0.17 | 100% | 0.142 | 0.062 | 100% | 109% |
| Ref11 | 0.30 | 100% | 0.142 | 0.062 | 100% | 117% |
| Ref12 | 0.36 | 100% | 0.142 | 0.062 | 100% | 122% |
| Ref13 | 0.45 | 100% | 0.142 | 0.062 | 100% | 131% |
| Ref14 | 0.31 | 100% | 0.142 | 0.062 | 100% | 113% |
| Ref15 | 0.30 | 100% | 0.142 | 0.062 | 100% | 126% |
| Ref16 | -0.03 | 101% | 0.142 | 0.062 | 99% | 102% |
| Ref17 | 0.06 | 101% | 0.142 | 0.062 | 99% | 104% |
| Ref18 | 0.13 | 101% | 0.142 | 0.062 | 99% | 105% |
| Ref19 | 0.16 | 101% | 0.142 | 0.062 | 99% | 106% |
| Ref20 | 0.21 | 101% | 0.142 | 0.062 | 99% | 108% |
| Ref21 | 0.05 | 101% | 0.142 | 0.062 | 99% | 109% |
| Ref22 | 0.11 | 101% | 0.142 | 0.062 | 99% | 115% |
| Ref23 | 0.14 | 101% | 0.142 | 0.062 | 99% | 119% |
| Ref24 | 0.18 | 101% | 0.142 | 0.062 | 99% | 127% |
| Ref25 | 0.15 | 101% | 0.142 | 0.062 | 99% | 111% |

**Table 10**

| | Property (@10mA) | | | | | LT |
|---|---|---|---|---|---|---|
| | V | Cd/A | Bx | By | EQE | |
| Ref26 | 0.27 | 101% | 0.142 | 0.062 | 99% | 119% |
| Ref27 | 0.34 | 101% | 0.142 | 0.062 | 99% | 125% |
| Ref28 | 0.43 | 101% | 0.142 | 0.062 | 99% | 135% |
| Ref29 | 0.29 | 101% | 0.142 | 0.062 | 99% | 115% |
| Ref30 | 0.28 | 101% | 0.142 | 0.062 | 99% | 129% |
| Ref31 | 0.00 | 103% | 0.141 | 0.062 | 102% | 100% |
| Ref32 | 0.09 | 103% | 0.141 | 0.062 | 102% | 102% |
| Ref33 | 0.15 | 103% | 0.141 | 0.062 | 102% | 104% |
| Ref34 | 0.18 | 103% | 0.141 | 0.062 | 102% | 104% |
| Ref35 | 0.23 | 103% | 0.141 | 0.062 | 102% | 106% |
| Ref36 | 0.08 | 103% | 0.141 | 0.062 | 102% | 107% |
| Ref37 | 0.14 | 103% | 0.141 | 0.062 | 102% | 114% |
| Ref38 | 0.16 | 103% | 0.141 | 0.062 | 102% | 117% |
| Ref39 | 0.20 | 103% | 0.141 | 0.062 | 102% | 125% |
| Ref40 | 0.17 | 103% | 0.141 | 0.062 | 102% | 109% |
| Ref41 | 0.30 | 103% | 0.141 | 0.062 | 102% | 117% |
| Ref42 | 0.36 | 103% | 0.141 | 0.062 | 102% | 122% |
| Ref43 | 0.45 | 103% | 0.141 | 0.062 | 102% | 132% |
| Ref44 | 0.31 | 103% | 0.141 | 0.062 | 102% | 113% |
| Ref45 | 0.30 | 103% | 0.141 | 0.062 | 102% | 127% |
| Ref46 | -0.03 | 104% | 0.141 | 0.063 | 102% | 102% |
| Ref47 | 0.06 | 104% | 0.141 | 0.063 | 102% | 104% |
| Ref48 | 0.13 | 104% | 0.141 | 0.063 | 102% | 105% |
| Ref49 | 0.16 | 104% | 0.141 | 0.063 | 102% | 106% |
| Ref50 | 0.21 | 104% | 0.141 | 0.063 | 102% | 108% |

**Table 11**

| | Property (@10mA) | | | | | LT |
|---|---|---|---|---|---|---|
| | V | Cd/A | Bx | By | EQE | |
| Ref51 | 0.05 | 104% | 0.141 | 0.063 | 102% | 109% |
| Ref52 | 0.11 | 104% | 0.141 | 0.063 | 102% | 116% |
| Ref53 | 0.14 | 104% | 0.141 | 0.063 | 102% | 120% |
| Ref54 | 0.18 | 104% | 0.141 | 0.063 | 102% | 127% |
| Ref55 | 0.15 | 104% | 0.141 | 0.063 | 102% | 111% |
| Ref56 | 0.27 | 104% | 0.141 | 0.063 | 102% | 120% |
| Ref57 | 0.34 | 104% | 0.141 | 0.063 | 102% | 125% |
| Ref58 | 0.43 | 104% | 0.141 | 0.063 | 102% | 135% |
| Ref59 | 0.29 | 104% | 0.141 | 0.063 | 102% | 116% |
| Ref60 | 0.28 | 104% | 0.141 | 0.063 | 102% | 130% |
| Ref61 | -0.05 | 102% | 0.141 | 0.061 | 104% | 100% |
| Ref62 | 0.05 | 102% | 0.141 | 0.061 | 104% | 101% |
| Ref63 | 0.12 | 102% | 0.141 | 0.061 | 104% | 103% |
| Ref64 | 0.15 | 102% | 0.141 | 0.061 | 104% | 104% |
| Ref65 | 0.19 | 102% | 0.141 | 0.061 | 104% | 105% |
| Ref66 | 0.04 | 102% | 0.141 | 0.061 | 104% | 107% |
| Ref67 | 0.10 | 102% | 0.141 | 0.061 | 104% | 113% |
| Ref68 | 0.13 | 102% | 0.141 | 0.061 | 104% | 117% |
| Ref69 | 0.17 | 102% | 0.141 | 0.061 | 104% | 124% |
| Ref70 | 0.14 | 102% | 0.141 | 0.061 | 104% | 108% |
| Ref71 | 0.26 | 102% | 0.141 | 0.061 | 104% | 117% |
| Ref72 | 0.33 | 102% | 0.141 | 0.061 | 104% | 122% |
| Ref73 | 0.42 | 102% | 0.141 | 0.061 | 104% | 131% |
| Ref74 | 0.28 | 102% | 0.141 | 0.061 | 104% | 113% |
| Ref75 | 0.27 | 102% | 0.141 | 0.061 | 104% | 126% |

**Table 12**

| | Property (@10mA) | | | | | LT |
|---|---|---|---|---|---|---|
| | V | Cd/A | Bx | By | EQE | |
| Ref76 | -0.08 | 103% | 0.142 | 0.062 | 103% | 101% |
| Ref77 | 0.02 | 103% | 0.142 | 0.062 | 103% | 103% |
| Ref78 | 0.09 | 103% | 0.142 | 0.062 | 103% | 105% |
| Ref79 | 0.12 | 103% | 0.142 | 0.062 | 103% | 106% |
| Ref80 | 0.17 | 103% | 0.142 | 0.062 | 103% | 107% |
| Ref81 | 0.01 | 103% | 0.142 | 0.062 | 103% | 109% |
| Ref82 | 0.07 | 103% | 0.142 | 0.062 | 103% | 115% |
| Ref83 | 0.10 | 103% | 0.142 | 0.062 | 103% | 119% |
| Ref84 | 0.14 | 103% | 0.142 | 0.062 | 103% | 126% |
| Ref85 | 0.11 | 103% | 0.142 | 0.062 | 103% | 110% |
| Ref86 | 0.24 | 103% | 0.142 | 0.062 | 103% | 119% |
| Ref87 | 0.31 | 103% | 0.142 | 0.062 | 103% | 124% |
| Ref88 | 0.41 | 103% | 0.142 | 0.062 | 103% | 134% |
| Ref89 | 0.26 | 103% | 0.142 | 0.062 | 103% | 115% |
| Ref90 | 0.25 | 103% | 0.142 | 0.062 | 103% | 129% |
| Ref91 | 0.04 | 100% | 0.141 | 0.061 | 101% | 117% |
| Ref92 | 0.11 | 100% | 0.141 | 0.061 | 101% | 119% |
| Ref93 | 0.14 | 100% | 0.141 | 0.061 | 101% | 120% |
| Ref94 | 0.19 | 100% | 0.141 | 0.061 | 101% | 122% |
| Ref95 | 0.28 | 100% | 0.141 | 0.061 | 101% | 132% |
| Ref96 | -0.01 | 101% | 0.141 | 0.062 | 100% | 118% |
| Ref97 | 0.06 | 101% | 0.141 | 0.062 | 100% | 120% |
| Ref98 | 0.09 | 101% | 0.141 | 0.062 | 100% | 121% |
| Ref99 | 0.14 | 101% | 0.141 | 0.062 | 100% | 123% |
| Ref100 | 0.24 | 101% | 0.141 | 0.062 | 100% | 133% |

**Table 13**

| | Property (@10mA) | | | | | LT |
|---|---|---|---|---|---|---|
| | V | Cd/A | Bx | By | EQE | |
| Ref101 | 0.04 | 103% | 0.140 | 0.062 | 103% | 118% |
| Ref102 | 0.11 | 103% | 0.140 | 0.062 | 103% | 120% |
| Ref103 | 0.14 | 103% | 0.140 | 0.062 | 103% | 122% |
| Ref104 | 0.19 | 103% | 0.140 | 0.062 | 103% | 124% |
| Ref105 | 0.28 | 103% | 0.140 | 0.062 | 103% | 134% |
| Ref106 | -0.01 | 104% | 0.140 | 0.062 | 103% | 119% |
| Ref107 | 0.06 | 104% | 0.140 | 0.062 | 103% | 121% |
| Ref108 | 0.09 | 104% | 0.140 | 0.062 | 103% | 122% |
| Ref109 | 0.14 | 104% | 0.140 | 0.062 | 103% | 125% |
| Ref110 | 0.24 | 104% | 0.140 | 0.062 | 103% | 135% |
| Ref111 | 0.02 | 102% | 0.141 | 0.061 | 104% | 116% |
| Ref112 | 0.09 | 102% | 0.141 | 0.061 | 104% | 118% |
| Ref113 | 0.12 | 102% | 0.141 | 0.061 | 104% | 119% |
| Ref114 | 0.17 | 102% | 0.141 | 0.061 | 104% | 121% |
| Ref115 | 0.26 | 102% | 0.141 | 0.061 | 104% | 131% |
| Ref116 | -0.04 | 103% | 0.141 | 0.061 | 104% | 117% |
| Ref117 | 0.04 | 103% | 0.141 | 0.061 | 104% | 119% |
| Ref118 | 0.07 | 103% | 0.141 | 0.061 | 104% | 120% |
| Ref119 | 0.12 | 103% | 0.141 | 0.061 | 104% | 122% |
| Ref120 | 0.22 | 103% | 0.141 | 0.061 | 104% | 132% |

**Table 14**

| | Property (@10mA) | | | | | LT |
|---|---|---|---|---|---|---|
| | V | Cd/A | Bx | By | EQE | |
| Ex1 | 0.03 | 100% | 0.141 | 0.061 | 101% | 124% |
| Ex2 | 0.09 | 100% | 0.141 | 0.061 | 101% | 133% |
| Ex3 | 0.12 | 100% | 0.141 | 0.061 | 101% | 138% |
| Ex4 | 0.16 | 100% | 0.141 | 0.061 | 101% | 148% |
| Ex5 | 0.26 | 100% | 0.141 | 0.061 | 101% | 151% |
| Ex6 | -0.03 | 101% | 0.141 | 0.062 | 100% | 125% |
| Ex7 | 0.04 | 101% | 0.141 | 0.062 | 100% | 134% |
| Ex8 | 0.07 | 101% | 0.141 | 0.062 | 100% | 139% |
| Ex9 | 0.11 | 101% | 0.141 | 0.062 | 100% | 149% |
| Ex10 | 0.22 | 101% | 0.141 | 0.062 | 100% | 152% |
| Ex11 | 0.03 | 103% | 0.140 | 0.062 | 103% | 125% |
| Ex12 | 0.09 | 103% | 0.140 | 0.062 | 103% | 134% |
| Ex13 | 0.12 | 103% | 0.140 | 0.062 | 103% | 140% |
| Ex14 | 0.16 | 103% | 0.140 | 0.062 | 103% | 150% |
| Ex15 | 0.26 | 103% | 0.140 | 0.062 | 103% | 153% |

**Table 15**

| | Property (@10mA) | | | | | LT |
|---|---|---|---|---|---|---|
| | V | Cd/A | Bx | By | EQE | |
| Ex16 | -0.03 | 104% | 0.140 | 0.062 | 103% | 126% |
| Ex17 | 0.04 | 104% | 0.140 | 0.062 | 103% | 135% |
| Ex18 | 0.07 | 104% | 0.140 | 0.062 | 103% | 141% |
| Ex19 | 0.11 | 104% | 0.140 | 0.062 | 103% | 151% |
| Ex20 | 0.22 | 104% | 0.140 | 0.062 | 103% | 154% |
| Ex21 | 0.01 | 102% | 0.141 | 0.061 | 104% | 123% |
| Ex22 | 0.07 | 102% | 0.141 | 0.061 | 104% | 131% |
| Ex23 | 0.10 | 102% | 0.141 | 0.061 | 104% | 136% |
| Ex24 | 0.14 | 102% | 0.141 | 0.061 | 104% | 146% |
| Ex25 | 0.25 | 102% | 0.141 | 0.061 | 104% | 149% |
| Ex26 | -0.05 | 103% | 0.141 | 0.061 | 104% | 123% |
| Ex27 | 0.02 | 103% | 0.141 | 0.061 | 104% | 132% |
| Ex28 | 0.05 | 103% | 0.141 | 0.061 | 104% | 137% |
| Ex29 | 0.09 | 103% | 0.141 | 0.061 | 104% | 147% |
| Ex30 | 0.20 | 103% | 0.141 | 0.061 | 104% | 150% |

As shown in Tables 2 to 15, in comparison to the OLED of Comparative Examples 1 and 120, the OLED of Examples 1 to 30 has an advantage in at least one of the emitting efficiency, the color purity, and the lifespan.

For example, in the OLED of Comparative Examples 6 to 9 and Examples 1 to 4, which use the same first host, i.e., the compounds BH3_D1, BH3_D2, BH3_D3 and BH3_D4) and the same second host, i.e., the compound BH3, the OLED of Examples 1 to 4, which uses the compound, i.e., the compound BD2_B2, represented by Formula 3a as the first dopant in the first blue emitting layer and the compound, i.e., the compound BD1_A1, represented by Formula 7 as the second dopant in the second blue emitting layer, has advantages in the emitting efficiency, the color purity and the lifespan in comparison to the OLED of Comparative Examples 6 to 9, which uses the compound, i.e., the compound BD1_A1, represented by Formula 7 as the first dopant in the first blue emitting layer the compound, i.e., the compound BD2_B2, represented by Formula 3 as the second dopant in the second blue emitting layer.

In addition, in the OLED of the Comparative Examples 91 to 94 and Examples 1 to 4, which use the same first dopant, i.e., the compound BD2_B1, and the same second dopant, i.e., the compound BD1_A1, the OLED of Examples 1 to 4, which uses the compound, i.e., the compounds BH_D1, BH_D2, BH_D3 and BH_D4, represented by Formula 1 as the first host in the first blue emitting layer and the compound, i.e., the compound BH3, represented by Formula 5 as the second host in the second blue emitting layer, has advantages in the emitting efficiency, the color purity and the lifespan in comparison to the OLED of Comparative Examples 91 to 94, which uses the compound, i.e., the compound BH3, represented by Formula 5 as the first host in the first blue emitting layer and the compound, i.e., the compounds BH_D1, BH_D2, BH_D3 and BH_D4, represented by Formula 1 as the second host in the second blue emitting layer.

Namely, in the OLED, in which a deuteration ratio of the host of the first blue emitting layer, which is closer to an anode, is greater than that of the host of the second blue emitting layer, which is closer to a cathode and the dopant of the first blue emitting layer and the dopant of the second blue emitting layer are respectively represented by Formulas 3 and 7, at least one of the emitting efficiency, the color purity and the lifespan is improved.

Moreover, as shown in Table 1, in the OLED, in which the first blue emitting layer, which is disposed to be closer to an anode, includes the host having a relatively large deuteration ratio and the dopant having a relatively high HOMO energy level and the second blue emitting layer, which is disposed to be closer to a cathode, includes the host having a relatively small deuteration ratio and the dopant having a relatively low HOMO energy level, at least one of the emitting efficiency, the color purity and the lifespan is improved.

## Claims

1. An organic light emitting diode, comprising:
a first electrode;
a second electrode facing the first electrode; and
a first emitting part including a first blue emitting layer and a second blue emitting layer and positioned between the first and second electrode, the second blue emitting layer positioned between the first blue emitting layer and the second electrode and contacting the first blue emitting layer,
wherein the first blue emitting layer includes a first host and a first dopant, and the second blue emitting layer includes a second host and a second dopant,
wherein the first host is an anthracene derivative having a first deuteration ratio, and the second host is an anthracene derivative having a second deuteration ratio smaller than the first deuteration ratio,
**characterized in that** the first dopant is represented by Formula 3a: 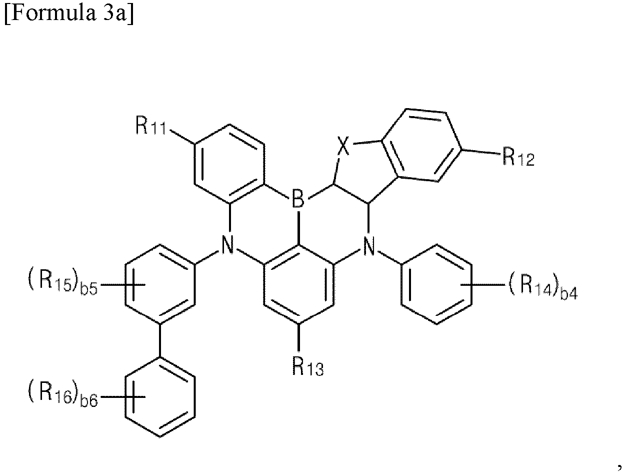
wherein in the Formula 3a,
each of b4 and b6 is independently an integer of 0 to 5, and b5 is an integer of 0 to 4, X is O or S,
R₁₁, R₁₂ and R₁₃ is independently selected from the group consisting of a substituted or unsubstituted C1 to C30 alkyl group, a substituted or unsubstituted C3 to C30 cycloalkyl group, a substituted or unsubstituted C6 to C30 arylamino group, a substituted or unsubstituted C6 to C30 aryl group and a substituted or unsubstituted C3 to C30 heteroaryl group, or at least one pair of adjacent two or more R₁₁, adjacent two or more R₁₂ and adjacent two or more R₁₃ are connected to each other to form a substitute or unsubstituted ring, and
each of R₁₄, R₁₅ and R₁₆ is selected from the group consisting of a substituted or unsubstituted C1 to C30 alkyl group and a substituted or unsubstituted C3 to C30 cycloalkyl group, or at least one pair of adjacent two R₁₄ and adjacent R₁₅ and R₁₆ are connected to each other to form a substituted or unsubstituted ring
wherein the second dopant is a second compound represented by Formula 7: 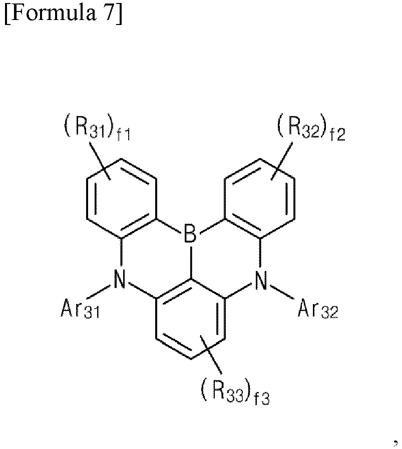
wherein in the Formula 7,
each of f1 and f2 is independently an integer of 0 to 4, and f3 is an integer of 0 to 3,
each of Ar₃₁ and Ar₃₂ is independently selected from the group consisting of a substituted or unsubstituted C6 to C30 aryl group, a substituted or unsubstituted C3 to C30 heteroaryl group and a substituted or unsubstituted C6 to C30 alicyclic group, and
R₃₁, R₃₂ and R₃₃ is independently selected from the group consisting of a substituted or unsubstituted C1 to C30 alkyl group, a substituted or unsubstituted C3 to C30 cycloalkyl group, a substituted or unsubstituted C6 to C30 arylamino group, a substituted or unsubstituted C6 to C30 aryl group and a substituted or unsubstituted C3 to C30 heteroaryl group.

2. The organic light emitting diode according to claim 1, wherein the second dopant is represented by Formula 7a: 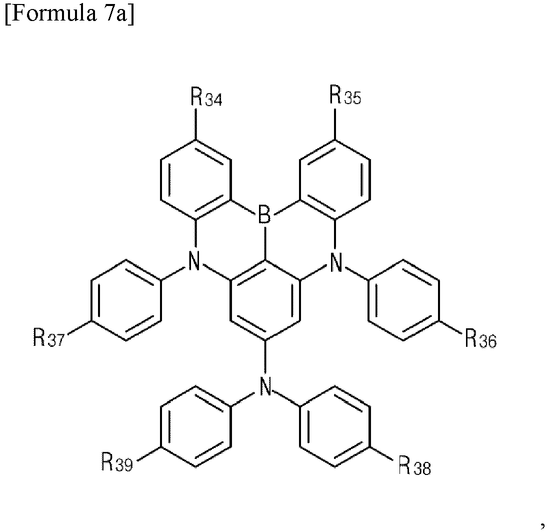 wherein in the Formula 7a, each of R₃₄ to R₃₉ is independently selected from the group consisting of hydrogen, a substituted or unsubstituted C1 to C30 alkyl group, a substituted or unsubstituted C3 to C30 cycloalkyl group, a substituted or unsubstituted C6 to C30 aryl group and a substituted or unsubstituted C3 to C30 heteroaryl group.

3. The organic light emitting diode according to any of claims 1 to 2, wherein the first dopant is one of compounds in Formula 4:

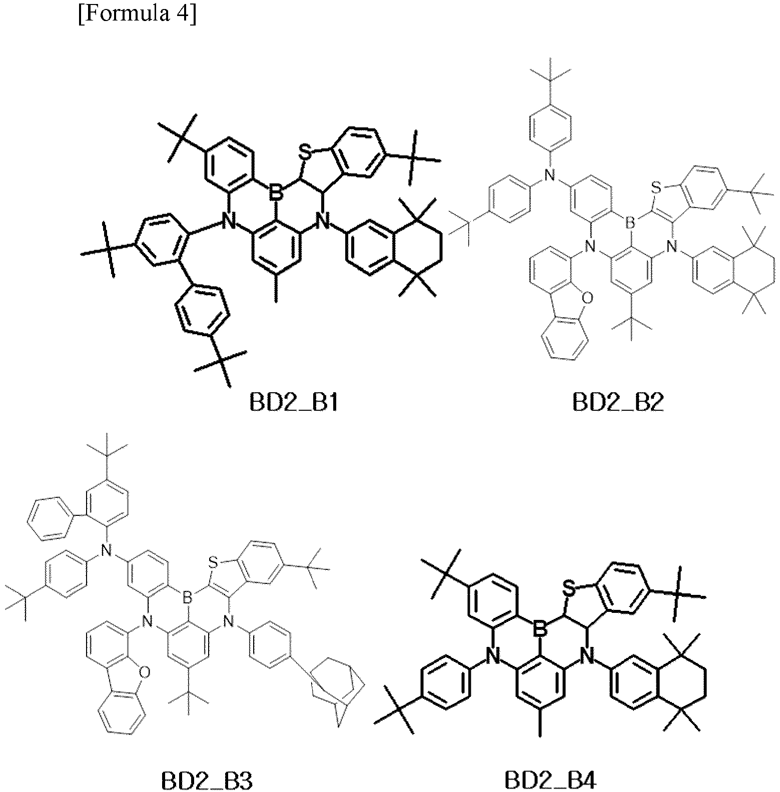

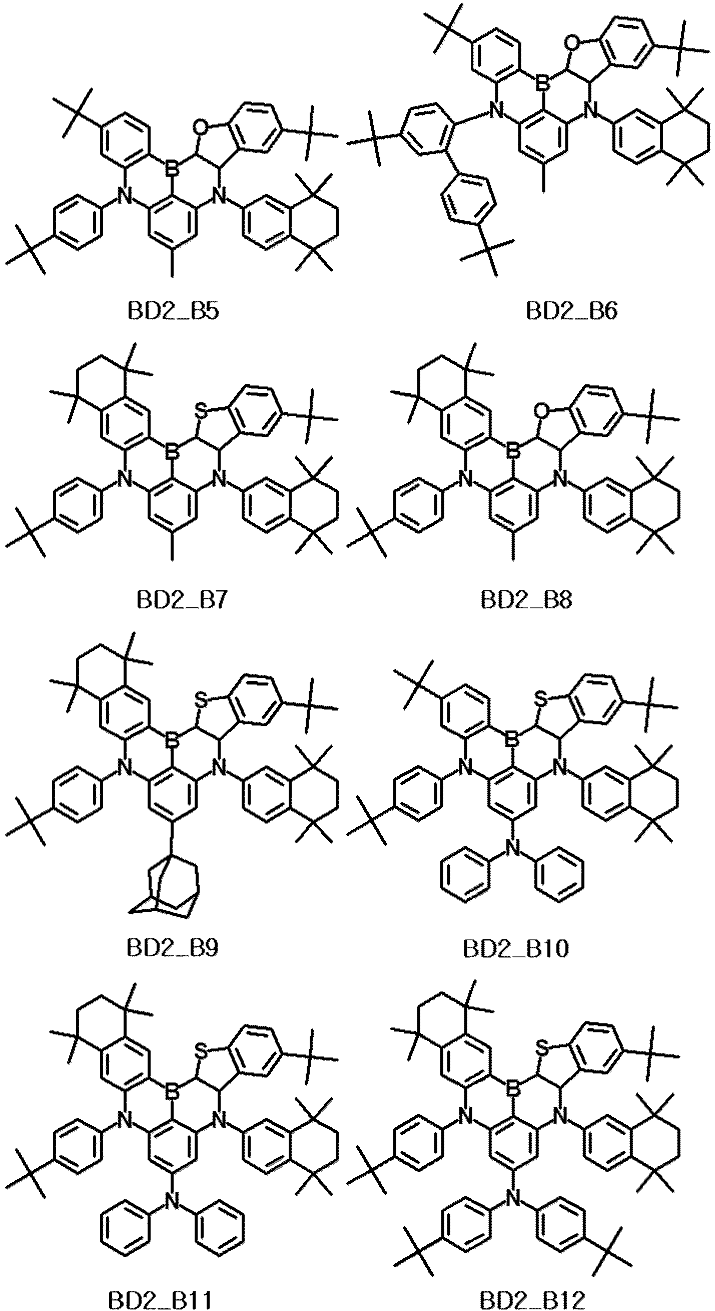

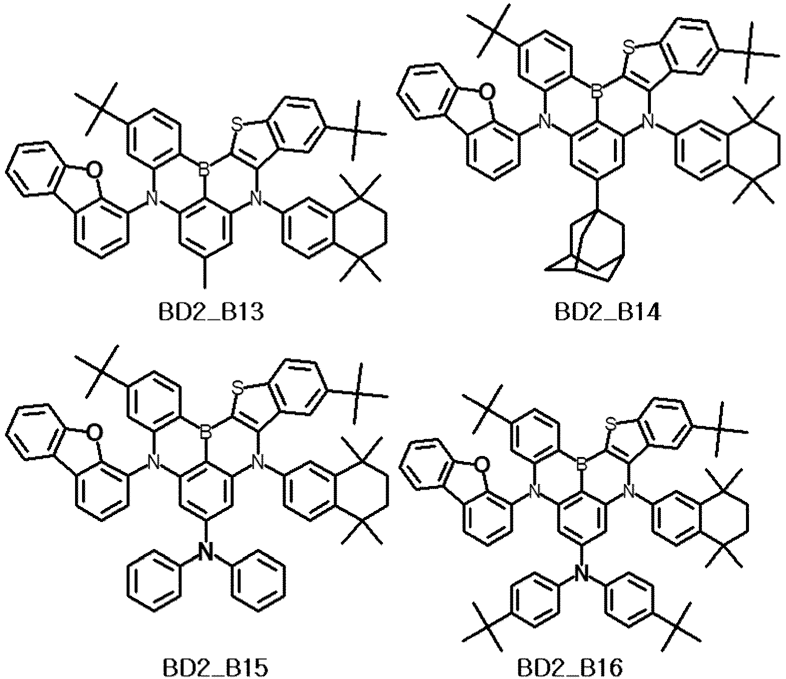

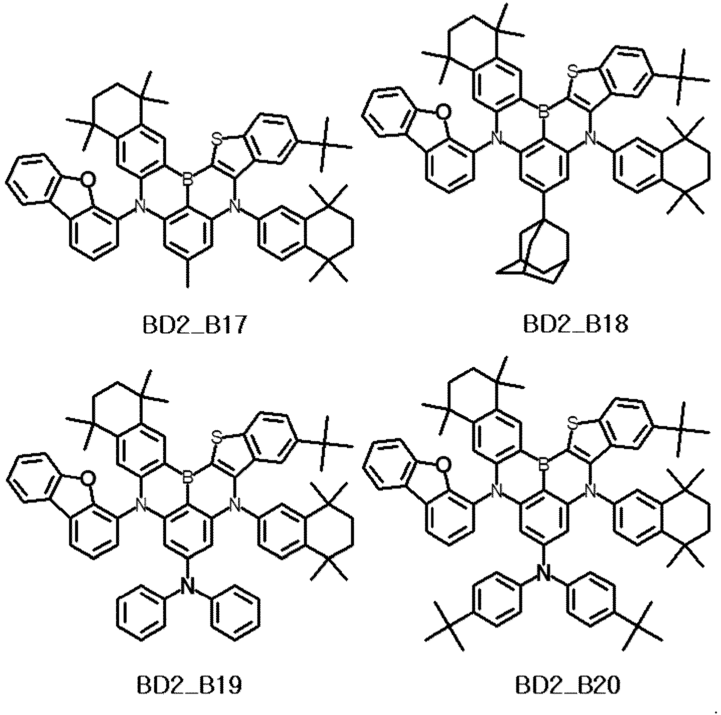

4. The organic light emitting diode according to any of claims 1 to 3, wherein the second dopant is one of compounds in Formula 8:

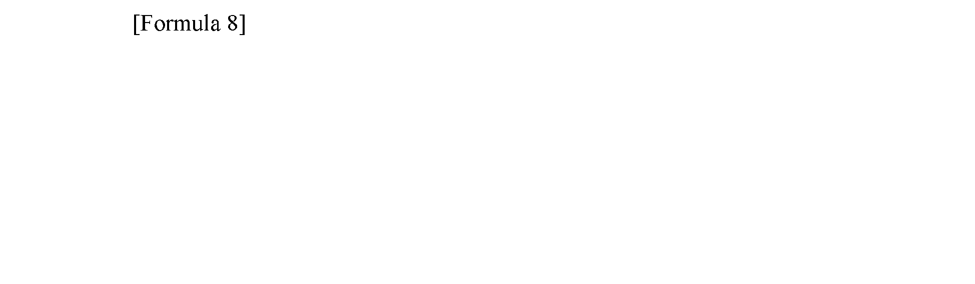

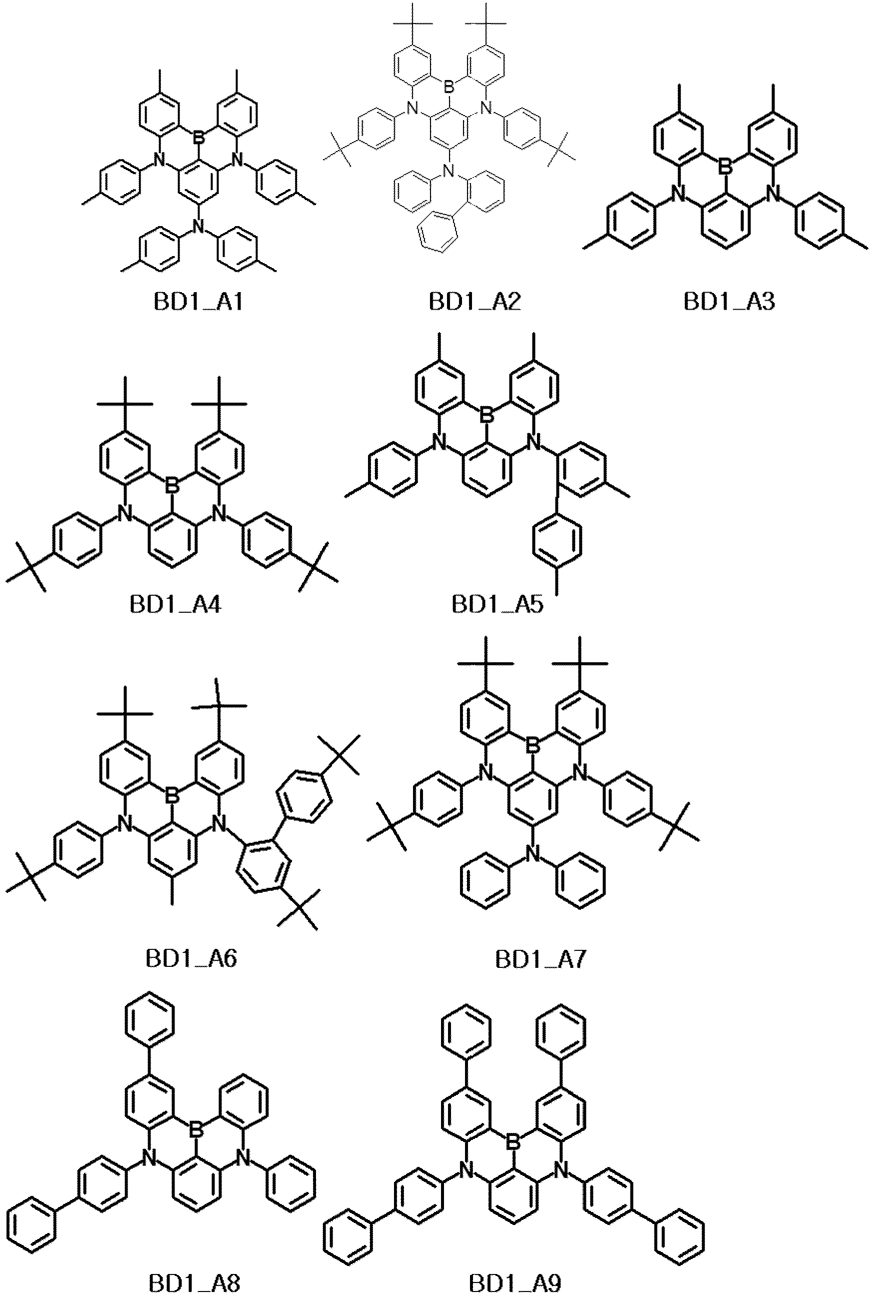

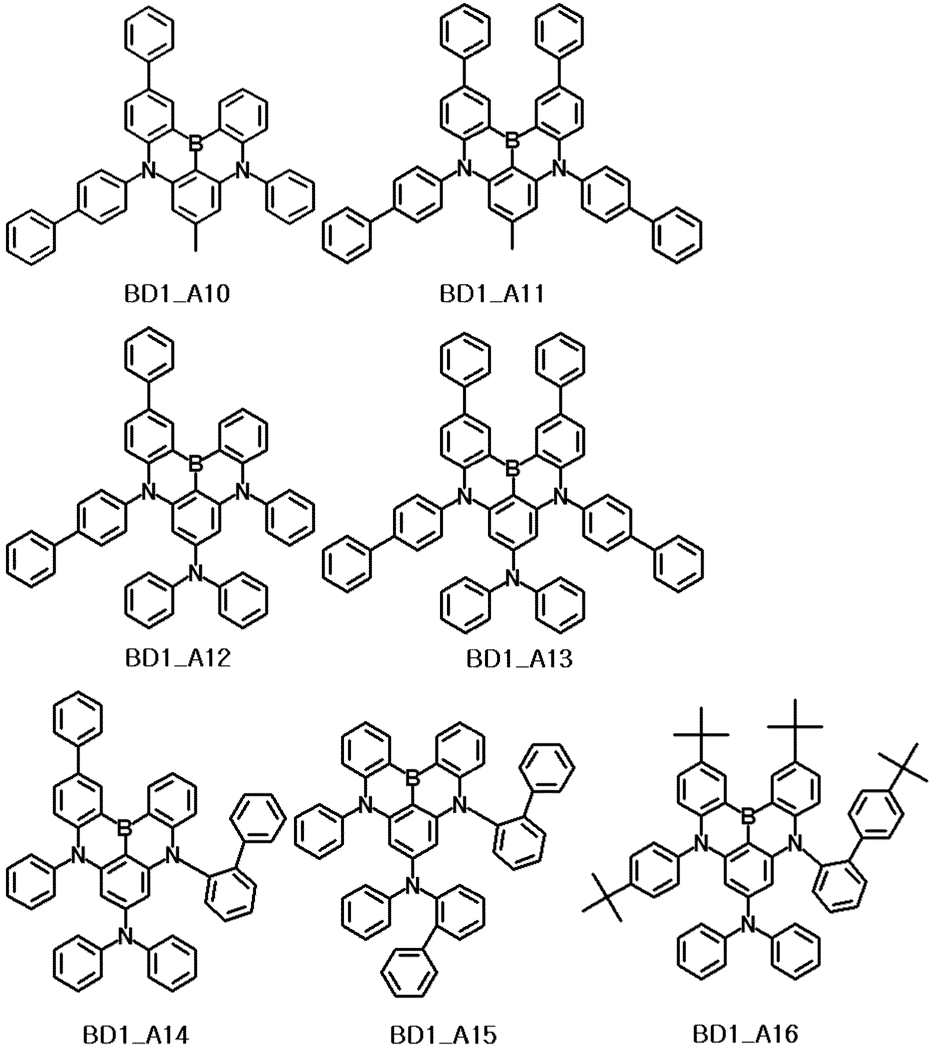

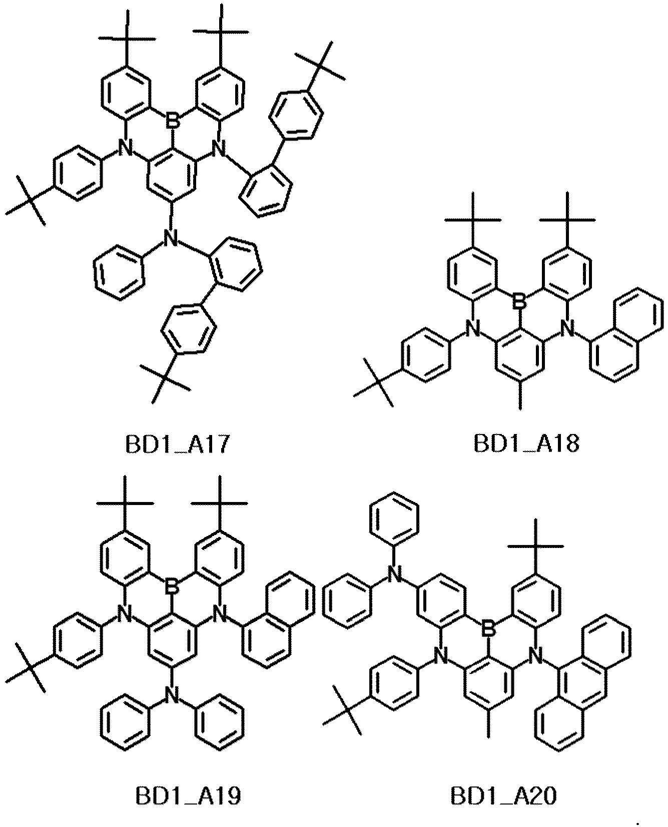

5. The organic light emitting diode according to any of claims 1 to 4, wherein the first host is represented by Formula 1: 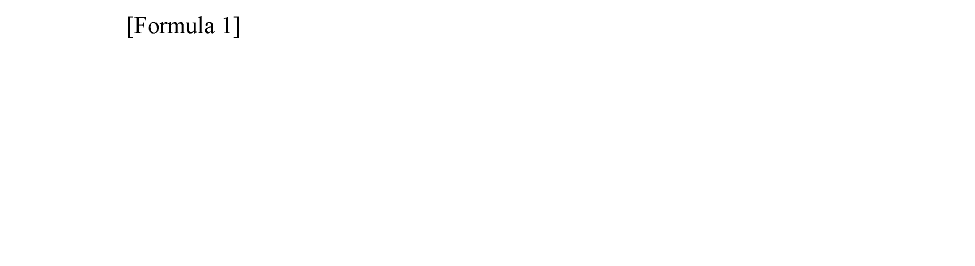 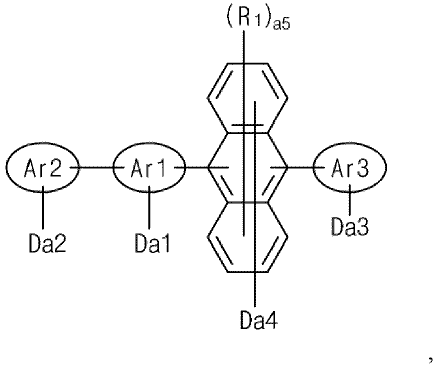
wherein in the Formula 1,
each of a1, a2 and a3 is independently an integer of 0 or 30, each of a4 and a5 is independently an integer of 0 to 8, and at least one of a1 to a4 is a positive integer,
Ar1 is selected from the group consisting of a single bond (a direct bond), a substituted or unsubstituted C6 to C30 arylene group and a substituted or unsubstituted C3 to C30 heteroarylene group,
each of Ar2 and Ar3 is selected from the group consisting of a substituted or unsubstituted C6 to C30 aryl group and a substituted or unsubstituted C3 to C30 heteroaryl group, and
R₁ is selected from the group consisting of a C1 to C30 alkyl group unsubstituted or substituted with deuterium and a C3 to C30 cycloalkyl group unsubstituted or substituted with deuterium,
wherein the second host is represented by Formula 5: 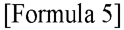 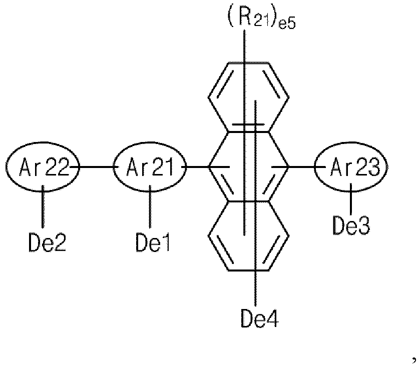
wherein in the Formula 5,
each of e1, e2 and e3 is independently an integer of 0 or 30, each of e4 and e5 is independently an integer of 0 to 8, and a summation of e1 to e4 is smaller than a summation of a1 to a4 in Formula 1,
Ar21 is selected from the group consisting of a single bond (a direct bond), a substituted or unsubstituted C6 to C30 arylene group and a substituted or unsubstituted C3 to C30 heteroarylene group,
each of Ar22 and Ar23 is selected from the group consisting of a substituted or unsubstituted C6 to C30 aryl group and a substituted or unsubstituted C3 to C30 heteroaryl group, and
R₂₁ is selected from the group consisting of a C1 to C30 alkyl group unsubstituted or substituted with deuterium and a C3 to C30 cycloalkyl group unsubstituted or substituted with deuterium.

6. The organic light emitting diode according to any of claims 1 to 5, wherein the first host is represented by Formula 1a: 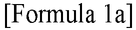 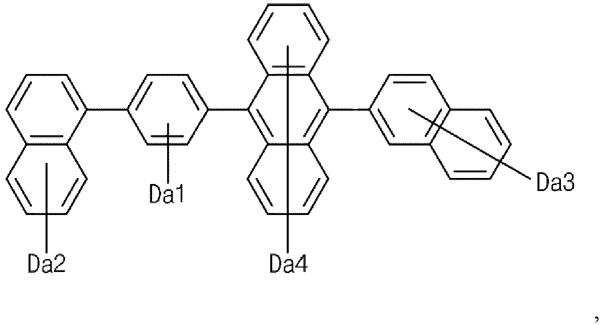
wherein in the Formula 1a, a1 is an integer of 0 to 4, each of a2 and a3 is independently an integer of 0 to 7, a4 is an integer of 0 to 8, and at least one of a1 to a4 is a positive integer,
wherein the second host is represented by Formula 5a: 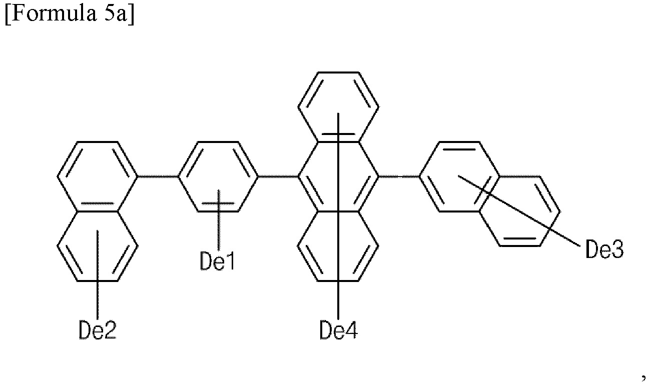
wherein in the Formula 5a, e1 is an integer of 0 to 4, each of e2 and e3 is independently an integer of 0 to 7, e4 is an integer of 0 to 8, and a summation of e1 to e4 is smaller than a summation of a1 to a4 in Formula 1a.

7. The organic light emitting diode according to any of claims 1 to 6, wherein the first host includes at least one of first host compounds in Formula 2:

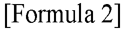

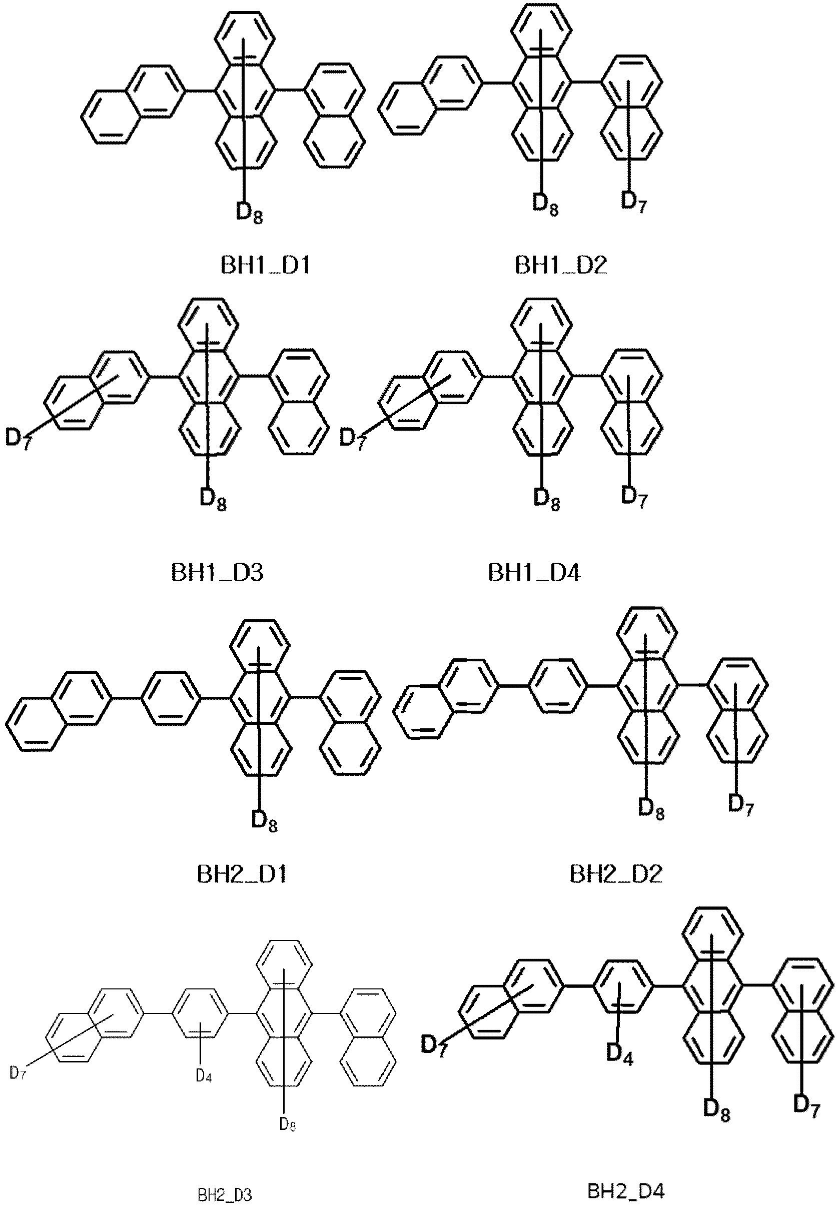

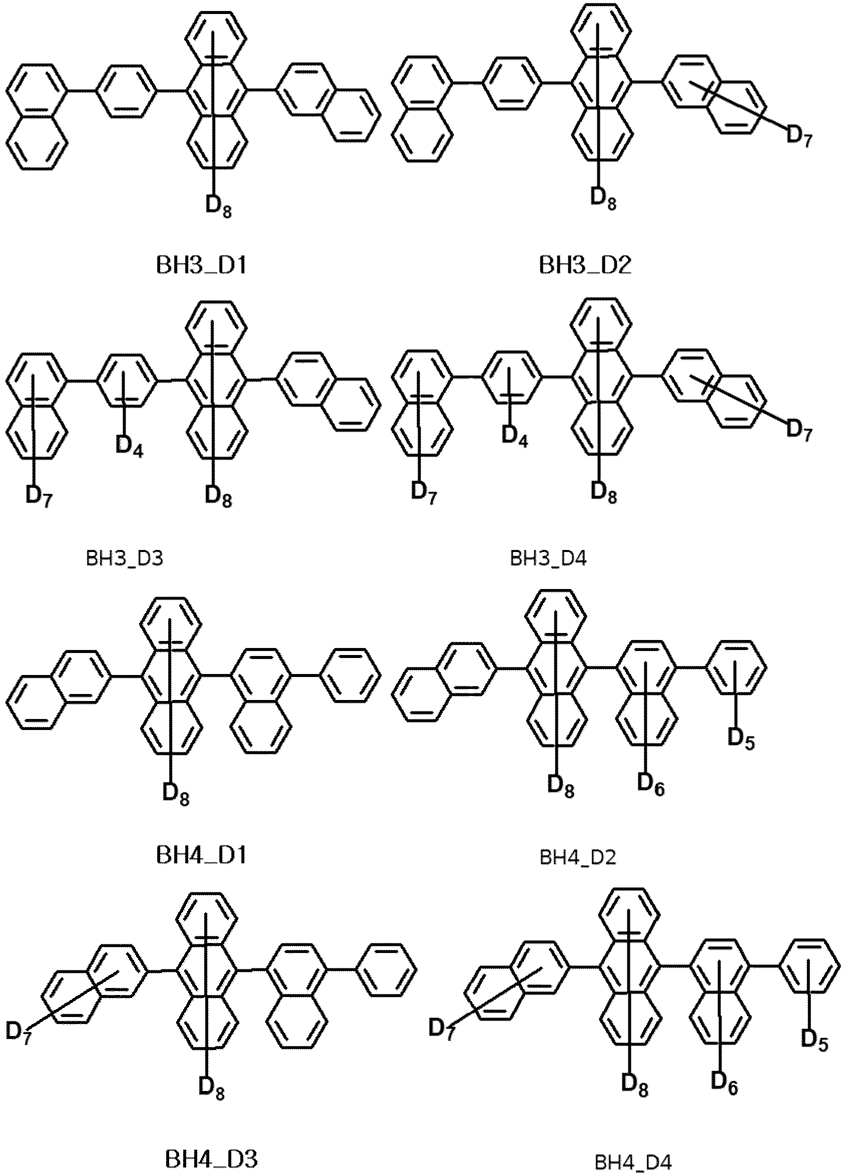

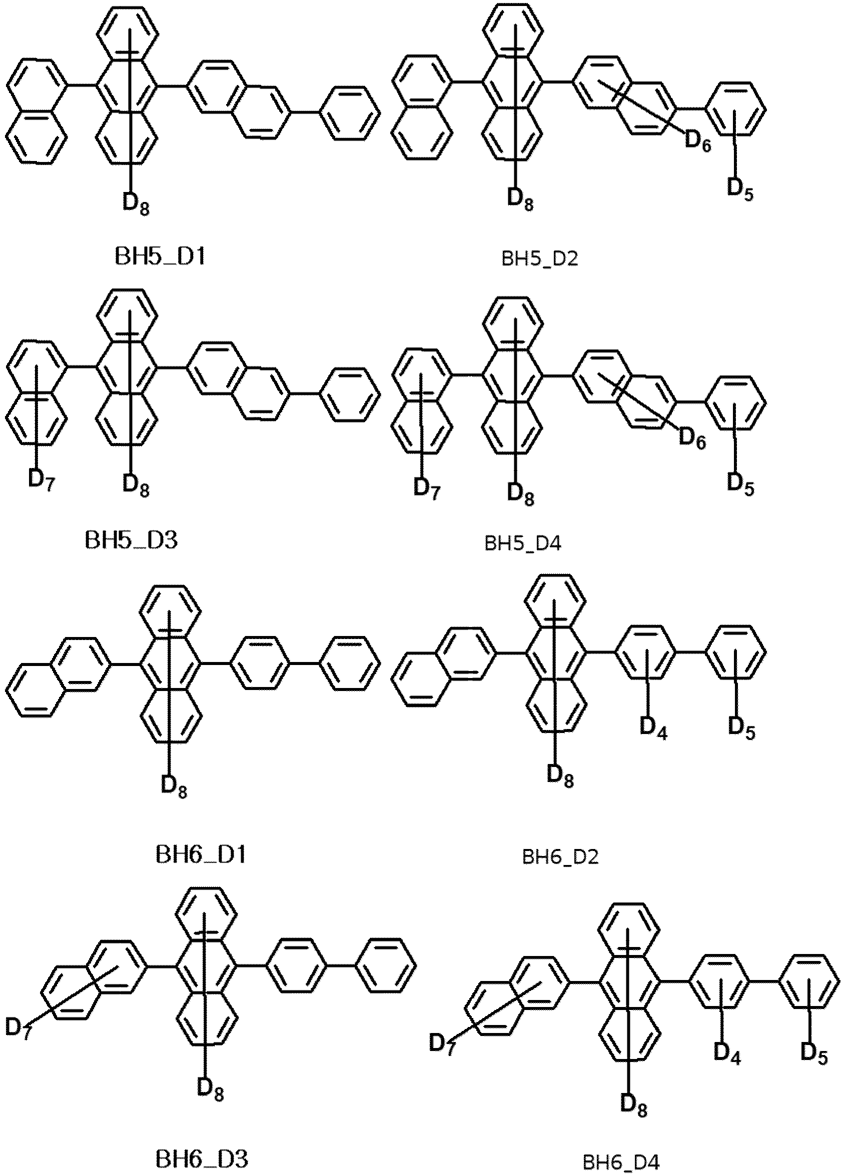

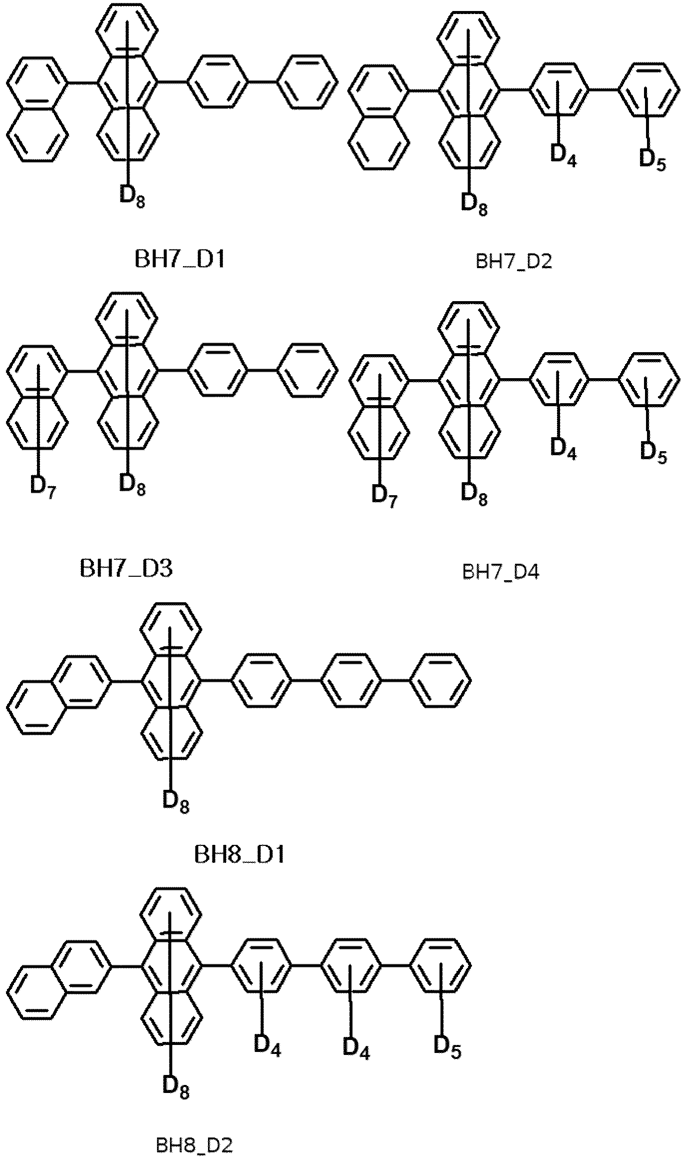

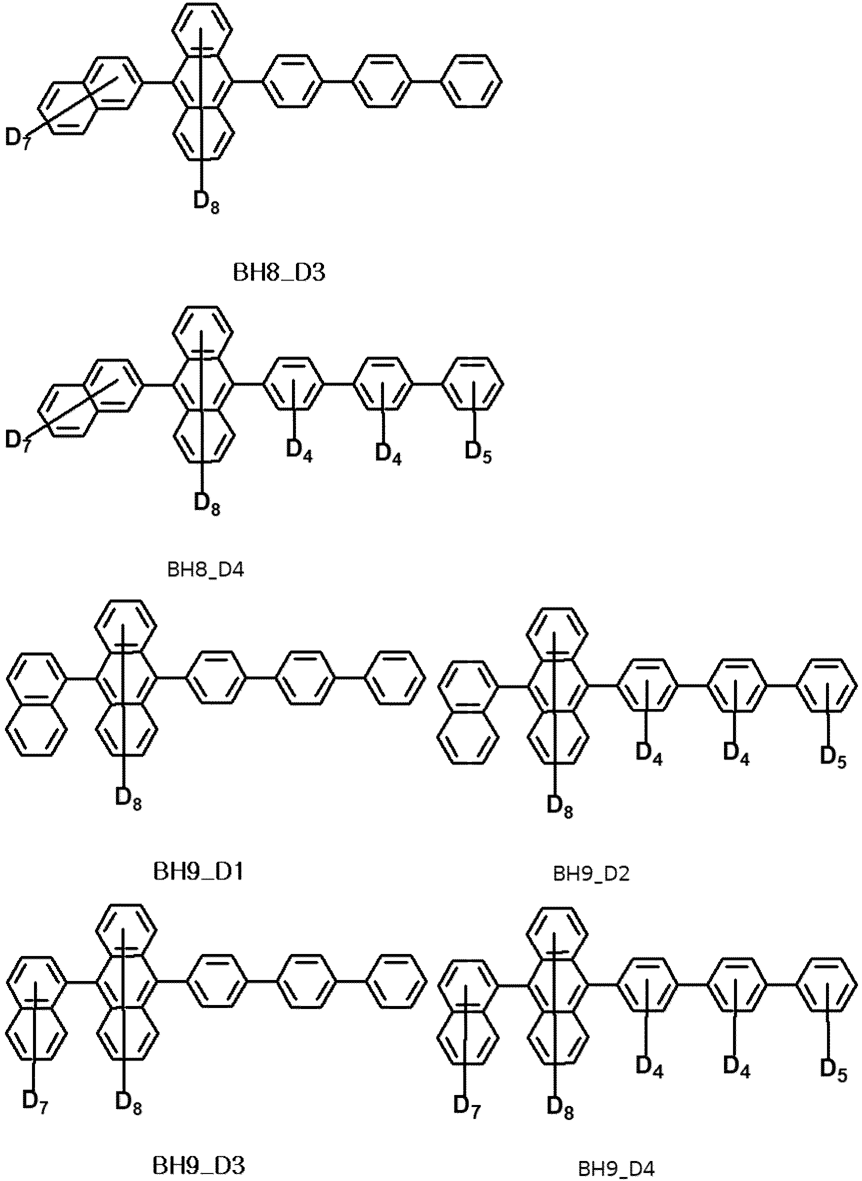

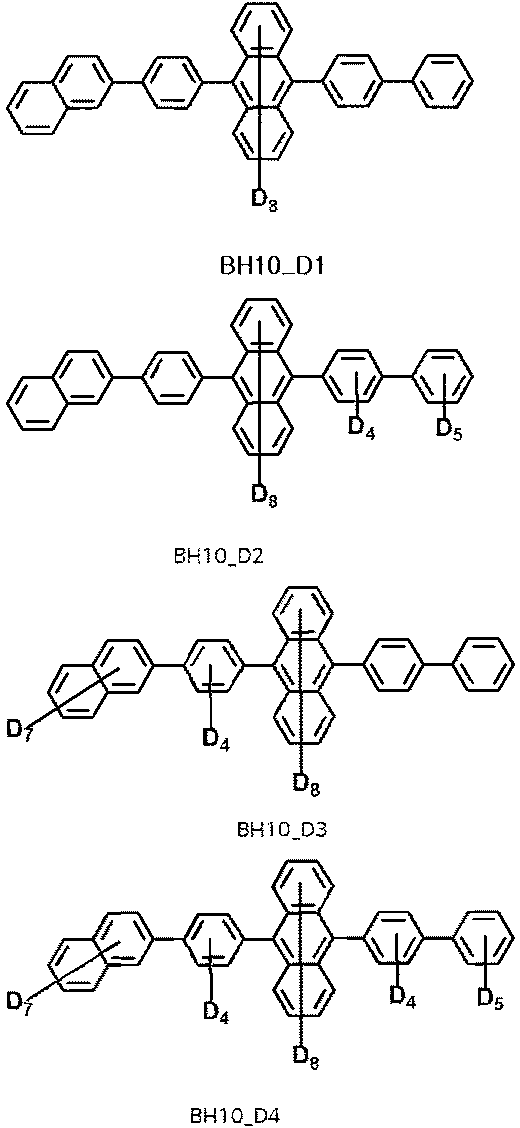

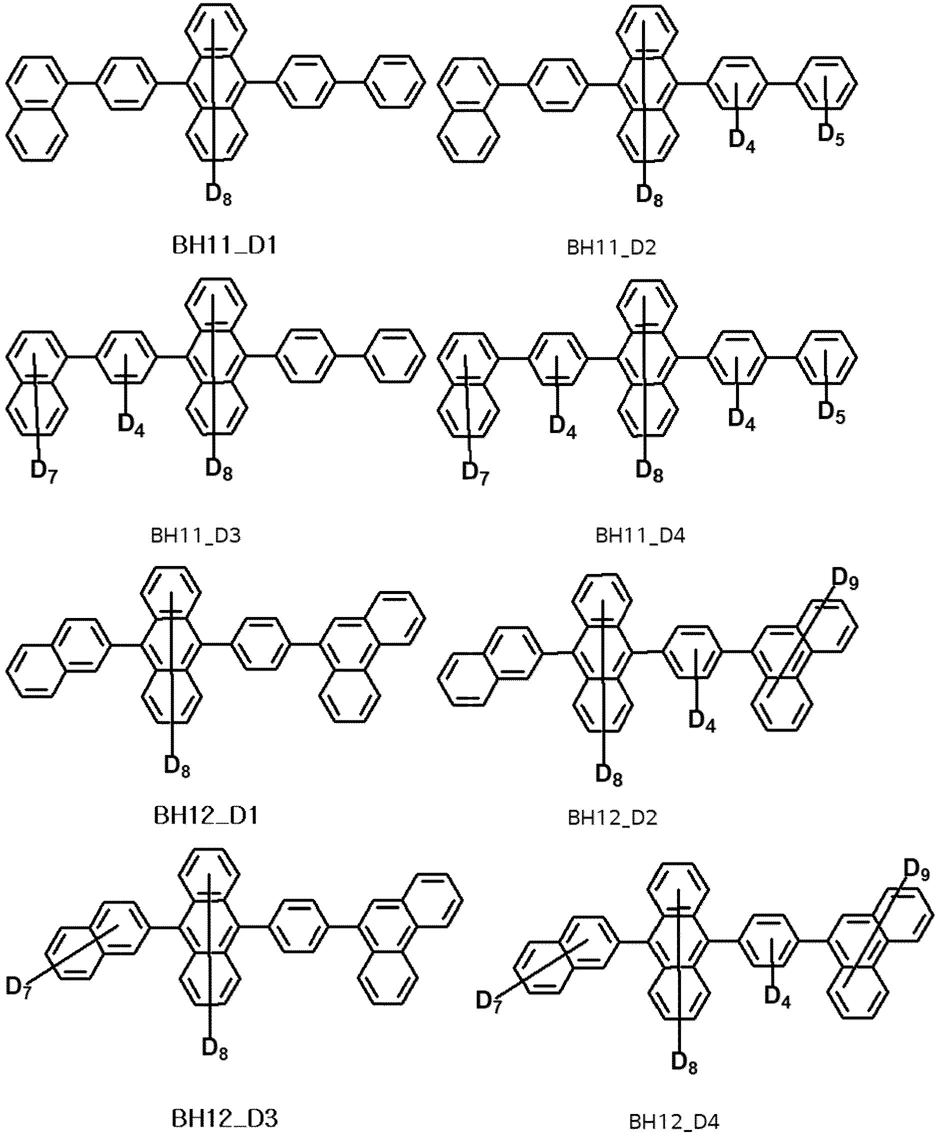

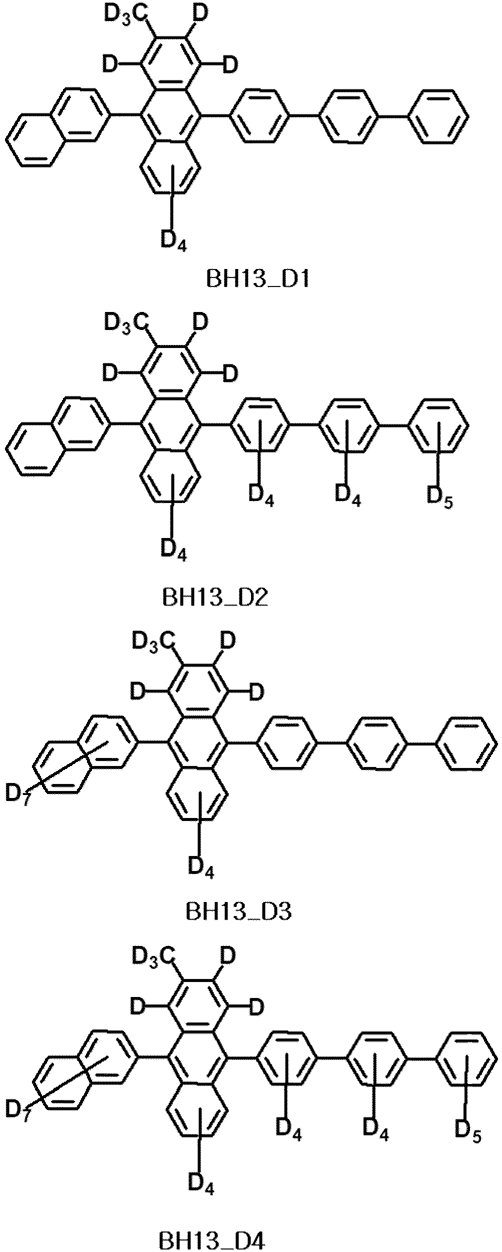

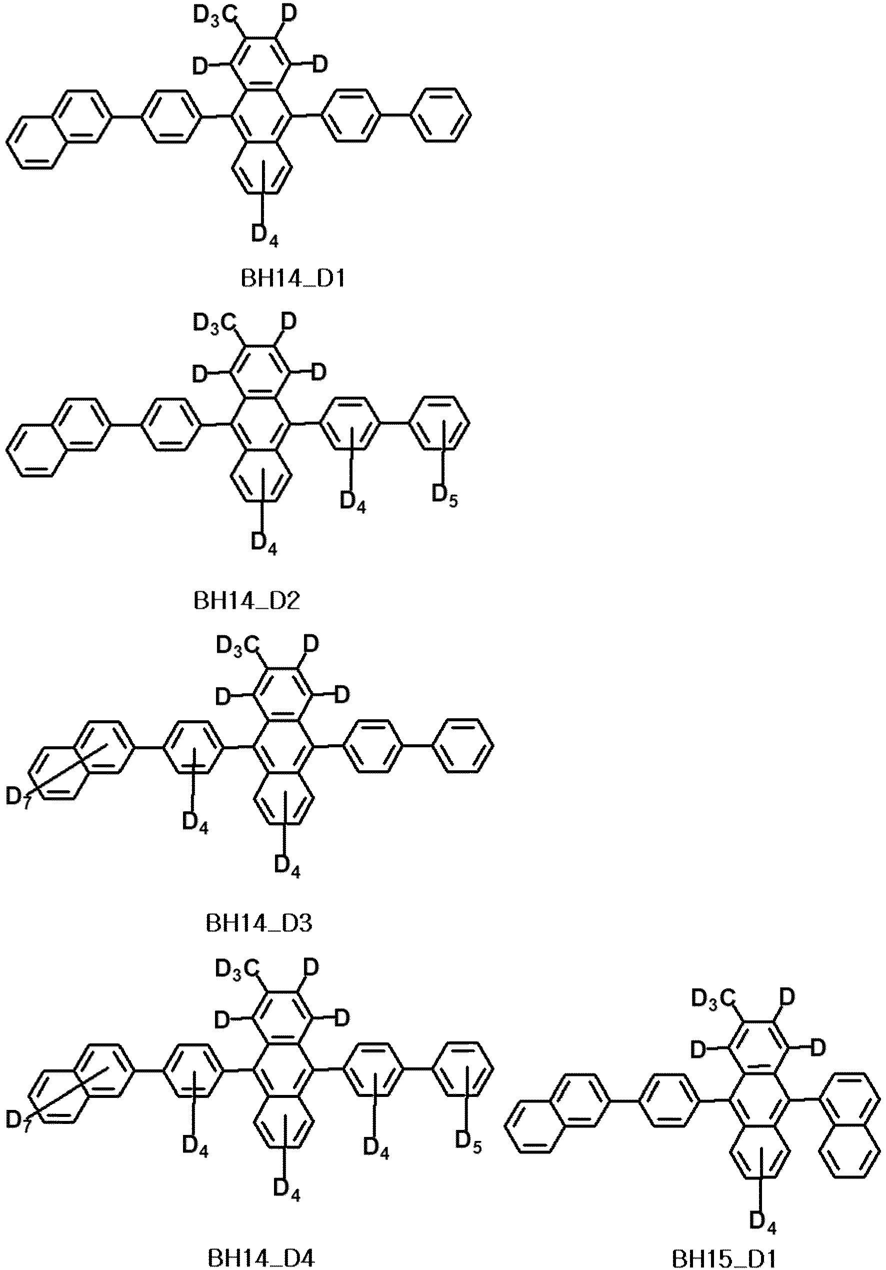

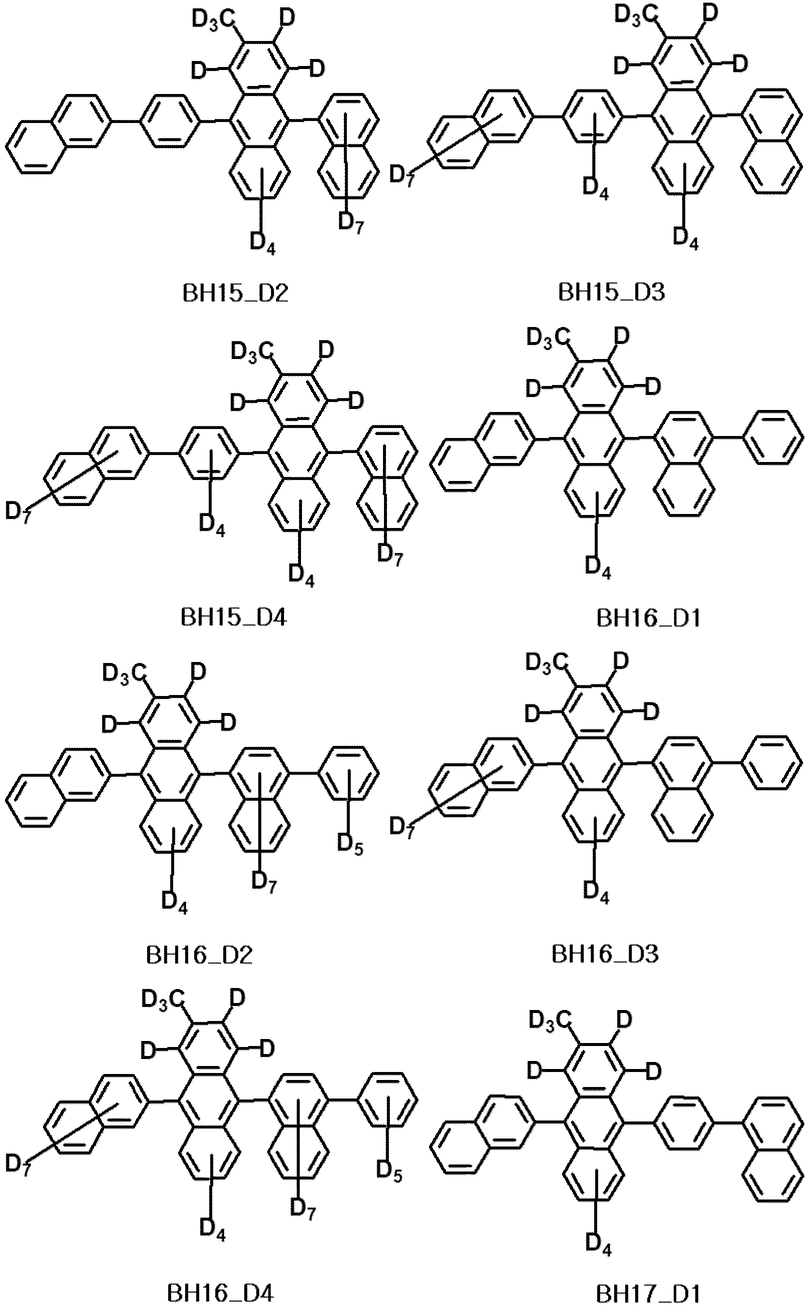

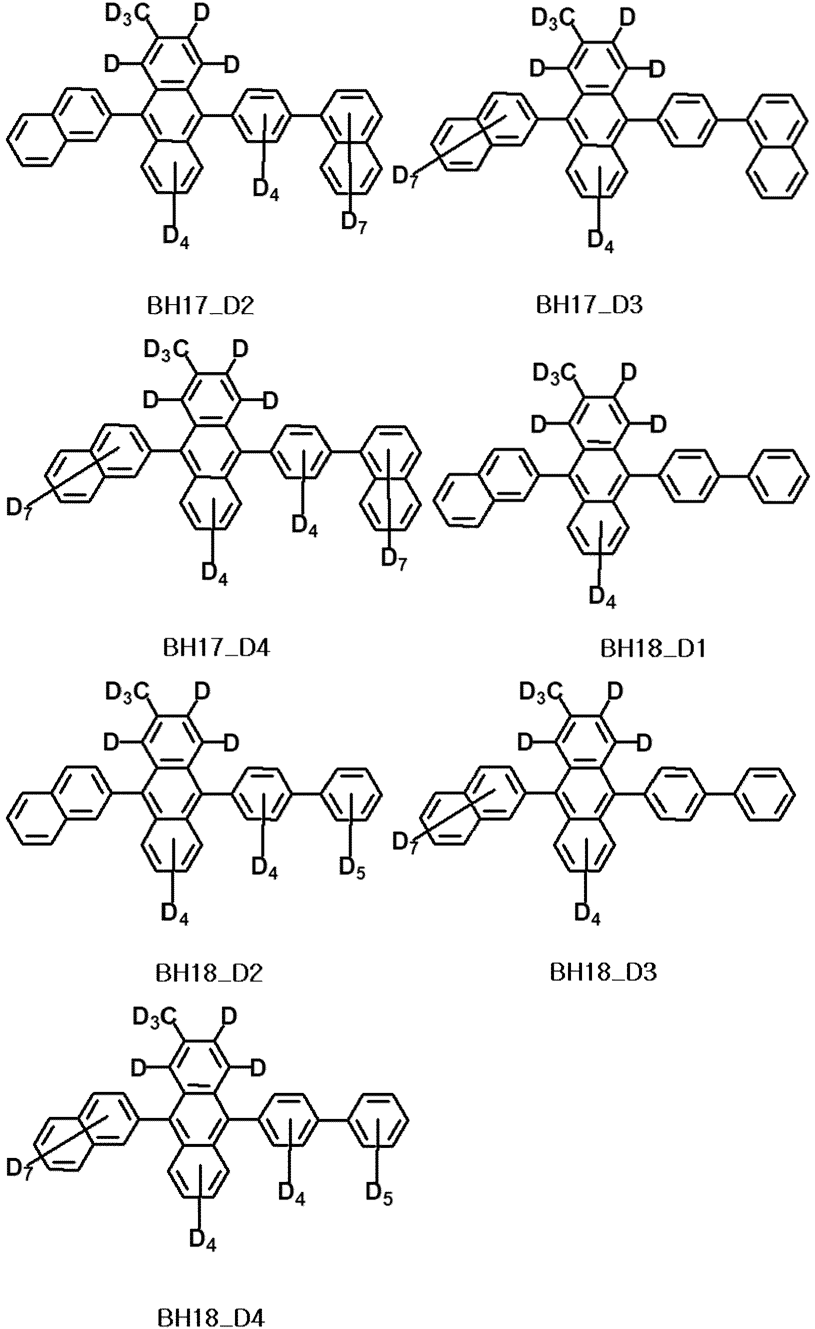

8. The organic light emitting diode according to any of claims 1 to 7, wherein the second host includes at least one of second host compounds in Formula 6:

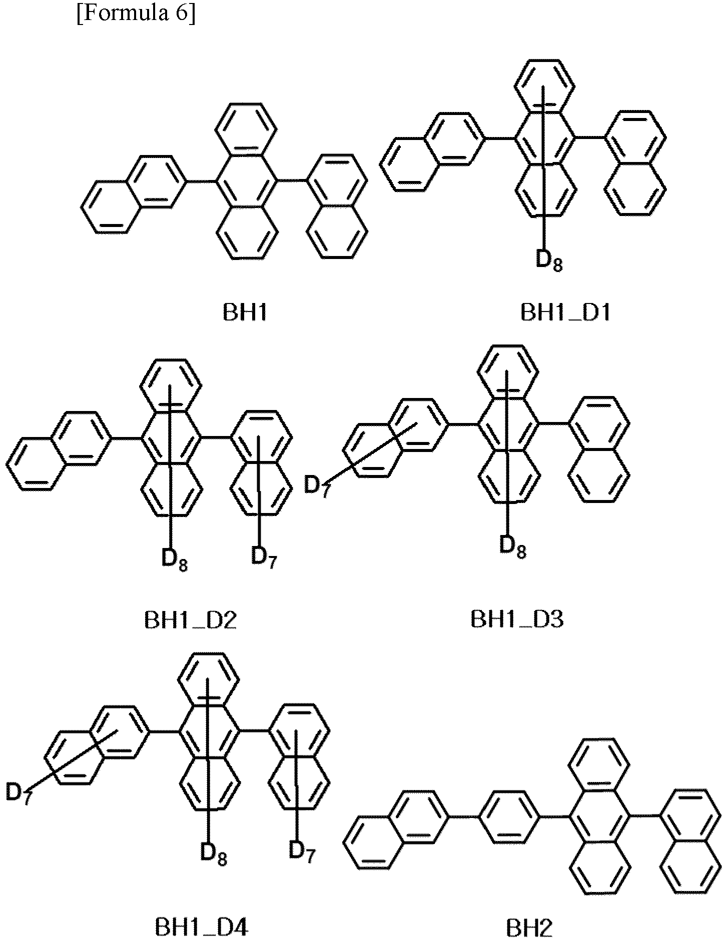

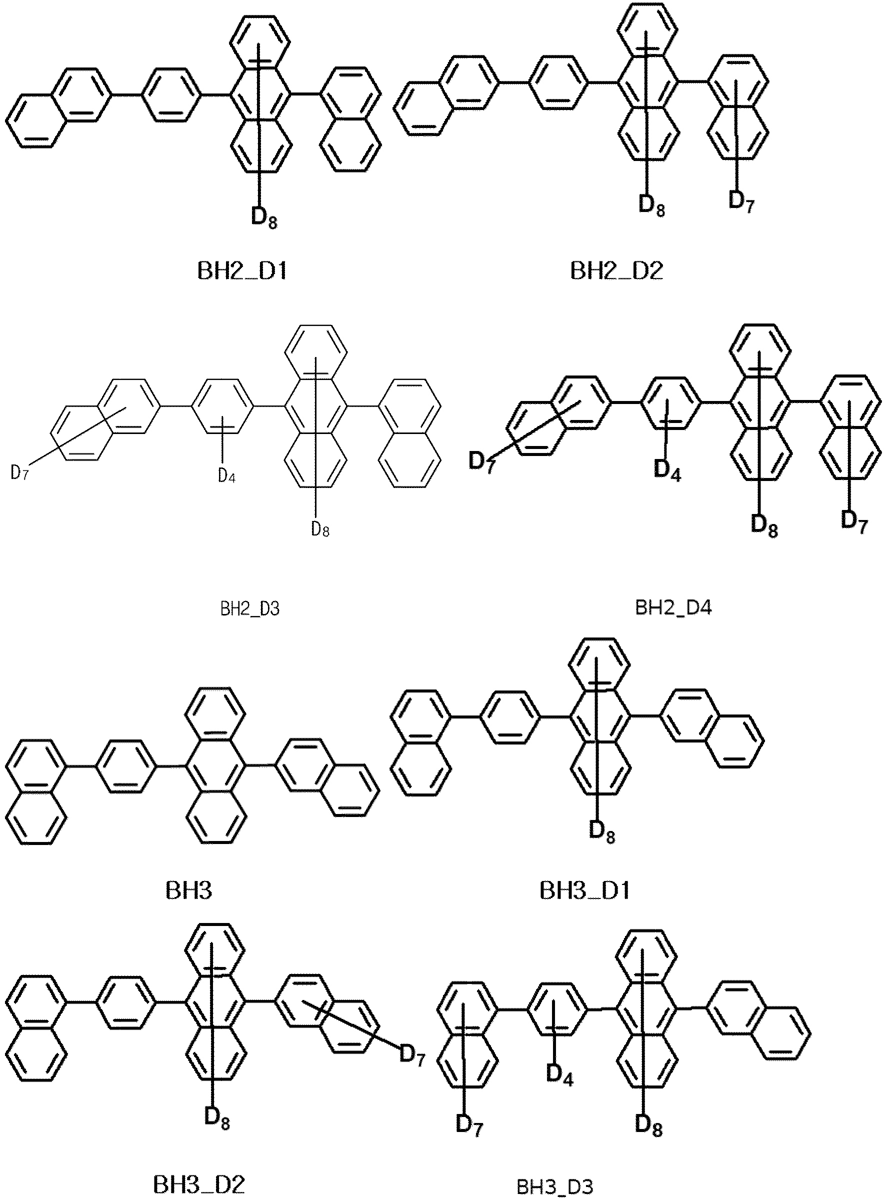

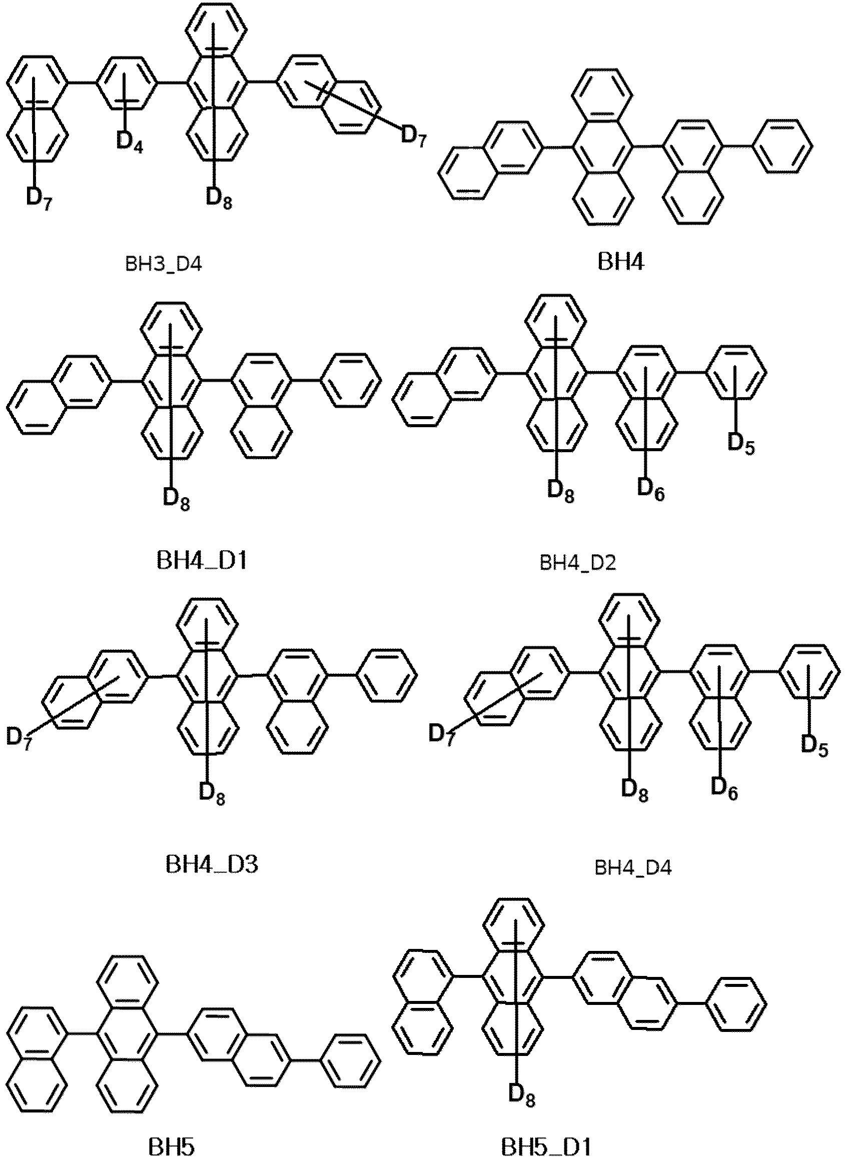

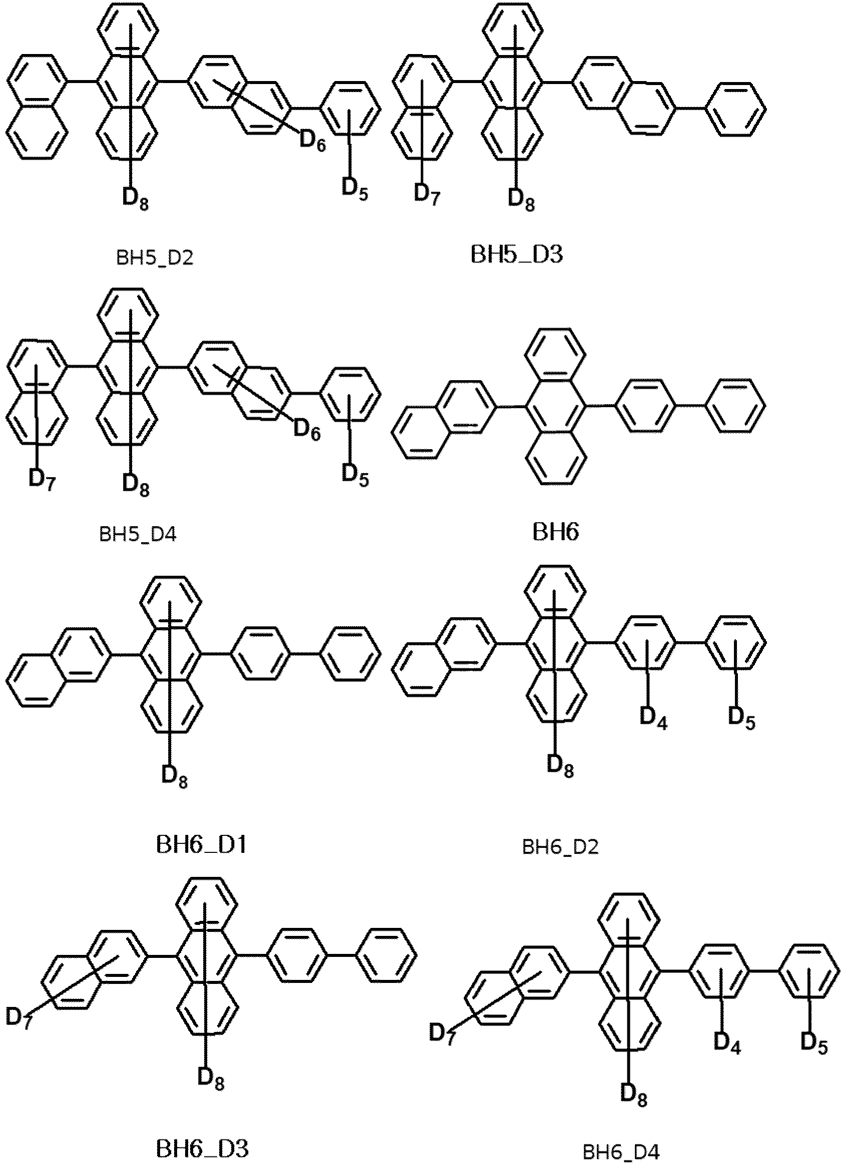

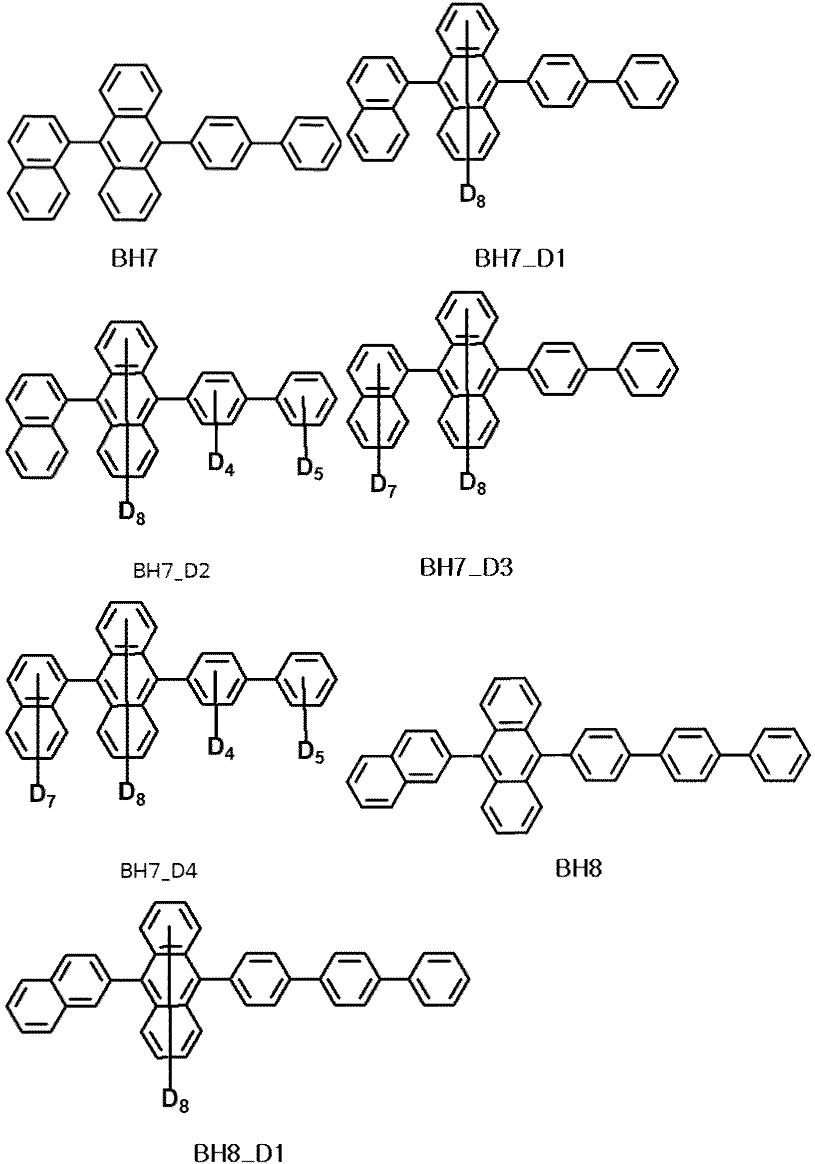

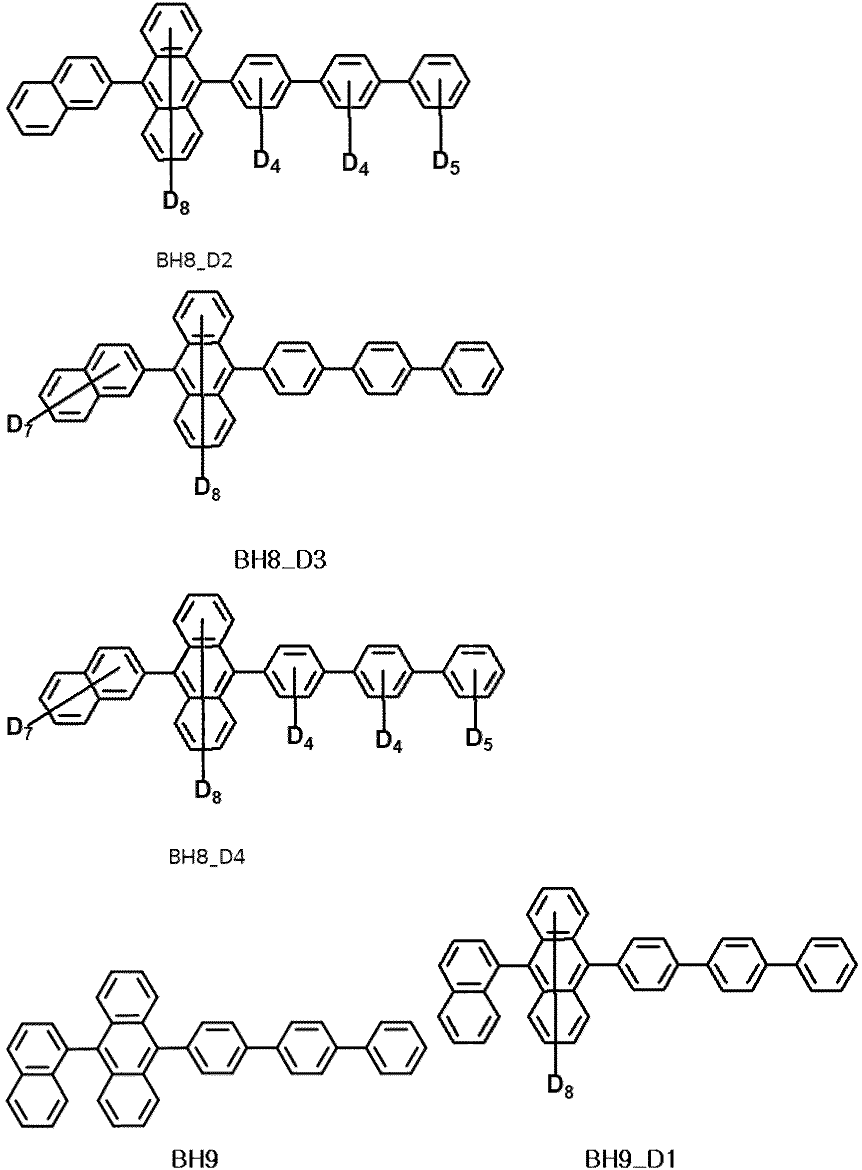

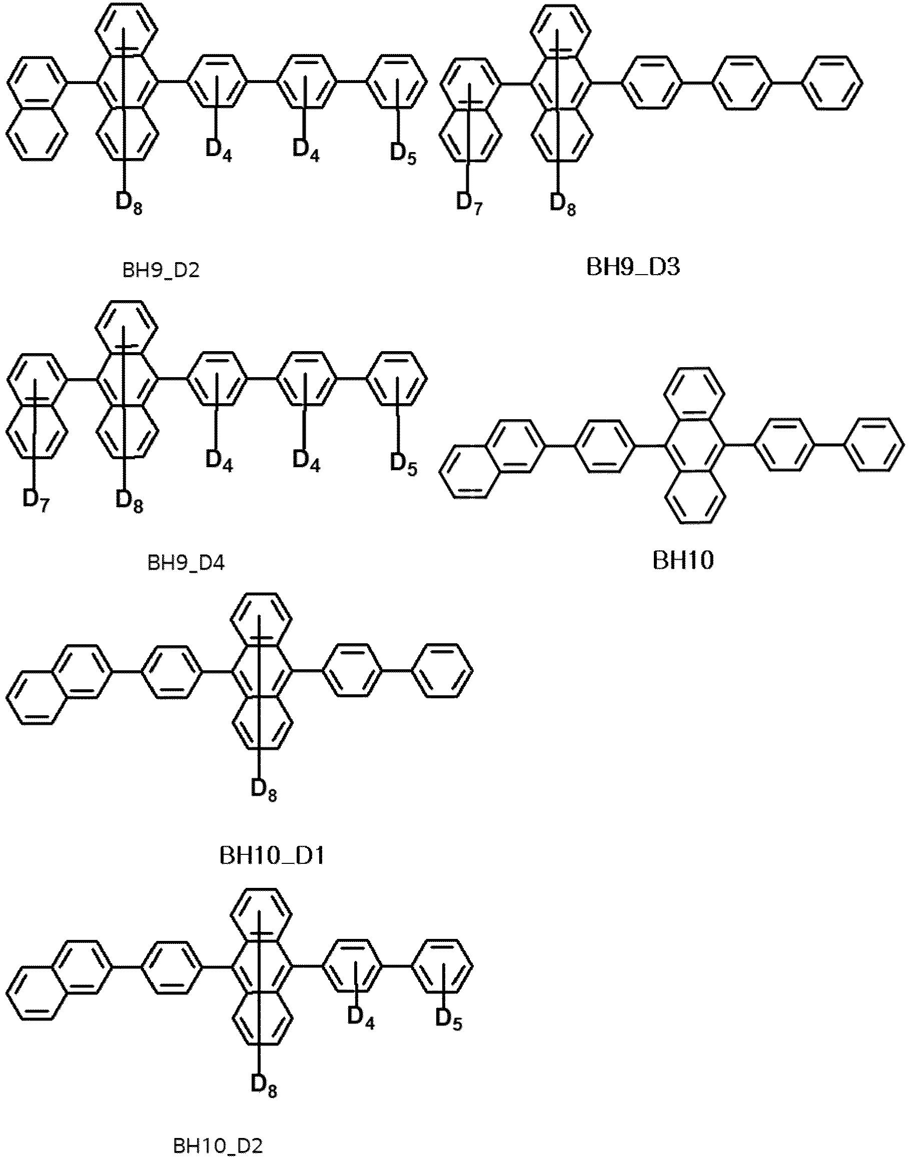

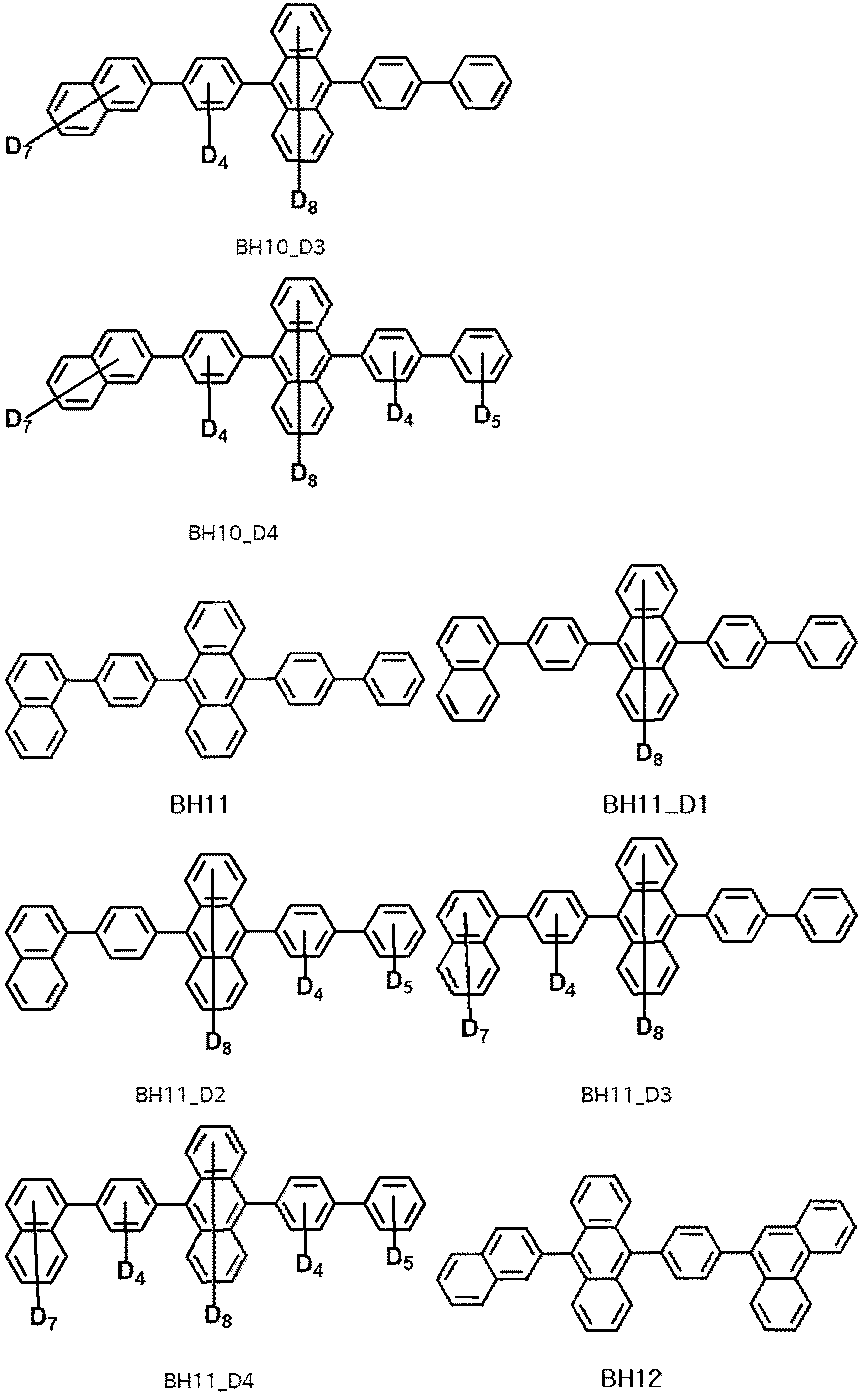

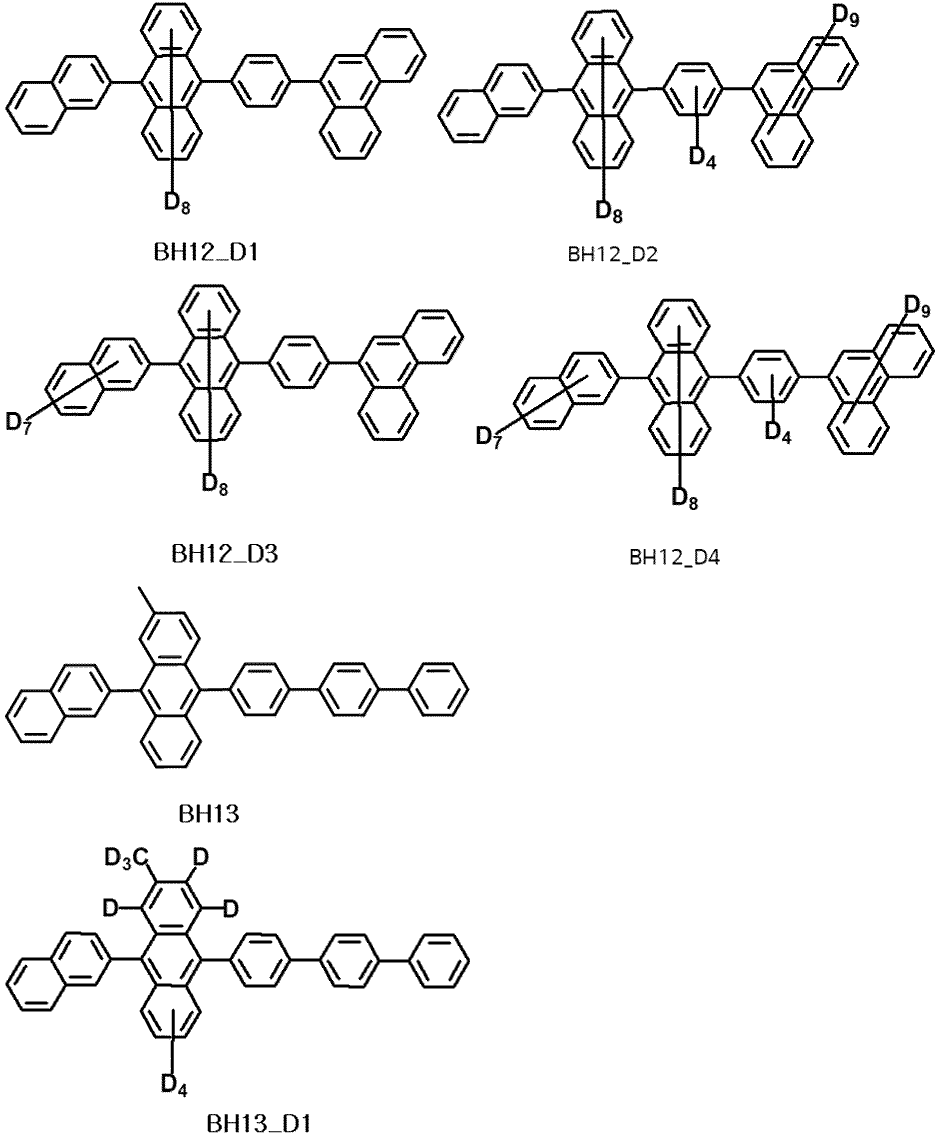

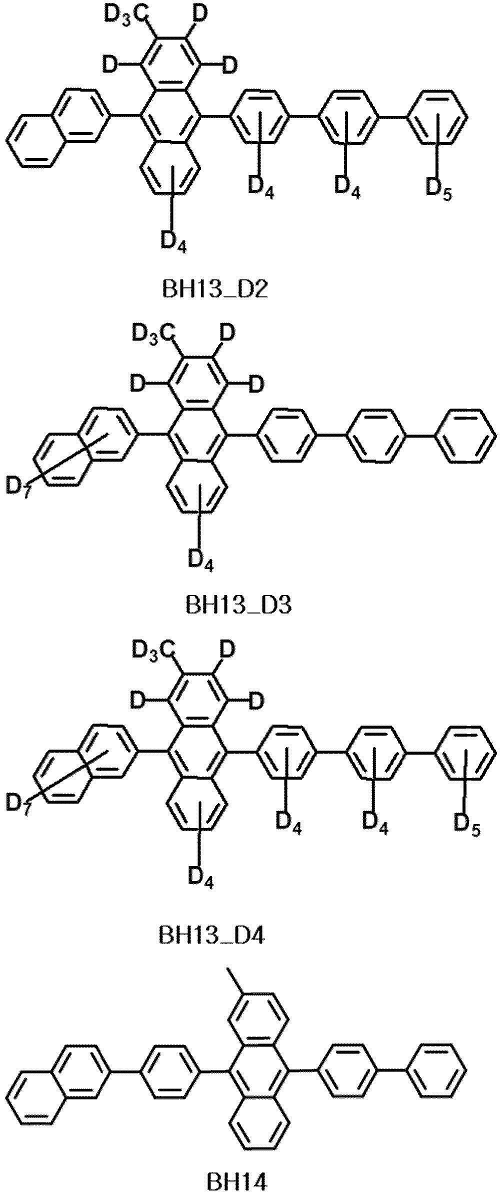

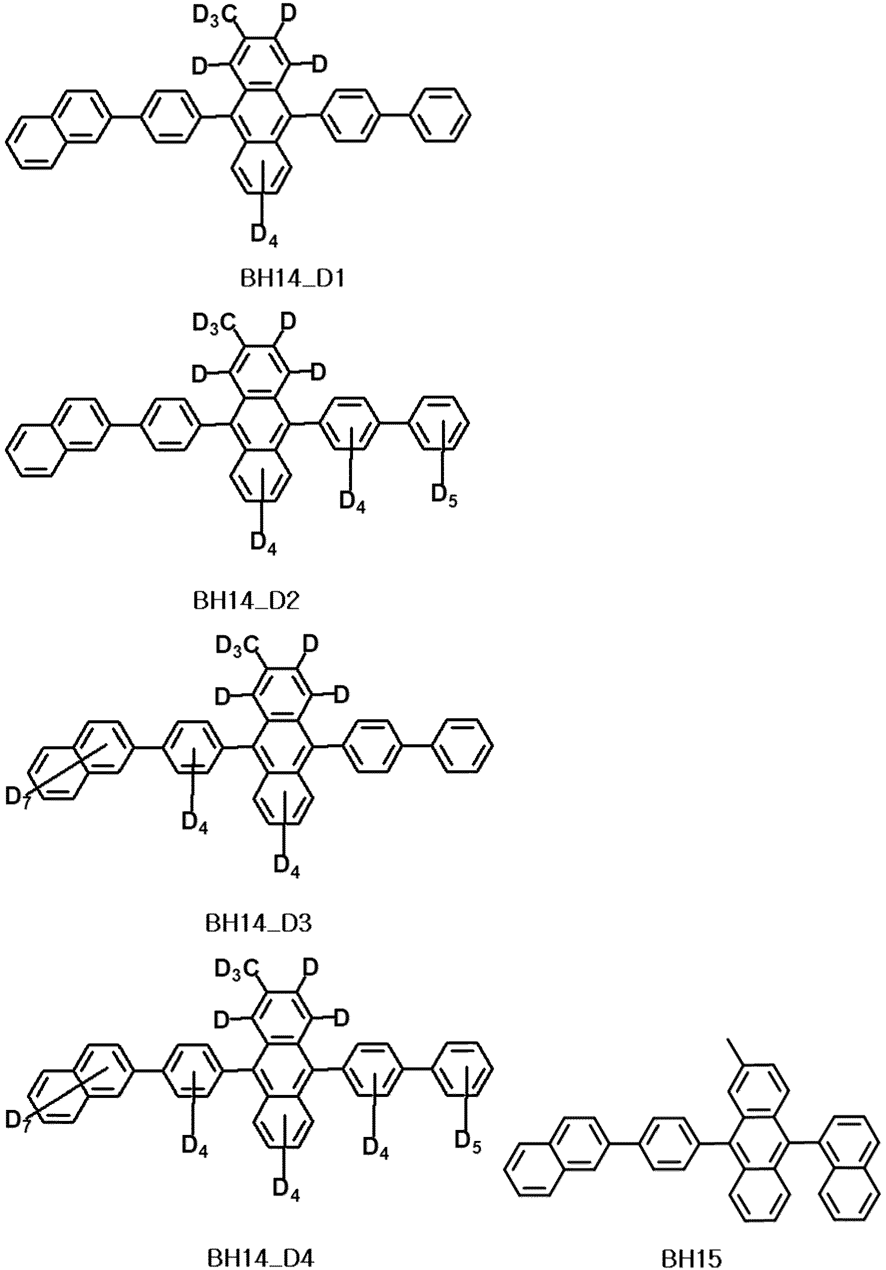

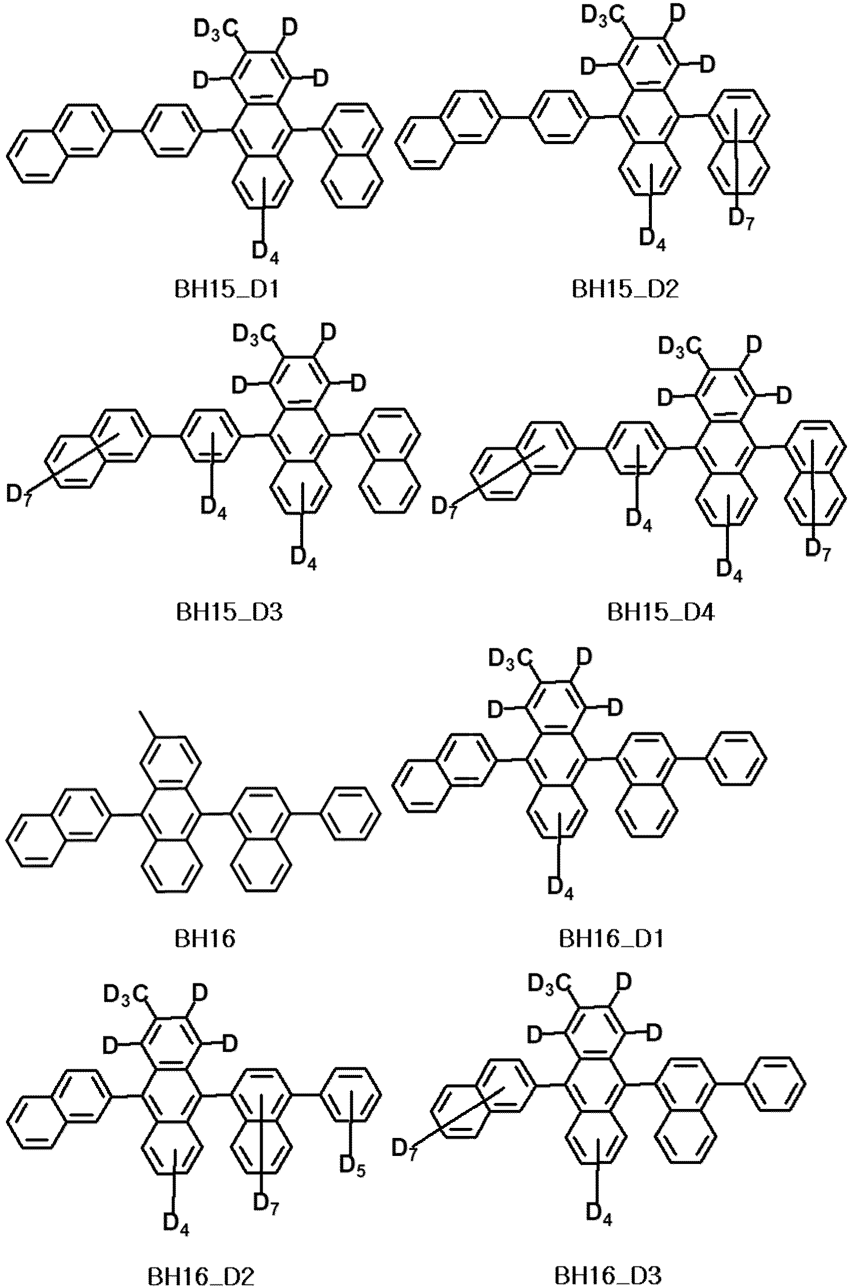

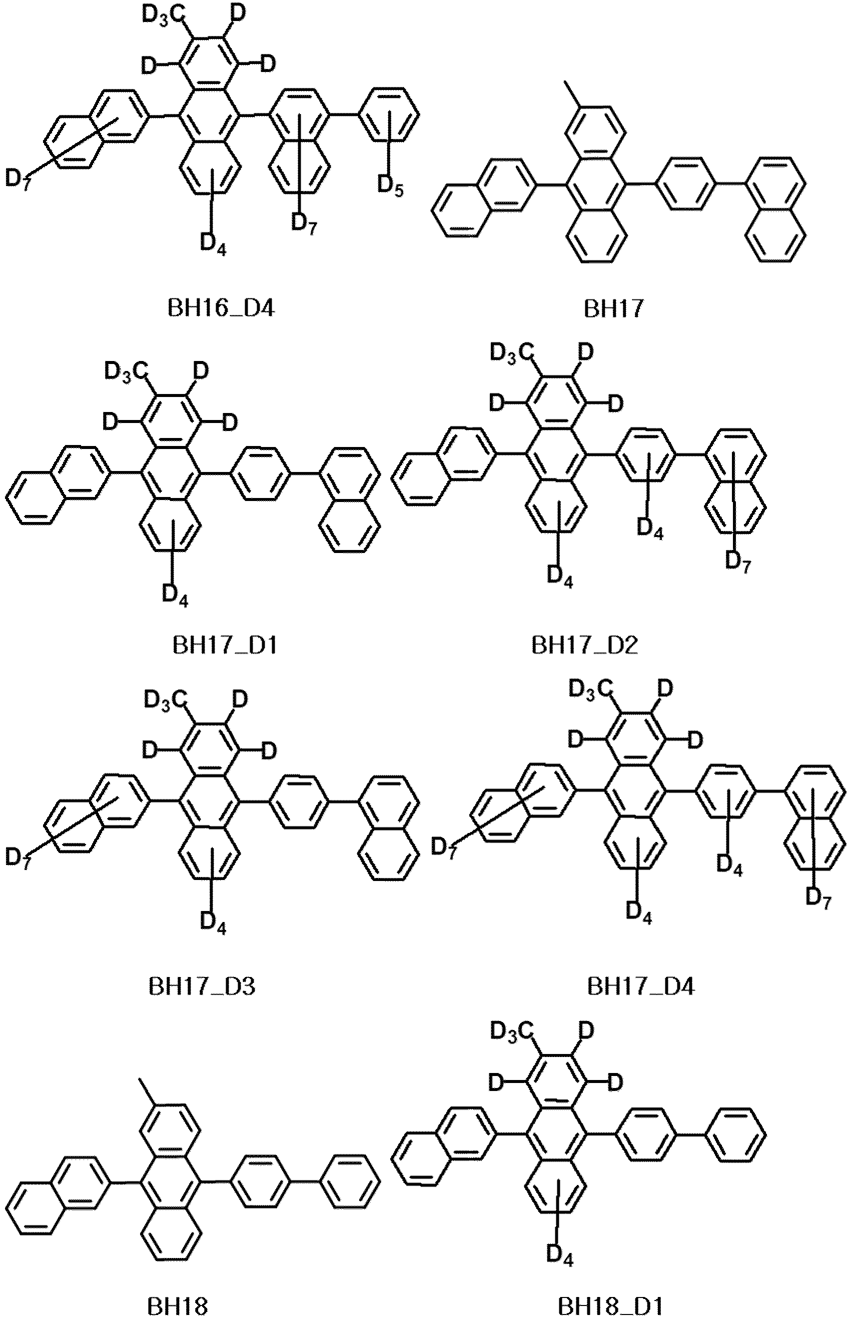

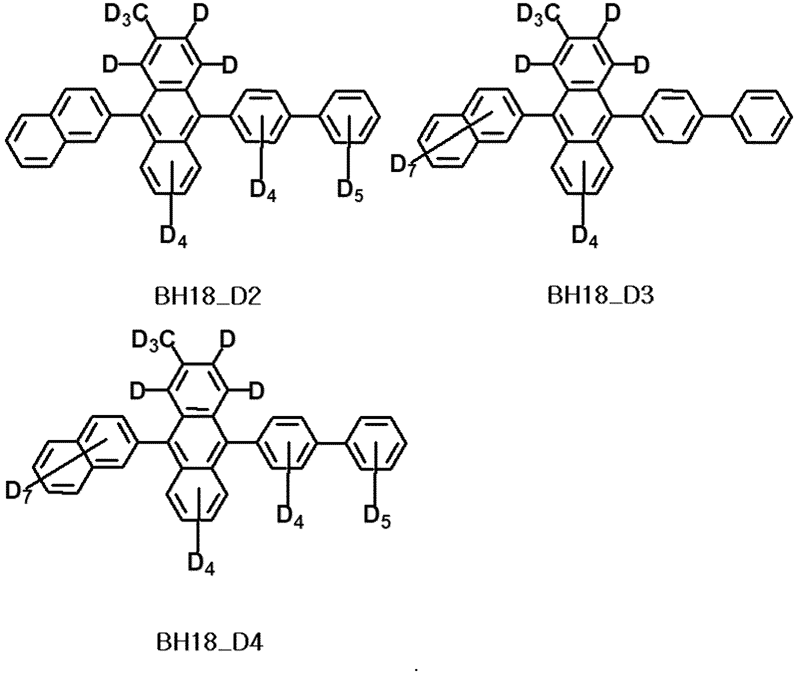

9. The organic light emitting diode according to any of claims 1 to 8, further comprising:
a second emitting part including a third blue emitting layer and a fourth blue emitting layer and positioned between the first emitting part and the second electrode, the fourth blue emitting layer positioned between the third blue emitting layer and the second electrode and contacting the third blue emitting layer,
wherein the third blue emitting layer includes a third host and a third dopant, and the fourth blue emitting layer includes a fourth host and a fourth dopant,
wherein the third host is an anthracene derivative having a third deuteration ratio, and the fourth host is an anthracene derivative having a fourth deuteration ratio smaller than the third deuteration ratio,
wherein the third dopant is a third compound represented by the Formula 3: 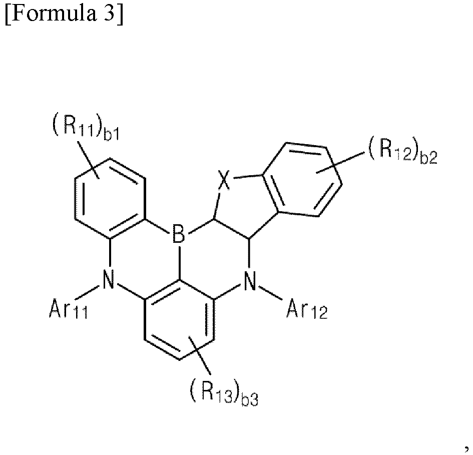
wherein in the Formula 3,
each of b1 and b2 is independently an integer of 0 to 4, and b3 is an integer of 0 to 3, X is O or S,
each of Ar₁₁ and Ar₁₂ is independently selected from the group consisting of a substituted or unsubstituted C6 to C30 aryl group, a substituted or unsubstituted C3 to C30 heteroaryl group and a substituted or unsubstituted C6 to C30 alicyclic group, and
R₁₁, R₁₂ and R₁₃ is independently selected from the group consisting of a substituted or unsubstituted C1 to C30 alkyl group, a substituted or unsubstituted C3 to C30 cycloalkyl group, a substituted or unsubstituted C6 to C30 arylamino group, a substituted or unsubstituted C6 to C30 aryl group and a substituted or unsubstituted C3 to C30 heteroaryl group, or at least one pair of adjacent two or more R₁₁, adjacent two or more R₁₂ and adjacent two or more R₁₃ are connected to each other to form a substitute or unsubstituted ring,
and the fourth dopant is a fourth compound represented by the Formula 7.

10. The organic light emitting diode according to claim 9, wherein the third dopant is represented by Formula 3a: 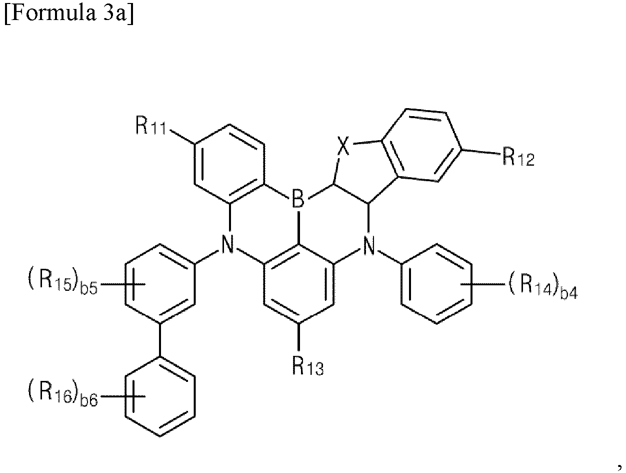
wherein in the Formula 3a, the definitions of X, R₁₁, R₁₂ and R₁₃ is same as those in Formula 3,
each of b4 and b6 is independently an integer of 0 to 5, and b5 is an integer of 0 to 4, each of R₁₄, R₁₅ and R₁₆ is selected from the group consisting of a substituted or unsubstituted C1 to C30 alkyl group and a substituted or unsubstituted C3 to C30 cycloalkyl group, or at least one pair of adjacent two R₁₄ and adjacent R₁₅ and R₁₆ are connected to each other to form a substituted or unsubstituted ring,
wherein the fourth dopant is represented by Formula 7a: 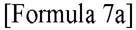 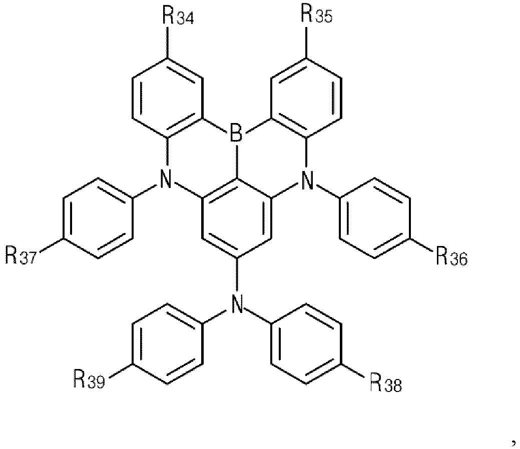
wherein in the Formula 7a, each of R₃₄ to R₃₉ is independently selected from the group consisting of hydrogen, a substituted or unsubstituted C1 to C30 alkyl group, a substituted or unsubstituted C3 to C30 cycloalkyl group, a substituted or unsubstituted C6 to C30 aryl group and a substituted or unsubstituted C3 to C30 heteroaryl group.

11. The organic light emitting diode according to any of claims 9 to 10, wherein the third host is represented by Formula 1: 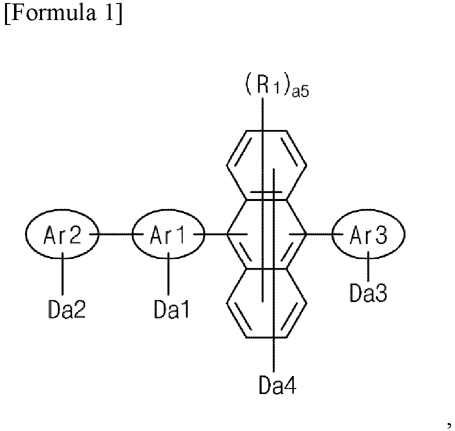
wherein in the Formula 1,
each of a1, a2 and a3 is independently an integer of 0 or 30, each of a4 and a5 is independently an integer of 0 to 8, and at least one of a1 to a4 is a positive integer,
Ar1 is selected from the group consisting of a single bond (a direct bond), a substituted or unsubstituted C6 to C30 arylene group and a substituted or unsubstituted C3 to C30 heteroarylene group,
each of Ar2 and Ar3 is selected from the group consisting of a substituted or unsubstituted C6 to C30 aryl group and a substituted or unsubstituted C3 to C30 heteroaryl group, and
R₁ is selected from the group consisting of a C1 to C30 alkyl group unsubstituted or substituted with deuterium and a C3 to C30 cycloalkyl group unsubstituted or substituted with deuterium,
wherein the fourth host is represented by Formula 5: 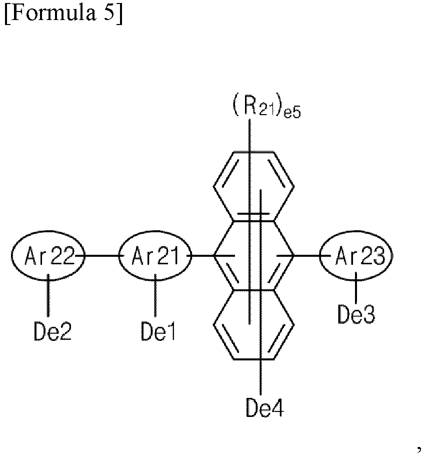
wherein in the Formula 5,
each of e1, e2 and e3 is independently an integer of 0 or 30, each of e4 and e5 is independently an integer of 0 to 8, and a summation of e1 to e4 is smaller than a summation of a1 to a4 in Formula 1,
Ar21 is selected from the group consisting of a single bond (a direct bond), a substituted or unsubstituted C6 to C30 arylene group and a substituted or unsubstituted C3 to C30 heteroarylene group,
each of Ar22 and Ar23 is selected from the group consisting of a substituted or unsubstituted C6 to C30 aryl group and a substituted or unsubstituted C3 to C30 heteroaryl group, and
R₂₁ is selected from the group consisting of a C1 to C30 alkyl group unsubstituted or substituted with deuterium and a C3 to C30 cycloalkyl group unsubstituted or substituted with deuterium.

12. The organic light emitting diode according to any of claims 9 to 11, wherein the third host is represented by Formula 1a: 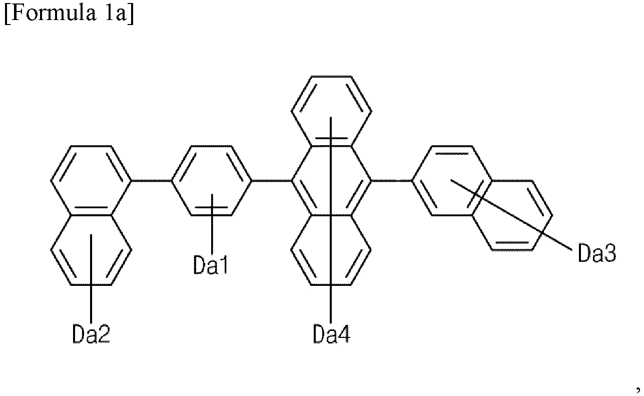
wherein in the Formula 1a, a1 is an integer of 0 to 4, each of a2 and a3 is independently an integer of 0 to 7, a4 is an integer of 0 to 8, and at least one of a1 to a4 is a positive integer,
wherein the fourth host is represented by Formula 5a: 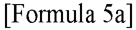 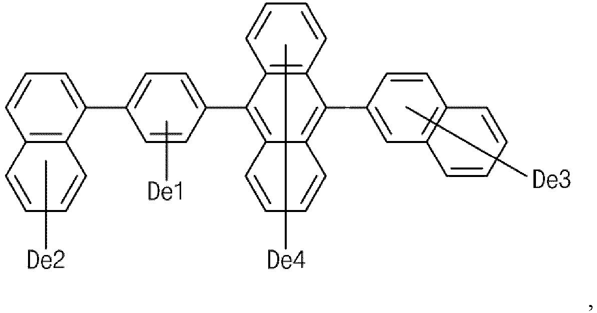
wherein in the Formula 5a, e1 is an integer of 0 to 4, each of e2 and e3 is independently an integer of 0 to 7, e4 is an integer of 0 to 8, and a summation of e1 to e4 is smaller than a summation of a1 to a4 in Formula 1a.

13. The organic light emitting diode according to any one of claims 1 to 12, wherein the first dopant is a boron derivative having a first HOMO energy level, and the second dopant is a boron derivative having a second HOMO energy level lower than the first HOMO energy level, and wherein the first dopant has a first triplet energy, and the second dopant has a second triplet energy greater than the first triplet energy.

14. An organic light emitting device, comprising:
a substrate;
an organic light emitting diode of claim 1 over the substrate; and
an encapsulation layer covering the organic light emitting diode,
wherein the substrate includes a red pixel region, a green pixel region and a blue pixel region, and the organic light emitting diode corresponds to the red pixel region, the green pixel region and the blue pixel region,
wherein the organic light emitting device further comprises: a color filter layer corresponding to the red pixel region, the green pixel region and the blue pixel region and positioned between the substrate and the organic light emitting diode or over the organic light emitting diode, or
wherein the organic light emitting device further comprises: a color conversion layer corresponding to the red pixel region and the green pixel region and positioned between the substrate and the organic light emitting diode or over the organic light emitting diode.

## Patentansprüche

1. Organische Leuchtdiode, umfassend:
eine erste Elektrode;
eine zweite Elektrode, die der ersten Elektrode gegenüberliegt; und
einen ersten emittierenden Teil, der eine erste blau emittierende Schicht und eine zweite blau emittierende Schicht umfasst und zwischen der ersten und der zweiten Elektrode angeordnet ist, wobei die zweite blau emittierende Schicht zwischen der ersten blau emittierenden Schicht und der zweiten Elektrode angeordnet ist und die erste blau emittierende Schicht kontaktiert,
wobei die erste blau emittierende Schicht einen ersten Wirtsstoff und einen ersten Dotierstoff umfasst und die zweite blau emittierende Schicht einen zweiten Wirtsstoff und einen zweiten Dotierstoff umfasst,
wobei der erste Wirtsstoff ein Anthracenderivat mit einem ersten Deuterierungsverhältnis ist und der zweite Wirtsstoff ein Anthracenderivat mit einem zweiten Deuterierungsverhältnis ist, das kleiner als das erste Deuterierungsverhältnis ist, **dadurch gekennzeichnet, dass** der erste Dotierstoff durch die Formel 3a dargestellt wird: 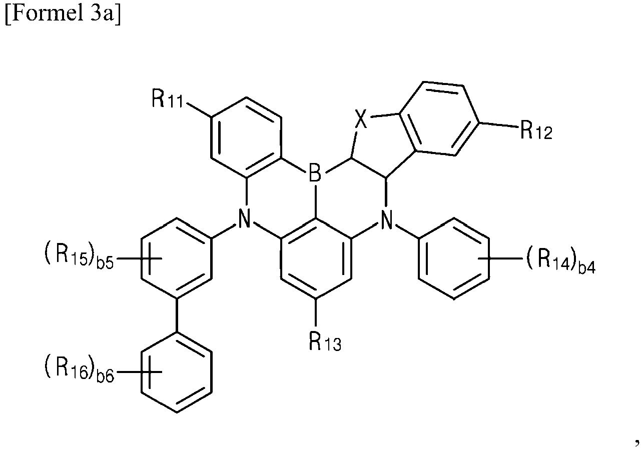
wobei in der Formel 3a
b4 und b6 jeweils unabhängig voneinander eine ganze Zahl von 0 bis 5 sind und b5 eine ganze Zahl von 0 bis 4 ist,
X O oder S ist,
R₁₁, R₁₂ und R₁₃ unabhängig voneinander ausgewählt sind aus der Gruppe, bestehend aus einer substituierten oder unsubstituierten C1- bis C30-Alkylgruppe, einer substituierten oder unsubstituierten C3- bis C30-Cycloalkylgruppe, einer substituierten oder unsubstituierten C6- bis C30-Arylaminogruppe, einer substituierten oder unsubstituierten C6- bis C30-Arylgruppe und einer substituierten oder unsubstituierten C3- bis C30-Heteroarylgruppe, oder mindestens ein Paar benachbarter zwei oder mehr R₁₁, benachbarter zwei oder mehr R₁₂ und benachbarter zwei oder mehr R₁₃ miteinander verbunden sind, um einen substituierten oder unsubstituierten Ring zu bilden, und
R₁₄, R₁₅ und R₁₆ jeweils ausgewählt sind aus der Gruppe, bestehend aus einer substituierten oder unsubstituierten C1- bis C30-Alkylgruppe und einer substituierten oder unsubstituierten C3- bis C30-Cycloalkylgruppe, oder mindestens ein Paar benachbarter zwei R₁₄ und benachbarter R₁₅ und R₁₆ miteinander verbunden sind, um einen substituierten oder unsubstituierten Ring zu bilden,
wobei der zweite Dotierstoff eine zweite Verbindung ist, die durch die Formel 7 dargestellt wird: 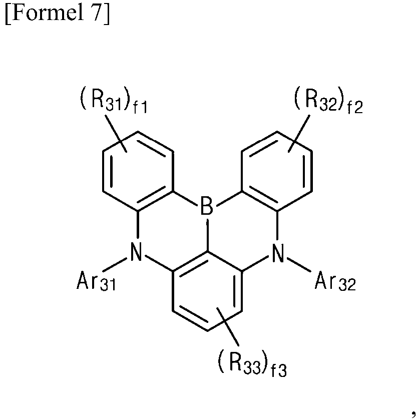
wobei in der Formel 7
f1 und f2 jeweils unabhängig voneinander eine ganze Zahl von 0 bis 4 sind und f3 eine ganze Zahl von 0 bis 3 ist,
Ar₃₁ und Ar₃₂ jeweils unabhängig voneinander ausgewählt sind aus der Gruppe, bestehend aus einer substituierten oder unsubstituierten C6- bis C30-Arylgruppe, einer substituierten oder unsubstituierten C3- bis C30-Heteroarylgruppe und einer substituierten oder unsubstituierten alicyclischen C6- bis C30-Gruppe, und
R₃₁, R₃₂ und R₃₃ unabhängig voneinander ausgewählt sind aus der Gruppe, bestehend aus einer substituierten oder unsubstituierten C1- bis C30-Alkylgruppe, einer substituierten oder unsubstituierten C3- bis C30-Cycloalkylgruppe, einer substituierten oder unsubstituierten C6- bis C30-Arylaminogruppe, einer substituierten oder unsubstituierten C6- bis C30-Arylgruppe und einer substituierten oder unsubstituierten C3- bis C30-Heteroarylgruppe.

2. Organische Leuchtdiode gemäß Anspruch 1, wobei der zweite Dotierstoff durch die Formel 7a dargestellt wird: 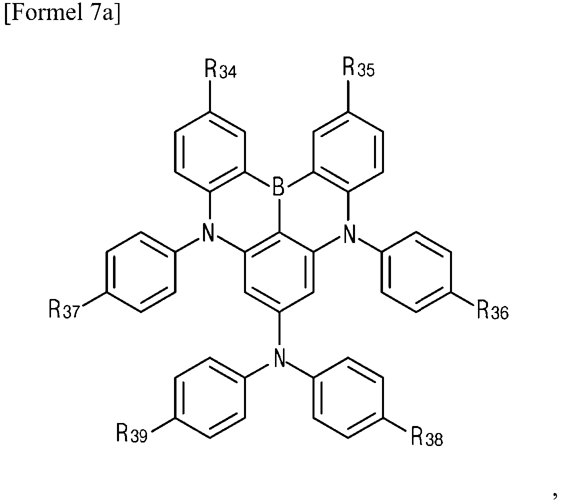 wobei in der Formel 7a R₃₄ bis R₃₉ jeweils unabhängig voneinander ausgewählt sind aus der Gruppe, bestehend aus Wasserstoff, einer substituierten oder unsubstituierten C1- bis C30-Alkylgruppe, einer substituierten oder unsubstituierten C3- bis C30-Cycloalkylgruppe, einer substituierten oder unsubstituierten C6- bis C30-Arylgruppe und einer substituierten oder unsubstituierten C3- bis C30-Heteroarylgruppe.

3. Organische Leuchtdiode gemäß einem der Ansprüche 1 bis 2, wobei der erste Dotierstoff eine der Verbindungen in der Formel 4 ist:

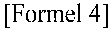

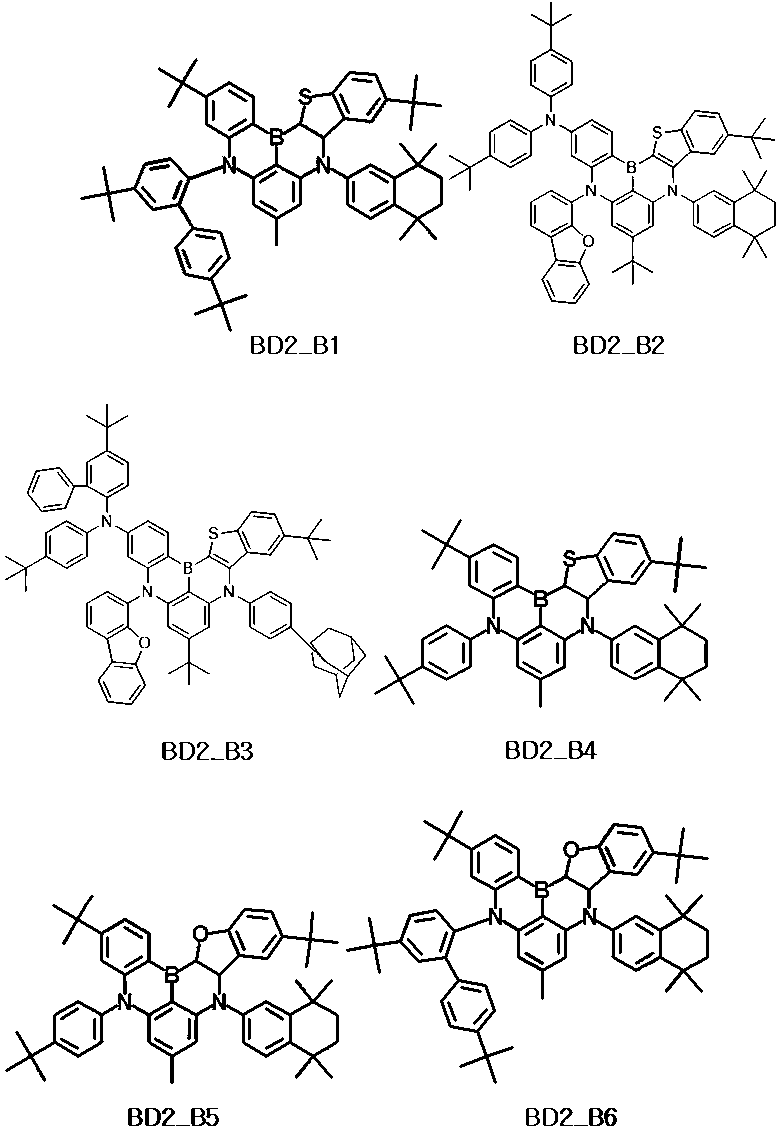

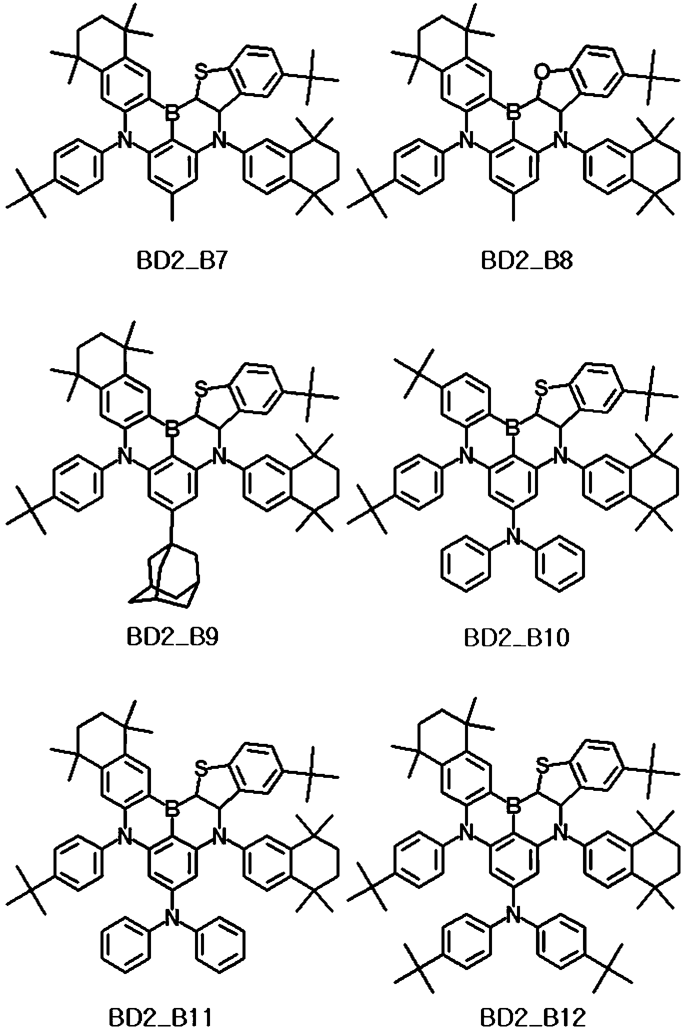

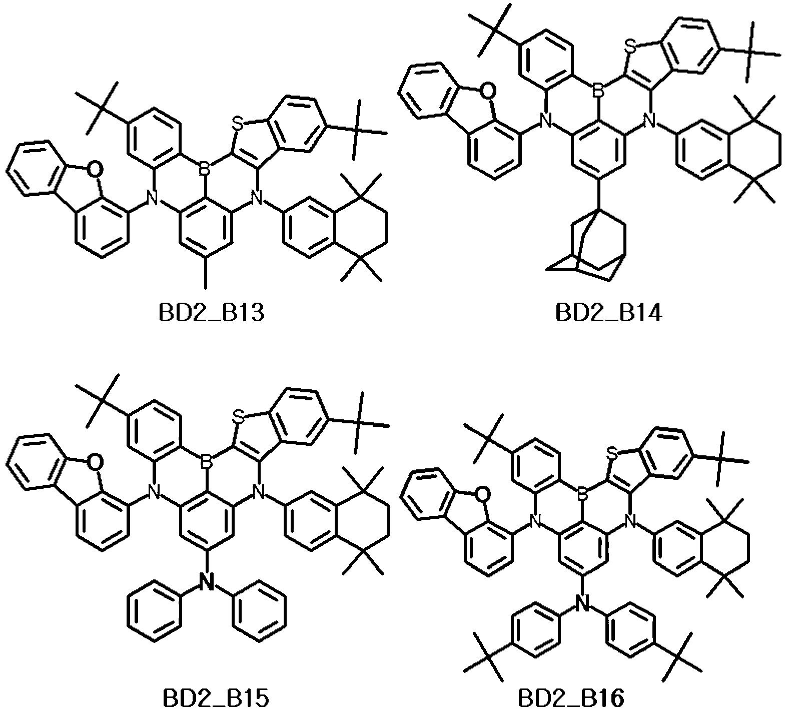

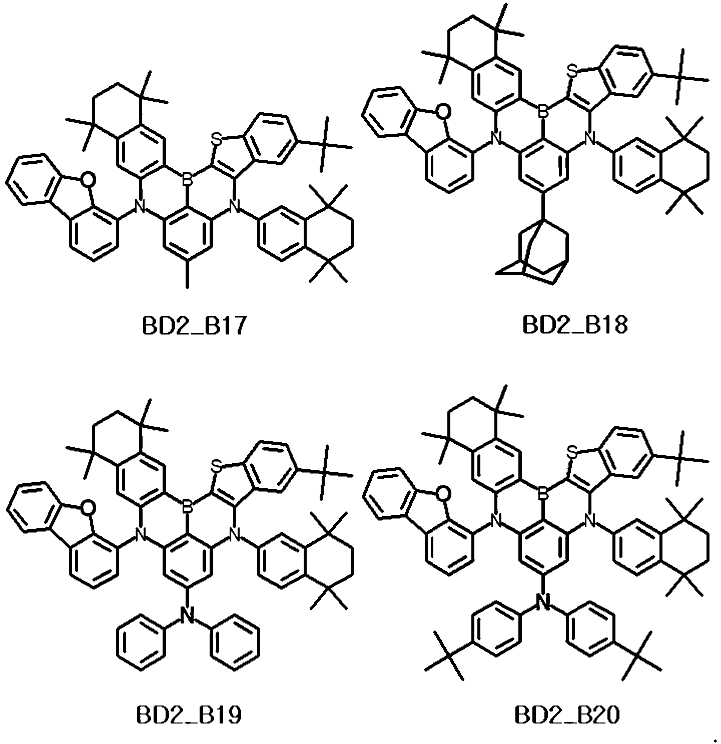

4. Organische Leuchtdiode gemäß einem der Ansprüche 1 bis 3, wobei der zweite Dotierstoff eine der Verbindungen in der Formel 8 ist:

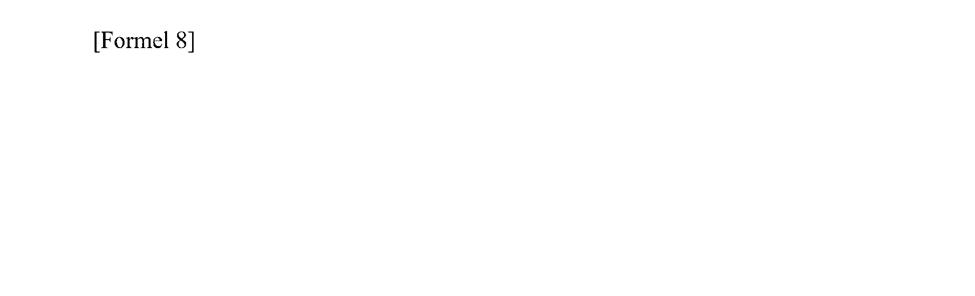

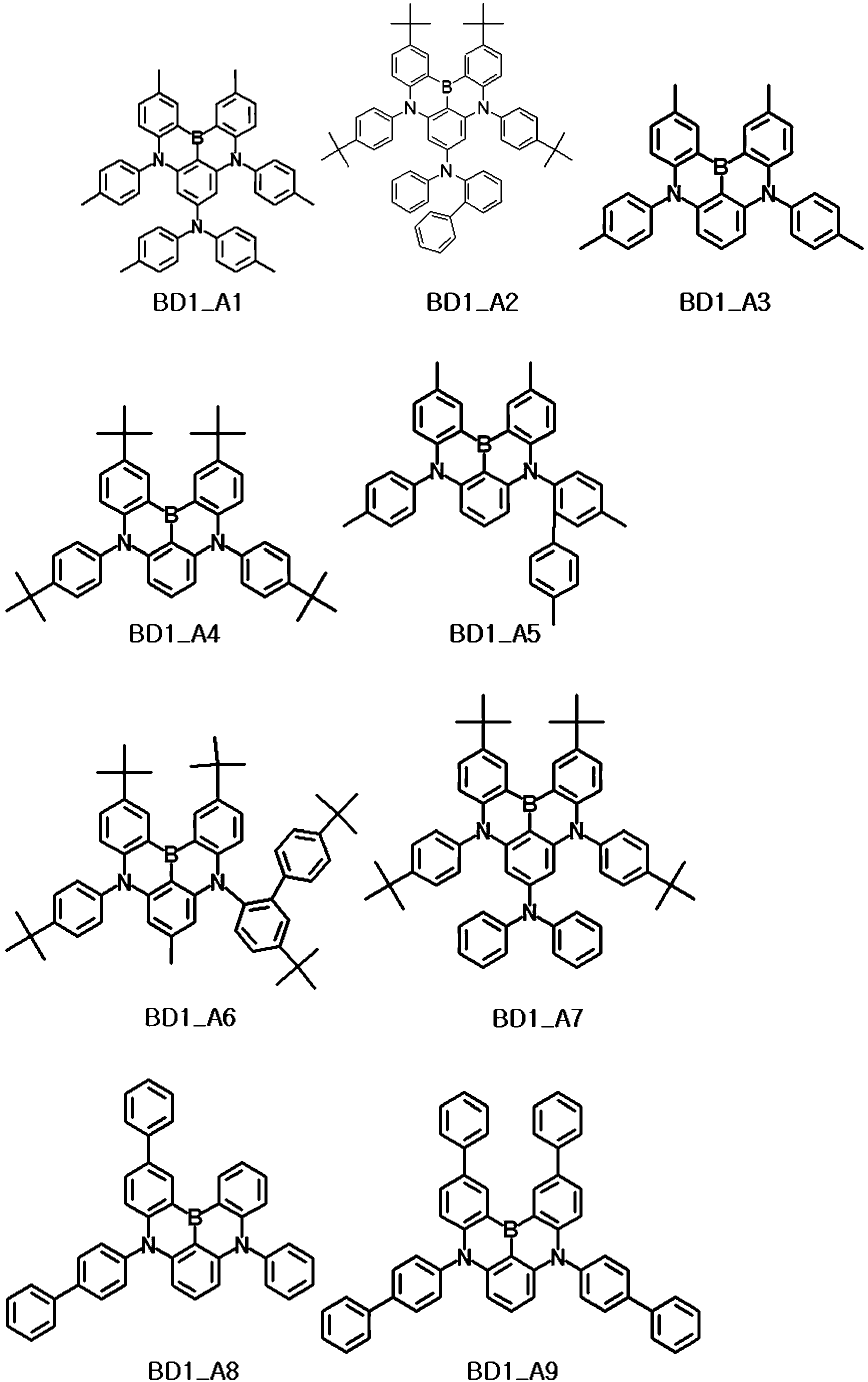

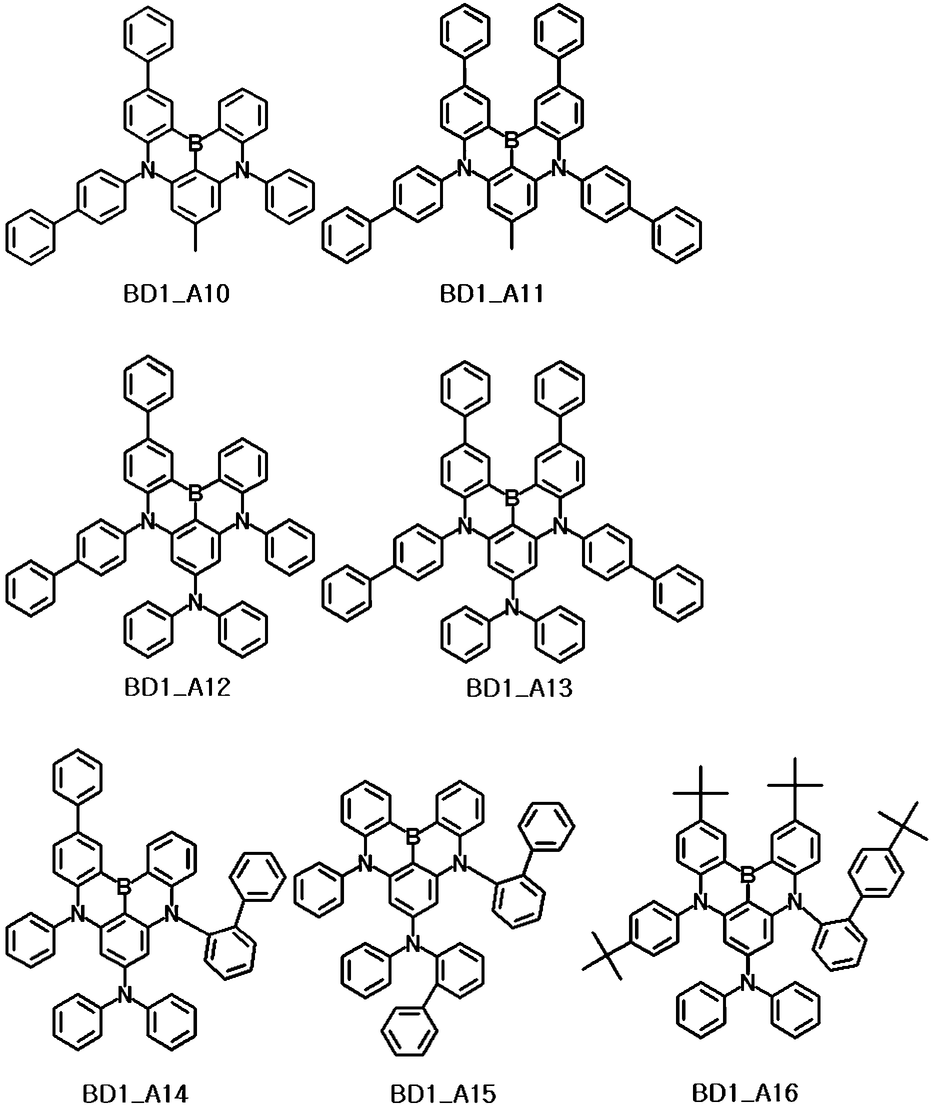

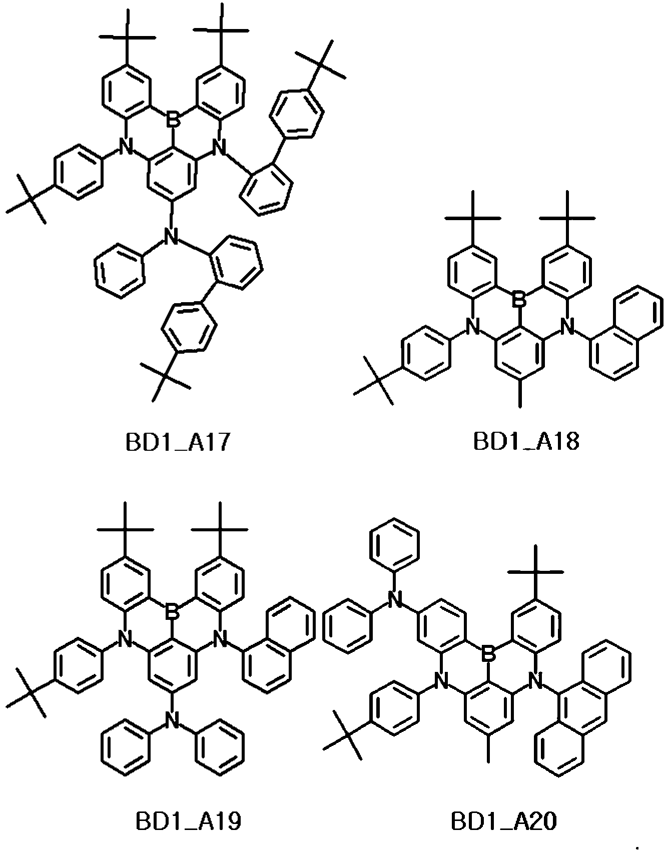

5. Organische Leuchtdiode gemäß einem der Ansprüche 1 bis 4, wobei der erste Wirtsstoff durch die Formel 1 dargestellt wird: 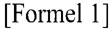 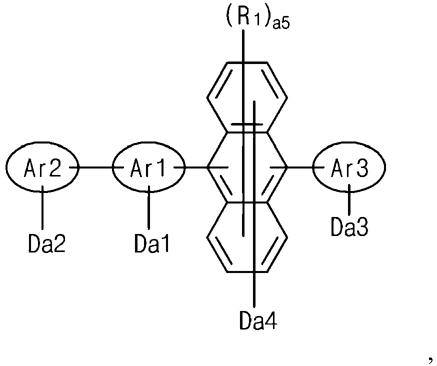
wobei in der Formel 1
a1, a2 und a3 jeweils unabhängig voneinander eine ganze Zahl von 0 oder 30 sind, a4 und a5 jeweils unabhängig voneinander eine ganze Zahl von 0 bis 8 sind und mindestens eines von a1 bis a4 eine positive ganze Zahl ist,
Ar1 ausgewählt ist aus der Gruppe, bestehend aus einer Einfachbindung (einer direkten Bindung), einer substituierten oder unsubstituierten C6- bis C30-Arylengruppe und einer substituierten oder unsubstituierten C3- bis C30-Heteroarylengruppe,
Ar2 und Ar3 jeweils ausgewählt sind aus der Gruppe, bestehend aus einer substituierten oder unsubstituierten C6- bis C30-Arylgruppe und einer substituierten oder unsubstituierten C3- bis C30-Heteroarylgruppe, und
R₁ ausgewählt ist aus der Gruppe, bestehend aus einer C1- bis C30-Alkylgruppe, die unsubstituiert oder mit Deuterium substituiert ist, und einer C3- bis C30-Cycloalkylgruppe, die unsubstituiert oder mit Deuterium substituiert ist,
wobei der zweite Wirtsstoff durch die Formel 5 dargestellt wird: 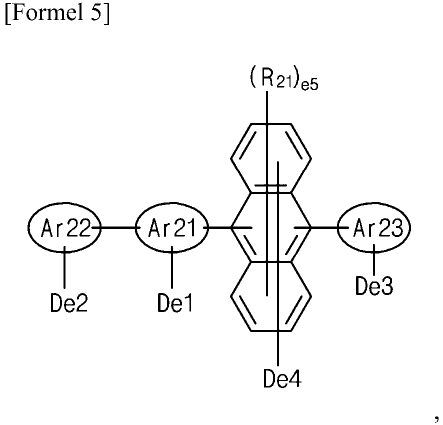
wobei in der Formel 5
e1, e2 und e3 jeweils unabhängig voneinander eine ganze Zahl von 0 oder 30 sind, e4 und e5 jeweils unabhängig voneinander eine ganze Zahl von 0 bis 8 sind und die Summe von el bis e4 kleiner ist als die Summe von a1 bis a4 in der Formel 1,
Ar21 ausgewählt ist aus der Gruppe, bestehend aus einer Einfachbindung (einer direkten Bindung), einer substituierten oder unsubstituierten C6- bis C30-Arylengruppe und einer substituierten oder unsubstituierten C3- bis C30-Heteroarylengruppe,
Ar22 und Ar23 jeweils ausgewählt sind aus der Gruppe, bestehend aus einer substituierten oder unsubstituierten C6- bis C30-Arylgruppe und einer substituierten oder unsubstituierten C3- bis C30-Heteroarylgruppe, und
R₂₁ ausgewählt ist aus der Gruppe, bestehend aus einer C1- bis C30-Alkylgruppe, die unsubstituiert oder mit Deuterium substituiert ist, und einer C3- bis C30-Cycloalkylgruppe, die unsubstituiert oder mit Deuterium substituiert ist.

6. Organische Leuchtdiode gemäß einem der Ansprüche 1 bis 5, wobei der erste Wirtsstoff durch die Formel 1a dargestellt wird: 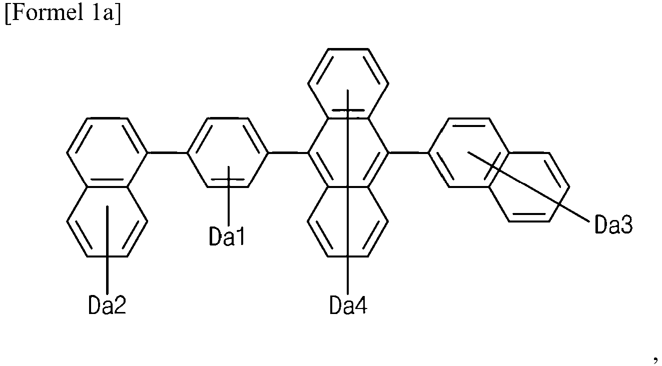
wobei in der Formel 1a a1 eine ganze Zahl von 0 bis 4 ist, a2 und a3 jeweils unabhängig voneinander eine ganze Zahl von 0 bis 7 sind, a4 eine ganze Zahl von 0 bis 8 ist und mindestens eines von a1 bis a4 eine positive ganze Zahl ist,
wobei der zweite Wirtsstoff durch die Formel 5a dargestellt wird: 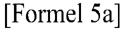 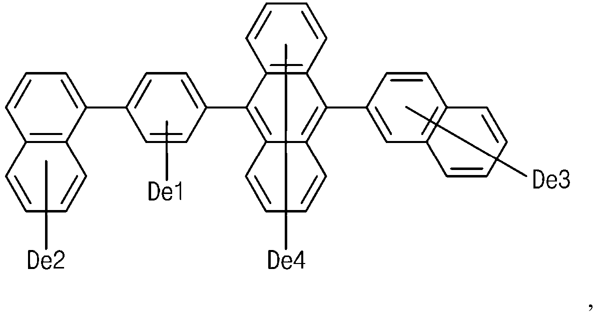
wobei in der Formel 5a e1 eine ganze Zahl von 0 bis 4 ist, e2 und e3 jeweils unabhängig voneinander eine ganze Zahl von 0 bis 7 sind, e4 eine ganze Zahl von 0 bis 8 ist und die Summe von e1 bis e4 kleiner ist als die Summe von a1 bis a4 in der Formel 1a.

7. Organische Leuchtdiode gemäß einem der Ansprüche 1 bis 6, wobei der erste Wirtsstoff mindestens eine der ersten Wirtsstoffverbindungen in der Formel 2 umfasst:

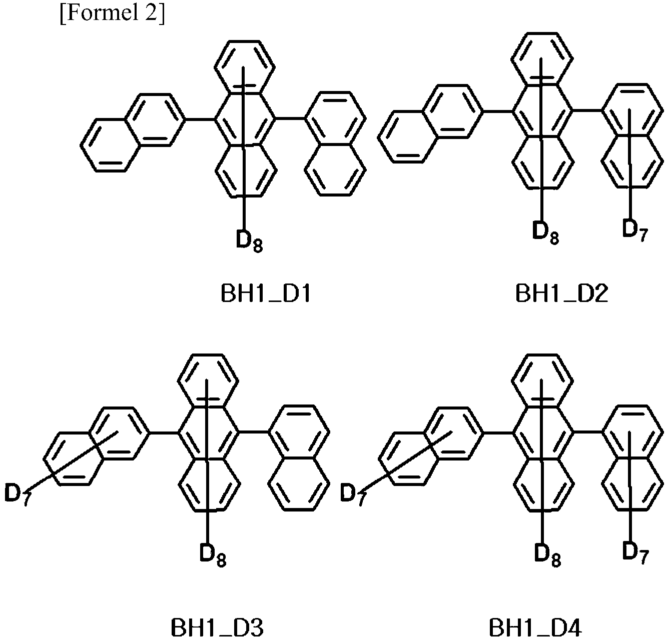

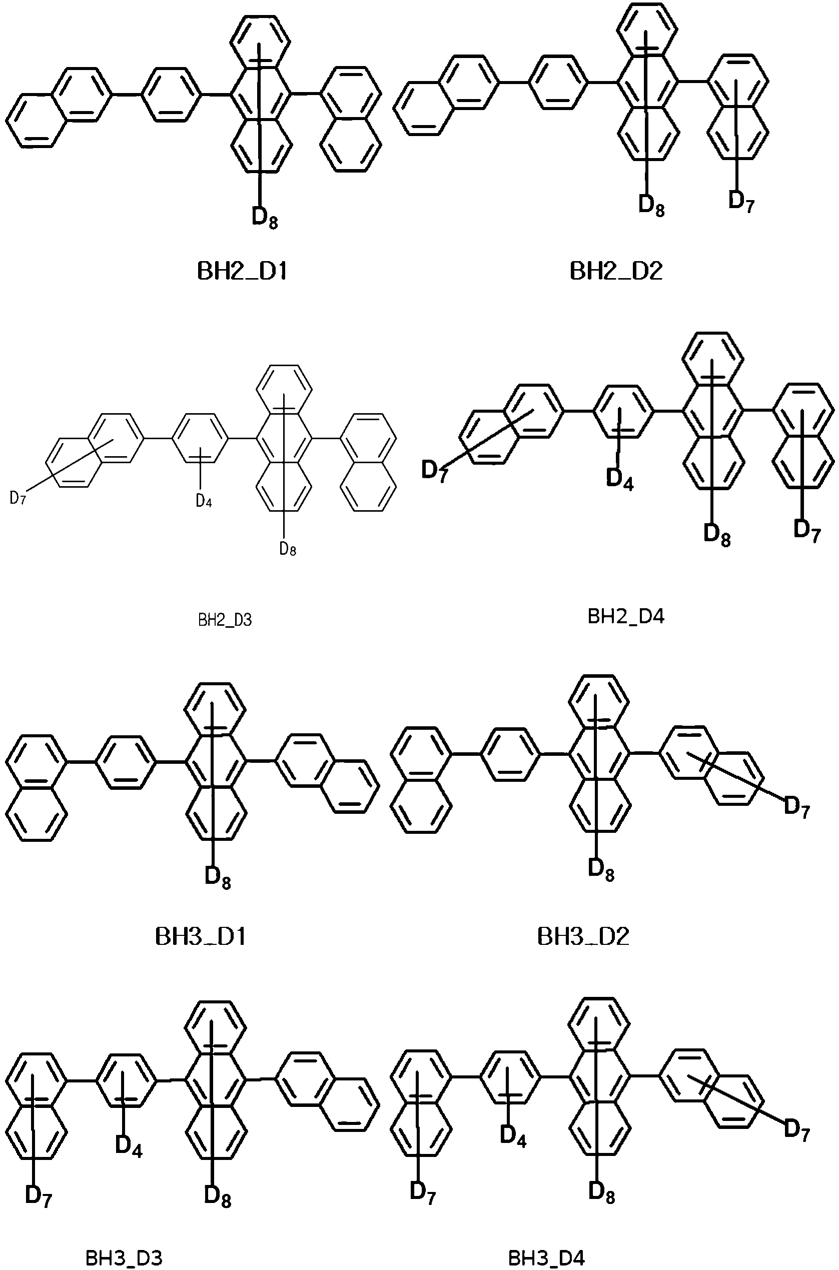

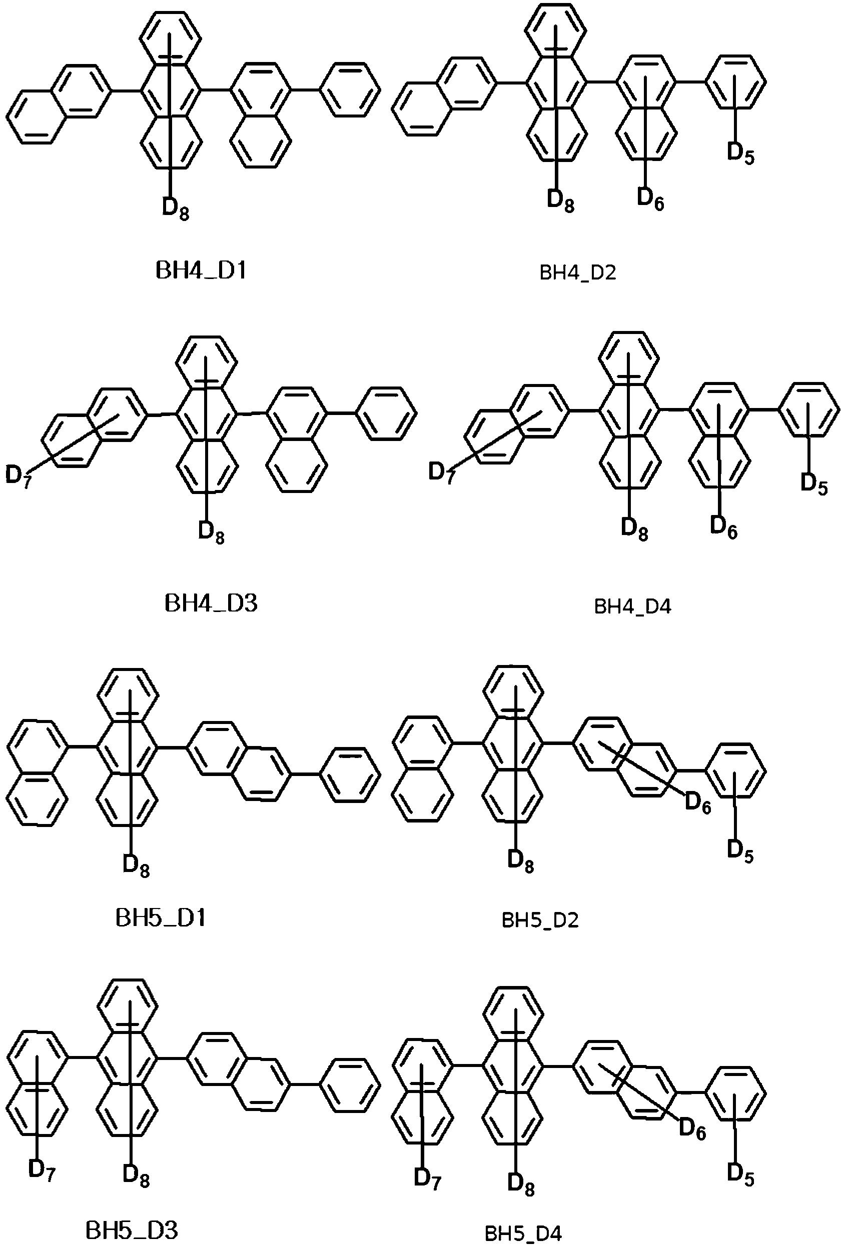

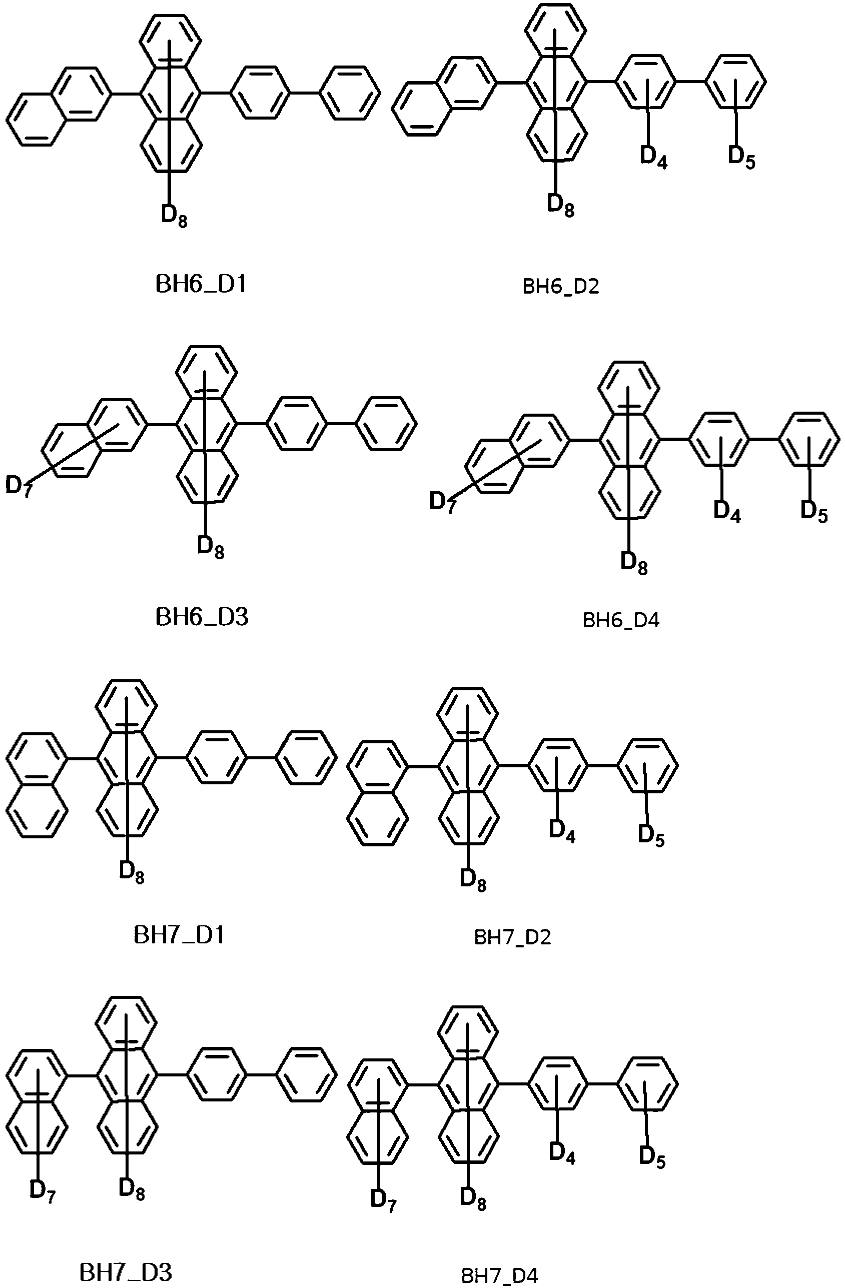

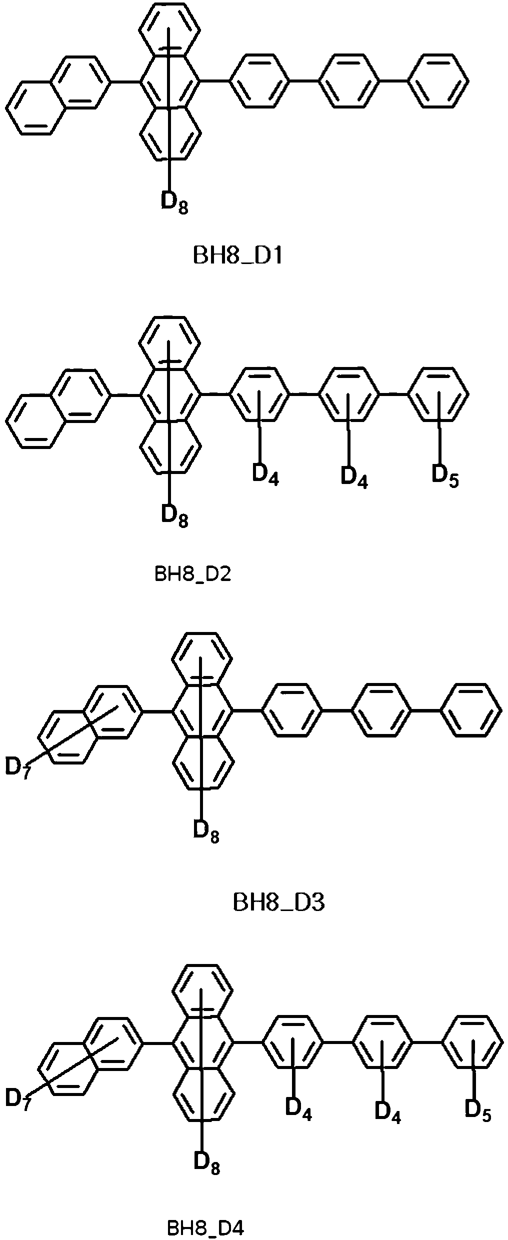

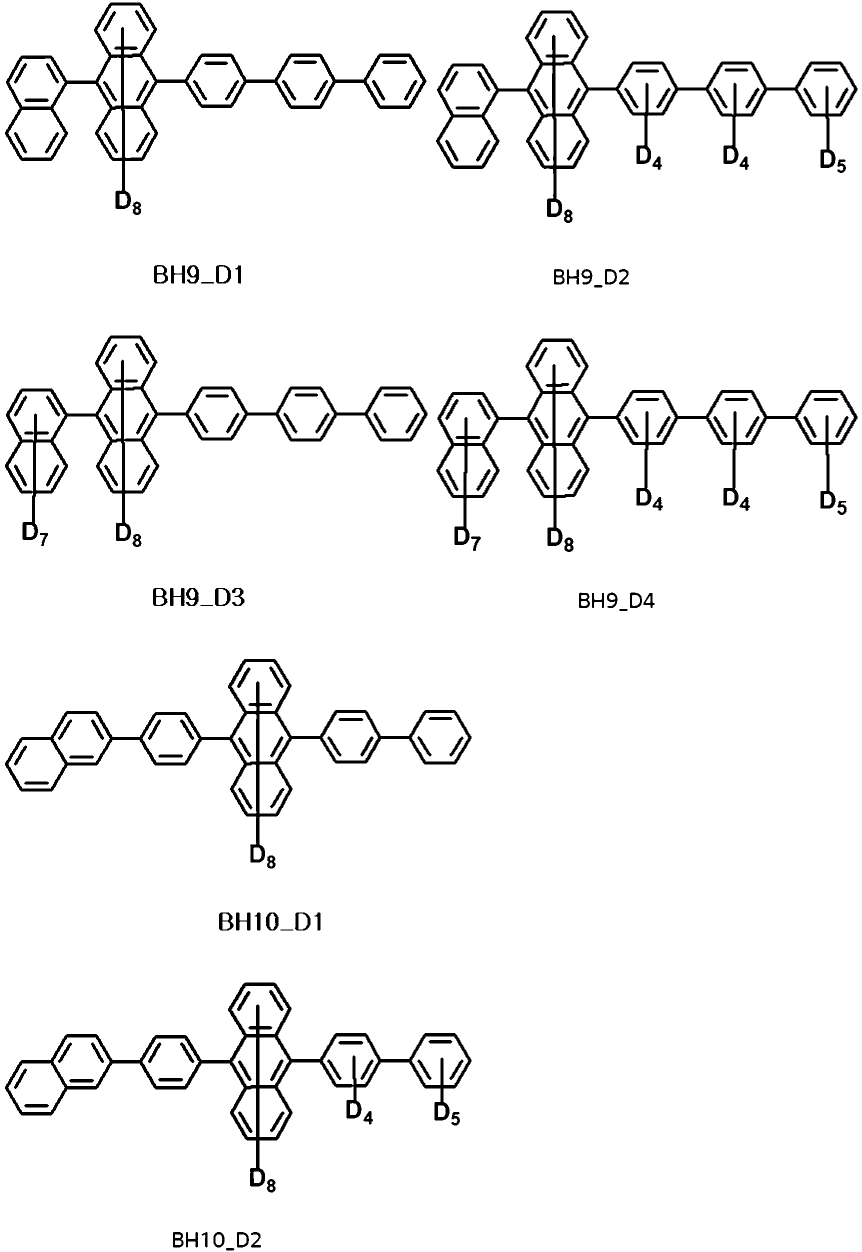

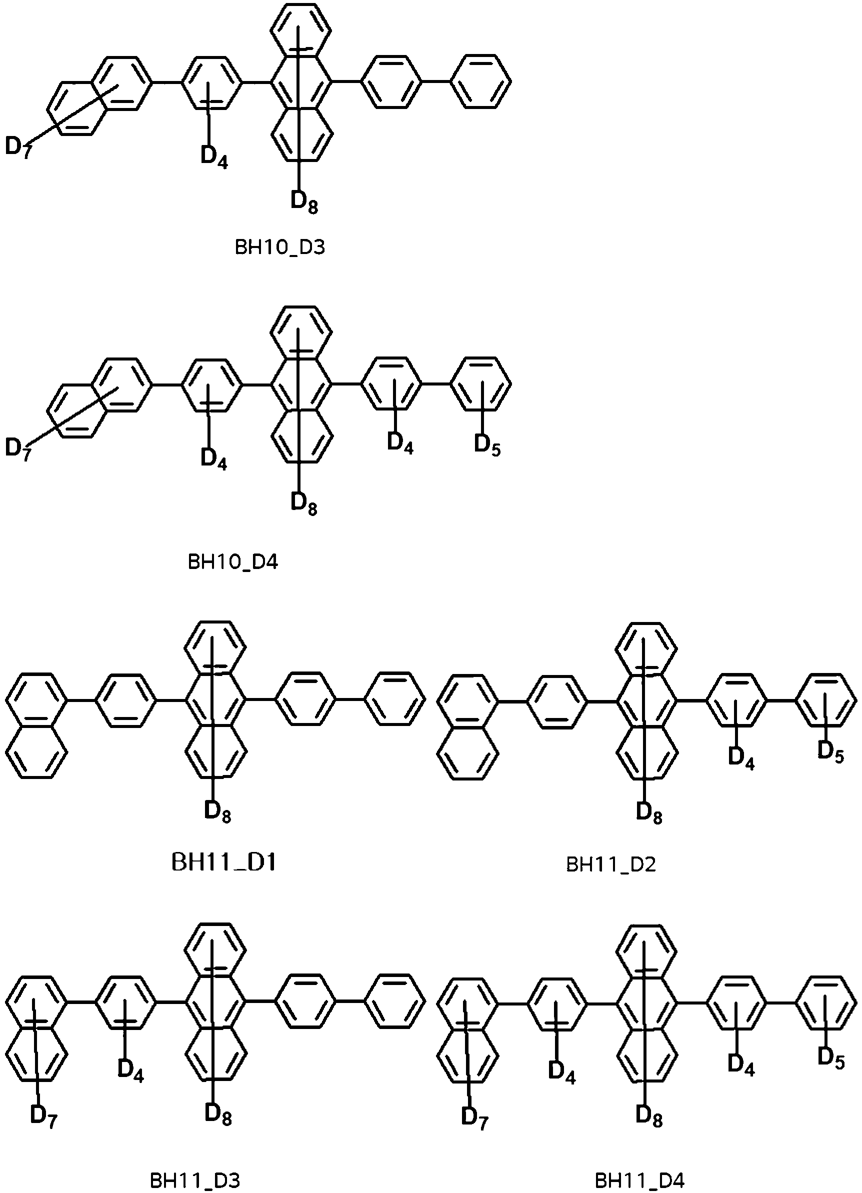

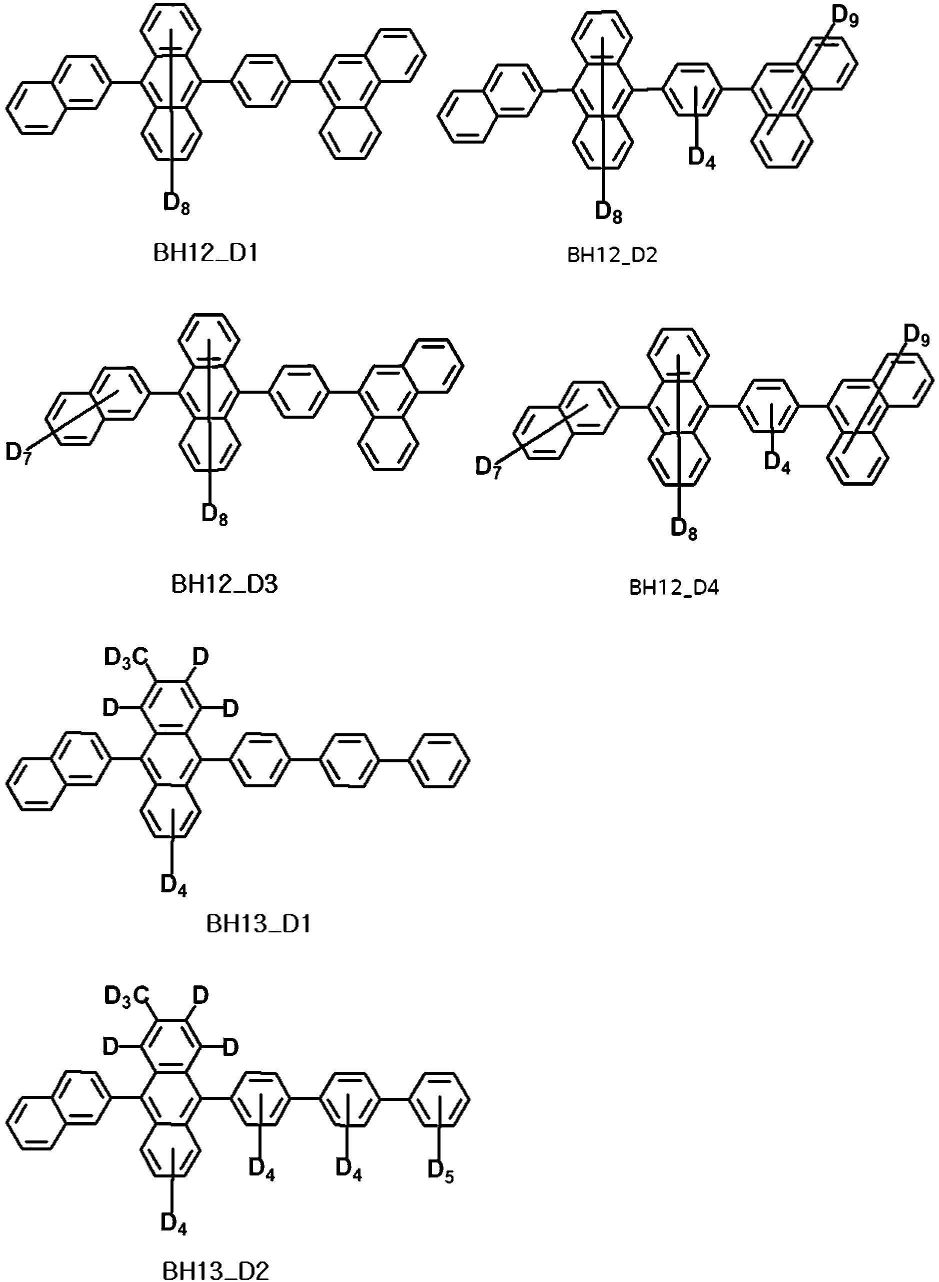

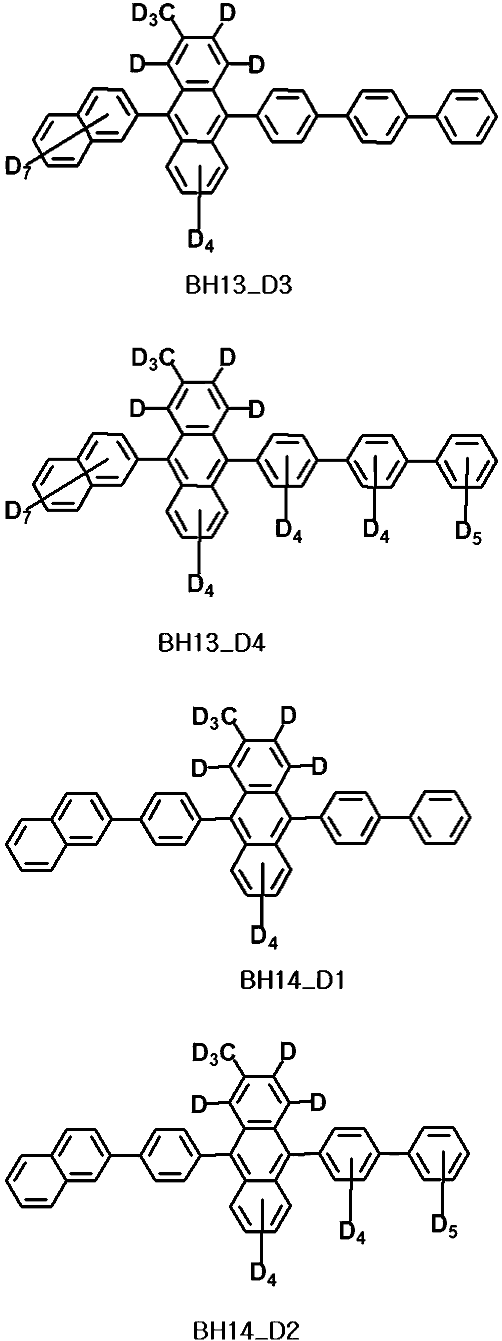

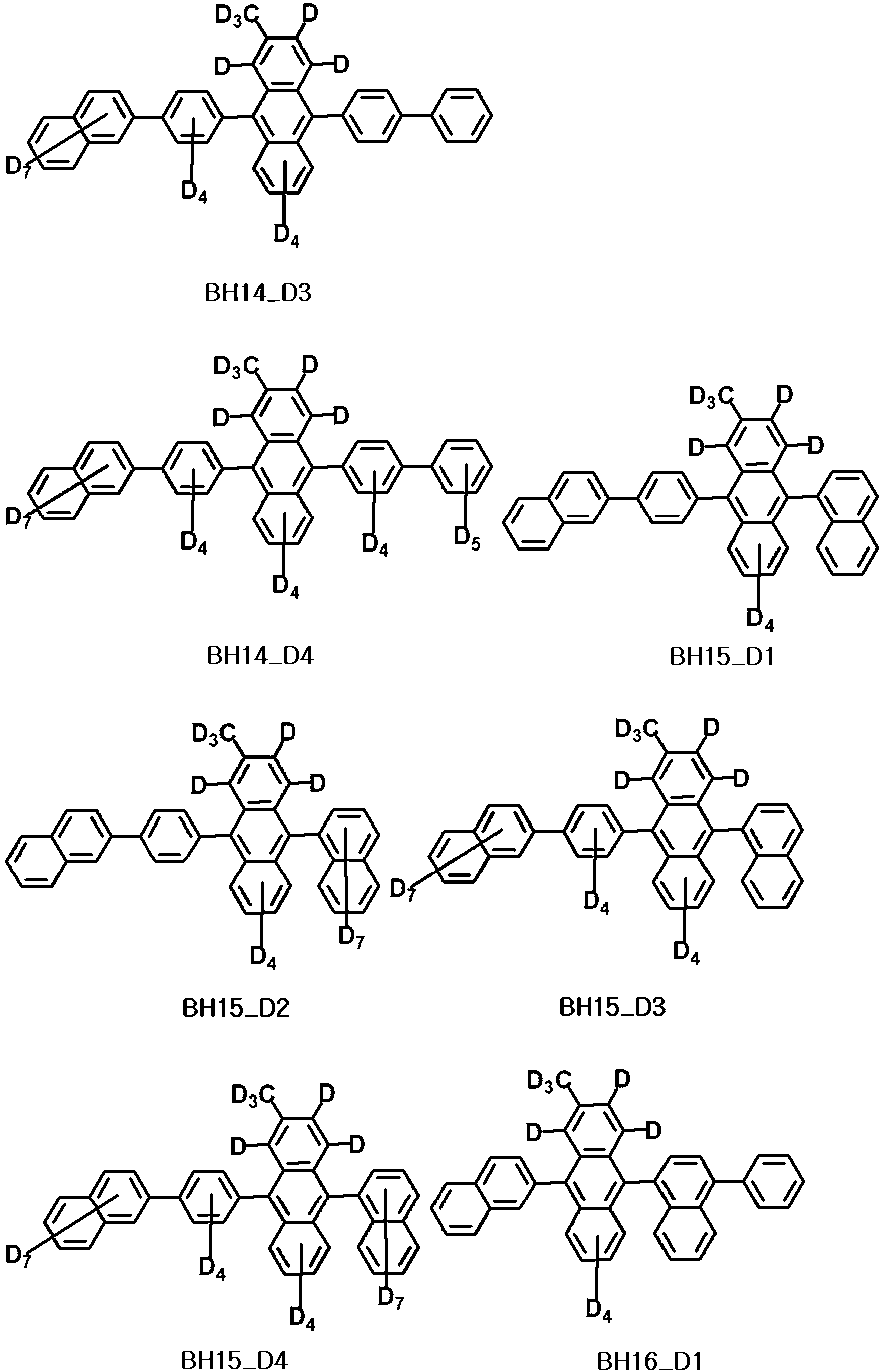

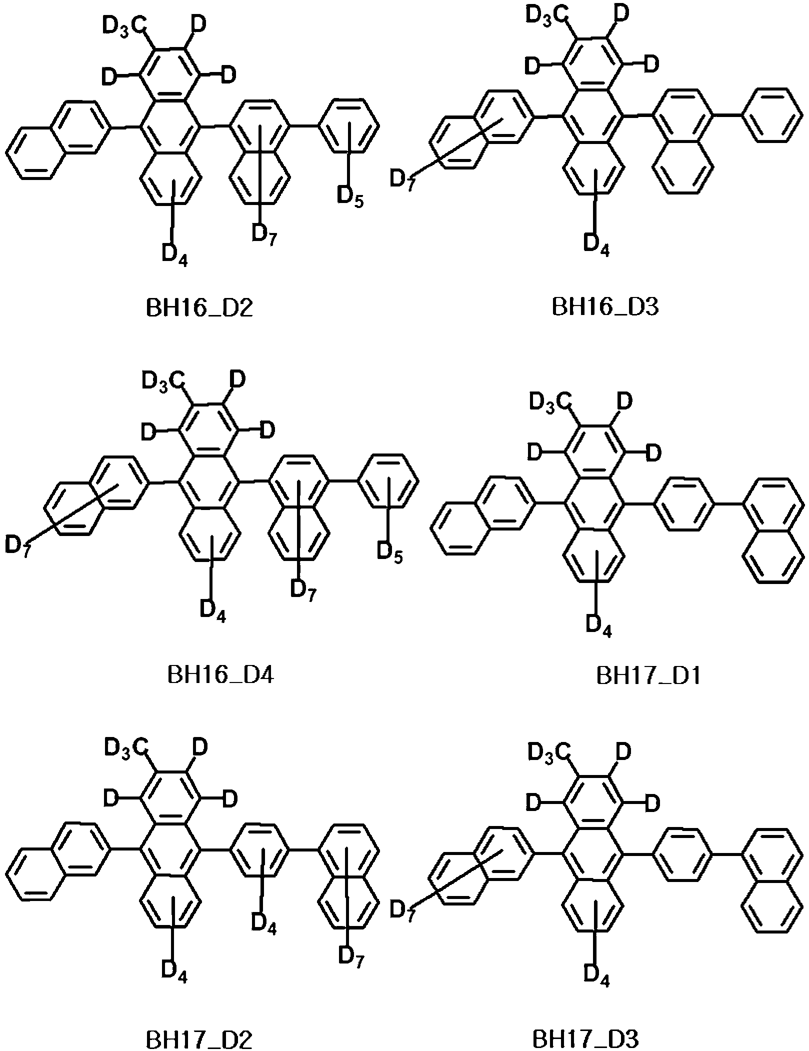

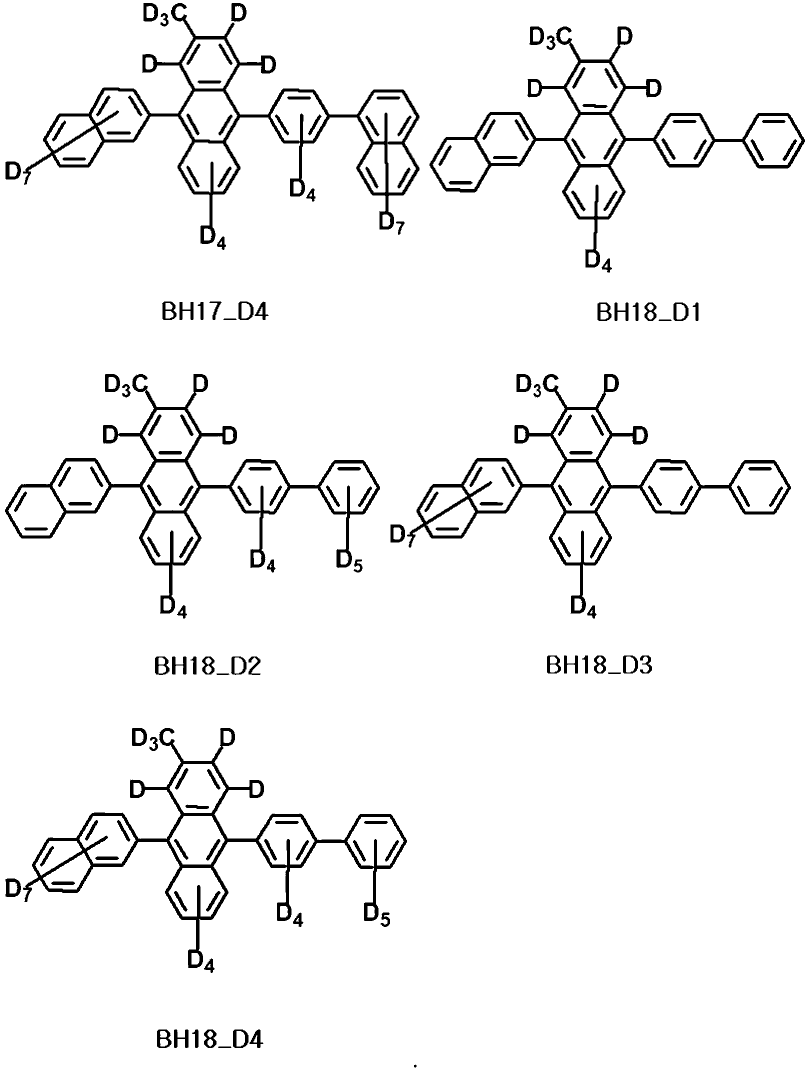

8. Organische Leuchtdiode gemäß einem der Ansprüche 1 bis 7, wobei der zweite Wirtsstoff mindestens eine der zweiten Wirtsstoffverbindungen in der Formel 6 umfasst:

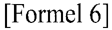

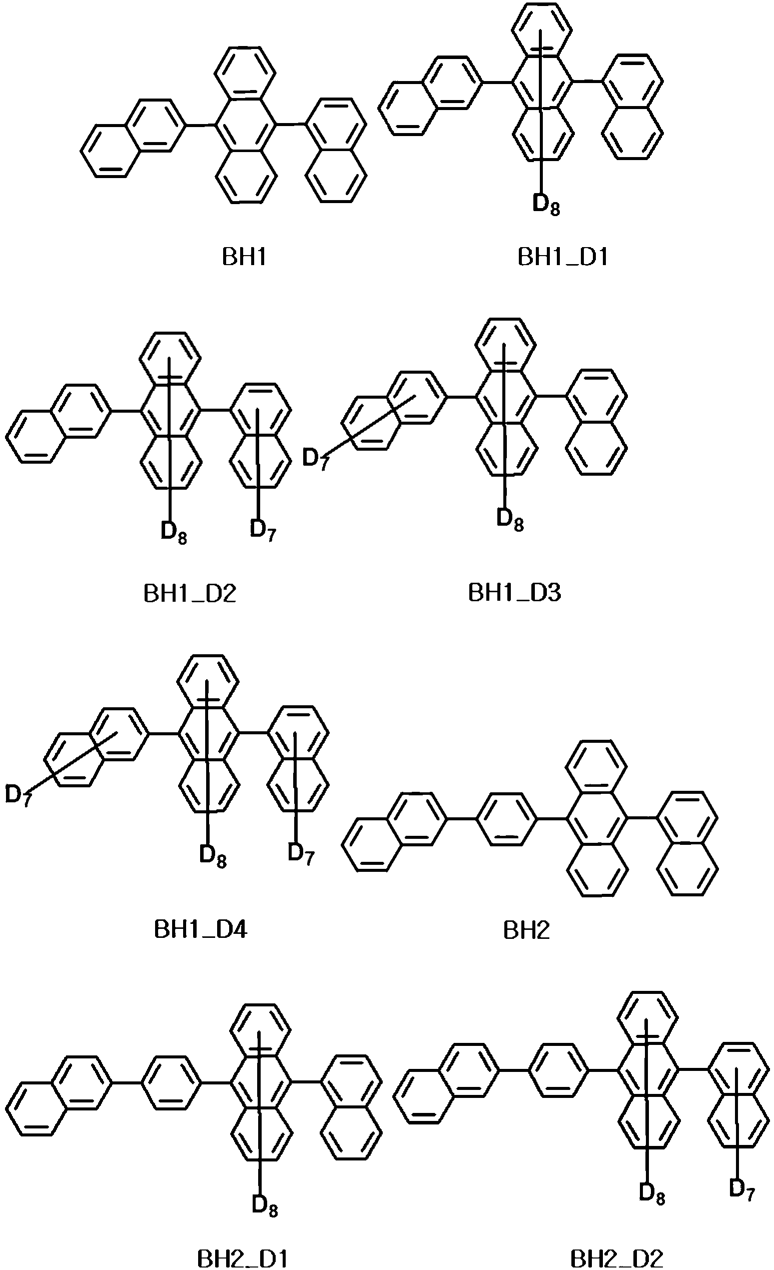

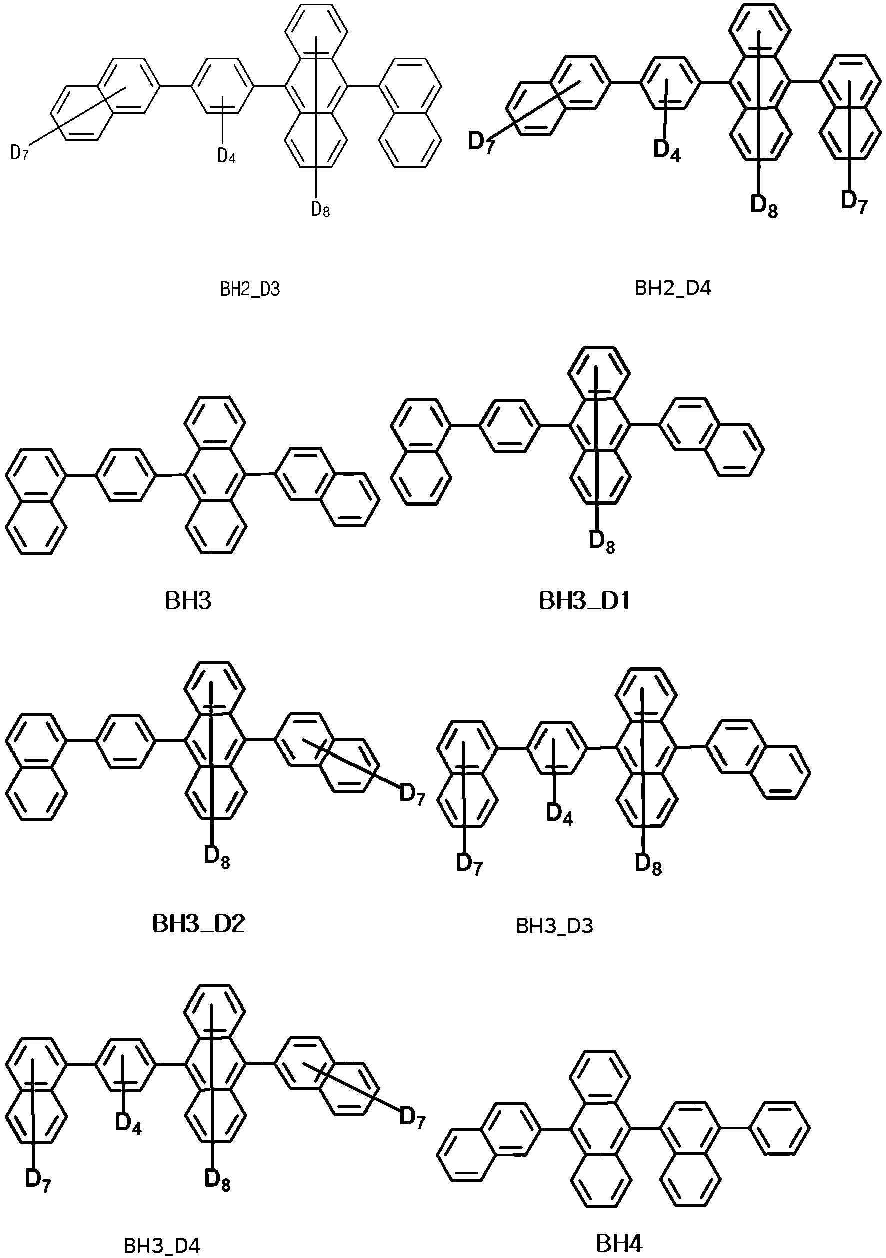

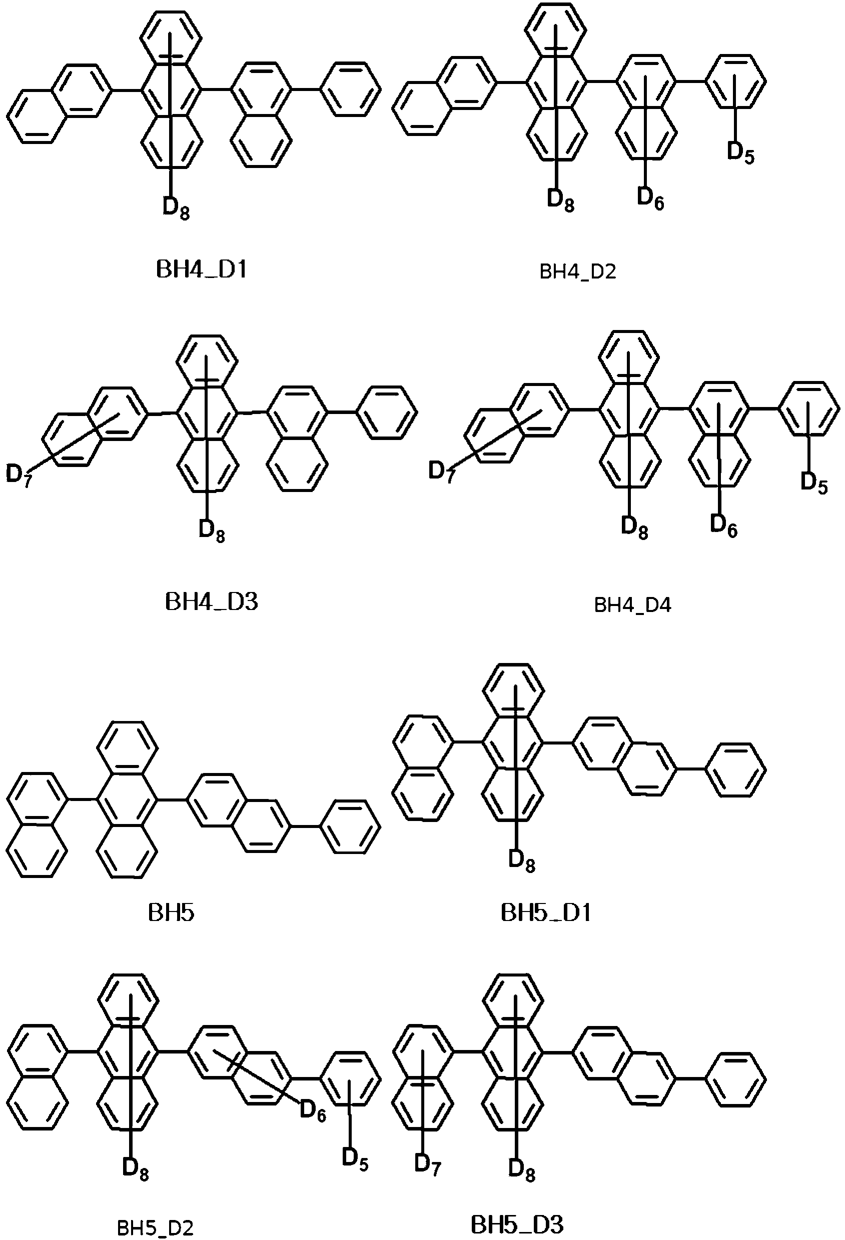

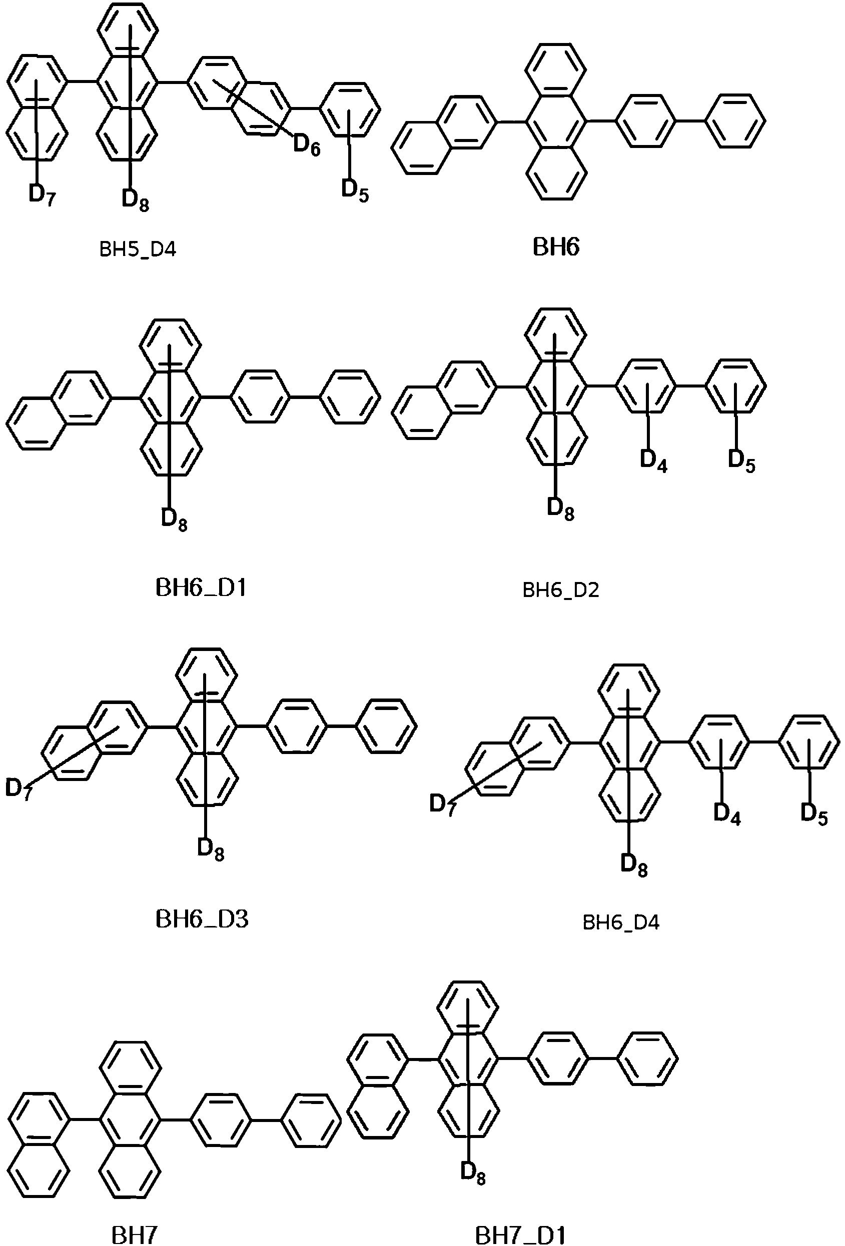

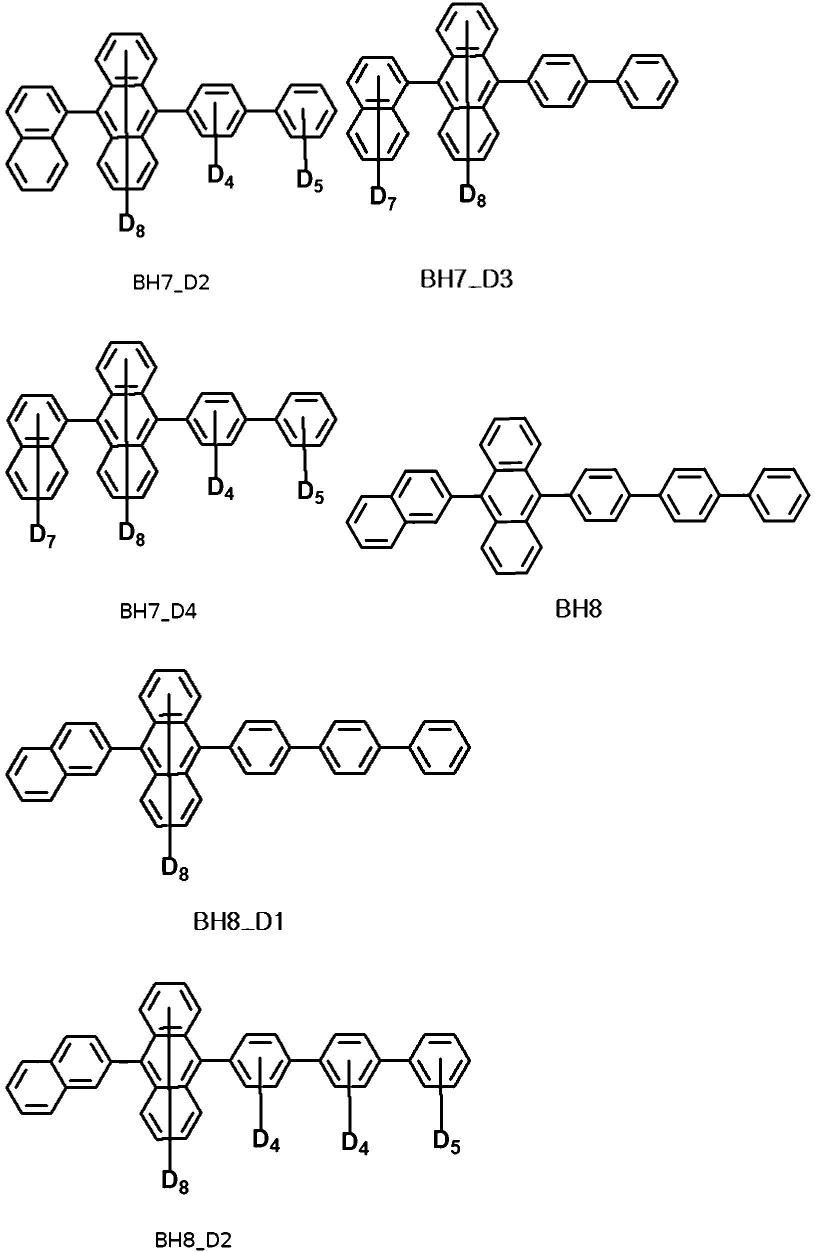

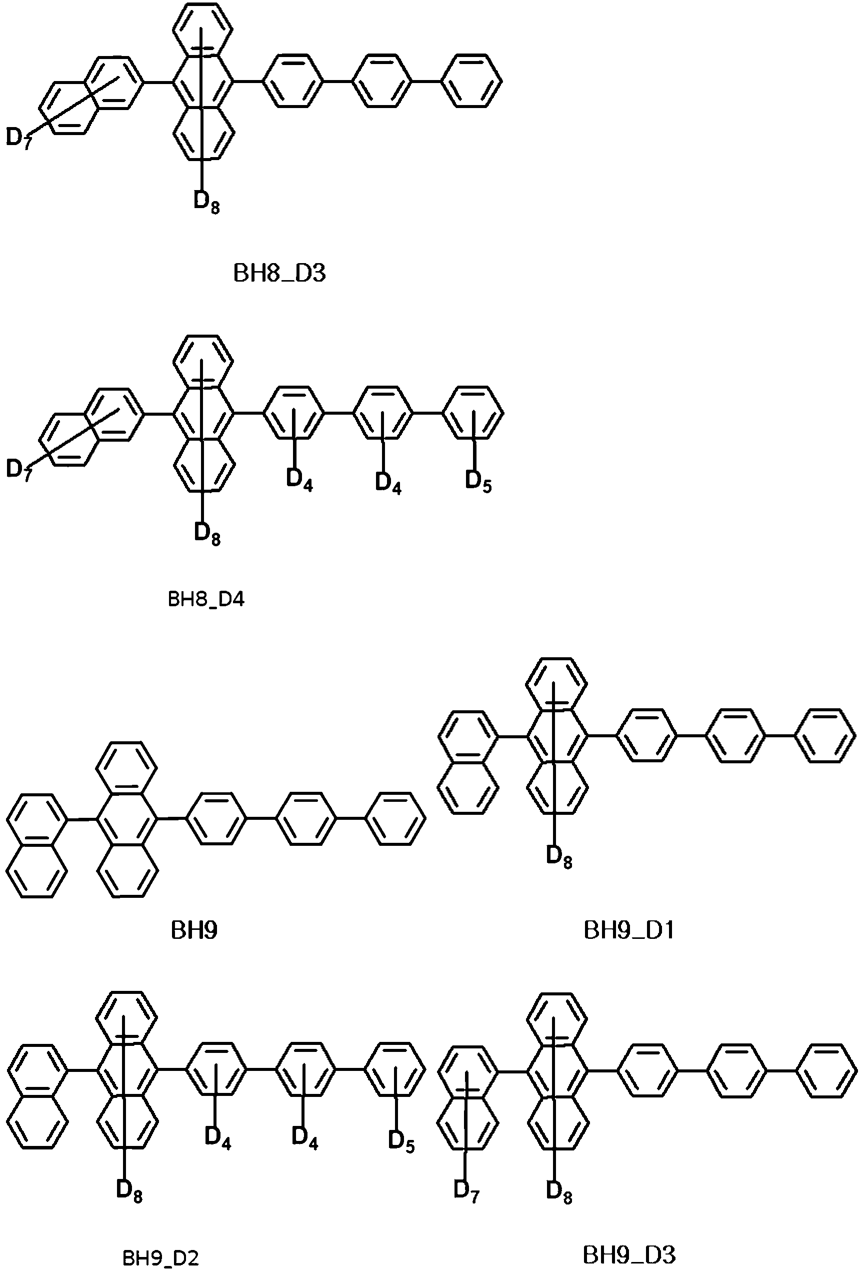

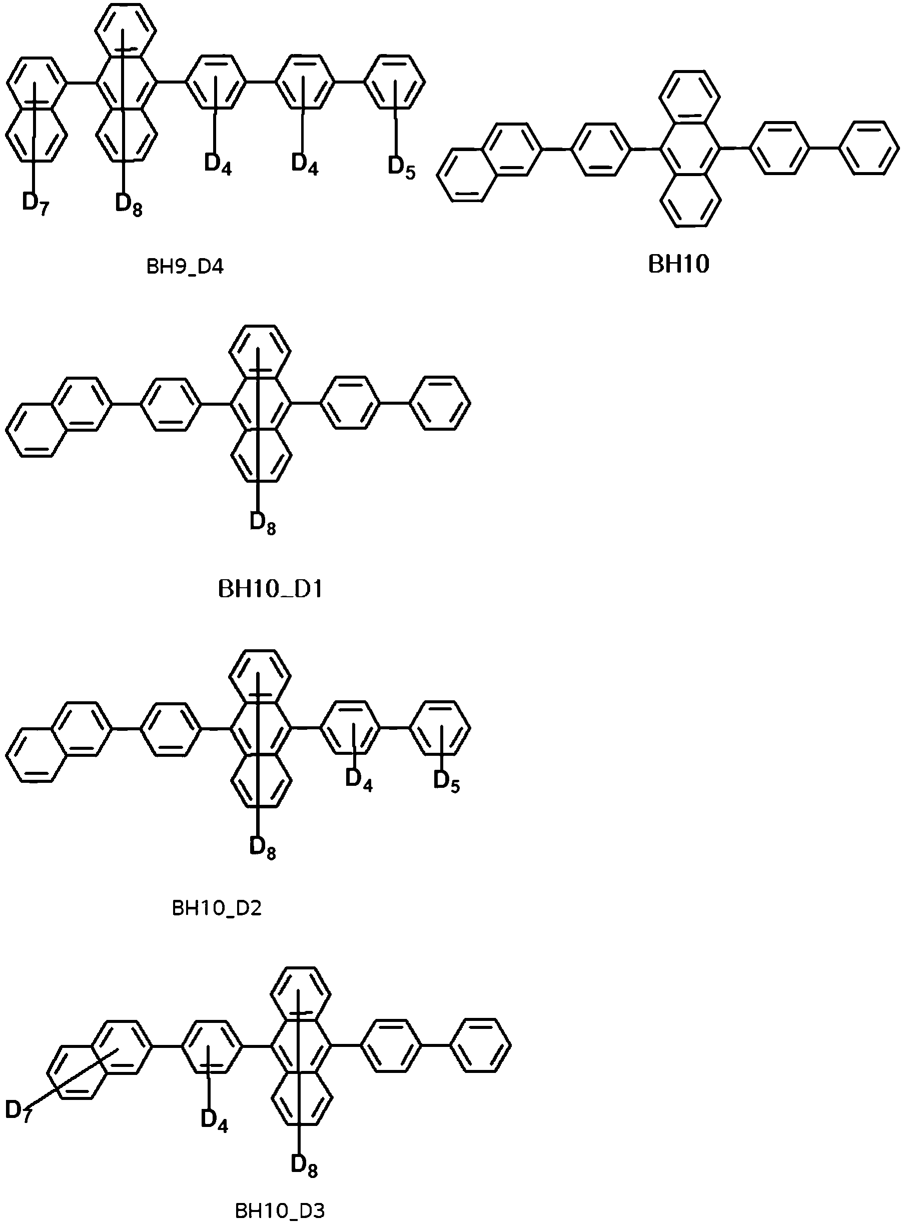

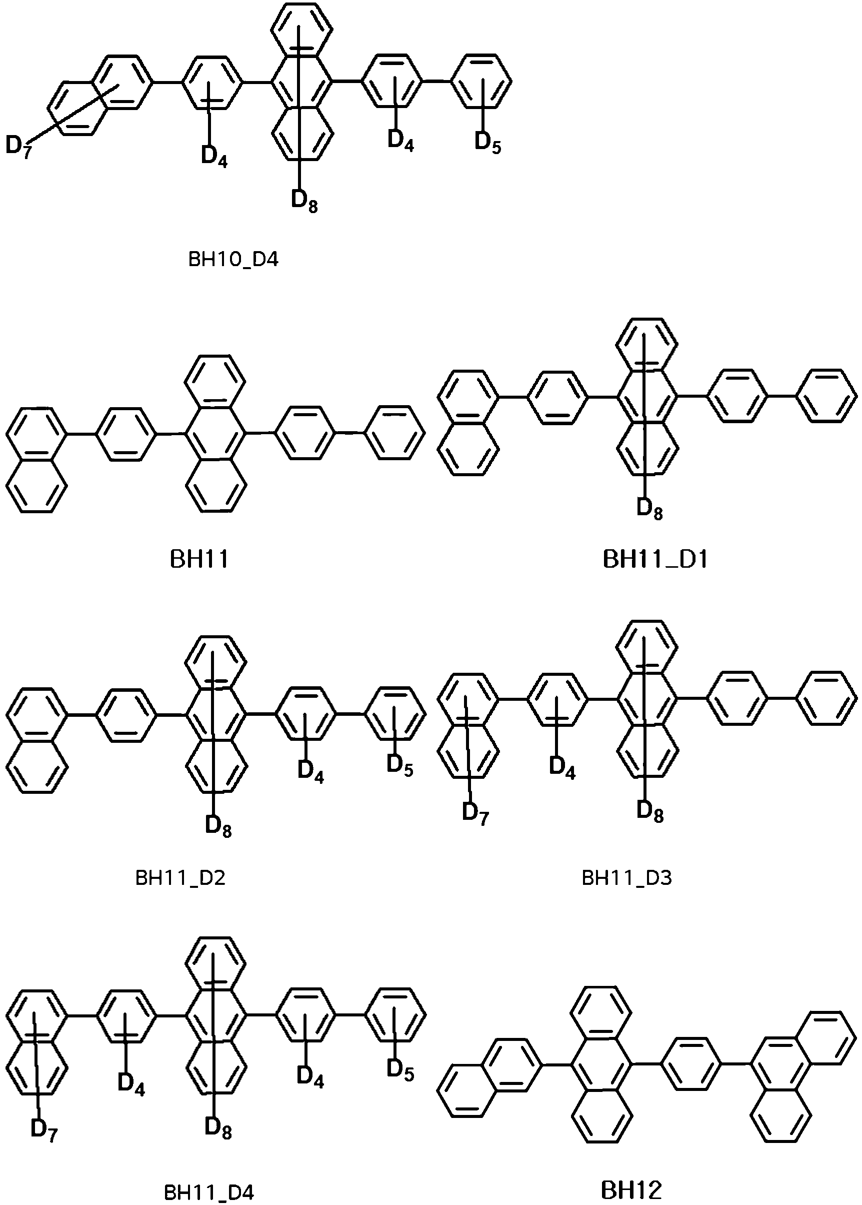

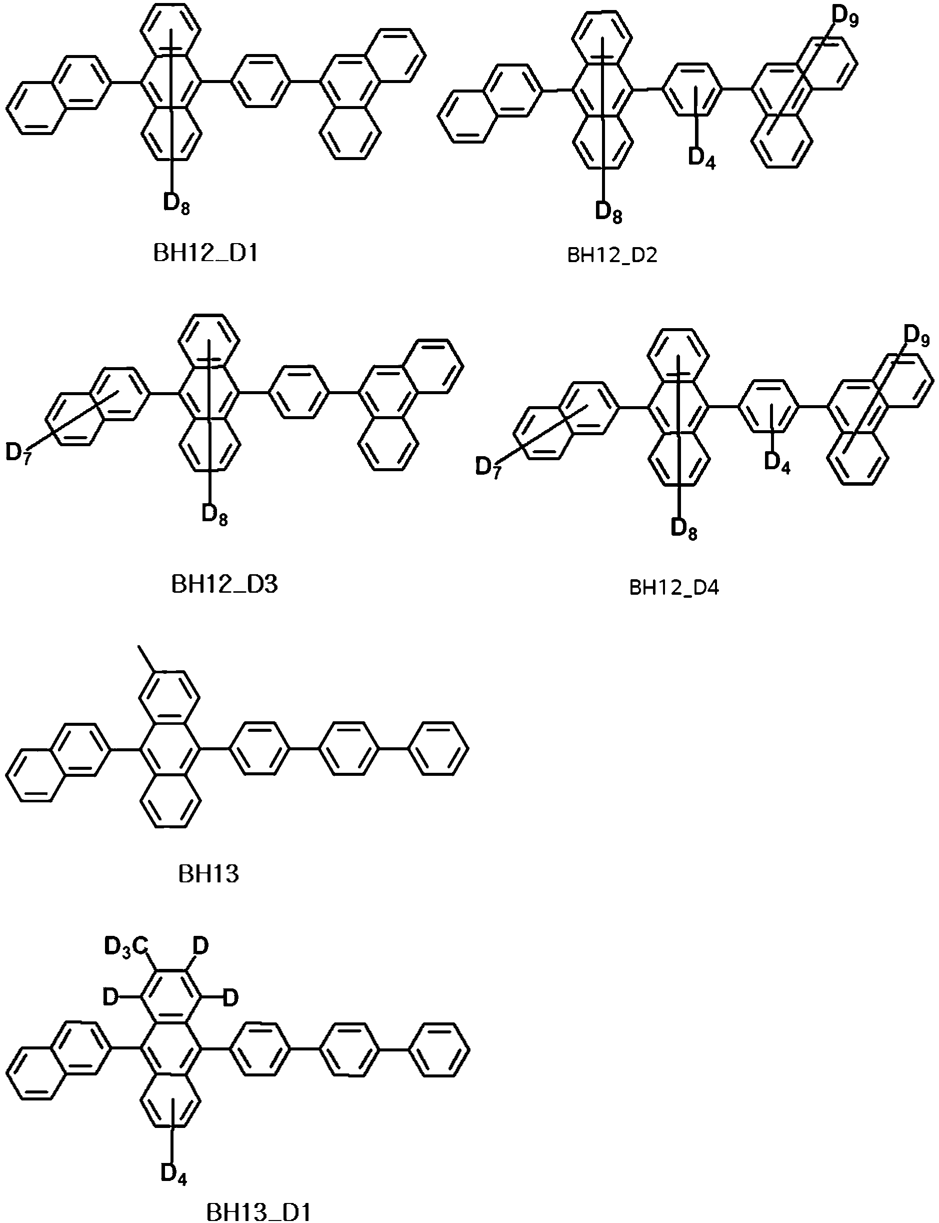

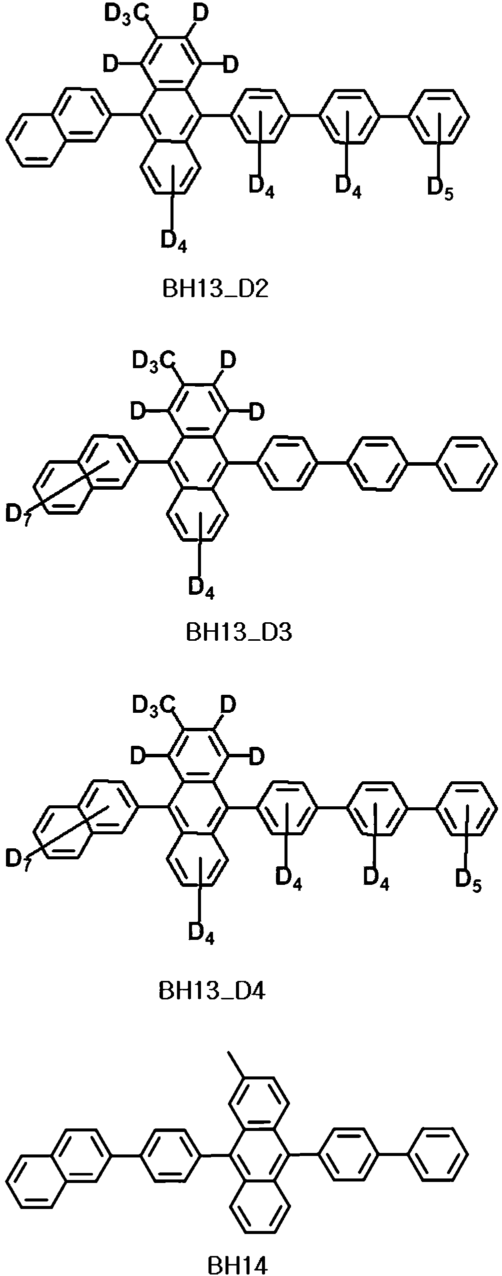

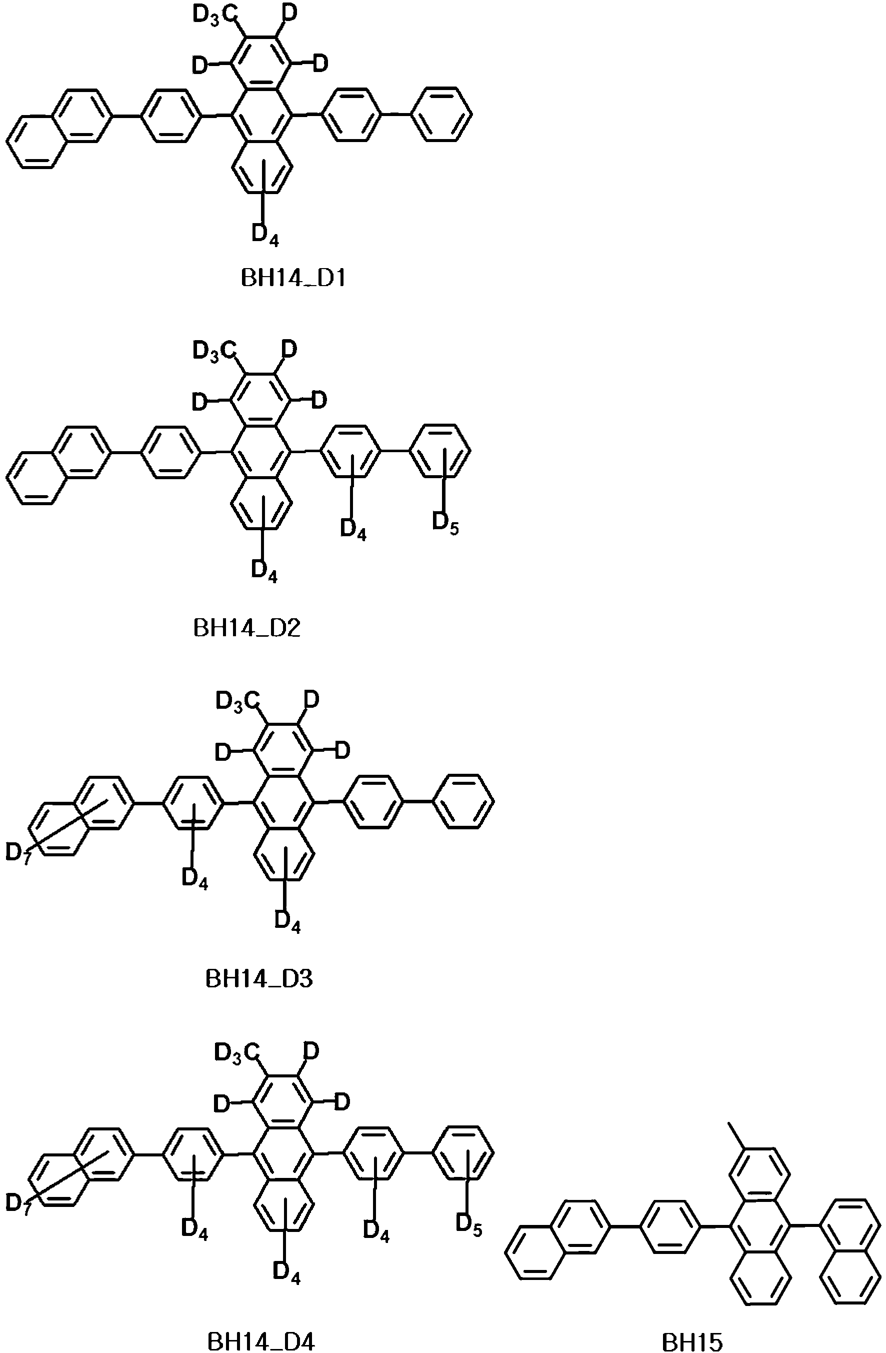

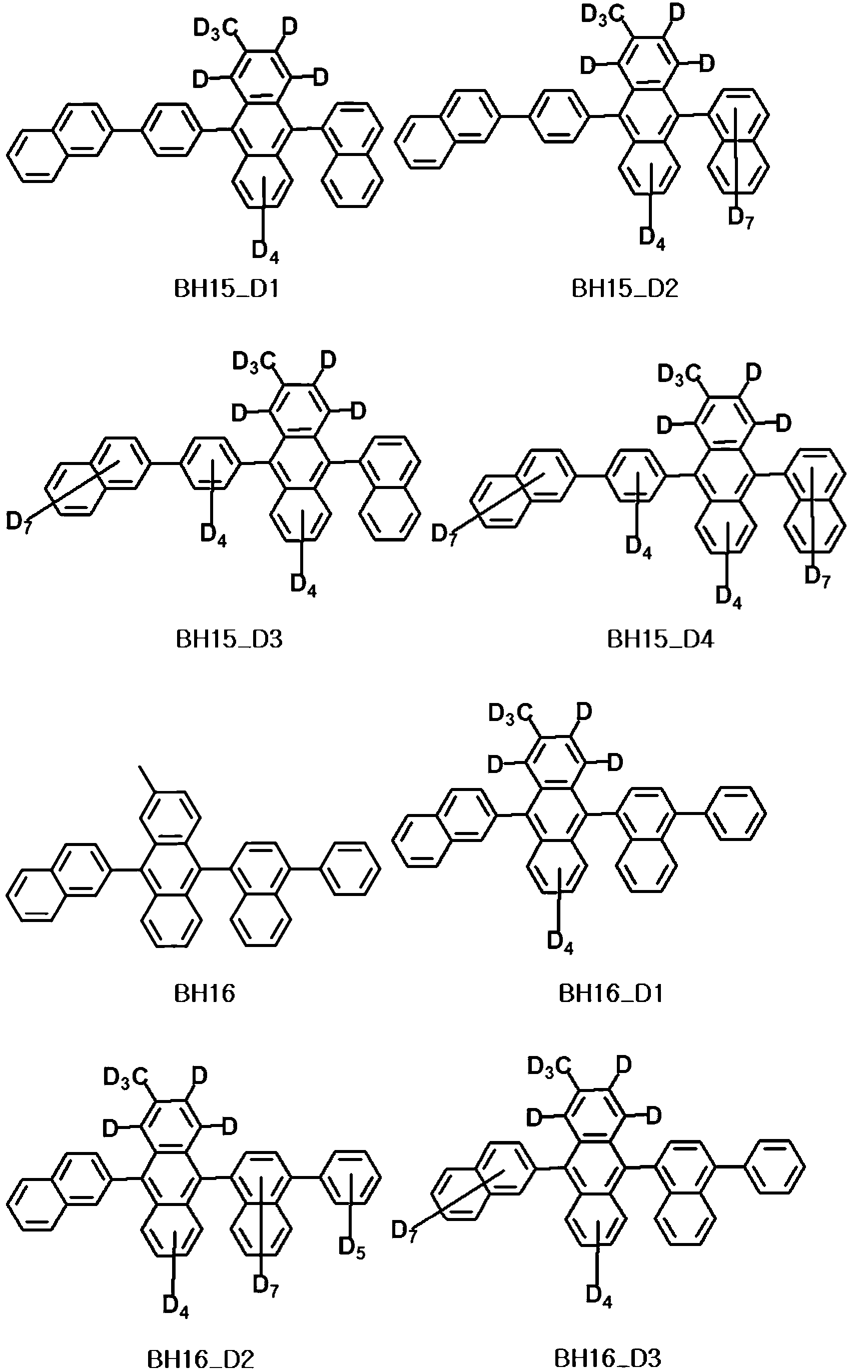

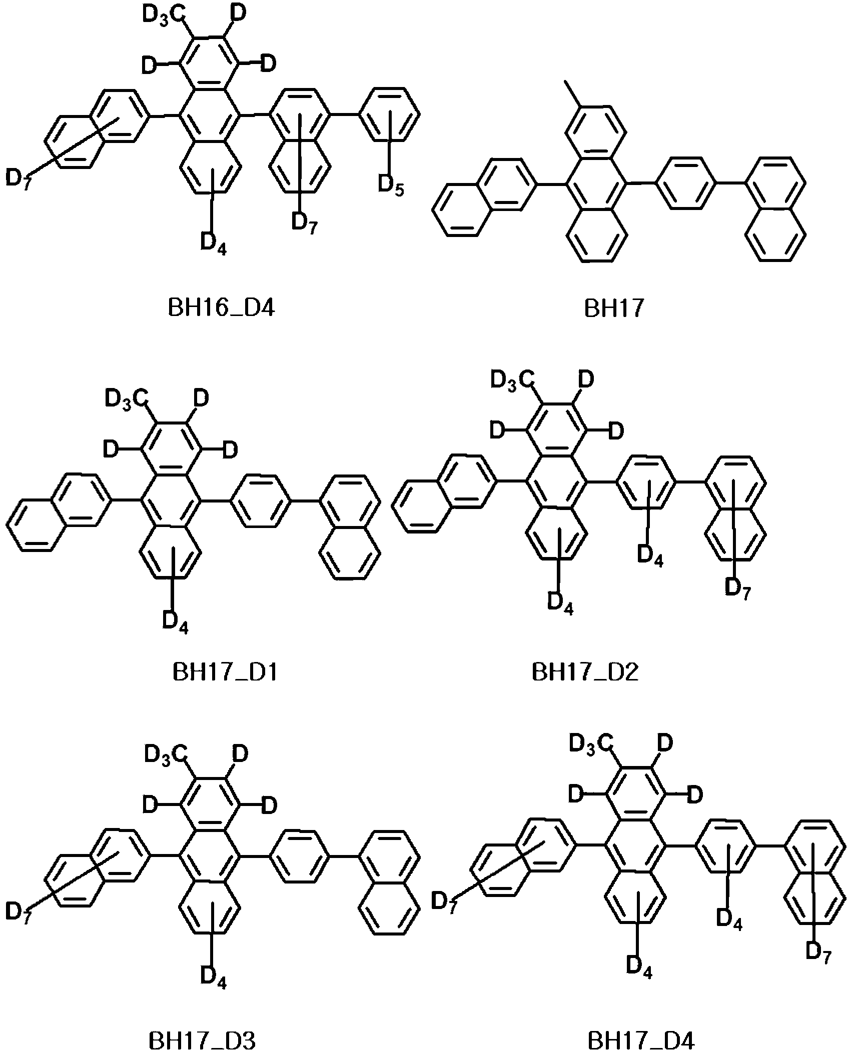

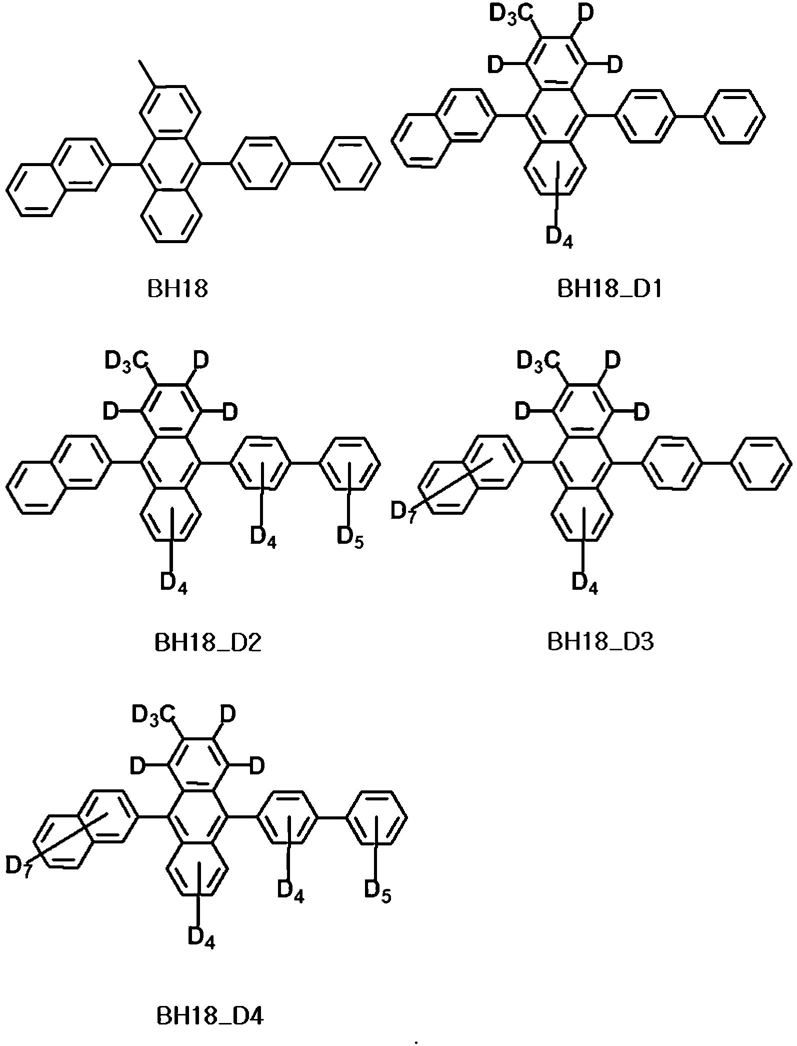

9. Organische Leuchtdiode gemäß einem der Ansprüche 1 bis 8, ferner umfassend:
einen zweiten emittierenden Teil, der eine dritte blau emittierende Schicht und eine vierte blau emittierende Schicht umfasst und zwischen dem ersten emittierenden Teil und der zweiten Elektrode angeordnet ist, wobei die vierte blau emittierende Schicht zwischen der dritten blau emittierenden Schicht und der zweiten Elektrode angeordnet ist und die dritte blau emittierende Schicht kontaktiert,
wobei die dritte blau emittierende Schicht einen dritten Wirtsstoff und einen dritten Dotierstoff umfasst, und die vierte blau emittierende Schicht einen vierten Wirtsstoff und einen vierten Dotierstoff umfasst,
wobei der dritte Wirtsstoff ein Anthracenderivat mit einem dritten Deuterierungsverhältnis ist und der vierte Wirtsstoff ein Anthracenderivat mit einem vierten Deuterierungsverhältnis ist, das kleiner als das dritte Deuterierungsverhältnis ist, wobei der dritte Dotierstoff eine dritte Verbindung ist, die durch die Formel 3 dargestellt wird: 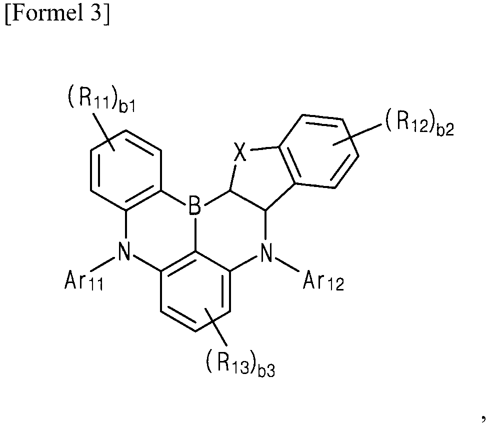
wobei in der Formel 3
b1 und b2 jeweils unabhängig voneinander eine ganze Zahl von 0 bis 4 sind und b3 eine ganze Zahl von 0 bis 3 ist,
X O oder S ist,
Ar₁₁ und Ar₁₂ jeweils unabhängig voneinander ausgewählt sind aus der Gruppe, bestehend aus einer substituierten oder unsubstituierten C6- bis C30-Arylgruppe, einer substituierten oder unsubstituierten C3- bis C30-Heteroarylgruppe und einer substituierten oder unsubstituierten alicyclischen C6- bis C30-Gruppe, und
R₁₁, R₁₂ und R₁₃ unabhängig voneinander ausgewählt sind aus der Gruppe, bestehend aus einer substituierten oder unsubstituierten C1- bis C30-Alkylgruppe, einer substituierten oder unsubstituierten C3- bis C30-Cycloalkylgruppe, einer substituierten oder unsubstituierten C6- bis C30-Arylaminogruppe, einer substituierten oder unsubstituierten C6- bis C30-Arylgruppe und einer substituierten oder unsubstituierten C3- bis C30-Heteroarylgruppe, oder mindestens ein Paar benachbarter zwei oder mehr R₁₁, benachbarter zwei oder mehr R₁₂ und benachbarter zwei oder mehr R₁₃ miteinander verbunden sind, um einen substituierten oder unsubstituierten Ring zu bilden,
und der vierte Dotierstoff eine vierte Verbindung ist, die durch die Formel 7 dargestellt wird.

10. Organische Leuchtdiode gemäß Anspruch 9, wobei der dritte Dotierstoff durch die Formel 3a dargestellt wird: 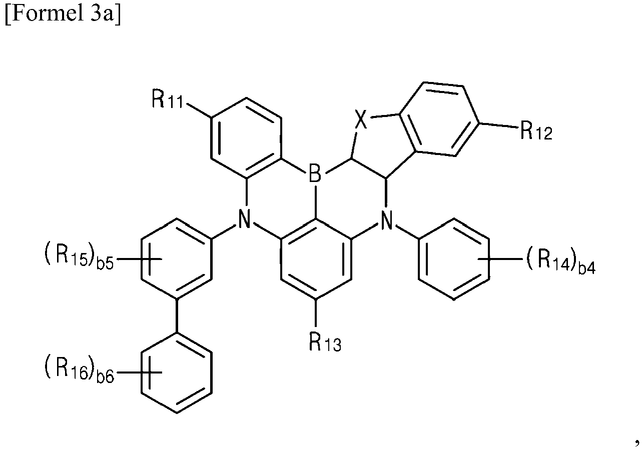
wobei in der Formel 3a die Definitionen von X, R₁₁, R₁₂ und R₁₃ dieselben sind wie in der Formel 3,
b4 und b6 jeweils unabhängig voneinander eine ganze Zahl von 0 bis 5 sind und b5 eine ganze Zahl von 0 bis 4 ist,
R₁₄, R₁₅ und R₁₆ jeweils ausgewählt sind aus der Gruppe, bestehend aus einer substituierten oder unsubstituierten C1- bis C30-Alkylgruppe und einer substituierten oder unsubstituierten C3- bis C30-Cycloalkylgruppe, oder mindestens ein Paar benachbarter zwei R₁₄ und benachbarter R₁₅ und R₁₆ miteinander verbunden sind, um einen substituierten oder unsubstituierten Ring zu bilden,
wobei der vierte Dotierstoff durch die Formel 7a dargestellt wird: 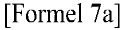 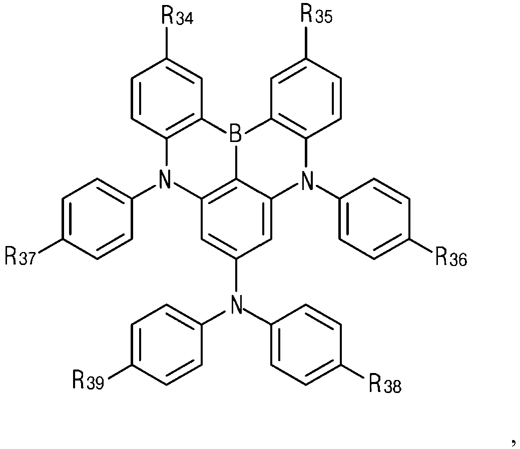
wobei in der Formel 7a R₃₄ bis R₃₉ jeweils unabhängig voneinander ausgewählt sind aus der Gruppe, bestehend aus Wasserstoff, einer substituierten oder unsubstituierten C1- bis C30-Alkylgruppe, einer substituierten oder unsubstituierten C3- bis C30-Cycloalkylgruppe, einer substituierten oder unsubstituierten C6- bis C30-Arylgruppe und einer substituierten oder unsubstituierten C3- bis C30-Heteroarylgruppe.

11. Organische Leuchtdiode gemäß einem der Ansprüche 9 bis 10, wobei der dritte Wirtsstoff durch die Formel 1 dargestellt wird: 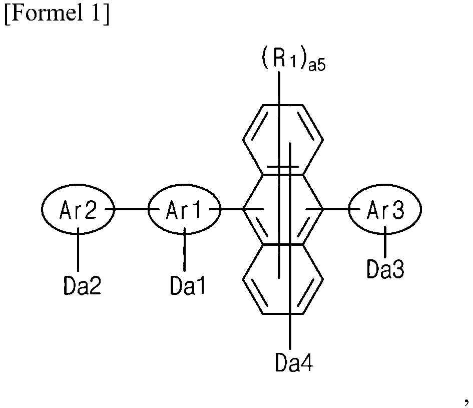
wobei in der Formel 1
a1, a2 und a3 jeweils unabhängig voneinander eine ganze Zahl von 0 oder 30 sind, a4 und a5 jeweils unabhängig voneinander eine ganze Zahl von 0 bis 8 sind und mindestens eines von a1 bis a4 eine positive ganze Zahl ist,
Ar1 ausgewählt ist aus der Gruppe, bestehend aus einer Einfachbindung (einer direkten Bindung), einer substituierten oder unsubstituierten C6- bis C30-Arylengruppe und einer substituierten oder unsubstituierten C3- bis C30-Heteroarylengruppe,
Ar2 und Ar3 jeweils ausgewählt sind aus der Gruppe, bestehend aus einer substituierten oder unsubstituierten C6- bis C30-Arylgruppe und einer substituierten oder unsubstituierten C3- bis C30-Heteroarylgruppe, und
R₁ ausgewählt ist aus der Gruppe, bestehend aus einer C1- bis C30-Alkylgruppe, die unsubstituiert oder mit Deuterium substituiert ist, und einer C3- bis C30-Cycloalkylgruppe, die unsubstituiert oder mit Deuterium substituiert ist,
wobei der vierte Wirtsstoff durch die Formel 5 dargestellt wird: 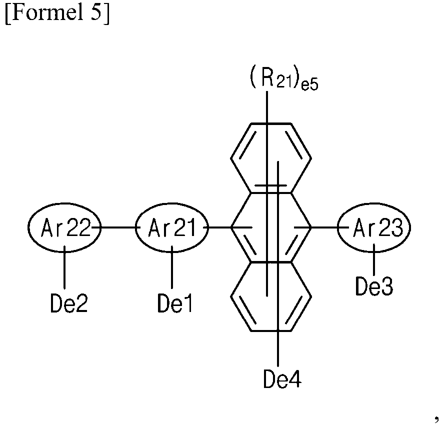
wobei in der Formel 5
e1, e2 und e3 jeweils unabhängig voneinander eine ganze Zahl von 0 oder 30 sind, e4 und e5 jeweils unabhängig voneinander eine ganze Zahl von 0 bis 8 sind und die Summe von el bis e4 kleiner ist als die Summe von a1 bis a4 in der Formel 1,
Ar21 ausgewählt ist aus der Gruppe, bestehend aus einer Einfachbindung (einer direkten Bindung), einer substituierten oder unsubstituierten C6- bis C30-Arylengruppe und einer substituierten oder unsubstituierten C3- bis C30-Heteroarylengruppe,
Ar22 und Ar23 jeweils ausgewählt sind aus der Gruppe, bestehend aus einer substituierten oder unsubstituierten C6- bis C30-Arylgruppe und einer substituierten oder unsubstituierten C3- bis C30-Heteroarylgruppe, und
R₂₁ ausgewählt ist aus der Gruppe, bestehend aus einer C1- bis C30-Alkylgruppe, die unsubstituiert oder mit Deuterium substituiert ist, und einer C3- bis C30-Cycloalkylgruppe, die unsubstituiert oder mit Deuterium substituiert ist.

12. Organische Leuchtdiode gemäß einem der Ansprüche 9 bis 11, wobei der dritte Wirtsstoff durch die Formel 1a dargestellt wird: 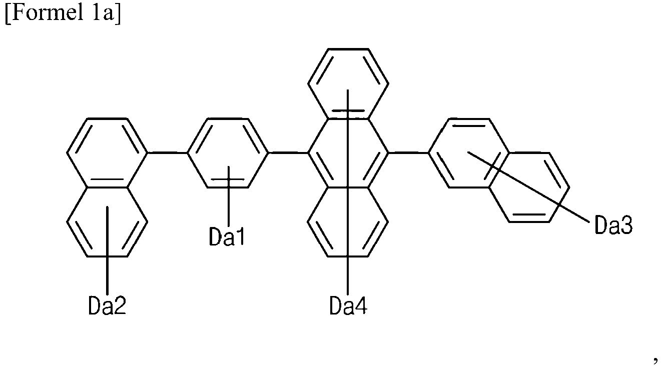
wobei in der Formel 1a a1 eine ganze Zahl von 0 bis 4 ist, a2 und a3 jeweils unabhängig voneinander eine ganze Zahl von 0 bis 7 sind, a4 eine ganze Zahl von 0 bis 8 ist und mindestens eines von a1 bis a4 eine positive ganze Zahl ist,
wobei der vierte Wirtsstoff durch die Formel 5a dargestellt wird: 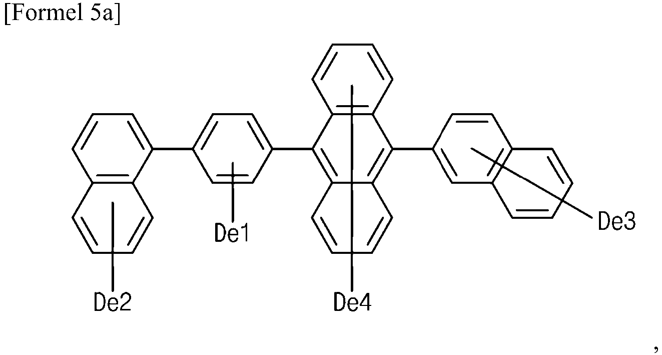
wobei in der Formel 5a e1 eine ganze Zahl von 0 bis 4 ist, e2 und e3 jeweils unabhängig voneinander eine ganze Zahl von 0 bis 7 sind, e4 eine ganze Zahl von 0 bis 8 ist und die Summe von e1 bis e4 kleiner ist als die Summe von a1 bis a4 in der Formel 1a.

13. Organische Leuchtdiode gemäß einem der Ansprüche 1 bis 12, wobei der erste Dotierstoff ein Borderivat mit einem ersten HOMO-Energieniveau ist und der zweite Dotierstoff ein Borderivat mit einem zweiten HOMO-Energieniveau ist, das niedriger als das erste HOMO-Energieniveau ist, und wobei der erste Dotierstoff eine erste Triplett-Energie hat und der zweite Dotierstoff eine zweite Triplett-Energie hat, die größer als die erste Triplett-Energie ist.

14. Organische lichtemittierende Vorrichtung, umfassend:
ein Substrat;
eine organische Leuchtdiode nach Anspruch 1 über dem Substrat; und
eine Verkapselungsschicht, die die organische Leuchtdiode bedeckt,
wobei das Substrat einen roten Pixelbereich, einen grünen Pixelbereich und einen blauen Pixelbereich umfasst und die organische Leuchtdiode dem roten Pixelbereich, dem grünen Pixelbereich und dem blauen Pixelbereich entspricht,
wobei die organische lichtemittierende Vorrichtung ferner umfasst: eine Farbfilterschicht, die dem roten Pixelbereich, dem grünen Pixelbereich und dem blauen Pixelbereich entspricht und zwischen dem Substrat und der organischen Leuchtdiode oder über der organischen Leuchtdiode angeordnet ist, oder
wobei die organische lichtemittierende Vorrichtung ferner umfasst: eine Farbkonversionsschicht, die dem roten Pixelbereich und dem grünen Pixelbereich entspricht und zwischen dem Substrat und der organischen Leuchtdiode oder über der organischen Leuchtdiode angeordnet ist.

## Revendications

1. Diode électroluminescente organique, comportant :
une première électrode ;
une seconde électrode faisant face à la première électrode ; et
une première partie émettrice incluant une première couche émettrice de bleu et une deuxième couche émettrice de bleu et positionnée entre les première et seconde électrodes, la deuxième couche émettrice de bleu étant positionnée entre la première couche émettrice de bleu et la seconde électrode et en contact avec la première couche émettrice de bleu,
dans laquelle la première couche émettrice de bleu inclut un premier hôte et un premier dopant, et la deuxième couche émettrice de bleu comporte un deuxième hôte et un deuxième dopant,
dans laquelle le premier hôte est un dérivé d'anthracène ayant un premier rapport de deutériation, et le deuxième hôte est un dérivé d'anthracène ayant un deuxième rapport de deutériation inférieur au premier rapport de deutériation,
**caractérisée en ce que** le premier dopant est représenté par la Formule 3a : 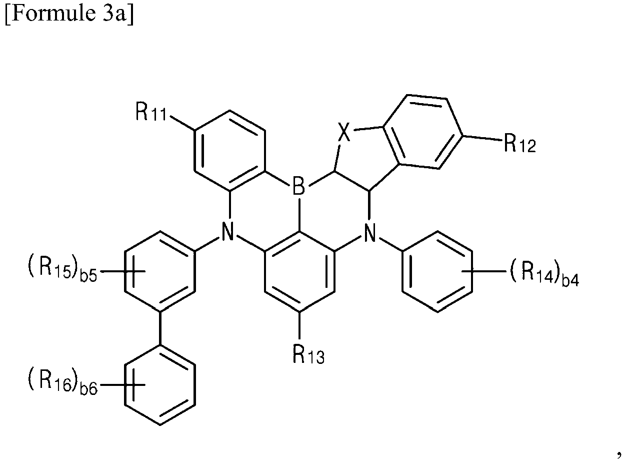
dans laquelle, dans la Formule 3a,
chaque élément parmi b4 et b6 est indépendamment un entier de 0 à 5, et b5 est un entier de 0 à 4,
X est O ou S,
R₁₁, R₁₂ et R₁₃ sont choisis indépendamment les uns des autres parmi le groupe constitué d'un groupe alkyle en C₁ à C₃₀ substitué ou non substitué, d'un groupe cycloalkyle en C₃ à C₃₀ substitué ou non substitué, d'un groupe arylamino en C₆ à C₃₀ substitué ou non substitué, d'un groupe aryle en C₆ à C₃₀ substitué ou non substitué et d'un groupe hétéroaryle en C₃ à C₃₀ substitué ou non substitué, ou au moins les éléments d'une paire de deux éléments R₁₁ adjacents ou plus, de deux éléments R₁₂ adjacents ou plus et de deux éléments R₁₃ adjacents ou plus sont reliés l'un à l'autre pour former un cycle substitué ou non substitué, et
chaque élément parmi R₁₄, R₁₅ et R₁₆ est choisi parmi le groupe constitué d'un groupe alkyle en C₁ à C₃₀ substitué ou non substitué et d'un groupe cycloalkyle en C₃ à C₃₀ substitué ou non substitué, ou au moins une paire de deux éléments R₁₄ adjacents et des éléments R₁₅ et R₁₆ adjacents sont reliés les uns aux autres pour former un cycle substitué ou non substitué,
dans laquelle le deuxième dopant est un deuxième composé représenté par la Formule 7 : 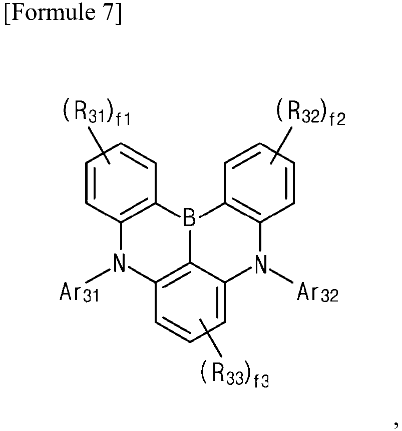
dans laquelle, dans la Formule 7,
chaque élément parmi f1 et f2 est indépendamment un entier de 0 à 4, et f3 est un entier de 0 à 3,
chaque élément parmi Ar₃₁ et Ar₃₂ est choisi indépendamment de l'autre parmi le groupe constitué d'un groupe aryle en C₆ à C₃₀ substitué ou non substitué, d'un groupe hétéroaryle en C₃ à C₃₀ substitué ou non substitué, et d'un groupe alicyclique en C₆ à C₃₀ substitué ou non substitué, et
R₃₁, R₃₂ et R₃₃ sont choisis indépendamment les uns des autres parmi le groupe constitué d'un groupe alkyle en C₁ à C₃₀ substitué ou non substitué, d'un groupe cycloalkyle en C₃ à C₃₀ substitué ou non substitué, d'un groupe arylamino en C₆ à C₃₀ substitué ou non substitué, d'un groupe aryle en C₆ à C₃₀ substitué ou non substitué, et d'un groupe hétéroaryle en C₃ à C₃₀ substitué ou non substitué.

2. Diode électroluminescente organique selon la revendication 1, dans laquelle le deuxième dopant est représenté par la Formule 7a : 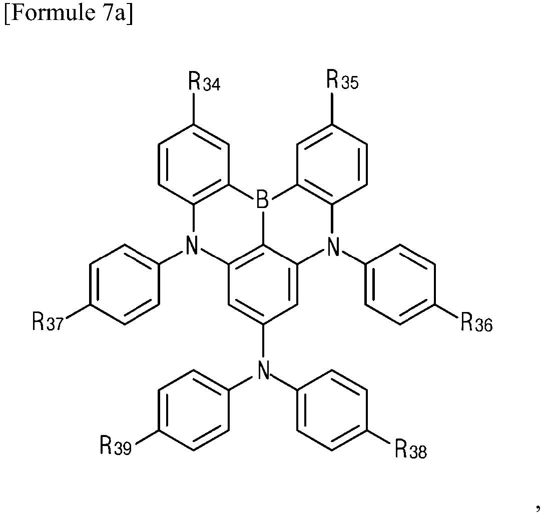 dans laquelle, dans la Formule 7a, chaque élément parmi R₃₄ à R₃₉ est choisi indépendamment des autres parmi le groupe constitué de l'hydrogène, d'un groupe alkyle en C₁ à C₃₀ substitué ou non substitué, d'un groupe cycloalkyle en C₃ à C₃₀ substitué ou non substitué, d'un groupe aryle en C₆ à C₃₀ substitué ou non substitué, et d'un groupe hétéroaryle en C₃ à C₃₀ substitué ou non substitué.

3. Diode électroluminescente organique selon l'une quelconque des revendications 1 à 2, dans laquelle le premier dopant est l'un des composés de Formule 4 :

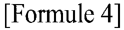

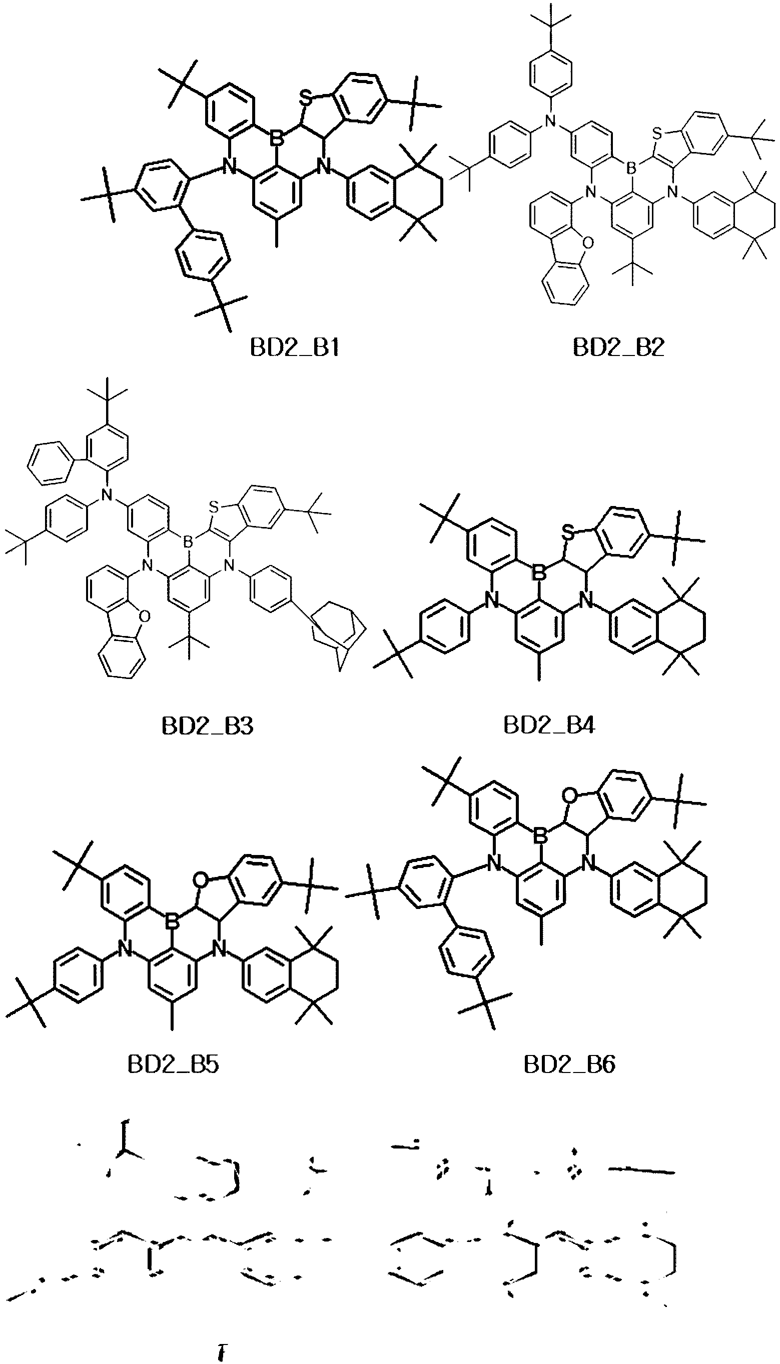

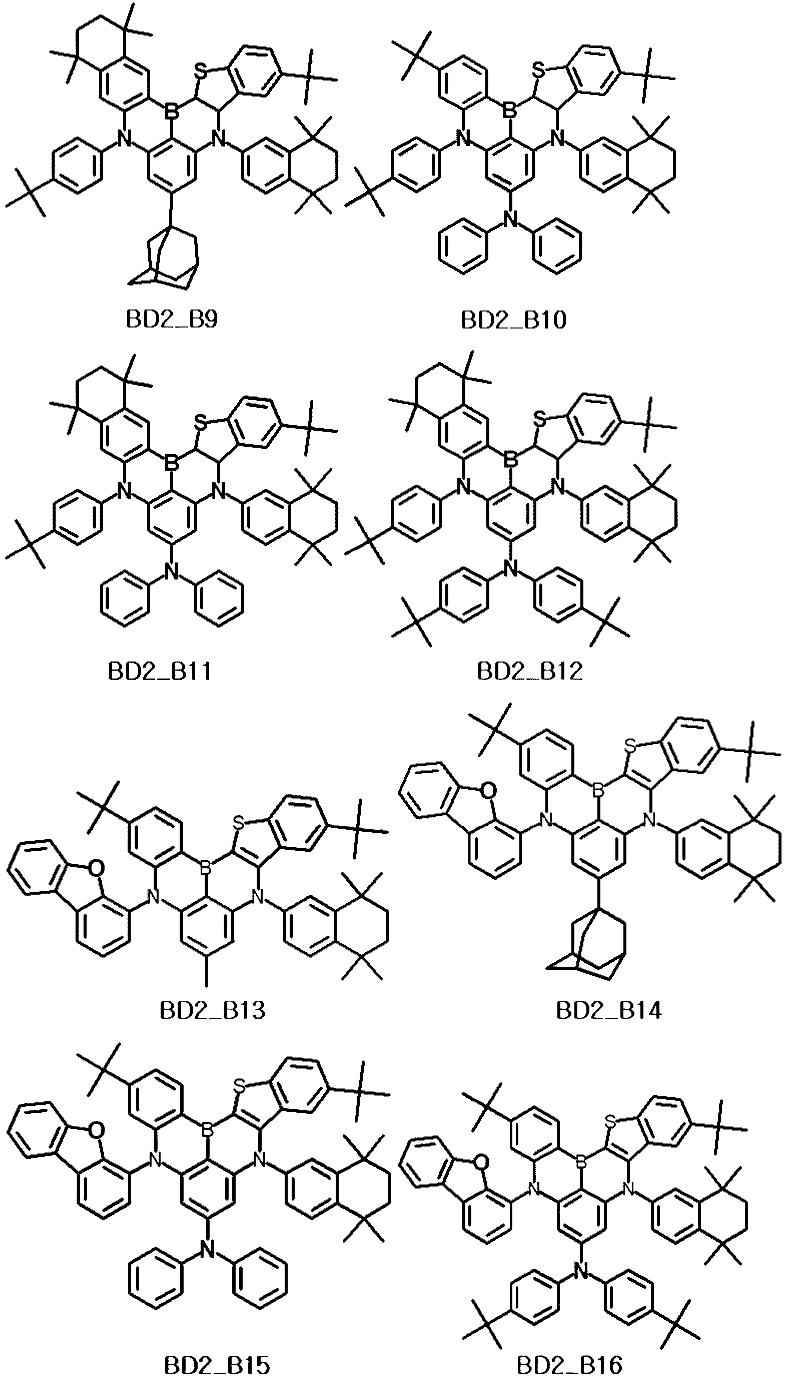

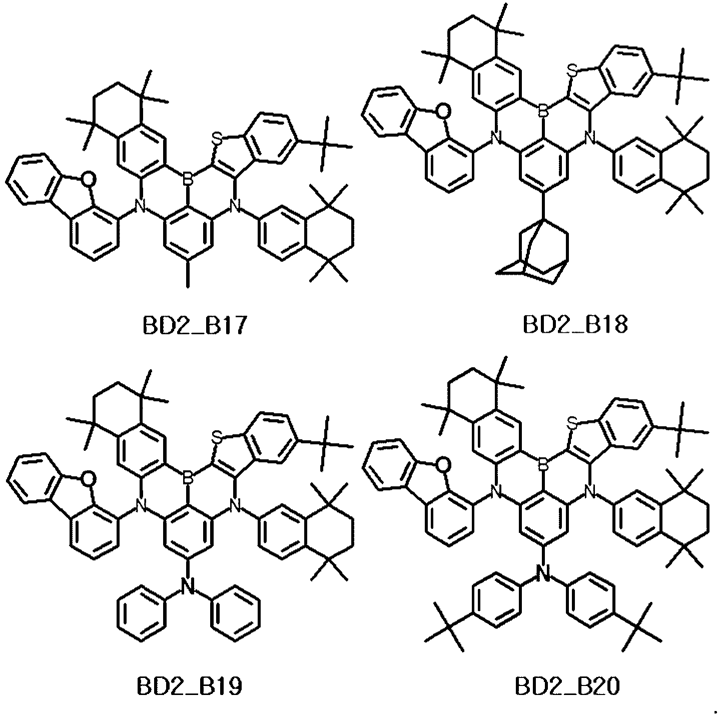

4. Diode électroluminescente organique selon l'une quelconque des revendications 1 à 3, dans laquelle le deuxième dopant est l'un des composés de Formule 8 :

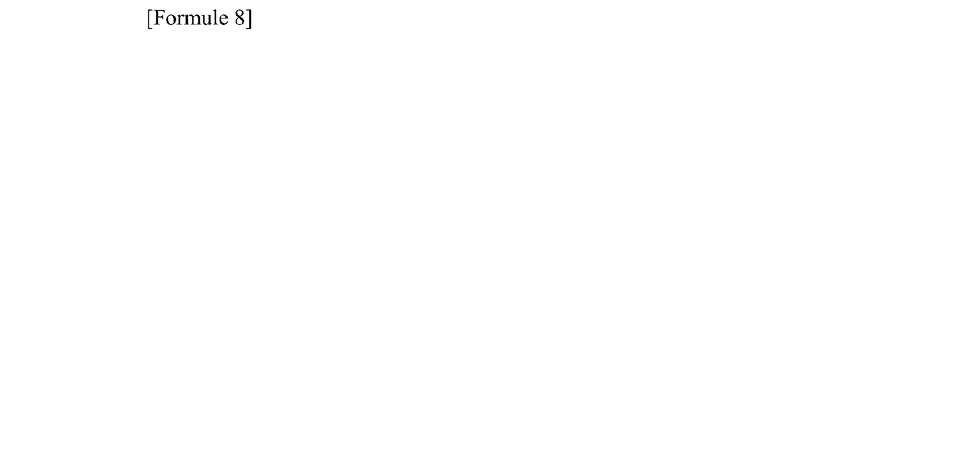

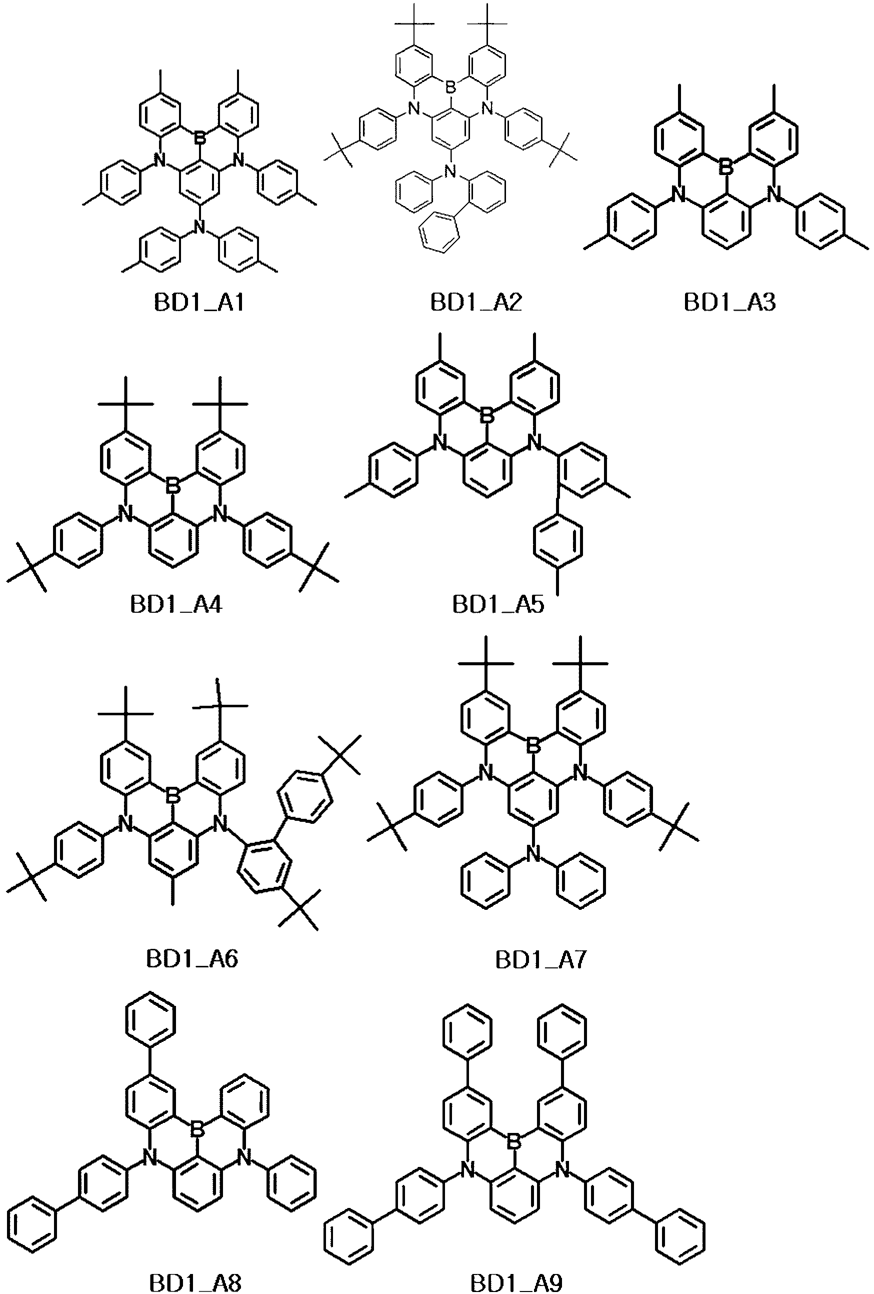

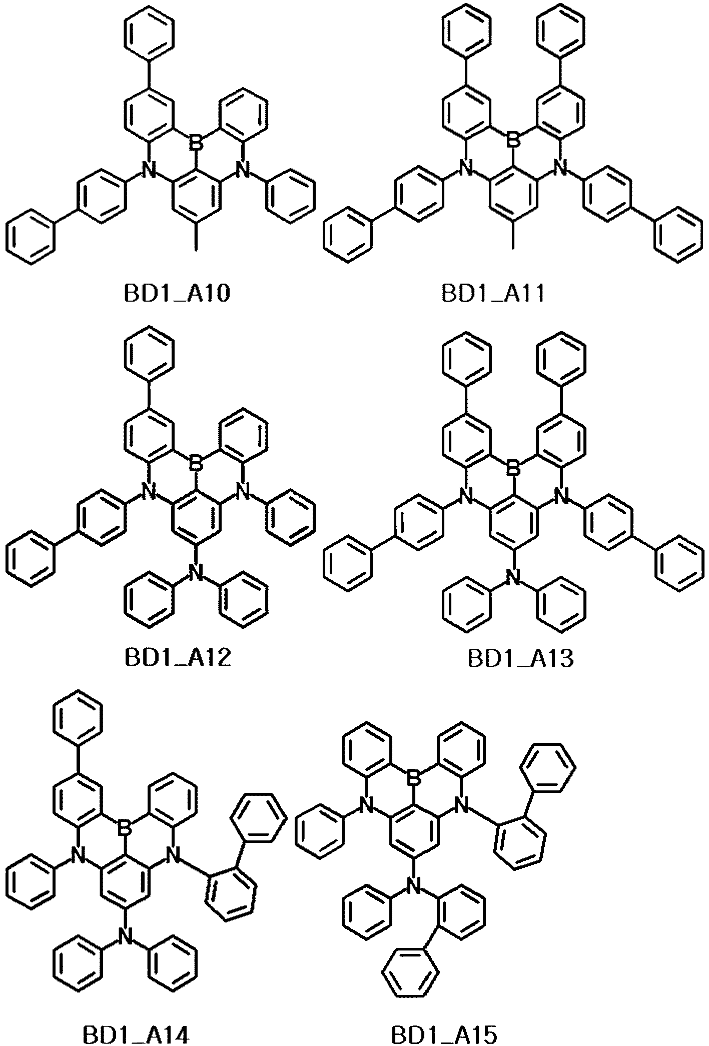

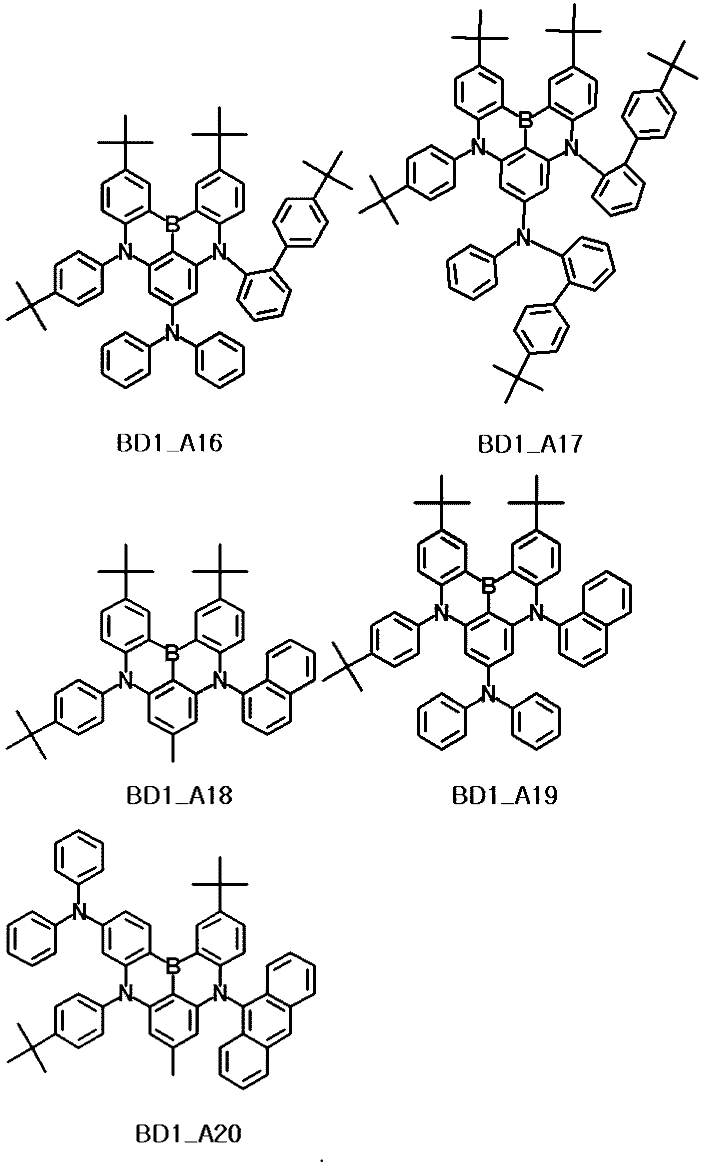

5. Diode électroluminescente organique selon l'une quelconque des revendications 1 à 4, dans laquelle le premier hôte est représenté par la Formule 1 : 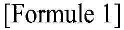 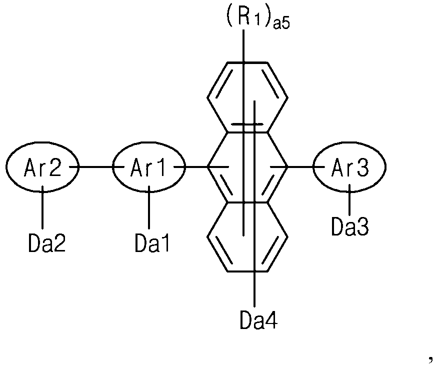
dans laquelle, dans la Formule 1,
chaque élément parmi al, a2 et a3 est indépendamment un entier de 0 ou 30, chaque élément parmi a4 et a5 est indépendamment un entier de 0 à 8, et au moins un élément parmi a1 à a4 est un entier positif,
Ar1 est choisi parmi le groupe constitué d'une liaison simple (une liaison directe), d'un groupe arylène en C₆ à C₃₀ substitué ou non substitué, et d'un groupe hétéroarylène en C₃ à C₃₀ substitué ou non substitué,
chaque élément parmi Ar2 et Ar3 est choisi parmi le groupe constitué d'un groupe aryle en C₆ à C₃₀ substitué ou non substitué, et d'un groupe hétéroaryle en C₃ à C₃₀ substitué ou non substitué, et
R₁ est choisi parmi le groupe constitué d'un groupe alkyle en C₁ à C₃₀ non substitué ou substitué par du deutérium, et d'un groupe cycloalkyle en C₃ à C₃₀ non substitué ou substitué par du deutérium,
dans laquelle le deuxième hôte est représenté par la Formule 5 : 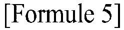 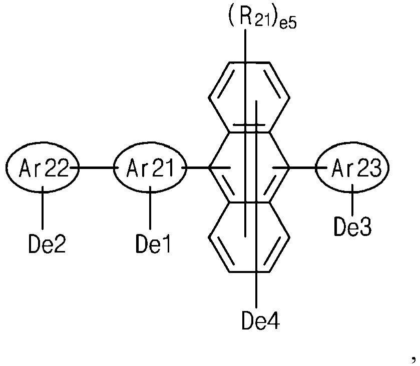
dans laquelle, dans la Formule 5,
chaque élément parmi el, e2 et e3 est indépendamment un entier de 0 ou 30, chaque élément parmi e4 et e5 est indépendamment un entier de 0 à 8, et une somme de e1 à e4 est inférieure à une somme de a1 à a4 dans la Formule 1,
Ar21 est choisi parmi le groupe constitué d'une liaison simple (une liaison directe), d'un groupe arylène en C₆ à C₃₀ substitué ou non substitué, et d'un groupe hétéroarylène en C₃ à C₃₀ substitué ou non substitué,
chaque élément parmi Ar22 et Ar23 est choisi parmi le groupe constitué d'un groupe aryle en C₆ à C₃₀ substitué ou non substitué, et d'un groupe hétéroaryle en C₃ à C₃₀ substitué ou non substitué, et
R₂₁ est choisi parmi le groupe constitué d'un groupe alkyle en C₁ à C₃₀ non substitué ou substitué par du deutérium, et d'un groupe cycloalkyle en C₃ à C₃₀ non substitué ou substitué par du deutérium.

6. Diode électroluminescente organique selon l'une quelconque des revendications 1 à 5, dans laquelle le premier hôte est représenté par la Formule la : 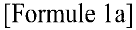 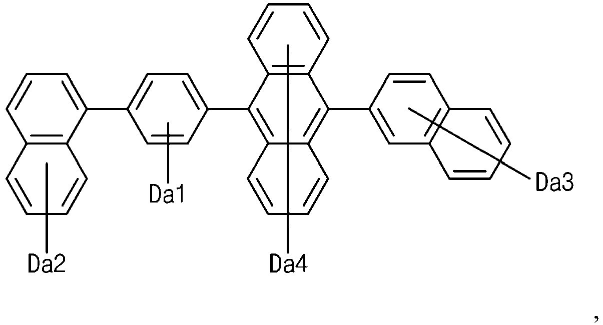
dans laquelle, dans la Formule 1a, a1 est un entier de 0 à 4, chaque élément parmi a2 et a3 est indépendamment un entier de 0 à 7, a4 est un entier de 0 à 8, et au moins un élément parmi a1 à a4 est un entier positif,
dans laquelle le deuxième hôte est représenté par la Formule 5a : 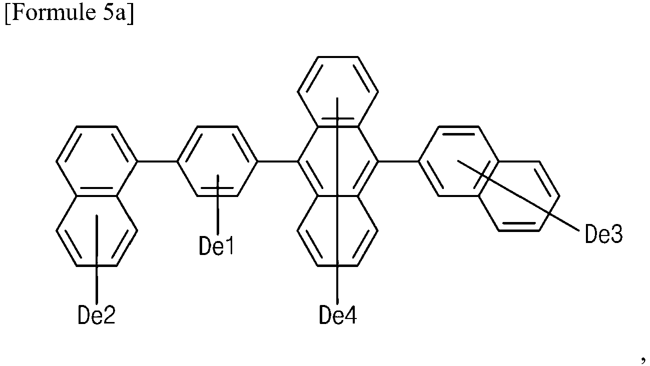
dans laquelle, dans la Formule 5a, e1 est un entier de 0 à 4, chaque élément parmi e2 et e3 est indépendamment un entier de 0 à 7, e4 est un entier de 0 à 8, et une somme de e1 à e4 est inférieure à une somme de a1 à a4 dans la Formule la.

7. Diode électroluminescente organique selon l'une quelconque des revendications 1 à 6, dans laquelle le premier hôte inclut au moins l'un des composés du premier hôte dans la Formule 2 :

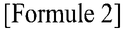

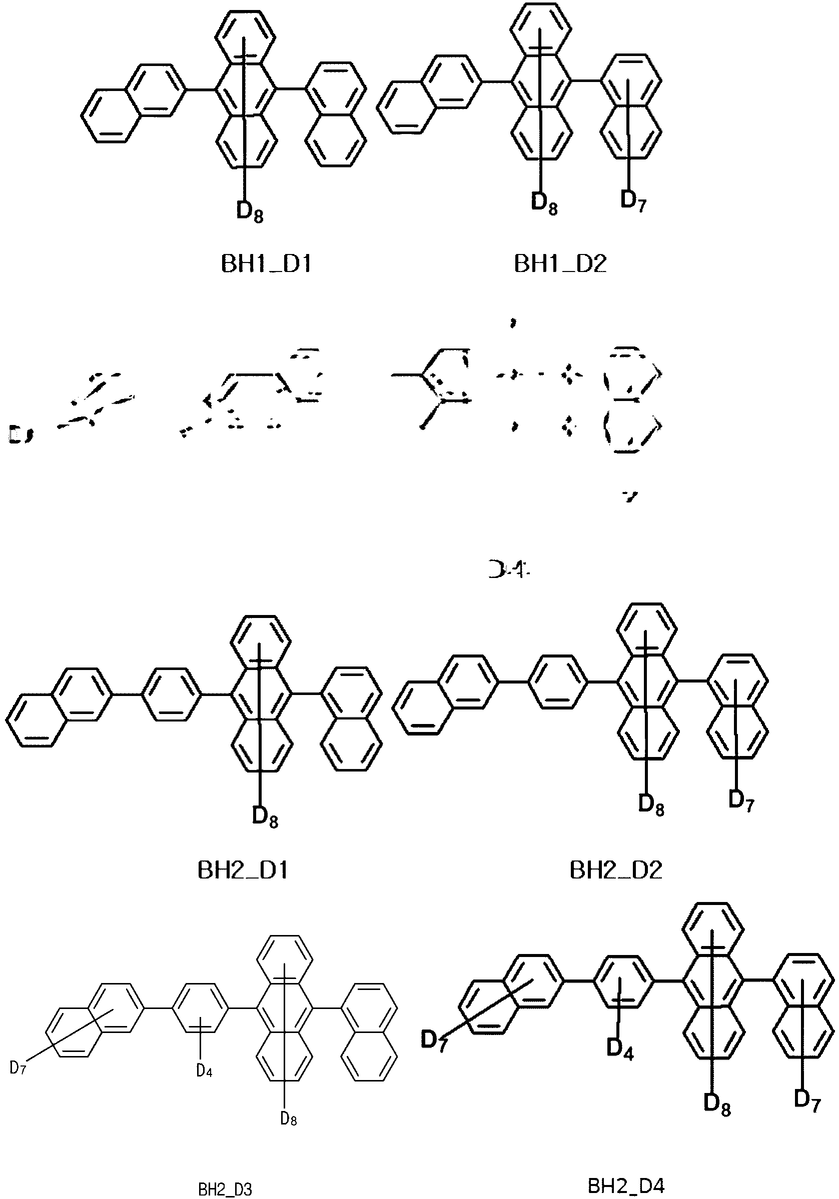

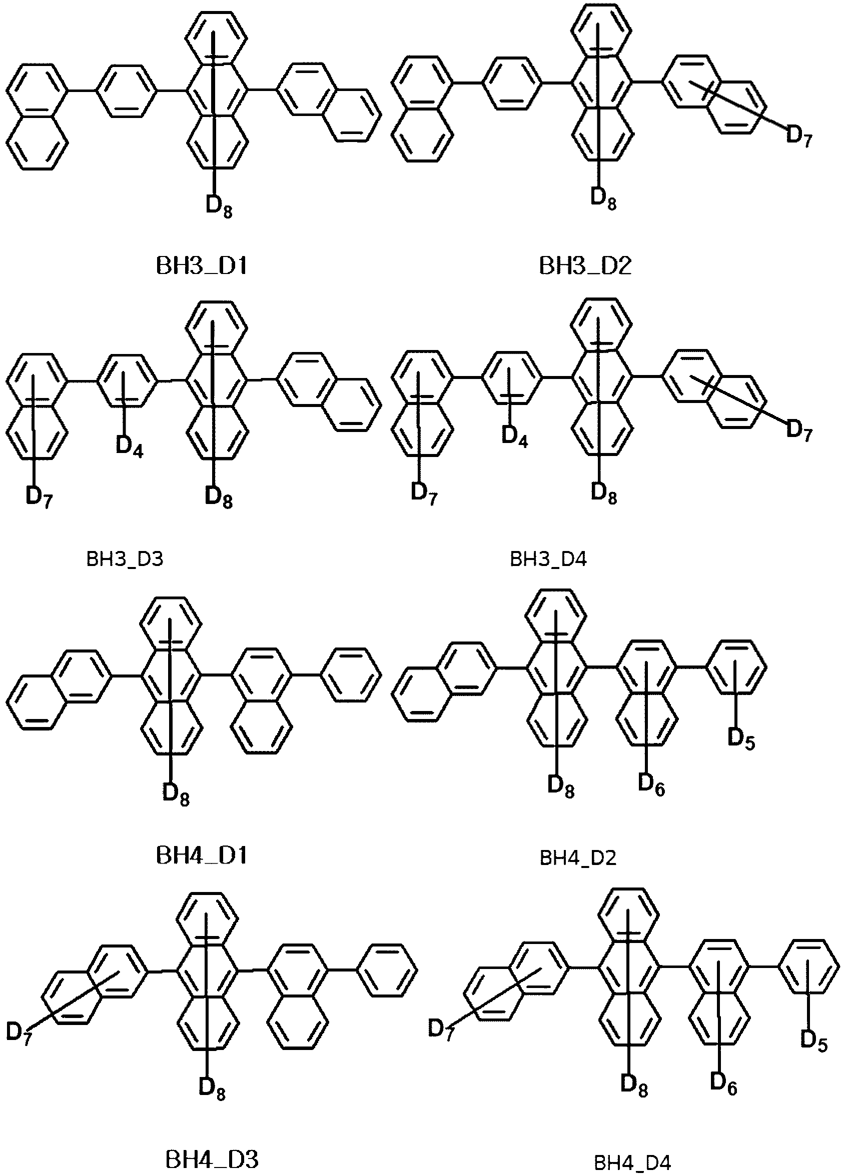

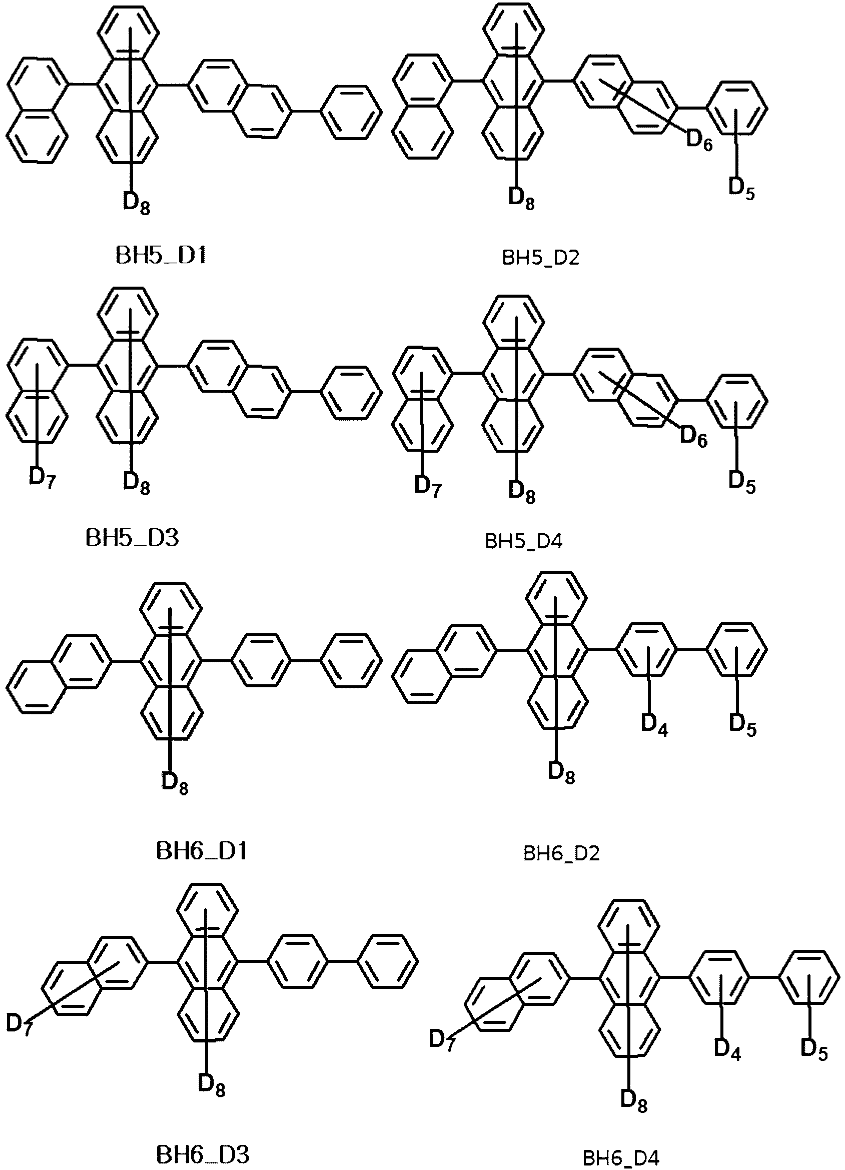

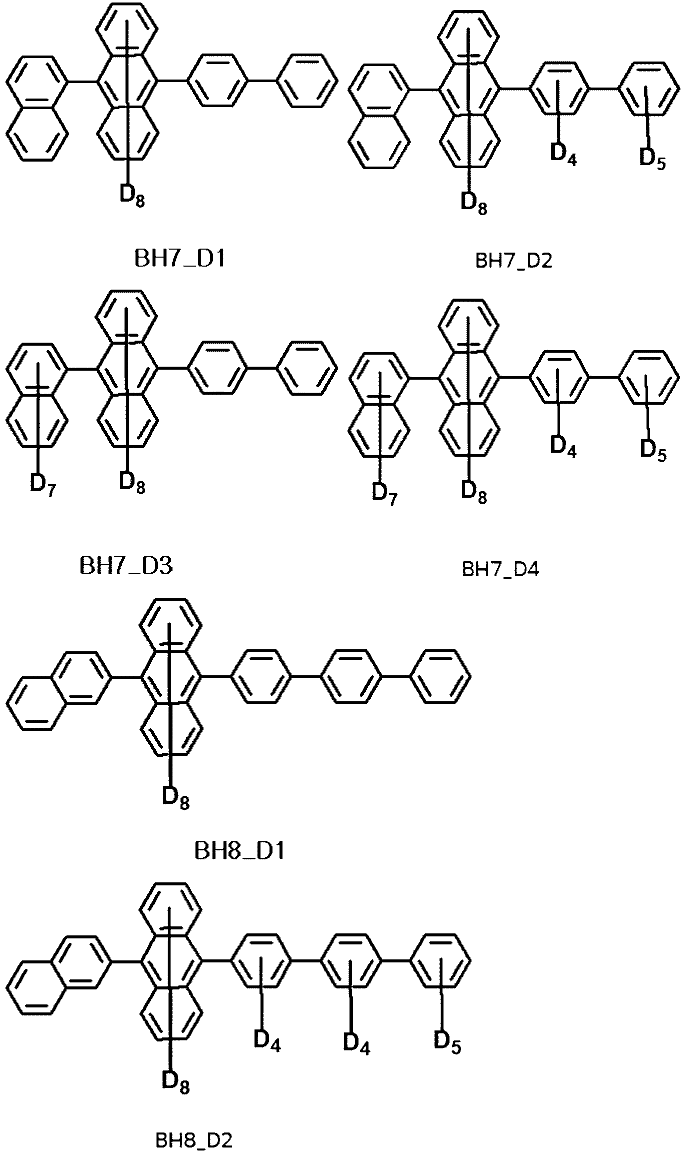

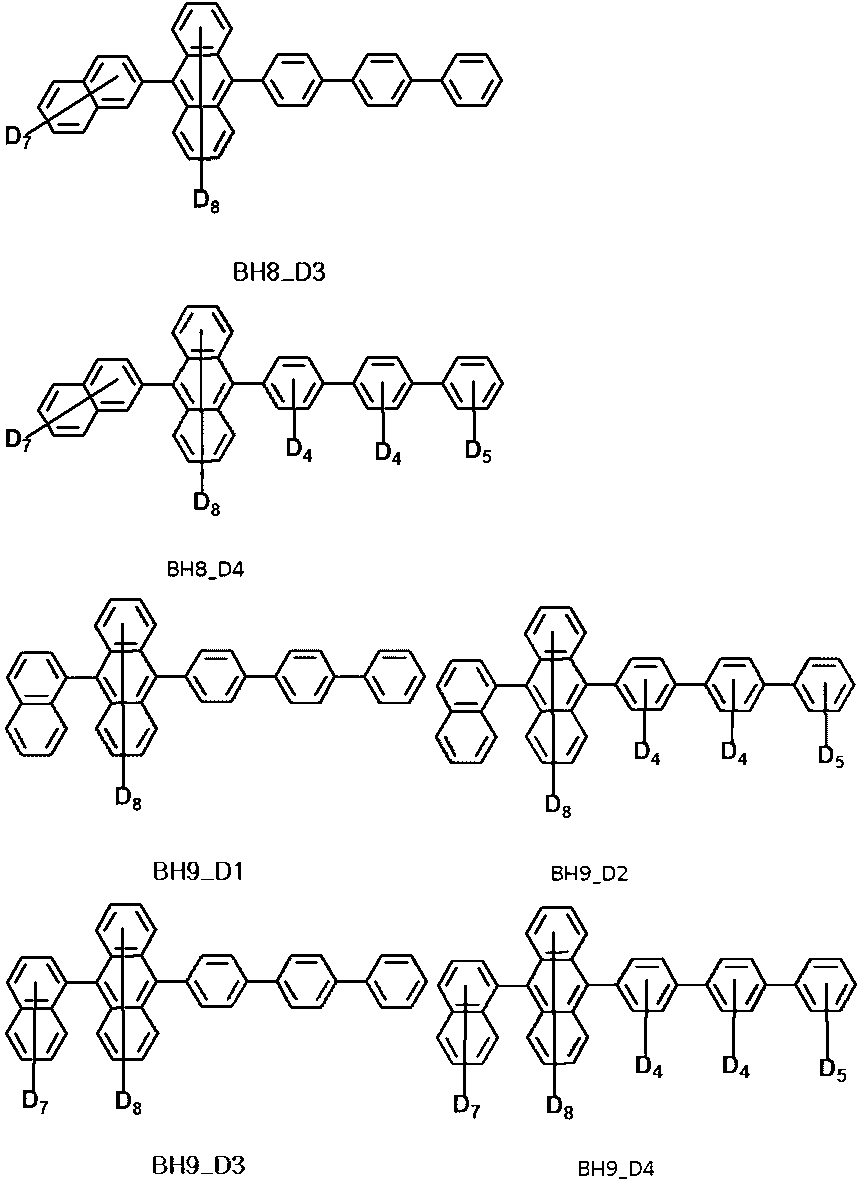

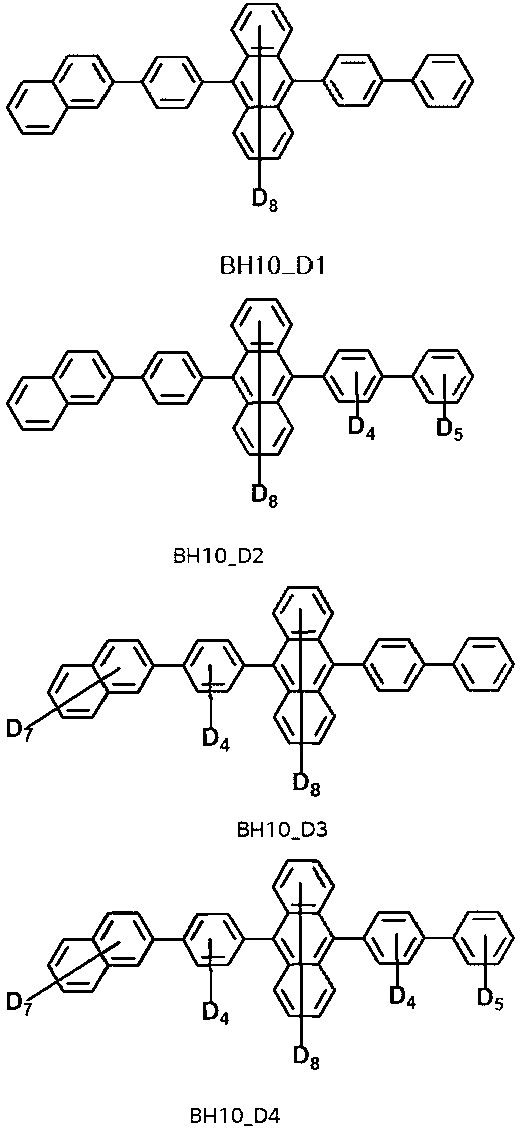

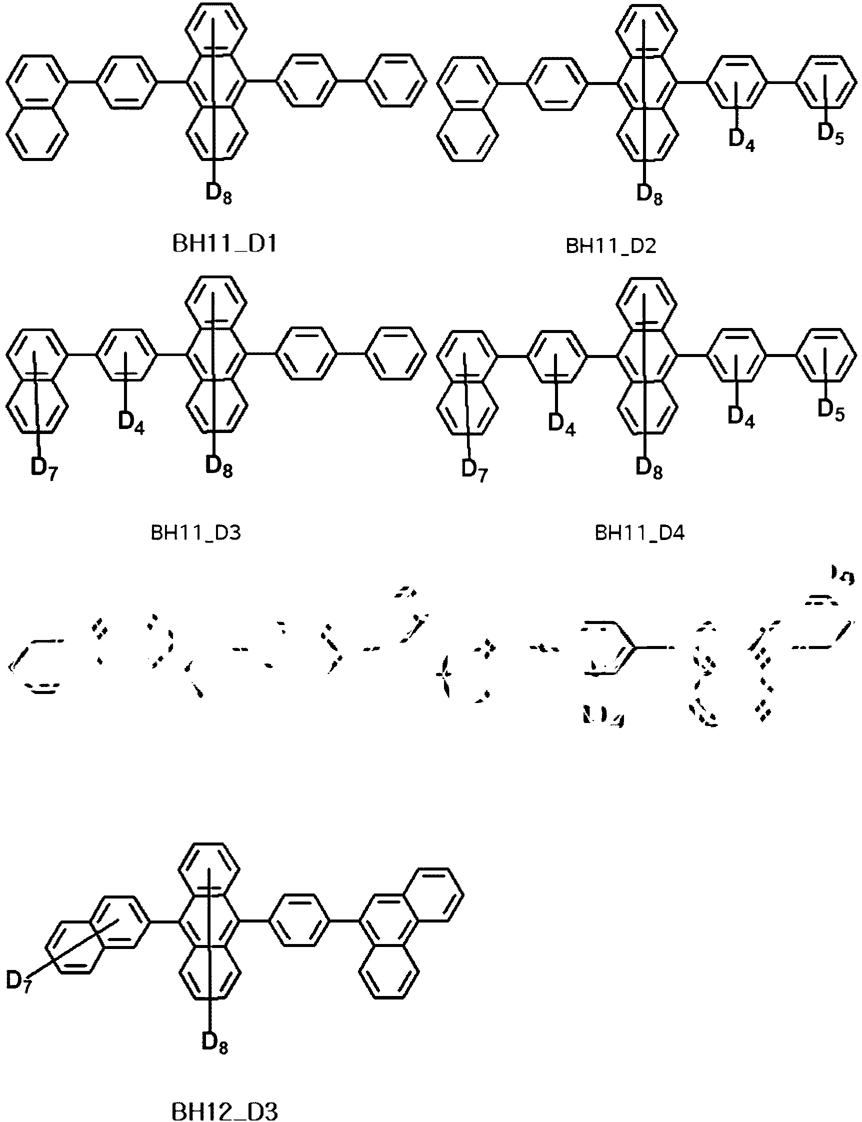

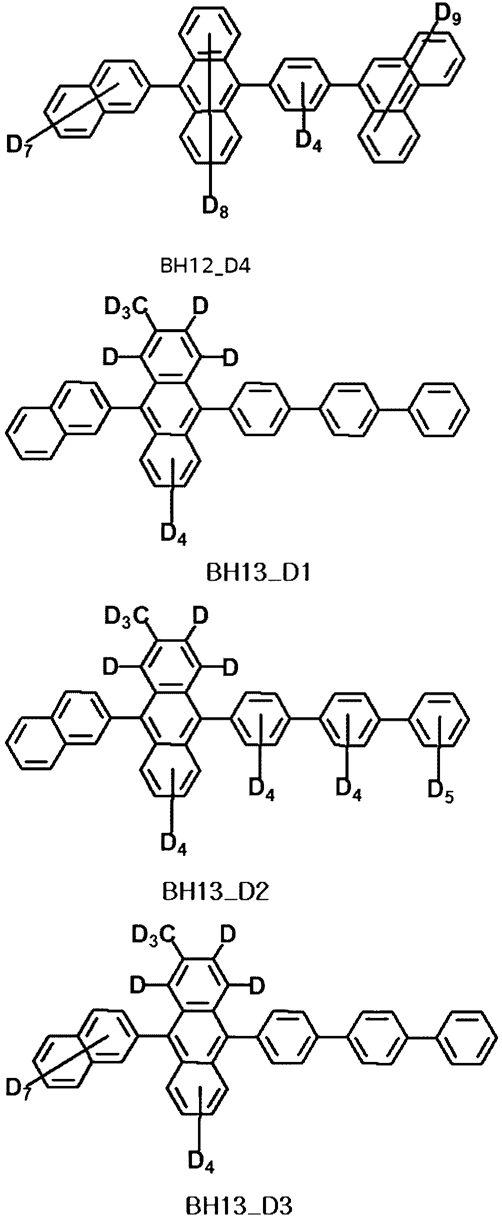

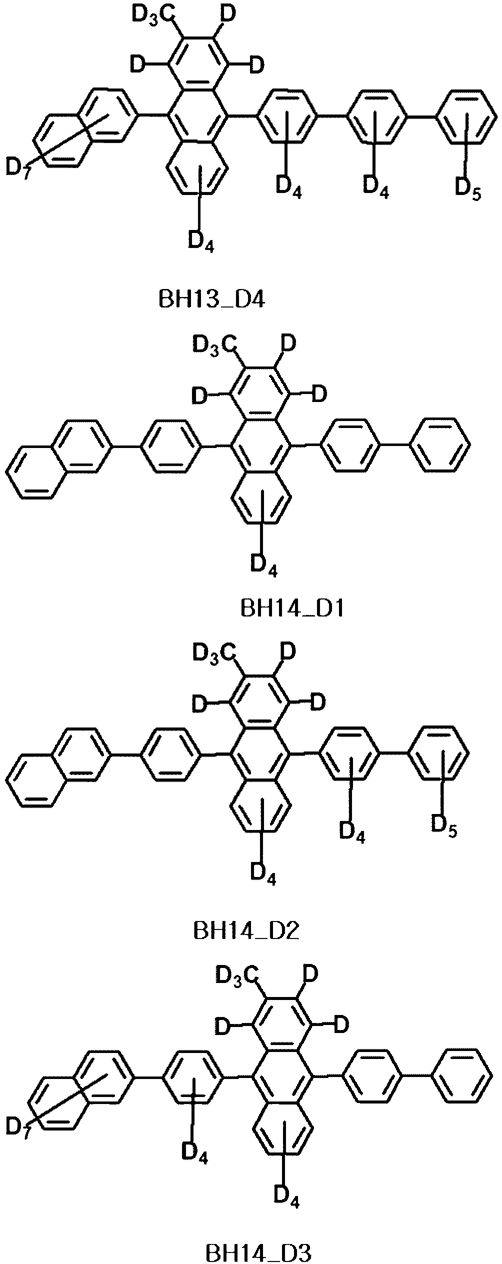

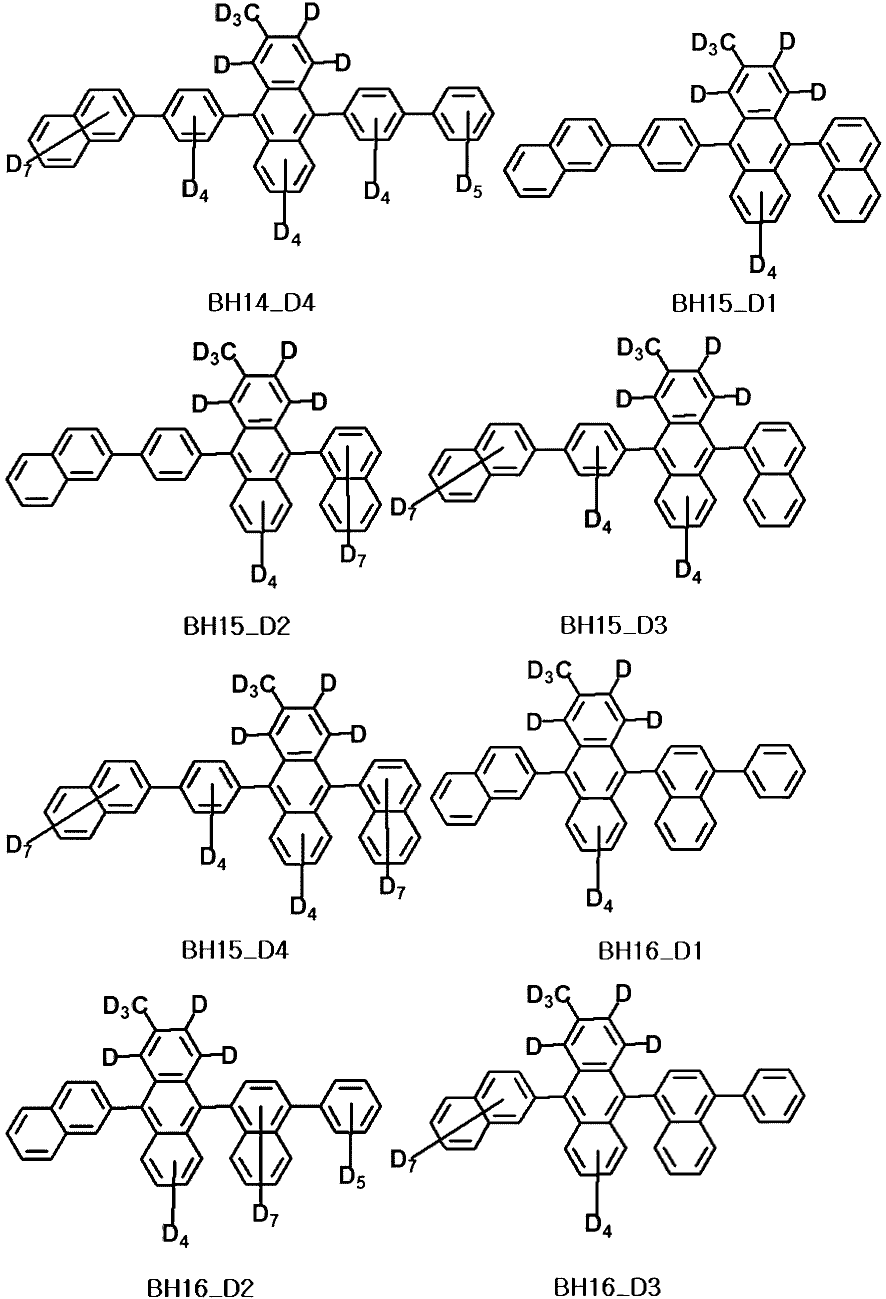

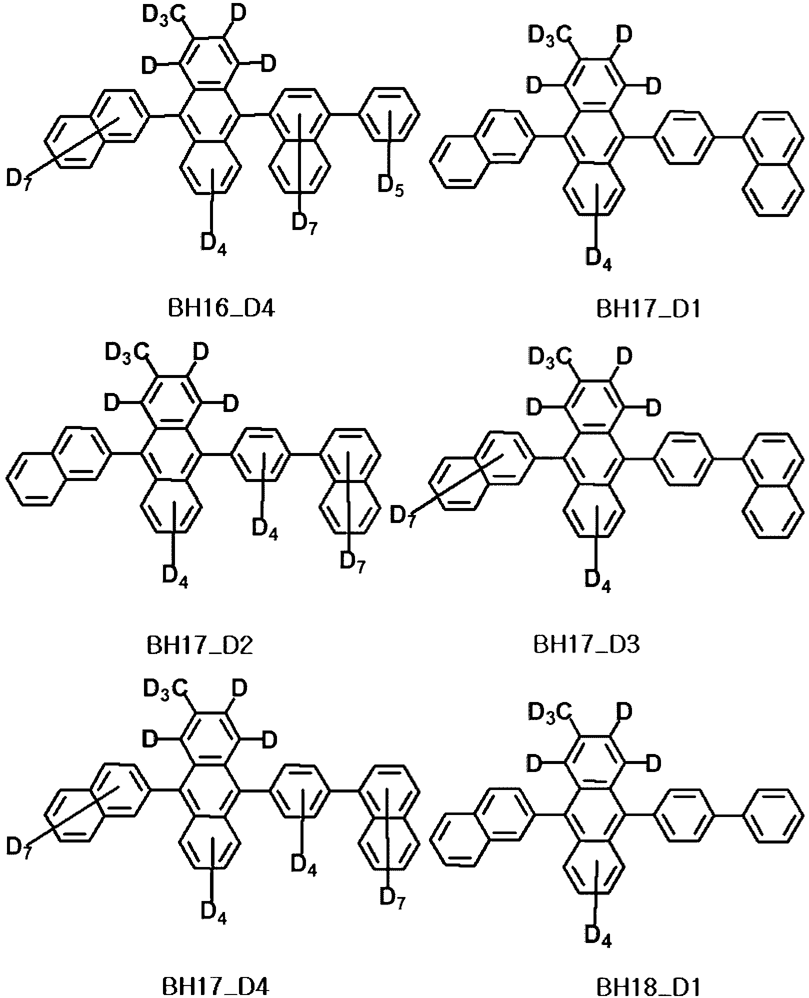

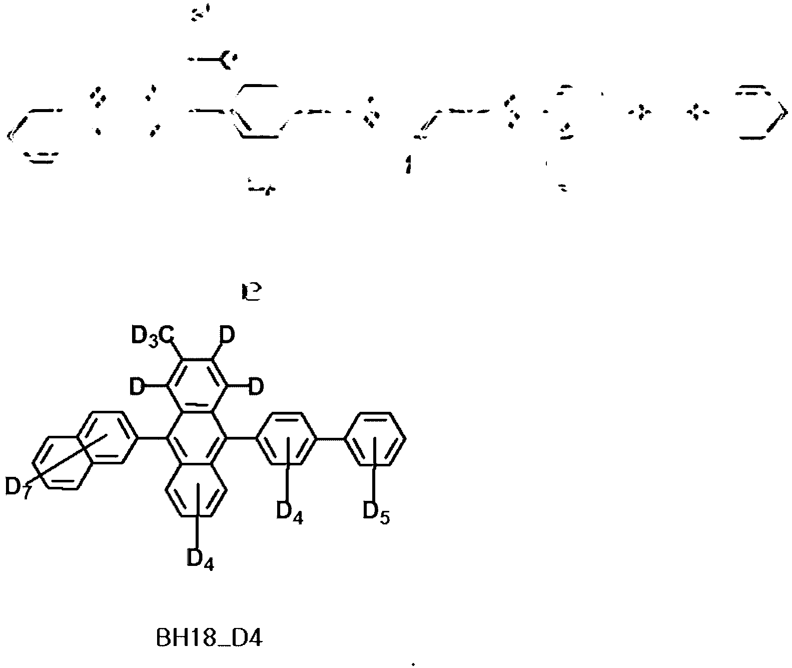

8. Diode électroluminescente organique selon l'une quelconque des revendications 1 à 7, dans laquelle le deuxième hôte inclut au moins l'un des composés du deuxième hôte dans la Formule 6 :

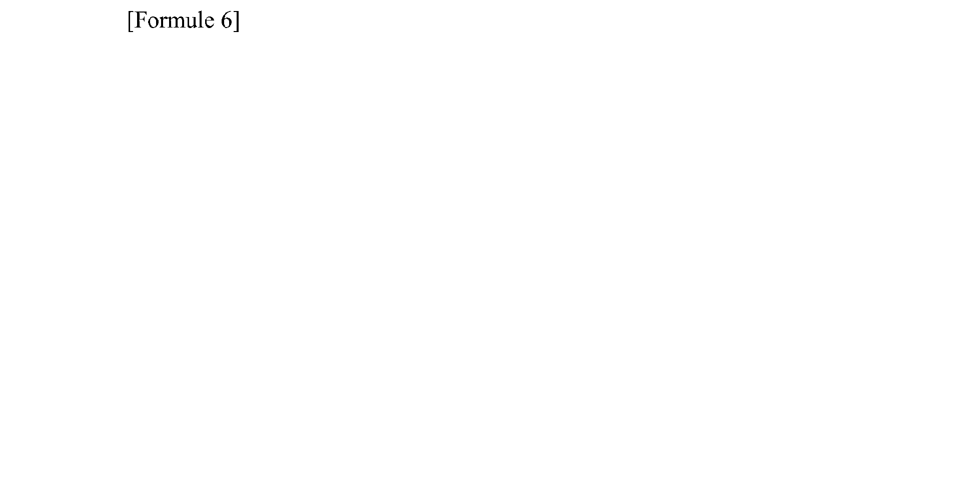

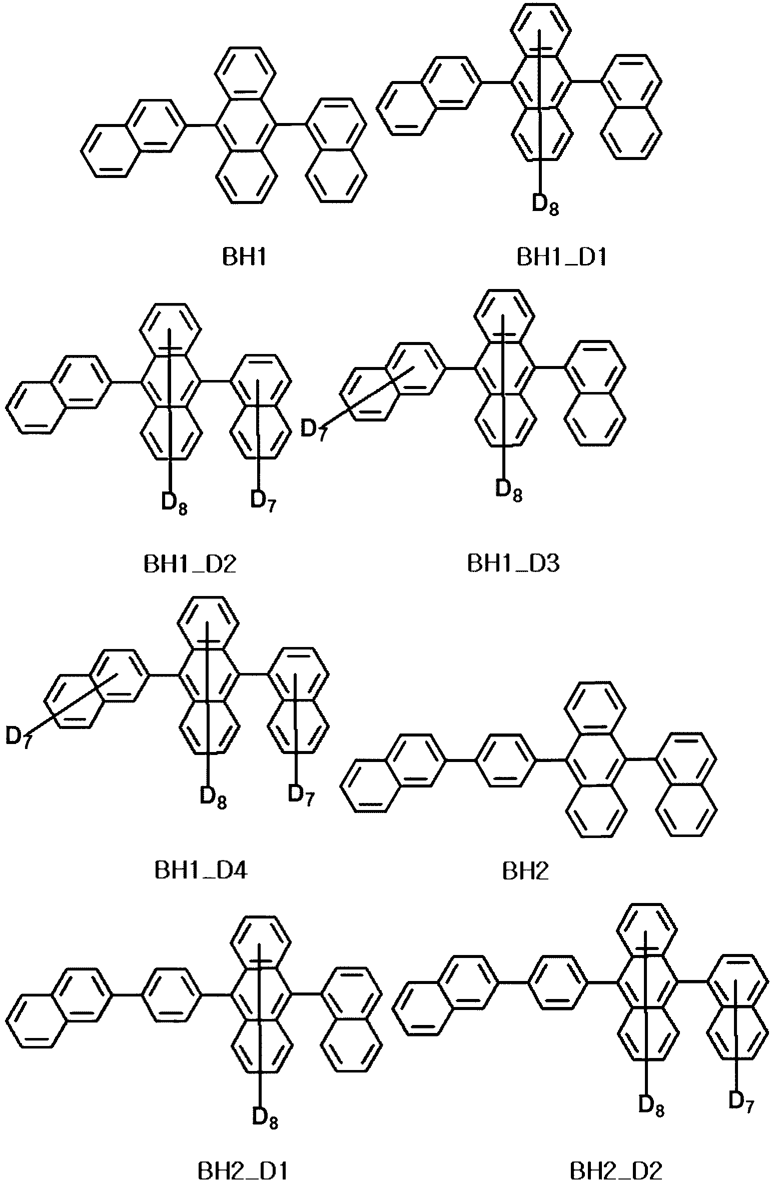

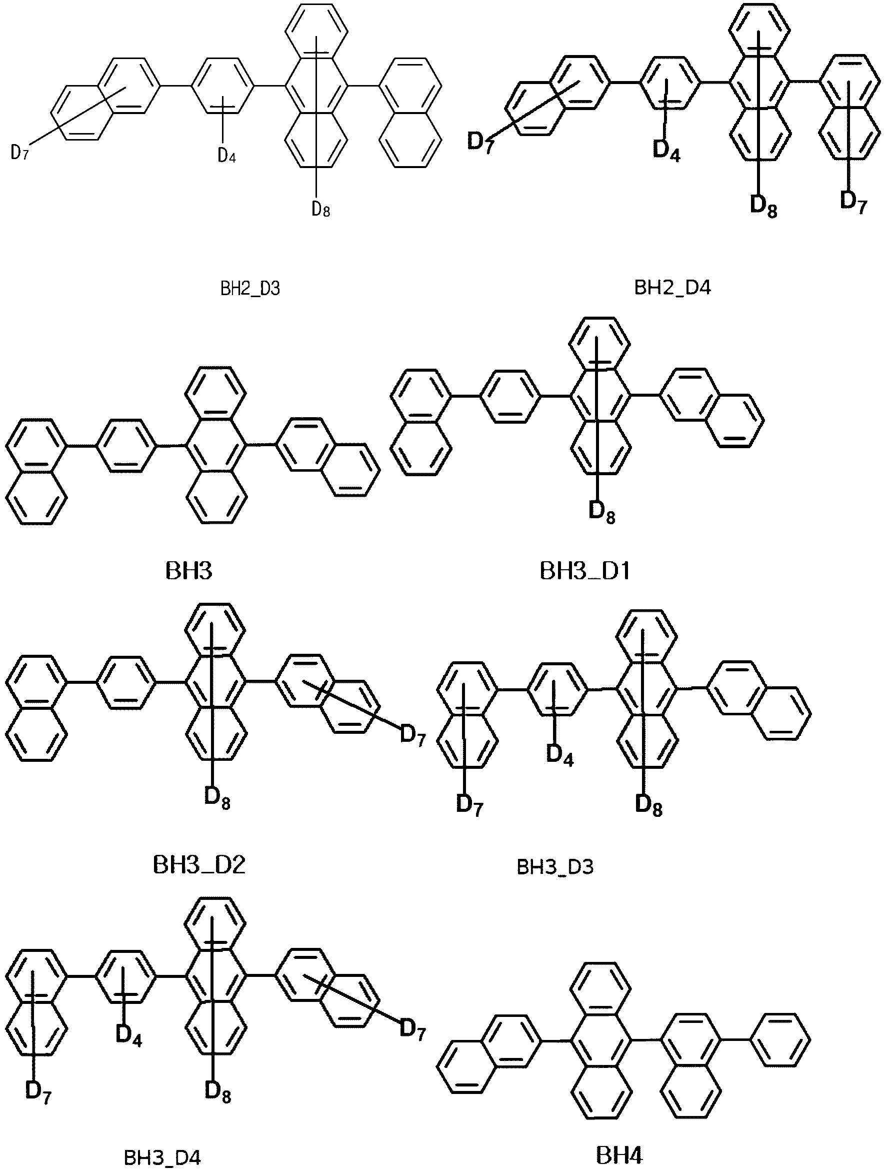

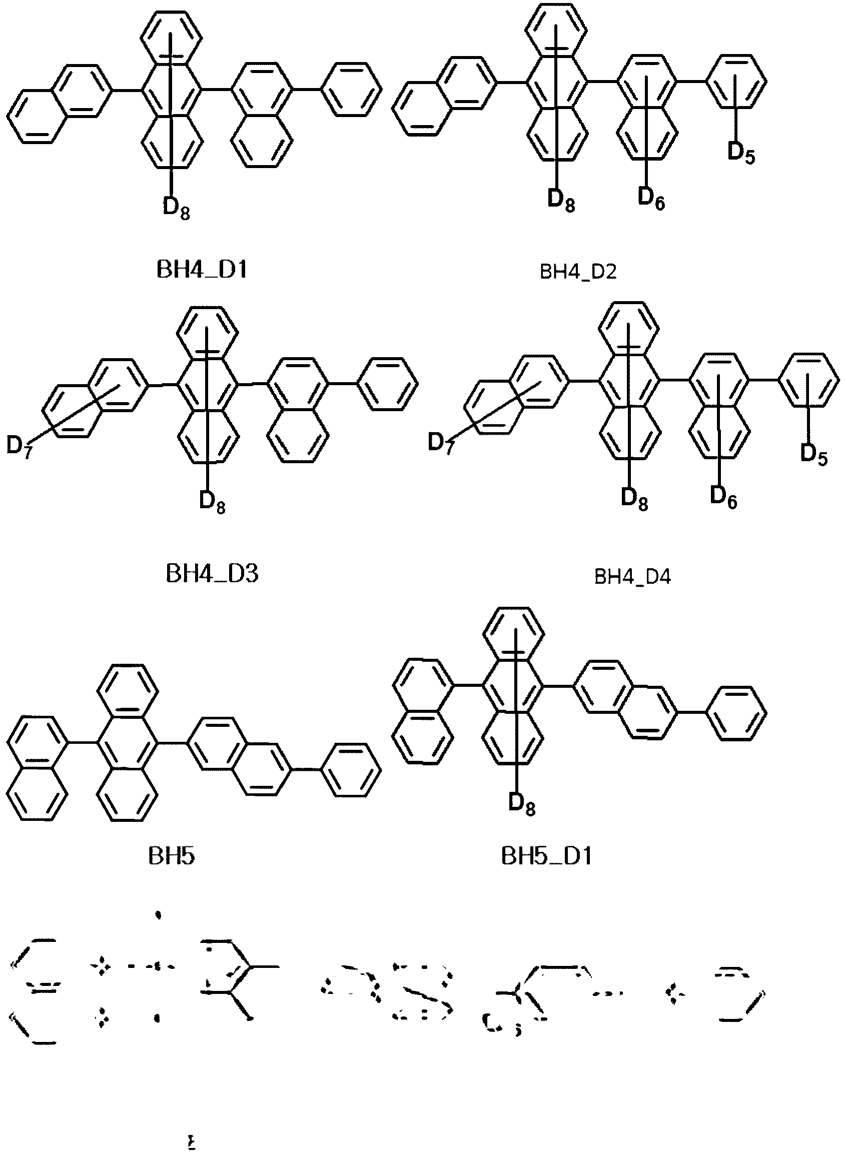

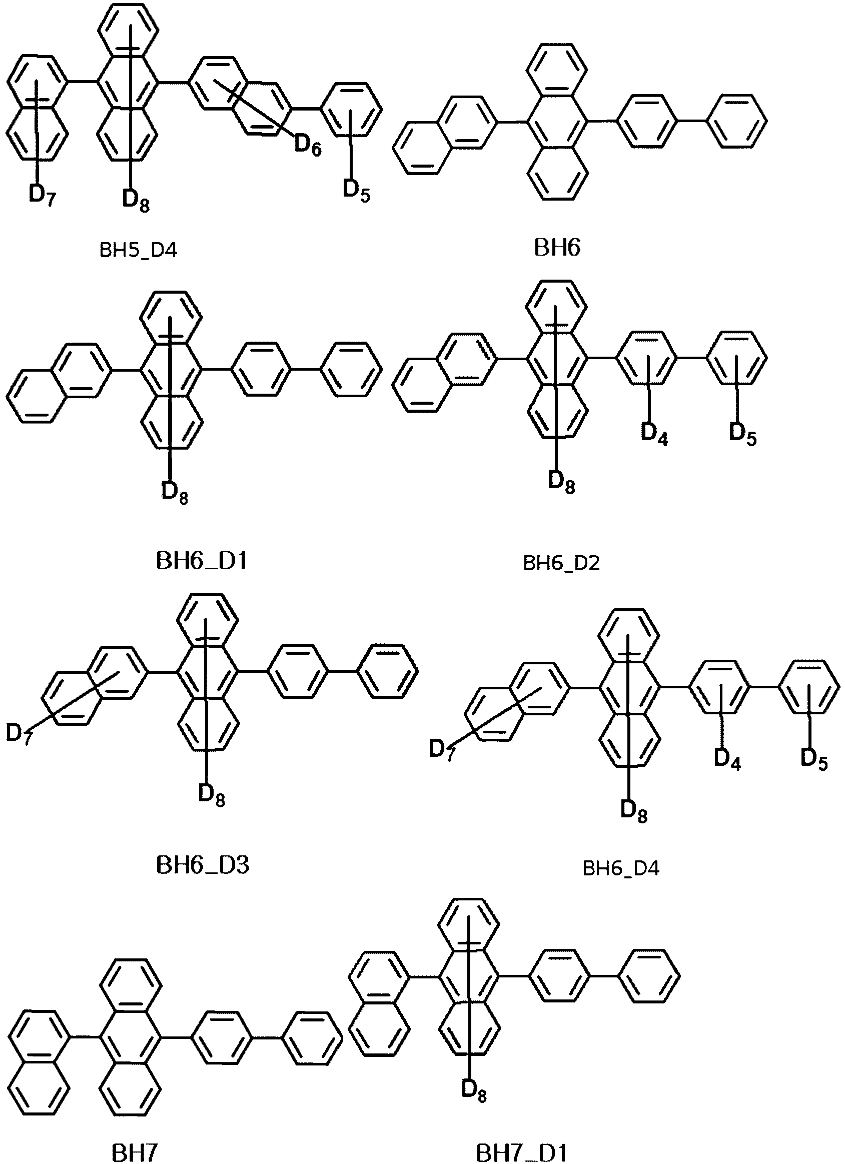

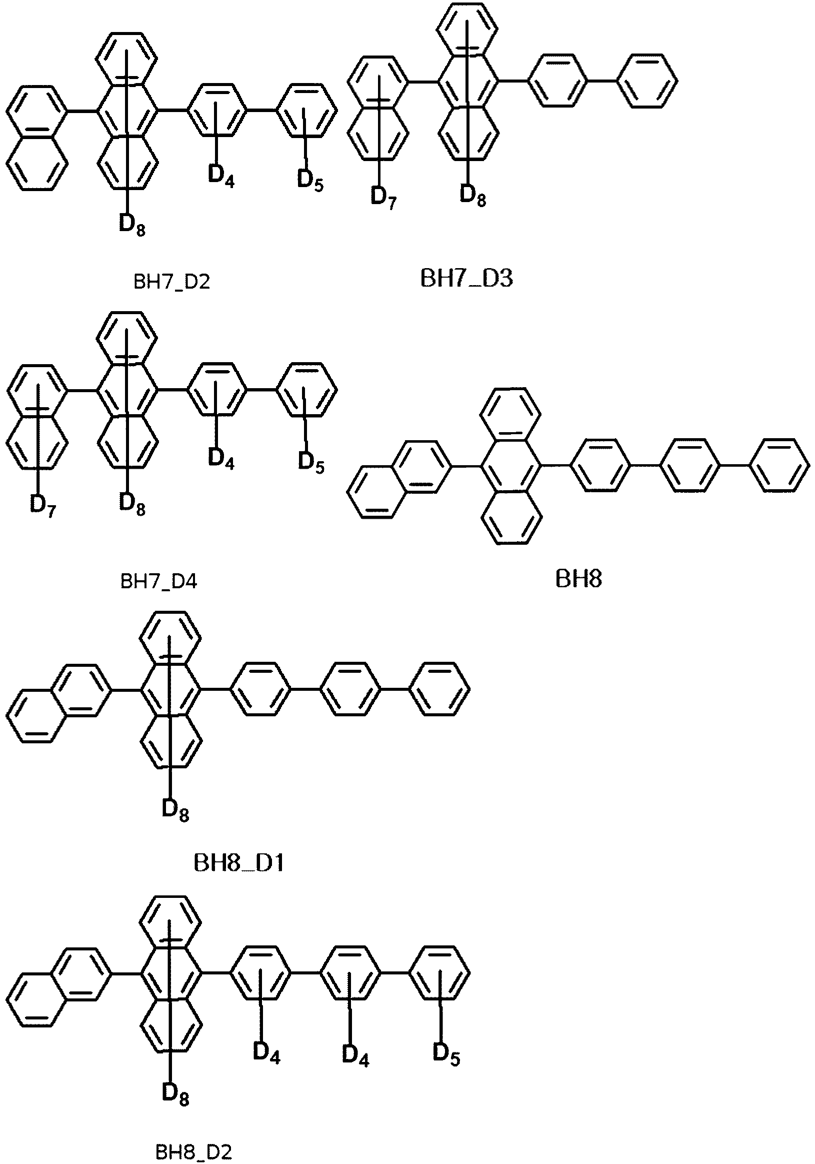

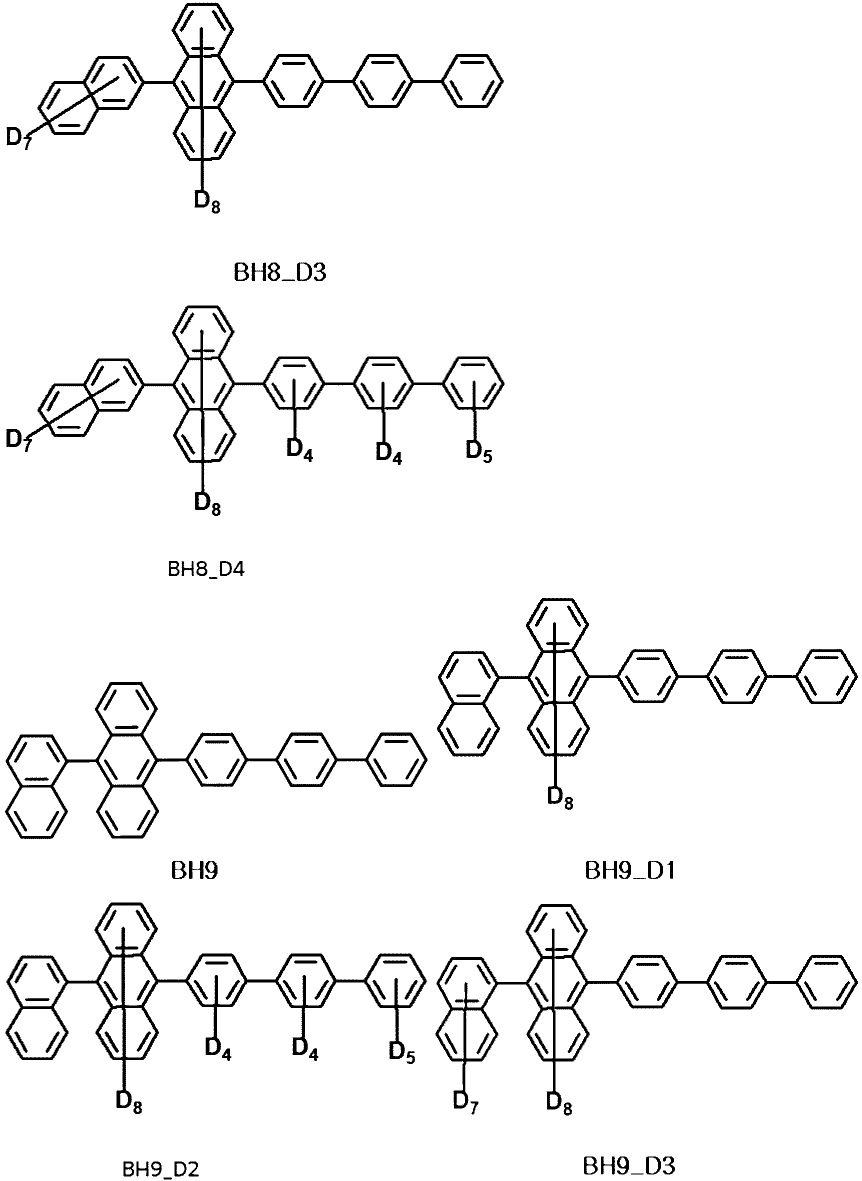

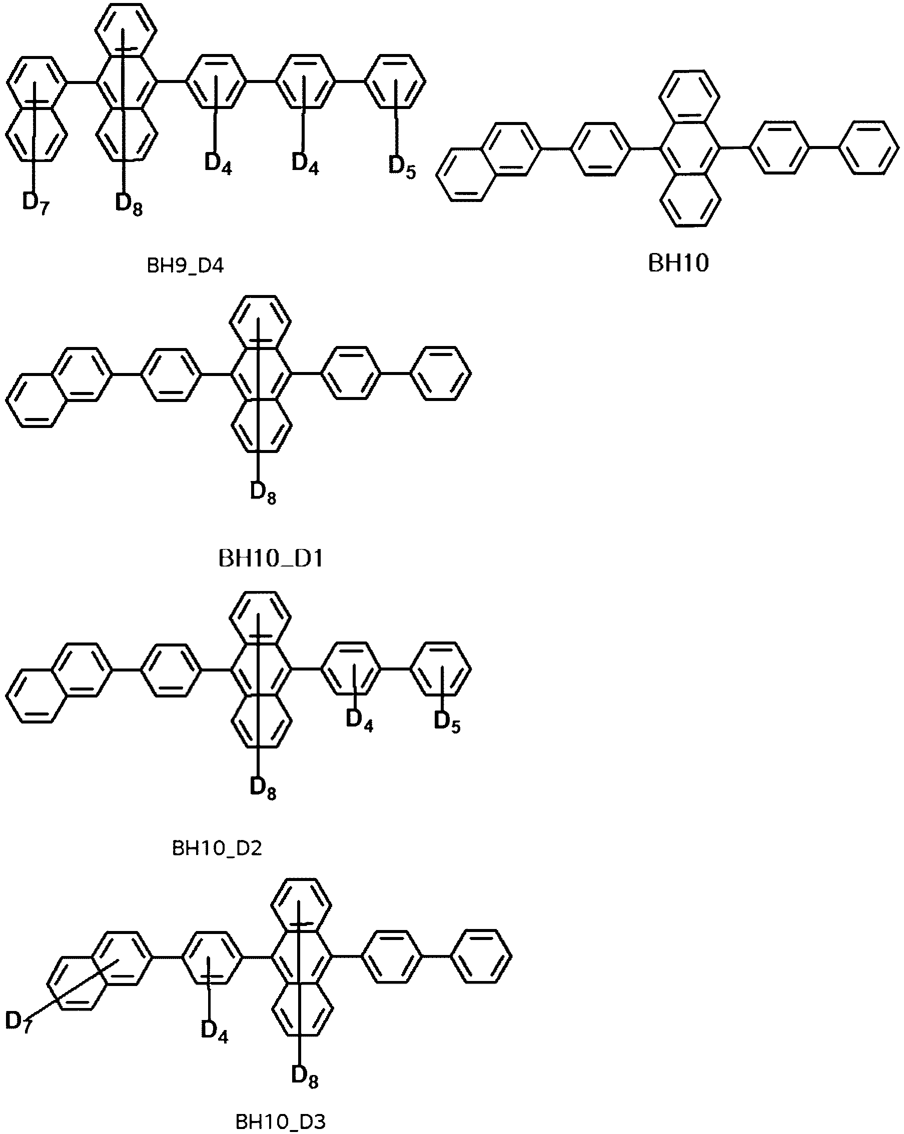

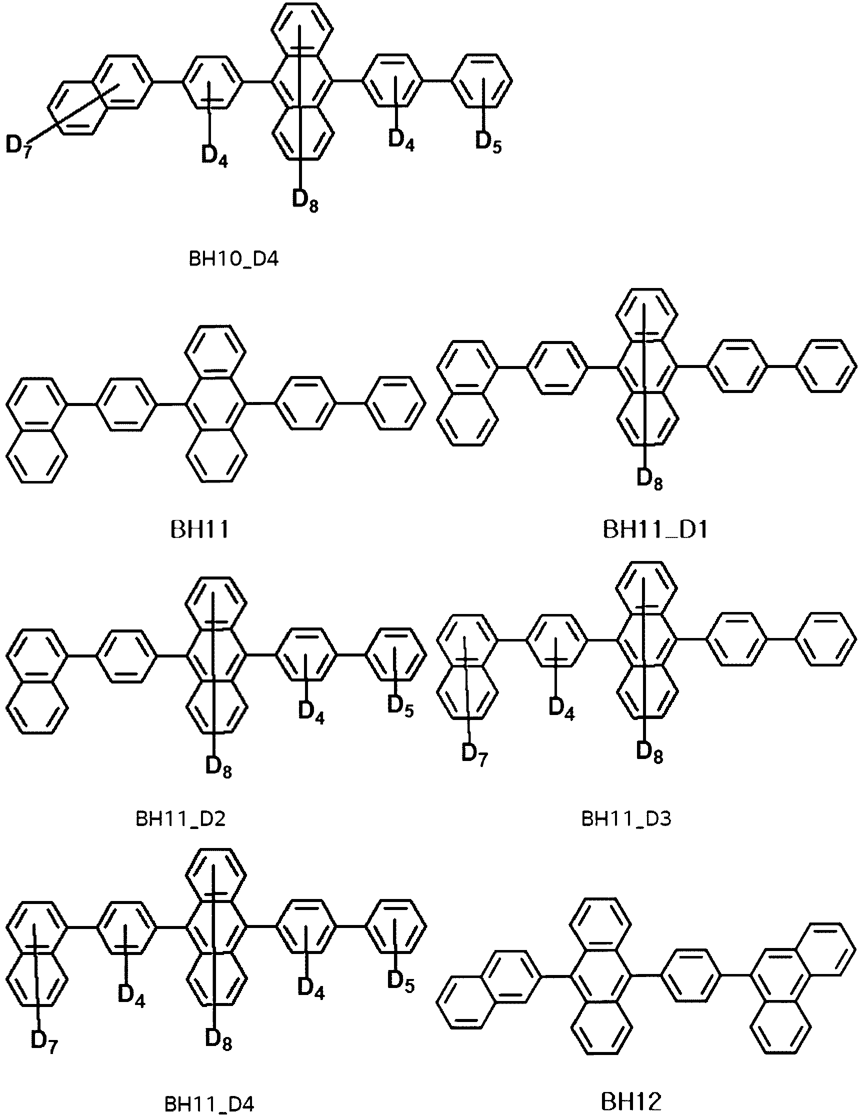

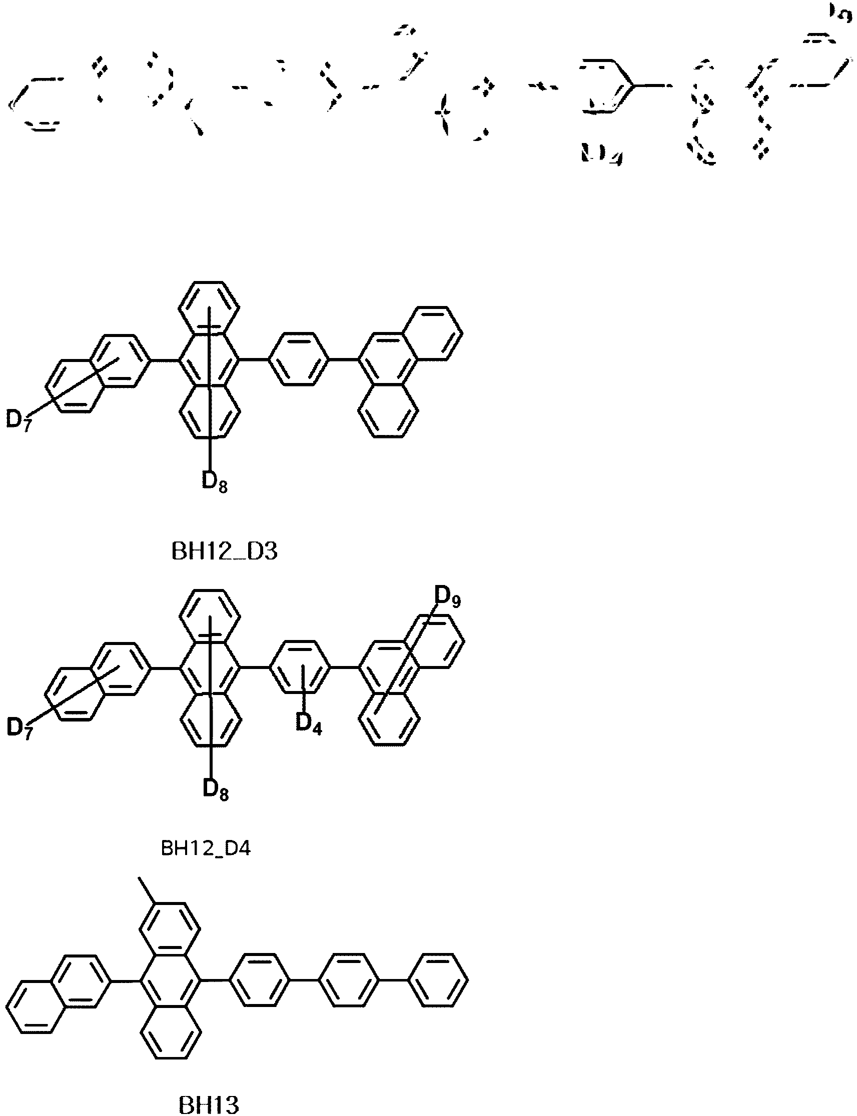

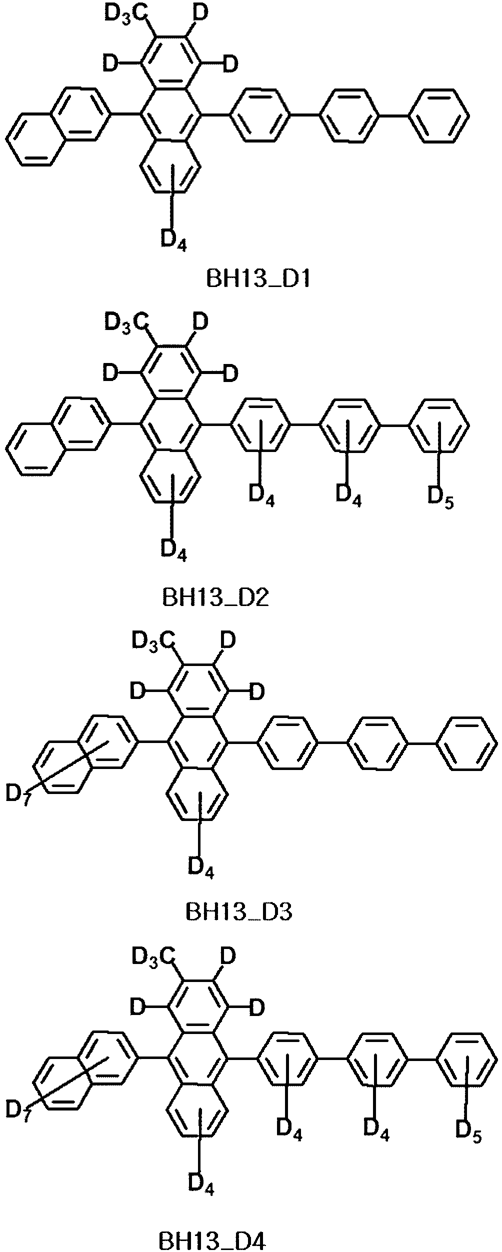

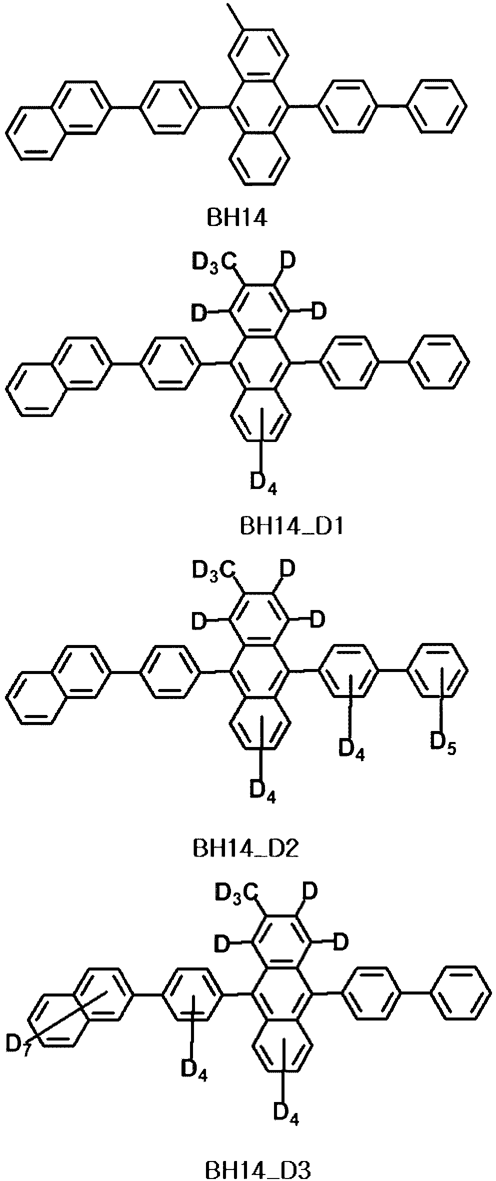

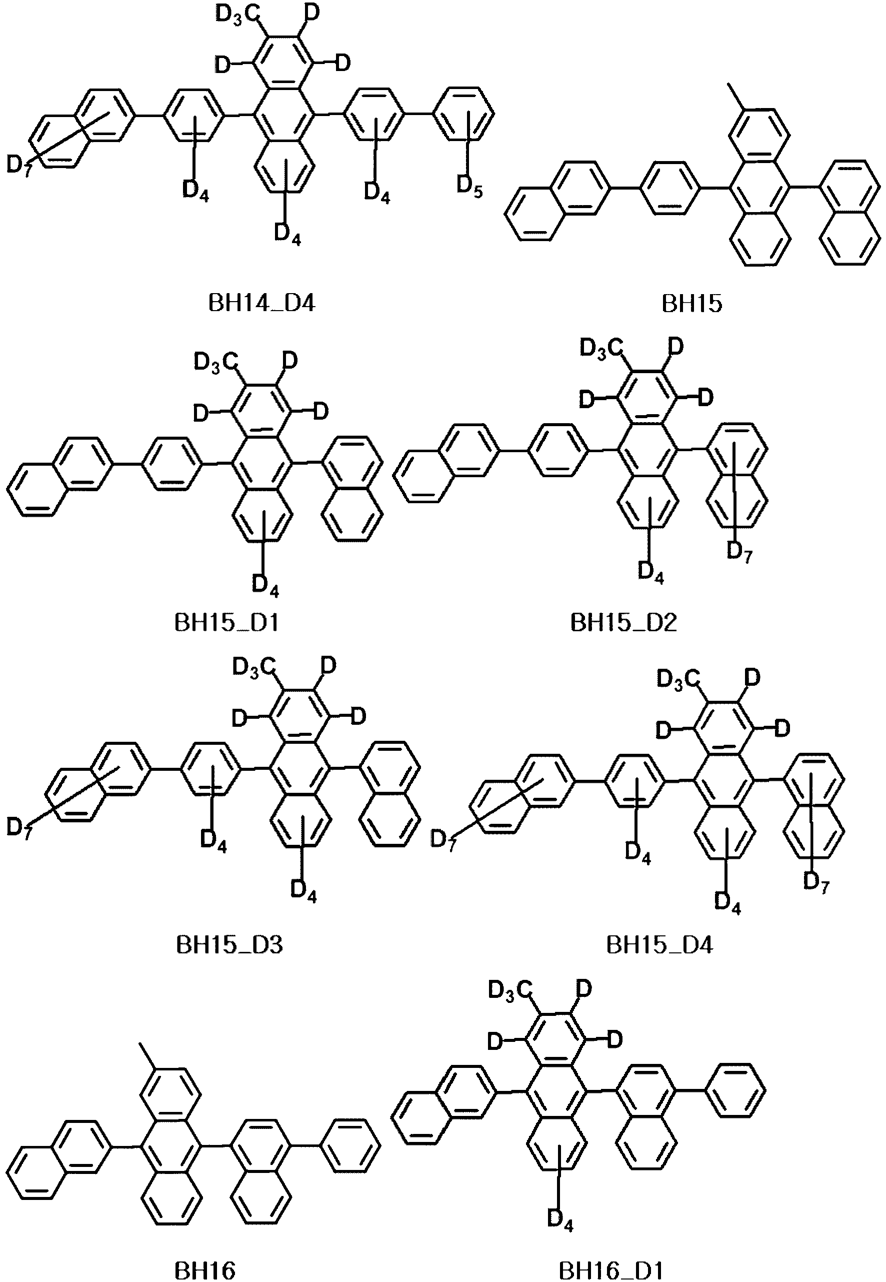

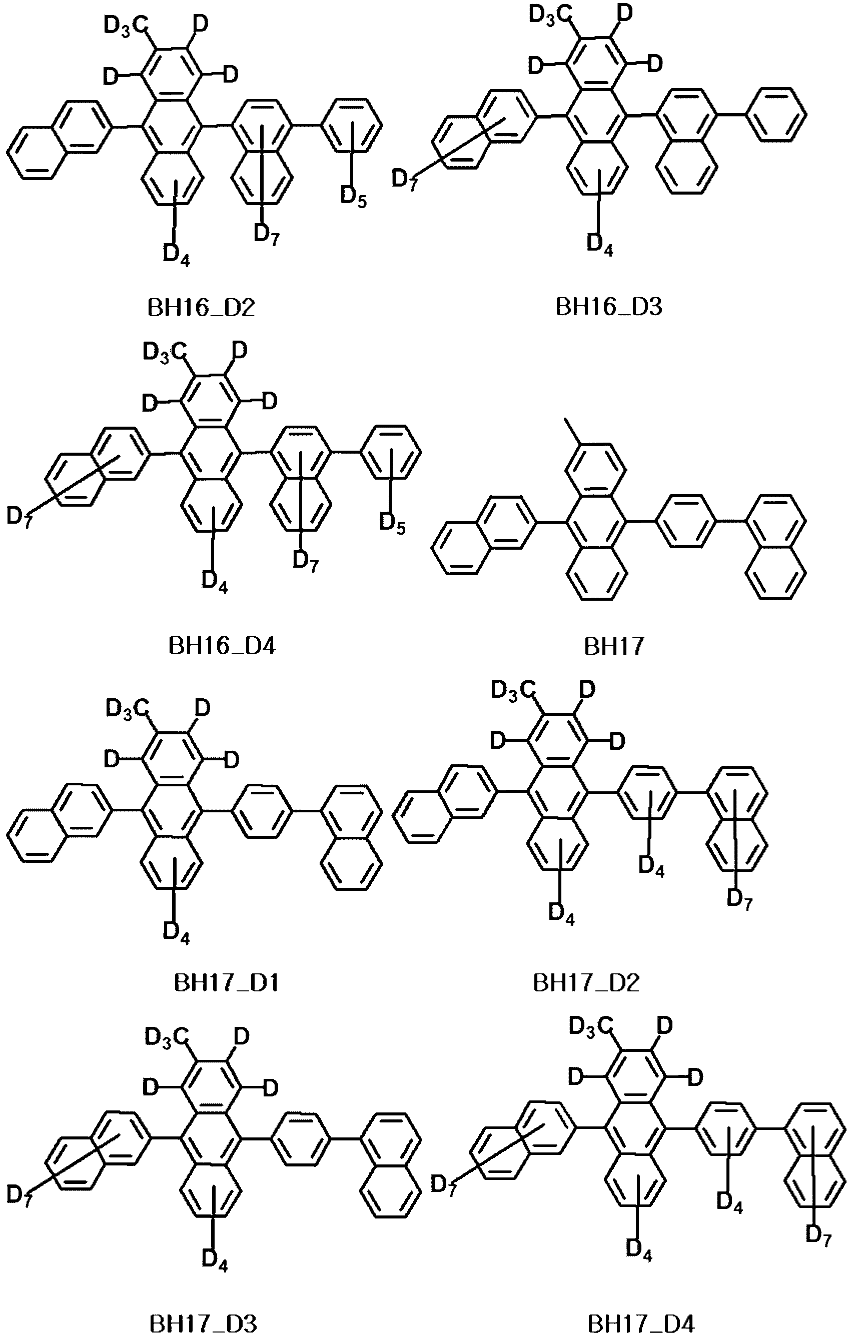

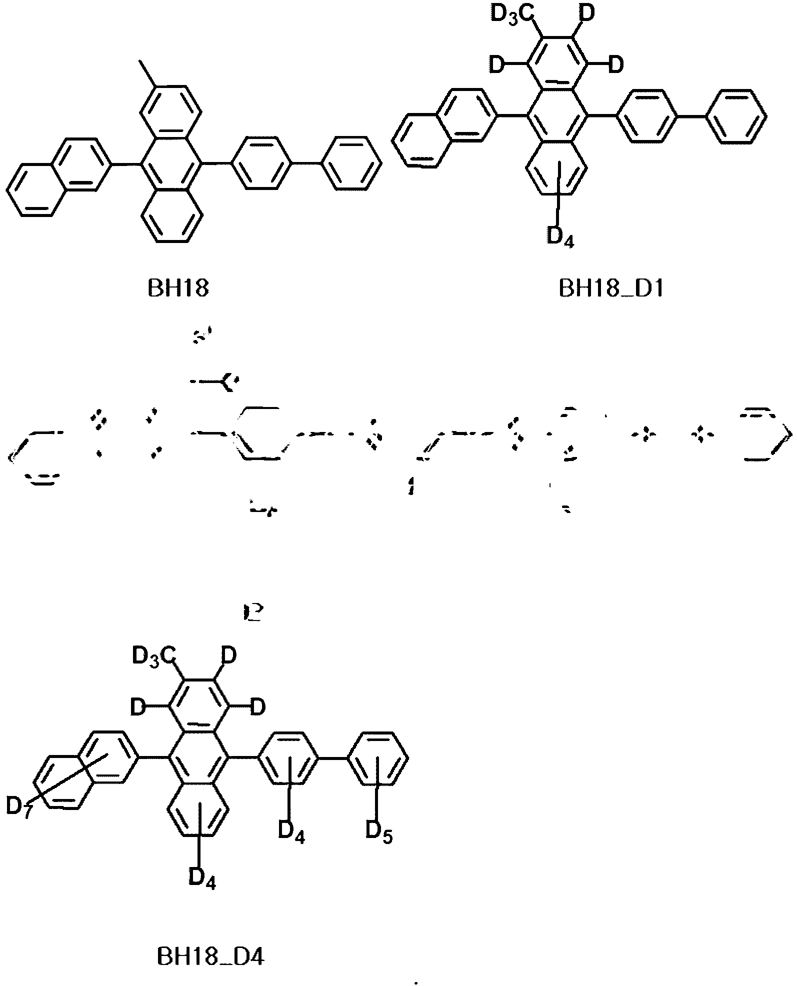

9. Diode électroluminescente organique selon l'une quelconque des revendications 1 à 8, comportant en outre :
une seconde partie émettrice incluant une troisième couche émettrice de bleu et une quatrième couche émettrice de bleu et positionnée entre la première partie émettrice et la seconde électrode, la quatrième couche émettrice de bleu étant positionnée entre la troisième couche émettrice de bleu et la seconde électrode et en contact avec la troisième couche émettrice de bleu,
dans laquelle la troisième couche émettrice de bleu inclut un troisième hôte et un troisième dopant, et la quatrième couche émettrice de bleu inclut un quatrième hôte et un quatrième dopant,
dans laquelle le troisième hôte est un dérivé d'anthracène ayant un troisième rapport de deutériation, et le quatrième hôte est un dérivé d'anthracène ayant un quatrième rapport de deutériation inférieur au troisième rapport de deutériation,
dans laquelle le troisième dopant est un troisième composé représenté par la Formule 3 : 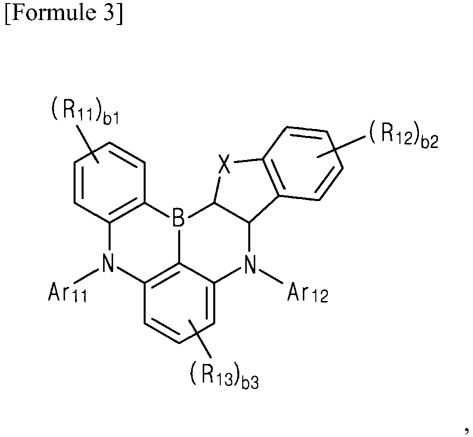
dans laquelle, dans la Formule 3,
chaque élément parmi b1 et b2 est indépendamment un entier de 0 à 4, et b3 est un entier de 0 à 3,
X est O ou S,
chaque élément parmi Ar₁₁ et Ar₁₂ est choisi indépendamment parmi le groupe constitué d'un groupe aryle en C₆ à C₃0 substitué ou non substitué, d'un groupe hétéroaryle en C₃ à C₃₀ substitué ou non substitué, et d'un groupe alicyclique en C₆ à C₃₀ substitué ou non substitué, et
R₁₁, R₁₂ et R₁₃ sont choisis indépendamment les uns des autres parmi le groupe constitué d'un groupe alkyle en C₁ à C₃₀ substitué ou non substitué, d'un groupe cycloalkyle en C₃ à C₃₀ substitué ou non substitué, d'un groupe arylamino en C₆ à C₃₀ substitué ou non substitué, d'un groupe aryle en C₆ à C₃₀ substitué ou non substitué et d'un groupe hétéroaryle en C₃ à C₃₀ substitué ou non substitué, ou au moins les éléments d'une paire parmi deux éléments R₁₁ adjacents ou plus, deux éléments R₁₂ adjacents ou plus et deux éléments R₁₃ adjacents ou plus sont reliés l'un à l'autre pour former un cycle substitué ou non substitué,
et le quatrième dopant est un quatrième composé représenté par la Formule 7 :

10. Diode électroluminescente organique selon la revendication 9, dans laquelle le troisième dopant est représenté par la Formule 3a : 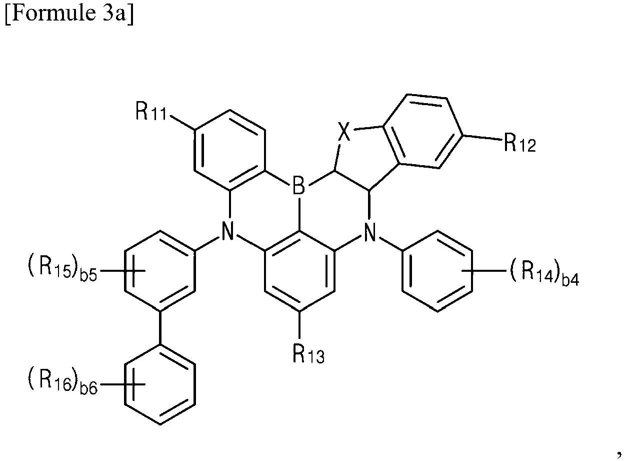
dans laquelle, dans la Formule 3a, les définitions de X, R₁₁, R₁₂ et R₁₃ sont identiques à celles de la Formule 3,
chaque élément parmi b4 et b6 est indépendamment un entier de 0 à 5, et b5 est un entier de 0 à 4,
chaque élément parmi R₁₄, R₁₅ et R₁₆ est choisi parmi le groupe constitué d'un groupe alkyle en C₁ à C₃₀ substitué ou non substitué et d'un groupe cycloalkyle en C₃ à C₃₀ substitué ou non substitué, ou au moins une paire de deux éléments R₁₄ adjacents et deux éléments R₁₅ et R₁₆ adjacents sont reliés les uns aux autres pour former un cycle substitué ou non substitué,
dans laquelle le quatrième dopant est représenté par la Formule 7a : 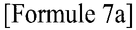 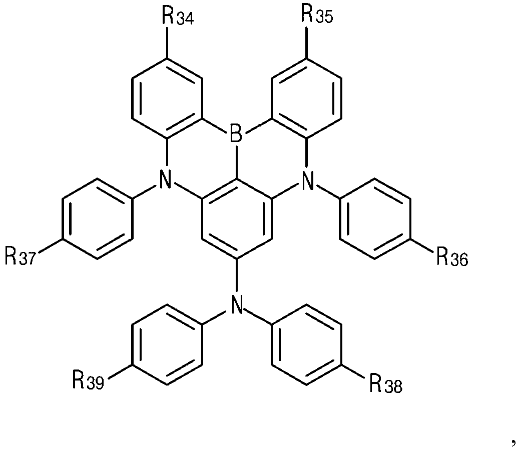
dans laquelle, dans la Formule 7a, chaque élément parmi R₃₄ à R₃₉ est choisi indépendamment des autres parmi le groupe constitué de l'hydrogène, d'un groupe alkyle en C₁ à C₃₀ substitué ou non substitué, d'un groupe cycloalkyle en C₃ à C₃₀ substitué ou non substitué, d'un groupe aryle en C₆ à C₃₀ substitué ou non substitué, et d'un groupe hétéroaryle en C₃ à C₃₀ substitué ou non substitué.

11. Diode électroluminescente organique selon l'une quelconque des revendications 9 à 10, dans laquelle le troisième hôte est représenté par la Formule 1 : 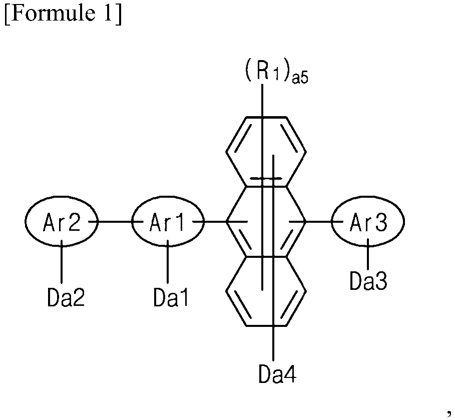
dans laquelle, dans la Formule 1,
chaque élément parmi a1, a2 et a3 est indépendamment un entier de 0 ou 30, chaque élément parmi a4 et a5 est indépendamment un entier de 0 à 8, et au moins un élément parmi a1 à a4 est un entier positif,
Ar1 est choisi parmi le groupe constitué d'une liaison simple (une liaison directe), d'un groupe arylène en C₆ à C₃₀ substitué ou non substitué, et d'un groupe hétéroarylène en C₃ à C₃₀ substitué ou non substitué,
chaque élément parmi Ar2 et Ar3 est choisi parmi le groupe constitué d'un groupe aryle en C₆ à C₃₀ substitué ou non substitué, et d'un groupe hétéroaryle en C₃ à C₃₀ substitué ou non substitué, et
R₁ est choisi parmi le groupe constitué d'un groupe alkyle en C₁ à C₃₀ non substitué ou substitué par du deutérium, et d'un groupe cycloalkyle en C₃ à C₃₀ non substitué ou substitué par du deutérium,
dans laquelle le quatrième hôte est représenté par la formule 5 : 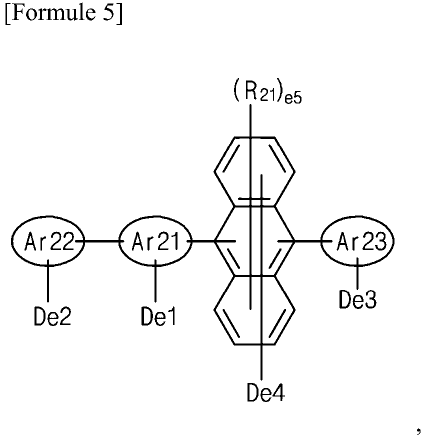
dans laquelle, dans la Formule 5,
chaque élément parmi el, e2 et e3 est indépendamment un entier de 0 ou 30, chaque élément parmi e4 et e5 est indépendamment un entier de 0 à 8, et une somme de e1 à e4 est inférieure à une somme de a1 à a4 dans la Formule 1,
Ar21 est choisi parmi le groupe constitué d'une liaison simple (une liaison directe), d'un groupe arylène en C₆ à C₃₀ substitué ou non substitué, et d'un groupe hétéroarylène en C₃ à C₃₀ substitué ou non substitué,
chaque élément parmi Ar22 et Ar23 est choisi parmi le groupe constitué d'un groupe aryle en C₆ à C₃₀ substitué ou non substitué, et d'un groupe hétéroaryle en C₃ à C₃₀ substitué ou non substitué, et
R₂₁ est choisi parmi le groupe constitué d'un groupe alkyle en C₁ à C₃₀ non substitué ou substitué par du deutérium, et d'un groupe cycloalkyle en C₃ à C₃₀ non substitué ou substitué par du deutérium.

12. Diode électroluminescente organique selon l'une quelconque des revendications 9 à 11, dans laquelle le troisième hôte est représenté par la Formule la : 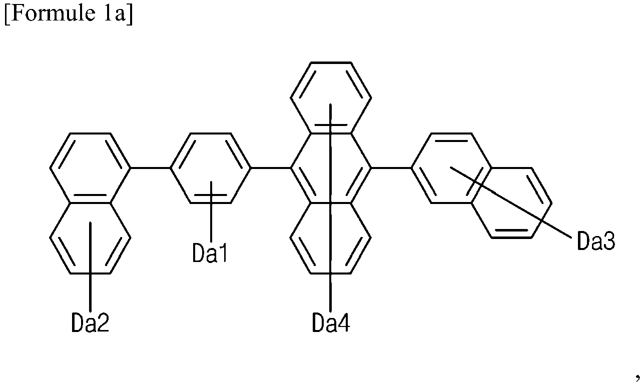
dans laquelle, dans la Formule 1a, a1 est un entier de 0 à 4, chaque élément parmi a2 et a3 est indépendamment un entier de 0 à 7, a4 est un entier de 0 à 8, et au moins un élément parmi a1 à a4 est un entier positif,
dans laquelle le quatrième hôte est représenté par la Formule 5a : 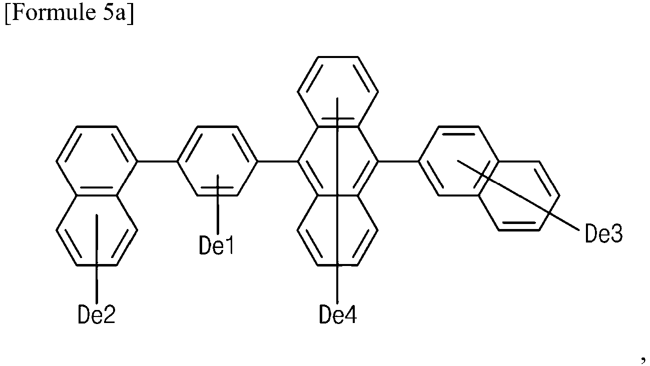
dans laquelle, dans la Formule 5a, e1 est un entier de 0 à 4, chaque élément parmi e2 et e3 est indépendamment un entier de 0 à 7, e4 est un entier de 0 à 8, et une somme de e1 à e4 est inférieure à une somme de a1 à a4 dans la Formule la.

13. Diode électroluminescente organique selon l'une quelconque des revendications 1 à 12, dans laquelle le premier dopant est un dérivé du bore ayant un premier niveau d'énergie HOMO, et le deuxième dopant est un dérivé du bore ayant un second niveau d'énergie HOMO inférieur au premier niveau d'énergie HOMO, et dans laquelle le premier dopant a une première énergie triplet, et le deuxième dopant a une seconde énergie triplet supérieure à la première énergie triplet.

14. Dispositif électroluminescent organique, comportant :
un substrat ;
une diode électroluminescente organique selon la revendication 1 au-dessus du substrat ; et
une couche d'encapsulation recouvrant la diode électroluminescente organique,
dans lequel le substrat inclut une région de pixel rouge, une région de pixel verte et une région de pixel bleue, et la diode électroluminescente organique correspond à la région de pixel rouge, à la région de pixel verte et à la région de pixel bleue,
dans lequel le dispositif électroluminescent organique comporte en outre : une couche de filtre à couleur correspondant à la région de pixel rouge, à la région de pixel verte et à la région de pixel bleue et positionnée entre le substrat et la diode électroluminescente organique ou au-dessus de la diode électroluminescente organique, ou
dans lequel le dispositif électroluminescent organique comporte en outre : une couche de conversion de couleur correspondant à la région de pixel rouge et à la région de pixel verte et positionnée entre le substrat et la diode électroluminescente organique ou au-dessus de la diode électroluminescente organique.
